# EUROPEAN PATENT SPECIFICATION

(11) **EP 4 400 559 B1**
(45) Date of publication and mention of the grant of the patent: **22.10.2025**
(21) Application number: 23216879.9
(22) Date of filing: 14.12.2023
(51) Int. Cl.: C09K 11/06, C07F 15/00, H10K 85/30

(54) **LIGHT-EMITTING DEVICE INCLUDING ORGANOMETALLIC COMPOUND, ELECTRONIC APPARATUS INCLUDING THE LIGHT-EMITTING DEVICE, AND THE ORGANOMETALLIC COMPOUND**
LICHTEMITTIERENDE VORRICHTUNG MIT ORGANOMETALLISCHER VERBINDUNG, ELEKTRONISCHE VORRICHTUNG MIT DER LICHTEMITTIERENDEN VORRICHTUNG UND ORGANOMETALLISCHE VERBINDUNG
DISPOSITIF ÉLECTROLUMINESCENT COMPRENANT UN COMPOSÉ ORGANOMÉTALLIQUE, APPAREIL ÉLECTRONIQUE COMPRENANT LE DISPOSITIF ÉLECTROLUMINESCENT ET LE COMPOSÉ ORGANOMÉTALLIQUE

(30) Priority: 12.01.2023 KR 20230004927
(43) Date of publication of application: 17.07.2024
(73) Proprietor: Samsung Display Co., Ltd., Yongin-si, Gyeonggi-do 17113 (KR)
(72) Inventor: JU, Jinhee, 17113 Yongin-si (KR); KIM, Sungbum, 17113 Yongin-si (KR); AHN, Seihwan, 17113 Yongin-si (KR); AHN, Eunsoo, 17113 Yongin-si (KR); LEE, Eunyoung, 17113 Yongin-si (KR); JEON, Mina, 17113 Yongin-si (KR)
(74) Representative: Marks & Clerk LLP

(56) References cited:
- US-A1- 2022 131 095
- US-A1- 2022 173 338

## Description

### BACKGROUND

### 1. Field

One or more aspects of embodiments of the present disclosure relate to a light-emitting device including an organometallic compound, an electronic apparatus including the light-emitting device, and the organometallic compound.

### 2. Description of the Related Art

Self-emissive devices (for example, organic light-emitting devices) are a class of light-emitting devices that have relatively wide viewing angles, high contrast ratios, short response times, and excellent or suitable characteristics in terms of luminance, driving voltage, and response speed.

In a light-emitting device, a first electrode is located on a substrate, and a hole transport region, an emission layer, an electron transport region, and a second electrode are sequentially arranged on the first electrode. Holes provided from the first electrode move toward the emission layer through the hole transport region, and electrons provided from the second electrode move toward the emission layer through the electron transport region. Carriers, such as holes and electrons, recombine in the emission layer to produce excitons. These excitons may transition (i.e., relax) from an excited state to a ground state to thereby generate light.

Implementation of the light-emitting device in a display device requires (or there is a desire) that the light-emitting device (e.g., self-emissive device) possess reduced driving voltage, improved luminescence efficiency, and/or a long lifespan. Therefore, the need exists for development of a material for a light-emitting device which is capable of stably (or suitably) implementing these properties. For example, to implement a light-emitting device having high luminescence efficiency, materials for an emission layer having excellent or suitable energy levels are continuously being developed and/or desired. US 2022/173338 A1 and US 2022/131095 A1 disclose light emitting organometallic Pt-complexes and organic light emitting devices comprising these organometallic complexes.

### SUMMARY

One or more aspects of embodiments of the present disclosure are directed toward a light-emitting device including an organometallic compound, an electronic apparatus including the light-emitting device, and the organometallic compound.

Additional aspects will be set forth in part in the description which follows and, in part, will be apparent from the description, or may be learned by practice of the presented embodiments of the disclosure.

According to one or more embodiments, a light-emitting device includes:
a first electrode,
a second electrode facing the first electrode,
an interlayer located between the first electrode and the second electrode and including an emission layer, and
an organometallic compound represented by Formula 1:

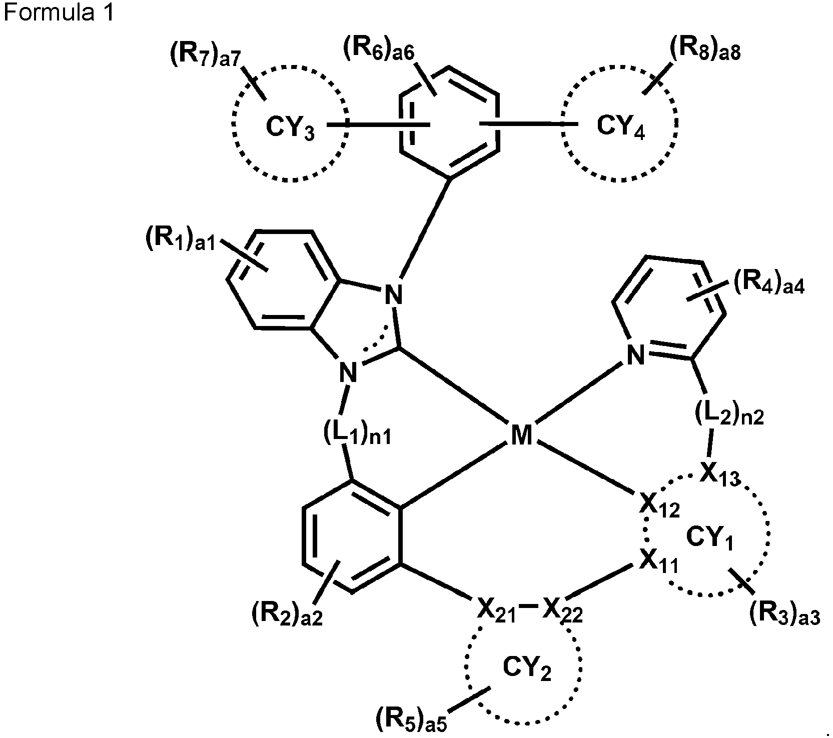

In Formula 1,
M is platinum (Pt), palladium (Pd), copper (Cu), silver (Ag), gold (Au), rhodium (Rh), ruthenium (Ru), osmium (Os), titanium (Ti), zirconium (Zr), hafnium (Hf), europium (Eu), terbium (Tb), or thulium (Tm),
X₁₁ to X₁₃, X₂₁, and X₂₂ are each independently C or N,
X₂₁ and X₂₂ are linked to each other via a chemical bond,
rings CY₁ to CY₄ are each independently a C₅-C₃₀ carbocyclic group or a C₁-C₃₀ heterocyclic group,
L₁ and L₂ are each independently a single bond, *-C(R₁ₐ)(R_{1b})-*', *-C(R₁ₐ)=*', *=C(R₁ₐ)-*', *-C(R₁ₐ)=C(R_{1b})-*', *-C(=O)-*', *-C(=S)-*', *-C≡C-*', *-B(R₁ₐ)-*', *-N(R₁ₐ)-*', *-O-*', *-P(R₁ₐ)-*', *-Al(R₁ₐ)-*, *-Si(R₁ₐ)(R_{1b})-*', *-P(=O)(R₁ₐ)-*', *-S-*', *-S(=O)-*', *-S(=O)₂-*', or *-Ge(R₁ₐ)(R_{1b})-*', and * and *' each indicate a binding site to a neighboring atom,
n1 and n2 are each independently an integer from 1 to 5,
R₁ to R₈, R₁ₐ, and R_{1b} are each independently hydrogen, deuterium, -F, -Cl, - Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₁-C₆₀ alkylthio group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -C(Q₁)(Q₂)(Q₃), -Si(Q₁)(Q₂)(Q₃), - N(Q₁)(Q₂), -B(Q₁)(Q₂), -C(=O)(Q₁), -S(=O)₂(Q₁), or -P(=O)(Q₁)(Q₂),
a1 is an integer from 1 to 4,
a2 is an integer from 1 to 3,
a3 is an integer from 1 to 6,
a4 is an integer from 1 to 4,
a5 is an integer from 1 to 8,
a6 is an integer from 1 to 3,
a7 and a8 are each independently an integer from 1 to 5,
R₁₀ₐ is
deuterium, -F, -Cl, -Br, -I, a hydroxyl group, a cyano group, or a nitro group,
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, -Si(Q₁₁)(Q₁₂)(Q₁₃), - N(Q₁₁)(Q₁₂), -B(Q₁₁)(Q₁₂), -C(=O)(Q₁₁), -S(=O)₂(Q₁₁), -P(=O)(Q₁₁)(Q₁₂), or a combination thereof,
a C₃-C₆₀ carbocyclic group, a C₁-C₆₀ heterocyclic group, a C₆-C₆₀ aryloxy group, or a C₆-C₆₀ arylthio group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, - Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), - P(=O)(Q₂₁)(Q₂₂), or a combination thereof, or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂),
wherein Q₁ to Q₃, Q₁₁ to Q₁₃, Q₂₁ to Q₂₃, and Q₃₁ to Q₃₃ are each independently hydrogen, deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, or a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or a combination thereof.

According to one or more embodiments, an electronic apparatus includes the light-emitting device.

According to one or more embodiments, electronic equipment includes the light-emitting device.

One or more embodiments of the present disclosure are directed toward an organometallic compound represented by Formula 1.

At least some of the above and other features of the invention are set out in the claims.

### BRIEF DESCRIPTION OF THE DRAWINGS

The accompanying drawings are included to provide a further understanding of the above and other aspects, features, and advantages of certain embodiments of the present disclosure are incorporated in and constitute a part of this specification. The drawings illustrate example embodiments and, together with the following description taken in conjunction with the accompanying drawings, serve to make the principles of the present disclosure more apparent. In the drawings:
FIG. 1 is a schematic cross-sectional view of a light-emitting device according to one or more embodiments of the present disclosure;
FIG. 2 is a schematic cross-sectional view of an electronic apparatus according to one or more embodiments of the present disclosure;
FIG. 3 is a schematic cross-sectional view of an electronic apparatus according to one or more embodiments of the present disclosure; and
FIG. 4 is a schematic perspective view of an electronic equipment including a light-emitting device according to one or more embodiments of the present disclosure;
FIG. 5 is a schematic perspective view of the exterior of a vehicle; and
FIG. 6A is a schematic view of the interior of a vehicle that includes electronic equipment according to one or more embodiments of the present disclosure;
FIG. 6B is a schematic view of the interior of a vehicle that includes electronic equipment according to one or more embodiments of the present disclosure; and
FIG. 6C is a schematic view of the interior of a vehicle that includes electronic equipment according to one or more embodiments of the present disclosure.

### DETAILED DESCRIPTION

Reference will now be made in more detail to embodiments of the present disclosure, examples of which are illustrated in the accompanying drawings, wherein like reference numerals refer to like elements throughout, and duplicative descriptions thereof may not be provided. In this regard, the present embodiments may have different forms and should not be construed as being limited to the descriptions set forth herein. Accordingly, the embodiments are merely described, by referring to the drawings, to explain aspects of the present description.

As utilized herein, the term "and/or" includes any and all combinations of one or more of the associated listed items. Expressions such as "at least one of," "one of," and "selected from," when preceding a list of elements, modify the entire list of elements and do not modify the individual elements of the list. For example, throughout the disclosure, the expression "at least one of a, b or c" indicates only a, only b, only c, both (e.g., simultaneously) a and b, both (e.g., simultaneously) a and c, both (e.g., simultaneously) b and c, all of a, b, and c, or variations thereof.

The terminology used herein is for the purpose of describing embodiments and is not intended to limit the embodiments described herein. Unless otherwise defined, all chemical names, technical and scientific terms, and terms defined in common dictionaries should be interpreted as having meanings consistent with the context of the related art, and should not be interpreted in an ideal or overly formal sense. It will be understood that, although the terms first, second, etc. may be used herein to describe various elements, these elements should not be limited by these terms. These terms are only used to distinguish one element from another element. Thus, a first element could be termed a second element without departing from the teachings of the present disclosure. Similarly, a second element could be termed a first element.

As used herein, singular forms such as "a," "an," and "the" are intended to include the plural forms as well, unless the context clearly indicates otherwise.

It will be further understood that the terms "comprise," "comprises," "comprising," "has," "have," "having," "include," "includes," and/or " including," when used in this specification, specify the presence of stated features, steps, operations, elements, and/or components, but do not preclude the presence or addition of one or more other features, steps, operations, elements, components, and/or groups thereof.

As used herein, the terms "use," "using," and "used" may be considered synonymous with the terms "utilize," "utilizing," and "utilized," respectively.

As used herein, the term "and/or" includes any, and all, combination(s) of one or more of the associated listed items.

The term "may" will be understood to refer to "one or more embodiments of the present disclosure," some of which include the described element and some of which exclude that element and/or include an alternate element. Similarly, alternative language such as "or" refers to "one or more embodiments of the present disclosure," each including a corresponding listed item.

It will be understood that when an element is referred to as being "on," "connected to," or "on" another element, it may be directly on, connected, or coupled to the other element or one or more intervening elements may also be present. When an element is referred to as being "directly on," "directly connected to," or "directly coupled to" another element, there are no intervening elements present.

Spatially relative terms, such as "beneath," "below," "lower," "above," "upper," "bottom," "top," and the like, may be used herein for ease of description to describe one element or feature's relationship to another element(s) or feature(s) as illustrated in the drawings. It will be understood that the spatially relative terms are intended to encompass different orientations of the device in use or operation in addition to the orientation depicted in the drawings. For example, if the device in the drawings is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

Unless otherwise defined, all terms (including technical and scientific terms) used herein have the same meaning as commonly understood by those of ordinary skill in the art to which the present disclosure pertains. It is also to be understood that terms defined in commonly used dictionaries should be interpreted as having meanings consistent with meanings in the context of the related art, unless expressly defined herein, and should not be interpreted in an ideal or overly formal sense.

In this context, "consisting essentially of" means that any additional components will not materially affect the chemical, physical, optical or electrical properties of the semiconductor film.

Further, in this specification, the phrase "on a plane," or "plan view," means viewing a target portion from the top, and the phrase "on a cross-section" means viewing a cross-section formed by vertically cutting a target portion from the side.

In one or more embodiments, a light-emitting device includes:
a first electrode;
a second electrode facing the first electrode;
an interlayer located between the first electrode and the second electrode and including an emission layer; and
an organometallic compound represented by Formula 1: 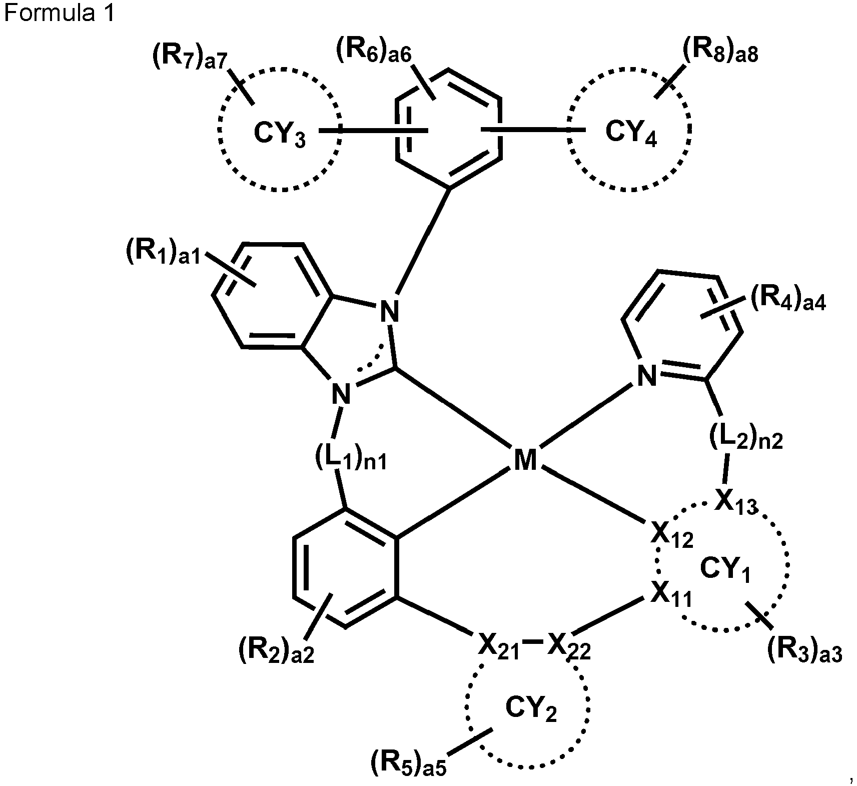 wherein Formula 1 is as described herein.
   In one or more embodiments,
   the first electrode of the light-emitting device may be an anode,
   the second electrode of the light-emitting device may be a cathode,
   the interlayer may further include a hole transport region between the first electrode and the emission layer and an electron transport region between the emission layer and the second electrode,
   the hole transport region may include a hole injection layer, a hole transport layer, an emission auxiliary layer, an electron blocking layer, or a combination thereof, and
   the electron transport region may include a hole blocking layer, an electron transport layer, an electron injection layer, or a combination thereof.

In one or more embodiments, the interlayer of the light-emitting device may include the organometallic compound represented by Formula 1.

In one or more embodiments, the emission layer of the light-emitting device may include the organometallic compound represented by Formula 1.

In one or more embodiments, the emission layer of the light-emitting device may include a dopant and a host, and the organometallic compound represented by Formula 1 may be included in the dopant. For example, the organometallic compound may act as a dopant. For example, the emission layer may be to emit blue light. The blue light may have a maximum emission wavelength in a range of, for example, about 430 nanometer (nm) to about 470 nm.

In one or more embodiments, the electron transport region of the light-emitting device may include a hole blocking layer, and the hole blocking layer may include a phosphine oxide-containing compound, a silicon-containing compound, or a combination thereof. In one or more embodiments, the hole blocking layer may directly contact the emission layer.

In one or more embodiments, the light-emitting device may further include a second compound including at least one π electron-deficient nitrogen-containing C₁-C₆₀ (e.g. C₁-C₃₀) heterocyclic group, a third compound including a group represented by Formula 3, a fourth compound capable of emitting delayed fluorescence, or a combination thereof, and
the organometallic compound, the second compound, the third compound, and the fourth compound in the light-emitting device may be different from each other.

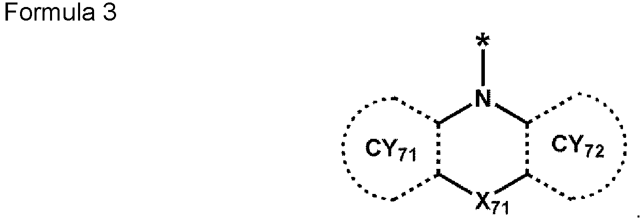

In Formula 3,
rings CY₇₁ and CY₇₂ are each independently a π electron-rich C₃-C₆₀ (e.g. C₃-C₃₀) cyclic group or a pyridine group,
X₇₁ is a single bond or a linking group including O, S, N, B, C, Si, or a combination thereof, and
* in Formula 3 is a binding site to an atom included in portions excluding Formula 3.

In one or more embodiments, the organometallic compound may include at least one deuterium.

In one or more embodiments, the second compound to the fourth compound may each include at least one deuterium.

In one or more embodiments, the second compound may include at least one silicon.

In one or more embodiments, the third compound may include at least one silicon.

In one or more embodiments, the light-emitting device may further include a second compound and a third compound in addition to the organometallic compound represented by Formula 1, and at least one of the second compound or the third compound may include at least one deuterium, at least one silicon, or a combination thereof.

In one or more embodiments, the light-emitting device (for example, the emission layer in the light-emitting device) may each further include a second compound, in addition to the organometallic compound. At least one of the organometallic compound or the second compound may include at least one deuterium. In one or more embodiments, the composition and the light-emitting device (for example, the emission layer in the light-emitting device) may each further include a third compound, a fourth compound, or a combination thereof, in addition to the organometallic compound and the second compound.

In one or more embodiments, the light-emitting device (for example, the emission layer in the light-emitting device) may each further include a second compound, in addition to the organometallic compound. At least one of the organometallic compound or the third compound may include at least one deuterium. In one or more embodiments, the composition and the light-emitting device (for example, the emission layer in the light-emitting device) may each further include a second compound, a fourth compound, or a combination thereof, in addition to the organometallic compound and the third compound.

In one or more embodiments, the light-emitting device (for example, the emission layer in the light-emitting device) may further include a fourth compound, in addition to the organometallic compound. At least one of the organometallic compound or the fourth compound may include at least one deuterium. The fourth compound may serve to improve color purity, luminescence efficiency, and lifespan characteristics of the light-emitting device. In one or more embodiments, the composition and the light-emitting device (for example, the emission layer in the light-emitting device) may each further include a second compound, a third compound, or a combination thereof, in addition to the organometallic compound and the fourth compound.

In one or more embodiments, the light-emitting device (for example, the emission layer in the light-emitting device) may further include a second compound and a third compound, in addition to the organometallic compound. The second compound and the third compound may form an exciplex. At least one of the organometallic compound, the second compound, or the third compound may include at least one deuterium.

In one or more embodiments, the emission layer of the light-emitting device may include: i) the organometallic compound; and ii) the second compound, the third compound, the fourth compound, or a combination thereof, and the emission layer may be to emit blue light.

In one or more embodiments, a maximum emission wavelength of the blue light may be in a range of about 430 nm to about 475 nm, about 440 nm to about 475 nm, about 450 nm to about 475 nm, about 430 nm to about 470 nm, about 440 nm to about 470 nm, about 450 nm to about 470 nm, about 430 nm to about 465 nm, about 440 nm to about 465 nm, about 450 nm to about 465 nm, about 430 nm to about 460 nm, about 440 nm to about 460 nm, or about 450 nm to about 460 nm.

In one or more embodiments, the second compound may include a pyridine group, a pyrimidine group, a pyrazine group, a pyridazine group, a triazine group, or a combination thereof.

In one or more embodiments, the following compounds may be excluded from the third compound.

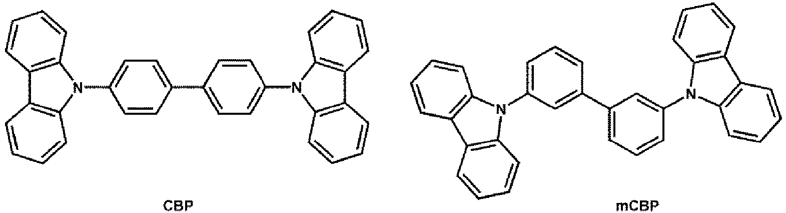

In one or more embodiments, a difference between a triplet energy level (electron volt (eV)) of the fourth compound and a singlet energy level (eV) of the fourth compound may be about 0 eV or higher and about 0.5 eV or lower (or, about 0 eV or higher and about 0.3 eV or lower).

In one or more embodiments, the fourth compound may be a compound including at least one cyclic group including as ring-forming atoms, each of boron (B) and nitrogen (N).

In one or more embodiments, the fourth compound may be a C₈-C₆₀ (e.g. C₈-C₃₀) polycyclic group-containing compound including at least two condensed cyclic groups that share a boron atom (B).

In one or more embodiments, the fourth compound may include a condensed ring in which at least one third ring may be condensed with at least one fourth ring,
the third ring may be a cyclopentane group, a cyclohexane group, a cycloheptane group, a cyclooctane group, a cyclopentene group, a cyclohexene group, a cycloheptene group, a cyclooctene group, an adamantane group, a norbornene group, a norobornane group, a bicyclo[1.1.1]pentane group, a bicyclo[2.1.1]hexane group, a bicyclo[2.2.2]octane group, a benzene group, a pyridine group, a pyrimidine group, a pyridazine group, a pyrazine group, or a triazine group, and
the fourth ring may be a 1,2-azaborinine group, a 1,3-azaborinine group, a 1,4-azaborinine group, a 1,2-dihydro-1,2-azaborinine group, a 1,4-oxaborinine group, a 1,4-thiaborinine group, or a 1,4-dihydroborinine group.

In one or more embodiments, the third compound may not include a (e.g., may exclude any) compound represented by Formula 3-1 described in the present specification.

In one or more embodiments, the second compound may include a compound represented by Formula 2: 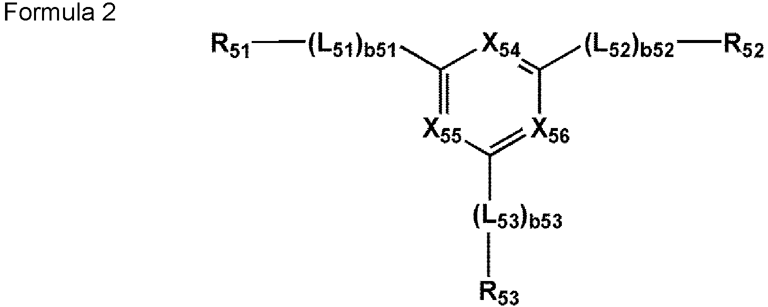 wherein, in Formula 2,
L₅₁ to L₅₃ are each independently a single bond, a C₃-C₆₀ (e.g. C₃-C₆₀) carbocyclic group unsubstituted or substituted with at least one R₁₀ₐ, or a C₁-C₆₀ (e.g. C₁-C₂₀) heterocyclic group unsubstituted or substituted with at least one R₁₀ₐ,
b51 to b53 are each independently an integer from 1 to 5,
X₅₄ is N or C(R₅₄), X₅₅ is N or C(R₅₅), X₅₆ is N or C(R₅₆), and at least one of X₅₄ to X₅₆ is N, and
R₅₁ to R₅₆ and R₁₀ₐ are each as described herein.

In one or more embodiments, the third compound may include a compound represented by Formula 3-1, a compound represented by Formula 3-2, a compound represented by Formula 3-3, a compound represented by Formula 3-4, a compound represented by Formula 3-5, or a combination thereof: 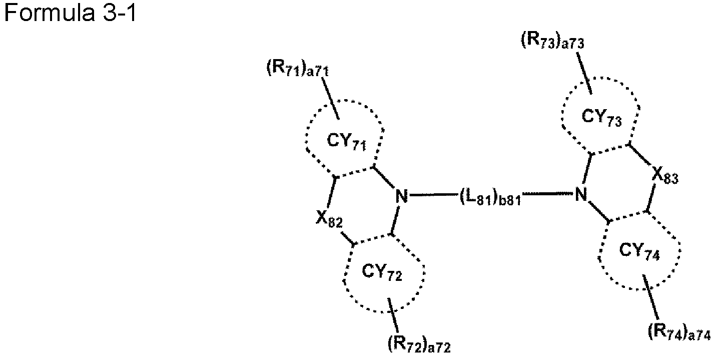 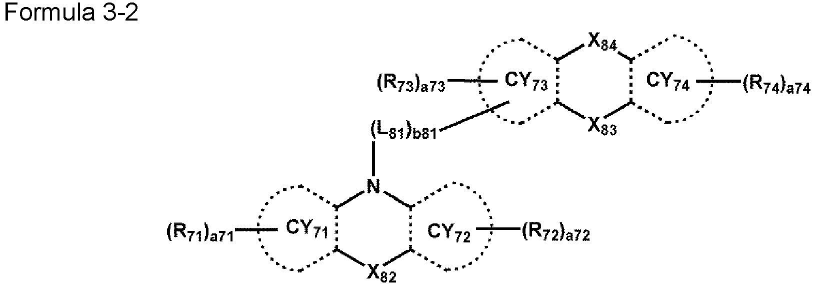 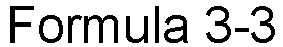 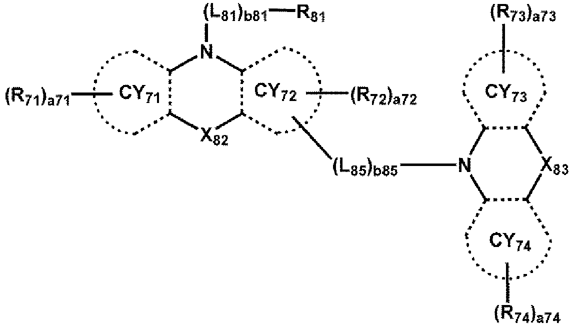 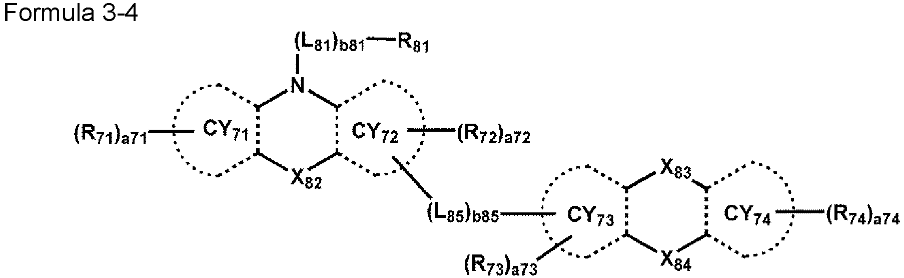 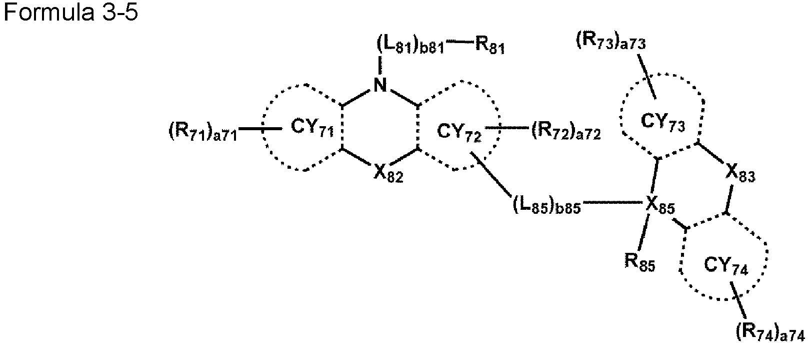 wherein, in Formulae 3-1 to 3-5,
ring CY₇₁ to ring CY₇₄ are each independently a π electron-rich C₃-C₆₀ (e.g. C₃-C₃₀) cyclic group or a pyridine group,
X₈₂ is a single bond, O, S, N-[(L₈₂)_{b82}-R₈₂], C(R₈₂ₐ)(R_{82b}), or Si(R₈₂ₐ)(R_{82b}),
X₈₃ is a single bond, O, S, N-[(L₈₃)_{b83}-R₈₃], C(R₈₃ₐ)(R_{83b}), or Si(R₈₃ₐ)(R_{83b}),
X₈₄ is O, S, N-[(L₈₄)_{b84}-R₈₄], C(R₈₄ₐ)(R_{84b}), or Si(R₈₄ₐ)(R_{84b}),
X₈₅ is C or Si,
L₈₁ to L₈₅ are each independently a single bond, *-C(Q₄)(Q₅)-*', *-Si(Q₄)(Q₅)-*', a π electron-rich C₃-C₆₀ (e.g. C₃-C₃₀) cyclic group that is unsubstituted or substituted with at least one R₁₀ₐ, or a pyridine group that is unsubstituted or substituted with at least one R₁₀ₐ, wherein Q₄ and Q₅ are each as described for Q₁,
b81 to b85 are each independently an integer from 1 to 5,
R₇₁ to R₇₄, R₈₁ to R₈₅, R₈₂ₐ, R_{82b}, R₈₃ₐ, R_{83b}, R₈₄ₐ, and R_{84b} are each as described herein,
a71 to a74 are each independently an integer from 0 to 20, and
R₁₀ₐ is as described for R₁₀ₐ.

In one or more embodiments, the fourth compound may be a compound represented by Formula 502, a compound represented by Formula 503, or a combination thereof: 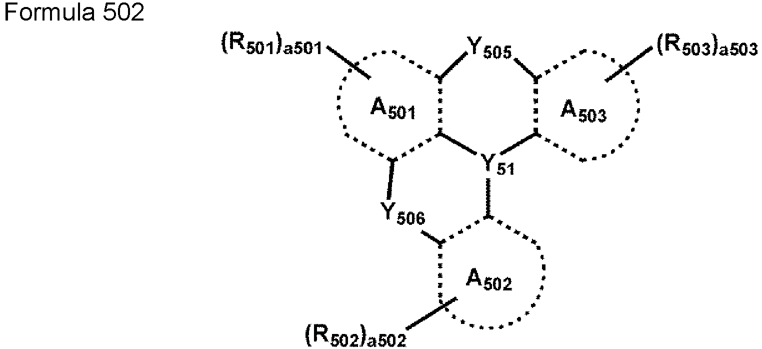 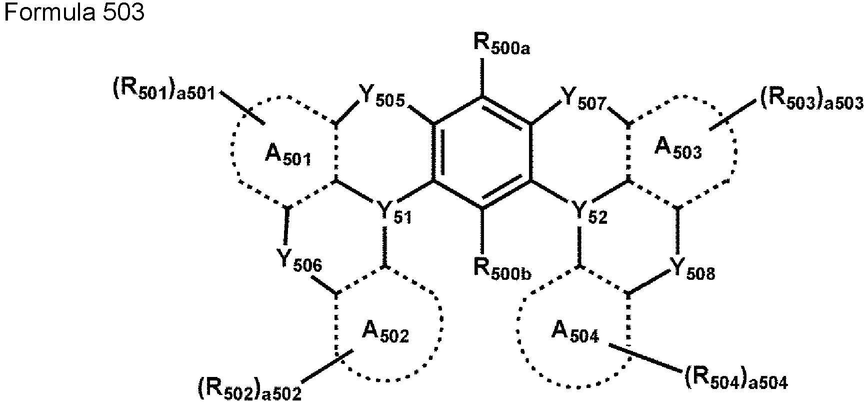 wherein, in Formulae 502 and 503,
ring A₅₀₁ to ring A₅₀₄ are each independently a C₃-C₆₀ (e.g. C₃-C₃₀) carbocyclic group or a C₁-C₆₀ (e.g. C₁-C₂₀) heterocyclic group,
Y₅₀₅ is O, S, N(R₅₀₅), B(R₅₀₅), C(R₅₀₅ₐ)(R_{505b}), or Si(R₅₀₅ₐ)(R_{505b}),
Y₅₀₆ is O, S, N(R₅₀₆), B(R₅₀₆), C(R₅₀₆ₐ)(R_{506b}), or Si(R₅₀₆ₐ)(R_{506b}),
Y₅₀₇ is O, S, N(R₅₀₇), B(R₅₀₇), C(R₅₀₇ₐ)(R_{507b}), or Si(R₅₀₇ₐ)(R_{507b}),
Y₅₀₈ is O, S, N(R₅₀₈), B(R₅₀₈), C(R₅₀₈ₐ)(R_{508b}), or Si(R₅₀₈ₐ)(R_{508b}),
Y₅₁ and Y₅₂ are each independently B, P(=O), or S(=O),
R₅₀₀ₐ, R_{500b}, R₅₀₁ to R₅₀₈, R₅₀₅ₐ, R_{505b}, R₅₀₆ₐ, R_{506b}, R₅₀₇ₐ, R_{507b}, R₅₀₈ₐ, and R_{508b} are each as described herein, and
a501 to a504 are each independently an integer from 0 to 20.

In one or more embodiments, the light-emitting device may satisfy at least one of Conditions 1 to 4: lowest unoccupied molecular orbital (LUMO) energy level (eV) of third compound > LUMO energy level (eV) of organometallic compound LUMO energy level (eV) of organometallic compound > LUMO energy level (eV) of second compound highest occupied molecular orbital (HOMO) energy level (eV) of organometallic compound > HOMO energy level (eV) of third compound HOMO energy level (eV) of the third compound > HOMO energy level (eV) of the second compound

The HOMO energy levels and the lowest LUMO energy levels of the organometallic compound, the second compound, and the third compound may each be a negative value, and may be measured according to any suitable method in the art.

In one or more embodiments, an absolute value of a difference between a LUMO energy level of the organometallic compound and a LUMO energy level of the second compound may be about 0.1 eV or higher and about 1.0 eV or lower. In one or more embodiments, an absolute value of a difference between a LUMO energy level of the organometallic compound and a LUMO energy level of the third compound may be about 0.1 eV or higher and about 1.0 eV or lower. In one or more embodiments, an absolute value of a difference between a HOMO energy level of the organometallic compound and a HOMO energy level of the second compound may be about 1.25 eV or lower (for example, about 1.25 eV or lower and about 0.2 eV or higher). In one or more embodiments, and an absolute value of a difference between a HOMO energy level of the organometallic compound and a HOMO energy level of the third compound may be about 1.25 eV or lower (for example, about 1.25 eV or lower and about 0.2 eV or higher).

When the relationships between LUMO energy level and HOMO energy level satisfy the conditions as described, the balance between holes and electrons injected into the emission layer can be made, e.g., the amount of holes and the amount of electrons injected into the emission layer may be optimized or suitable for the purposes described herein. The light-emitting device may have a structure of a first embodiment or a second embodiment.

### First embodiment

According to the first embodiment, the organometallic compound may be included in the emission layer of the interlayer in the light-emitting device, the emission layer may further include a host, the organometallic compound may be different from the host, and the emission layer may be to emit phosphorescence or fluorescence produced by the organometallic compound. For example, according to the first embodiment, the organometallic compound may be a dopant or an emitter. In one or more embodiments, the organometallic compound may be a phosphorescent dopant or a phosphorescent emitter.

In one or more embodiments, phosphorescence or fluorescence emitted from the organometallic compound may be blue light.

The emission layer may further include an ancillary dopant. The ancillary dopant may serve to improve luminescence efficiency from the first compound by effectively transferring energy to the organometallic compound as a dopant or an emitter.

The ancillary dopant may be different from the organometallic compound and the host.

In one or more embodiments, the ancillary dopant may be a delayed fluorescence-emitting compound.

In one or more embodiments, the ancillary dopant may be a compound including at least one cyclic group including boron (B) and nitrogen (N) as ring-forming atoms.

### Second embodiment

According to the second embodiment, the organometallic compound may be included in the emission layer of the interlayer in the light-emitting device, wherein the emission layer may further include a host and a dopant, the organometallic compound, the host and the dopant may be different from one another, and the emission layer may be to emit phosphorescence or fluorescence (e.g., delayed fluorescence) from the dopant.

In one or more embodiments, the organometallic compound in the second embodiment may serve as an auxiliary dopant that transfers energy to a dopant (or an emitter), not as a dopant.

In one or more embodiments, the organometallic compound in the second embodiment may serve as an emitter and as an auxiliary dopant that transfers energy to a dopant (or an emitter).

For example, phosphorescence or fluorescence emitted from the dopant (or the emitter) in the second embodiment may be blue phosphorescence or blue fluorescence (e.g., blue delayed fluorescence).

The dopant (or the emitter) in the second embodiment may be a phosphorescent dopant material (e.g., the organometallic compound represented by Formula 1, the organometallic compound represented by Formula 401, or a combination thereof) or any fluorescent dopant material (e.g., the compound represented by Formula 501, the compound represented by Formula 502, the compound represented by Formula 503, or a combination thereof).

In the first embodiment and the second embodiment, the blue light may be blue light having a maximum emission wavelength in a range of about 390 nm to about 500 nm, about 410 nm to about 490 nm, about 430 nm to about 480 nm, about 440 nm to about 475 nm, or about 455 nm to about 470 nm.

The ancillary dopant in the first embodiment may include, e.g., the fourth compound represented by Formula 502 or Formula 503.

The host in the first embodiment and the second embodiment may be any host material (e.g., the compound represented by Formula 301, the compound represented by 301-1, the compound represented by Formula 301-2, or a combination thereof).

In one or more embodiments, the host in the first embodiment and the second embodiment may be the second compound, the third compound, or a combination thereof.

In one or more embodiments, the light-emitting device may further include a capping layer located outside the first electrode and/or outside the second electrode.

In one or more embodiments, the light-emitting device may further include at least one of a first capping layer located outside the first electrode and a second capping layer located outside the second electrode, and the organometallic compound represented by Formula 1 may be included in at least one of the first capping layer or the second capping layer. More details for the first capping layer and/or second capping layer may each independently be the same as described in the present specification.

In one or more embodiments, the light-emitting device may further include:
a first capping layer located outside the first electrode and including the organometallic compound represented by Formula 1;
a second capping layer located outside the second electrode and including the organometallic compound represented by Formula 1; or
the first capping layer and the second capping layer.

The expression that an "(interlayer and/or a capping layer) includes at least one organometallic compound represented by Formula 1" as utilized herein may be construed as meaning that the "(interlayer and/or the capping layer) may include one organometallic compound of Formula 1 or two different organometallic compounds of Formula 1."

For example, the interlayer and/or capping layer may include Compound BD01 as the organometallic compound. In this regard, Compound BD01 exist in the emission layer of the light-emitting device. In one or more embodiments, the interlayer may include, as the organometallic compound, Compounds BD01 and BD02. In this regard, Compounds BD01 and BD02 may exist in an identical layer (for example, Compounds BD01 and BD02 may all exist in an emission layer) or in different layers (for example, Compound BD01 may exist in an emission layer and Compound BD02 may exist in an electron transport region).

The term "interlayer" as utilized herein refers to a single layer and/or all of a plurality of layers located between the first electrode and the second electrode of the light-emitting device.

Another aspect provides an electronic apparatus including the light-emitting device. The electronic apparatus may further include a thin-film transistor. For example, the electronic apparatus may further include a thin-film transistor including a source electrode and a drain electrode, wherein the first electrode of the light-emitting device may be electrically connected to the source electrode or the drain electrode. In one or more embodiments, the electronic apparatus may further include a color filter, a color conversion layer, a touch screen layer, a polarizing layer, or a combination thereof. For more details on the electronic apparatus, related descriptions provided herein may be referred to.

In one or more embodiments, electronic equipment includes the light-emitting device.

For example, the electronic equipment may be one selected from among a flat panel display, a curved display, a computer monitor, a medical monitor, a television, a billboard, an indoor or outdoor light and/or light for signal, a head-up display, a fully or partially transparent display, a flexible display, a rollable display, a foldable display, a stretchable display, a laser printer, a telephone, a portable phone, a tablet personal computer, a phablet, a personal digital assistant (PDA), a wearable device, a laptop computer, a digital camera, a camcorder, a viewfinder, a micro display, a three-dimensional (3D) display, a virtual reality or augmented reality display, a vehicle, a video wall with multiple displays tiled together, a theater or stadium screen, a phototherapy device, and/or a signboard.

One or more embodiments include an organometallic compound represented by Formula 1. The detailed description of Formula 1 is the same as described in the present specification.

Methods of synthesizing the organometallic compound may be easily understood to those of ordinary skill in the art by referring to Synthesis Examples and/or Examples described herein.

### Description of Formula 1

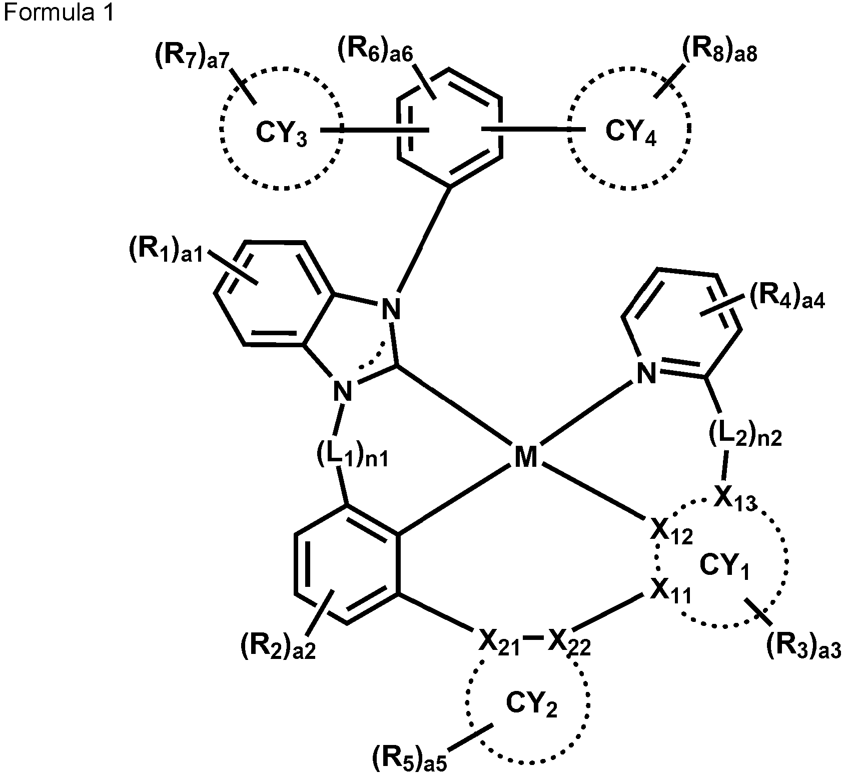

In Formula 1, M is platinum (Pt), palladium (Pd), copper (Cu), silver (Ag), gold (Au), rhodium (Rh), ruthenium (Ru), osmium (Os), titanium (Ti), zirconium (Zr), hafnium (Hf), europium (Eu), terbium (Tb), or thulium (Tm).

In one or more embodiments, M may be Pt or Pd.

In one or more embodiments, M may be Pt.

In Formula 1, X₁₁ to X₁₃, X₂₁, and X₂₂ are each independently C or N.

In one or more embodiments, X₁₁ and X₁₂ may each be C, and X₁₃ may be N.

In one or more embodiments, X₂₁ and X₂₂ are linked to each other via a chemical bond. Here, the chemical bond may be a single bond or a double bond.

In one or more embodiments, X₂₁ and X₂₂ may each be C.

Ring CY₁ to ring CY₄ in Formula 1 are each independently a C₅-C₃₀ (e.g. C₅-C₂₀) carbocyclic group or a C₁-C₃₀ (e.g. C₁-C₂₀) heterocyclic group.

In one or more embodiments, rings CY₁ to CY₄ may each independently be a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a dibenzoxasiline group, a dibenzothiasiline group, a dibenzodihydroazasiline group, a dibenzodihydrodisiline group, a dibenzodihydrosiline group, a dibenzodioxine group, a dibenzooxathiine group, a dibenzooxazine group, a dibenzopyran group, a dibenzodithiine group, a dibenzothiazine group, a dibenzothiopyran group, a dibenzocyclohexadiene group, a dibenzodihydropyridine group, or a dibenzodihydropyrazine group.

In one or more embodiments, ring CY₁ may be a pyridine group, a pyrimidine group, a dibenzofuran group, a dibenzothiophene group, a carbazole group, a fluorene group, a dibenzosilole group, an azadibenzofuran group, an azadibenzothiophene group, an azacarbazole group, an azafluorene group, or an azadibenzosilole group.

In one or more embodiments, ring CY₁ may be a carbazole group.

In one or more embodiments, CY₂ may be a benzene group, a naphthalene group, an anthracene group, a phenanthrene group, an indene group, a fluorene group, an indole group, a carbazole group, a benzofuran group, a dibenzofuran group, a benzothiophene group, a dibenzothiophene group, a quinoline group, an isoquinoline group, a quinoxaline group, or a quinazoline group.

In one or more embodiments, ring CY₂ may be a benzene group, a naphthalene group, a phenanthrene group, an indole group, a carbazole group, a benzofuran group, a benzothiophene group, a quinoline group, or an isoquinoline group.

In one or more embodiments, rings CY₃ and CY₄ may each independently be a benzene group, a naphthalene group, an anthracene group, a phenanthrene group, a triphenylene group, a pyrene group, a chrysene group, or a cyclopentadiene group.

In one or more embodiments, rings CY₃ and CY₄ may each independently be a benzene group.

In one or more embodiments, at least one of CY₃ and CY₄ may be substituted with at least one deuterium.

In one or more embodiments, at least one of CY₃ and CY₄ may be substituted with at least one deuterium, and the other may not be substituted with deuterium (e.g., excluding deuterium).

L₁ and L₂ in Formula 1 are each independently a single bond, *-C(R₁ₐ)(R_{1b})-*', *-C(R₁ₐ)=*', *=C(R₁ₐ)-*', *-C(R₁ₐ)=C(R_{1b})-*', *-C(=O)-*', *-C(=S)-*', *-C≡C-*', *-B(R₁ₐ)-*', *-N(R₁ₐ)-*', *-O-*', *-P(R₁ₐ)-*', *-Al(R₁ₐ)-*, *-Si(R₁ₐ)(R_{1b})-*', *-P(=O)(R₁ₐ)-*', *-S-*', *-S(=O)-*', *-S(=O)₂-*', or *-Ge(R₁ₐ)(R_{1b})-*', and * and *' may each indicate a binding site to a neighboring atom,

In Formula 1, R₁ₐ and R_{1b} are each independently hydrogen, deuterium, -F, - Cl, -Br, -I, a hydroxyl group, a cyano group, a nitro group, a C₁-C₆₀ (e.g. C₁-C₂₀) alkyl group unsubstituted or substituted with at least one R₁₀ₐ, a C₂-C₆₀ (e.g. C₂-C₂₀) alkenyl group unsubstituted or substituted with at least one R₁₀ₐ, a C₂-C₆₀ (e.g. C₂-C₂₀) alkynyl group unsubstituted or substituted with at least one R₁₀ₐ, a C₁-C₆₀ (e.g. C₁-C₂₀) alkoxy group unsubstituted or substituted with at least one R₁₀ₐ, a C₁-C₆₀ (e.g. C₁-C₂₀) alkylthio group unsubstituted or substituted with at least one R₁₀ₐ, a C₃-C₆₀ (e.g. C₃-C₃₀) carbocyclic group unsubstituted or substituted with at least one R₁₀ₐ, a C₁-C₆₀ (e.g. C₁-C₂₀) heterocyclic group unsubstituted or substituted with at least one R₁₀ₐ, a C₆-C₆₀ (e.g. C₆-C₃₀) aryloxy group unsubstituted or substituted with at least one R₁₀ₐ, a C₆-C₆₀ (e.g. C₆-C₃₀) arylthio group unsubstituted or substituted with at least one R₁₀ₐ, - C(Q₁)(Q₂)(Q₃), -Si(Q₁)(Q₂)(Q₃), -N(Q₁)(Q₂), -B(Q₁)(Q₂), -C(=O)(Q₁), -S(=O)₂(Q₁), **or** - P(=O)(Q₁)(Q₂).

In one or more embodiments, R₁₀ₐ and Q₁ to Q₃ are each as described herein.

In one or more embodiments, R₁ₐ and R_{1b} may each independently be:
hydrogen, deuterium, -F, -Cl, -Br, -I, a hydroxyl group, a cyano group, a nitro group, a C₁-C₂₀ (e.g. C₁-C₁₀) alkyl group, or a C₁-C₂₀ (e.g. C₁-C₁₀) alkoxy group;
a C₁-C₂₀ (e.g. C₁-C₁₀) alkyl group or a C₁-C₂₀ (e.g. C₁-C₁₀) alkoxy group, each substituted with deuterium, -F, -Cl, -Br, -I, -CD₃, -CD₂H, -CDH₂, -CF₃, -CF₂H, - CFH₂, a hydroxyl group, a cyano group, a nitro group, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, a pyrimidinyl group, or a combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzothiazolyl group, a benzoisoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, or an azadibenzosilolyl group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, a C₁-C₂₀ (e.g. C₁-C₁₀) alkyl group, a C₁-C₂₀ (e.g. C₁-C₁₀) alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, -O(Q₃₁), -S(Q₃₁), -Si(Q₃₁)(Q₃₂)(Q₃₃), -N(Q₃₁)(Q₃₂), -B(Q₃₁)(Q₃₂), -P(Q₃₁)(Q₃₂), - C(=O)(Q₃₁), -S(=O)₂(Q₃₁), -P(=O)(Q₃₁)(Q₃₂), or a combination thereof; or
-C(Q₁)(Q₂)(Q₃), -Si(Q₁)(Q₂)(Q₃), -N(Q₁)(Q₂)**,** -B(Q₁)(Q₂), -C(=O)(Q₁), - S(=O)₂(Q₁), or -P(=O)(Q₁)(Q₂),
wherein Q₁ to Q₃ and Q₃₁ to Q₃₃ are each as described herein.

In one or more embodiments, L₁ and L₂ may each be a single bond.

In one or more embodiments, n1 and n2 in Formula 1 are each independently an integer from 1 to 5.

In Formula 1, R₁ to R₈ are each independently hydrogen, deuterium, -F, -Cl, -Br, -I, a hydroxyl group, a cyano group, a nitro group, a C₁-C₆₀ (e.g. C₁-C₂₀) alkyl group unsubstituted or substituted with at least one R₁₀ₐ, a C₂-C₆₀ (e.g. C₂-C₂₀) alkenyl group unsubstituted or substituted with at least one R₁₀ₐ, a C₂-C₆₀ (e.g. C₂-C₂₀) alkynyl group unsubstituted or substituted with at least one R₁₀ₐ, a C₁-C₆₀ (e.g. C₁-C₂₀) alkoxy group unsubstituted or substituted with at least one R₁₀ₐ, a C₁-C₆₀ (e.g. C₁-C₂₀) alkylthio group unsubstituted or substituted with at least one R₁₀ₐ, a C₃-C₆₀ (e.g. C₃-C₃₀) carbocyclic group unsubstituted or substituted with at least one R₁₀ₐ, a C₁-C₆₀ (e.g. C₁-C₂₀) heterocyclic group unsubstituted or substituted with at least one R₁₀ₐ, a C₆-C₆₀ (e.g. C₆-C₃₀) aryloxy group unsubstituted or substituted with at least one R₁₀ₐ, a C₆-C₆₀ (e.g. C₆-C₃₀) arylthio group unsubstituted or substituted with at least one R₁₀ₐ, - C(Q₁)(Q₂)(Q₃), -Si(Q₁)(Q₂)(Q₃), -N(Q₁)(Q₂)**,** -B(Q₁)(Q₂), -C(=O)(Q₁), -S(=O)₂(Q₁), or - P(=O)(Q₁)(Q₂).

In one or more embodiments, R₁₀ₐ and Q₁ to Q₃ are each as described herein.

In one or more embodiments, R₁ to R₈ may each independently be:
hydrogen, deuterium, -F, -Cl, -Br, -I, a hydroxyl group, a cyano group, a nitro group, a C₁-C₂₀ (e.g. C₁-C₁₀) alkyl group, or a C₁-C₂₀ (e.g. C₁-C₁₀) alkoxy group;
a C₁-C₂₀ (e.g. C₁-C₁₀) alkyl group or a C₁-C₂₀ (e.g. C₁-C₁₀) alkoxy group, each substituted with deuterium, -F, -Cl, -Br, -I, -CD₃, -CD₂H, -CDH₂, -CF₃, -CF₂H, - CFH₂, a hydroxyl group, a cyano group, a nitro group, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, a pyrimidinyl group, or a combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzothiazolyl group, a benzoisoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, or an azadibenzosilolyl group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, a C₁-C₂₀ (e.g. C₁-C₁₀) alkyl group, a C₁-C₂₀ (e.g. C₁-C₁₀) alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, -O(Q₃₁), -S(Q₃₁), -Si(Q₃₁)(Q₃₂)(Q₃₃), -N(Q₃₁)(Q₃₂), -B(Q₃₁)(Q₃₂), -P(Q₃₁)(Q₃₂), - C(=O)(Q₃₁), -S(=O)₂(Q₃₁), -P(=O)(Q₃₁)(Q₃₂), or a combination thereof; or
-C(Q₁)(Q₂)(Q₃), -Si(Q₁)(Q₂)(Q₃), -N(Q₁)(Q₂)**,** -B(Q₁)(Q₂), -C(=O)(Q₁), - S(=O)₂(Q₁), or -P(=O)(Q₁)(Q₂),
wherein Q₁ to Q₃ and Q₃₁ to Q₃₃ are each as described herein.

In one or more embodiments, R₁ to R₈ may each independently be:
hydrogen, deuterium, or a C₁-C₂₀ (e.g. C₁-C₁₀) alkyl group;
a C₁-C₂₀ (e.g. C₁-C₁₀) alkyl group substituted with deuterium, -CD₃, -CD₂H, - CDH₂, or a combination thereof;
a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, or a chrysenyl group, each unsubstituted or substituted with deuterium, -CD₃, -CD₂H, -CDH₂, a C₁-C₂₀ alkyl group, or a combination thereof; or
-C(Q₁)(Q₂)(Q₃) or -Si(Q₁)(Q₂)(Q₃),
wherein Q₁ to Q₃ and Q₃₁ to Q₃₃ may each independently be: hydrogen; deuterium; a C₁-C₆₀ (e.g. C₁-C₂₀) alkyl group; a C₂-C₆₀ (e.g. C₂-C₂₀) alkenyl group; a C₂-C₆₀ (e.g. C₂-C₂₀) alkynyl group; or a C₃-C₆₀ (e.g. C₃-C₃₀) carbocyclic group unsubstituted or substituted with deuterium, a C₁-C₆₀ (e.g. C₁-C₂₀) alkyl group, a phenyl group, a biphenyl group, or a combination thereof.

In one or more embodiments, R₁ to R₈ may each independently be hydrogen, deuterium, a methyl group, an ethyl group, a sec-propyl group, or a tert-butyl group.

In Formula 1, a1 is an integer from 1 to 4, a2 is an integer from 1 to 3, a3 is an integer from 1 to 6, a4 is an integer from 1 to 4, a5 is an integer from 1 to 8, a6 is an integer from 1 to 3, and a7 and a8 are each independently an integer from 1 to 5.

In one or more embodiments, ring CY₂ in Formula 1 may be selected from groups represented by Formulae L1 to L10: 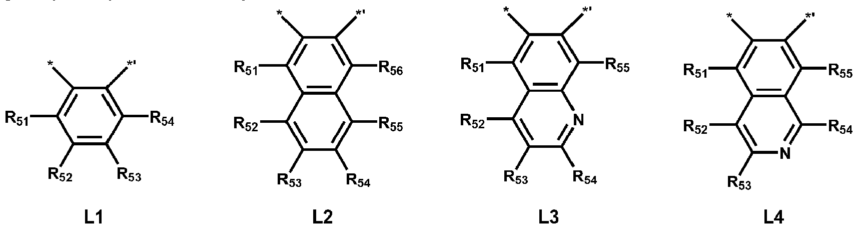 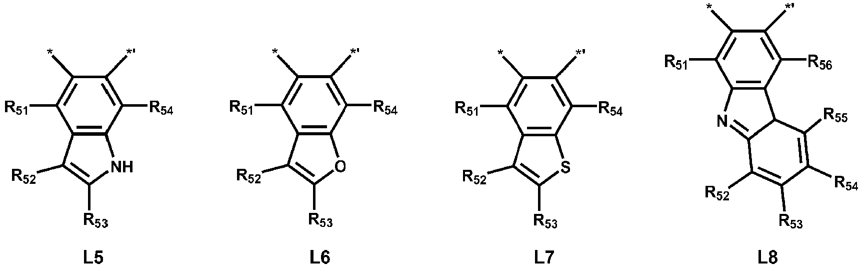 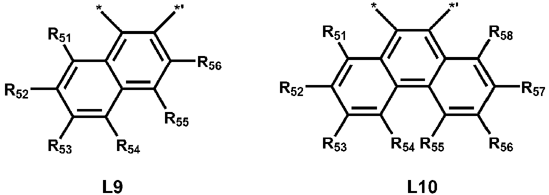 wherein, in Formulae L1 to L10,
R₅₁ to R₅₈ are as described for R₅, and
* and *' each indicate a binding site to a neighboring atom.

In one or more embodiments, a group in Formula 1 that is represented by the portion " 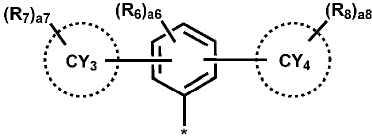 " may be a group represented by Formula 1-1: 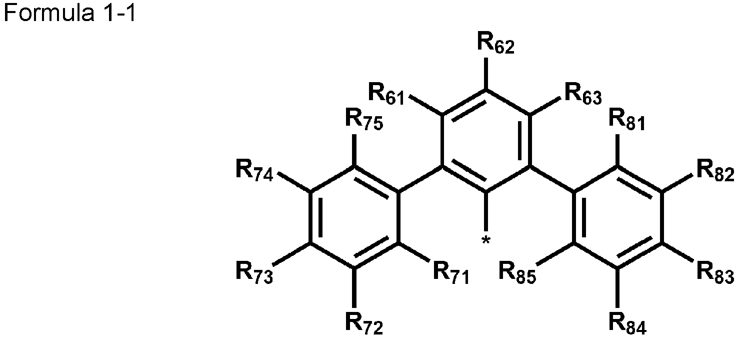 wherein, in Formula 1-1,
R₆₁ to R₆₃ are as described for R₆,
R₇₁ to R₇₅ are as described for R₇,
R₈₁ to R₈₅ are as described for R₈, and
* indicates a binding site to an adjacent atom.

Unless defined otherwise, for example, R₁₀ₐ in Formula 1 is:
deuterium, -F, -Cl, -Br, -I, a hydroxyl group, a cyano group, or a nitro group;
a C₁-C₆₀ (e.g. C₁-C₂₀) alkyl group, a C₂-C₆₀ (e.g. C₂-C₂₀) alkenyl group, a C₂-C₆₀ (e.g. C₂-C₂₀) alkynyl group, or a C₁-C₆₀ (e.g. C₁-C₂₀) alkoxy group, each unsubstituted or substituted with deuterium, -F, -Cl, -Br, -I, a hydroxyl group, a cyano group, a nitro group, a C₃-C₆₀ (e.g. C₃-C₃₀) carbocyclic group, a C₁-C₆₀ (e.g. C₁-C₂₀) heterocyclic group, a C₆-C₆₀ (e.g. C₆-C₃₀) aryloxy group, a C₆-C₆₀ (e.g. C₆-C₃₀) arylthio group, -Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁), - P(=O)(Q₁₁)(Q₁₂), or a combination thereof;
a C₃-C₆₀ (e.g. C₃-C₃₀) carbocyclic group, a C₁-C₆₀ (e.g. C₁-C₂₀) heterocyclic group, a C₆-C₆₀ (e.g. C₆-C₃₀) aryloxy group, or a C₆-C₆₀ (e.g. C₆-C₃₀) arylthio group, each unsubstituted or substituted with deuterium, -F, -Cl, -Br, -I, a hydroxyl group, a cyano group, a nitro group, a C₁-C₆₀ (e.g. C₁-C₂₀) alkyl group, a C₂-C₆₀ (e.g. C₂-C₂₀) alkenyl group, a C₂-C₆₀ (e.g. C₂-C₂₀) alkynyl group, a C₁-C₆₀ (e.g. C₁-C₂₀) alkoxy group, a C₃-C₆₀ (e.g. C₃-C₃₀) carbocyclic group, a C₁-C₆₀ (e.g. C₁-C₂₀) heterocyclic group, a C₆-C₆₀ (e.g. C₆-C₃₀) aryloxy group, a C₆-C₆₀ (e.g. C₆-C₃₀) arylthio group, - Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), - P(=O)(Q₂₁)(Q₂₂), or a combination thereof; or
-Si(Q₃₁)(Q₃₂)(Q₃₃), -N(Q₃₁)(Q₃₂), -B(Q₃₁)(Q₃₂)**,** -C(=O)(Q₃₁), -S(=O)₂(Q₃₁), or - P(=O)(Q₃₁)(Q₃₂).

Unless defined otherwise, for example, Q₁ to Q₃, Q₁₁ to Q₁₃, Q₂₁ to Q₂₃, and Q₃₁ to Q₃₃ in Formula 1 are each independently: hydrogen; deuterium; -F; -Cl; -Br; -I; a hydroxyl group; a cyano group; a nitro group; a C₁-C₆₀ (e.g. C₁-C₂₀) alkyl group; a C₂-C₆₀ (e.g. C₂-C₂₀) alkenyl group; a C₂-C₆₀ (e.g. C₂-C₂₀) alkynyl group; a C₁-C₆₀ (e.g. C₁-C₂₀) alkoxy group; or a C₃-C₆₀ (e.g. C₃-C₃₀) carbocyclic group or a C₁-C₆₀ (e.g. C₁-C₂₀) heterocyclic group, each unsubstituted or substituted with deuterium, -F, a cyano group, a C₁-C₆₀ (e.g. C₁-C₂₀) alkyl group, a C₁-C₆₀ (e.g. C₁-C₂₀) alkoxy group, a phenyl group, a biphenyl group, or a combination thereof.

In the organometallic compound represented by Formula 1, because ring CY₂ links a benzene group and ring CY₁ in Formula 1 (i.e., through X₂₁ and X₂₂, which are linked to each other via a chemical bond), the conjugation (e.g., an intermolecular conjugation), of the organometallic compound may be enhanced or strengthened, thereby lowering the HOMO energy level of the organometallic compound and improving molecular stability and color purity. Therefore, it is possible to enhance or increase emission efficiency (e.g., of the light-emitting device) by utilizing or applying the structural and energetic features described herein in (or to) the emission layer and to enhance or improve the device lifespan. Accordingly, by utilizing the organometallic compound of the present disclosure, an electronic device (for example, an organic light-emitting device) having high efficiency, high color purity, and long lifespan characteristics may be implemented.

### Description of other formulae

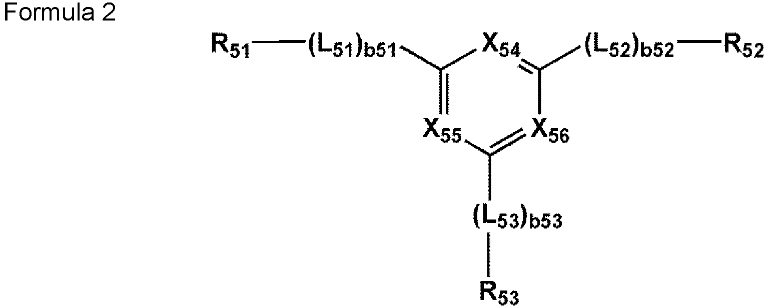

The symbols b51 to b53 in Formula 2 indicate the numbers of L₅₁ to L₅₃, respectively, and are each an integer from 1 to 5. When b51 is 2 or more, two or more of L₅₁(s) may be identical to or different from each other, when b52 is 2 or more, two or more of L₅₂(s) may be identical to or different from each other, and when b53 is 2 or more, two or more of L₅₃(s) may be identical to or different from each other. In one or more embodiments, b51 to b53 may each independently be 1 or 2.

L₅₁ to L₅₃ in Formula 2 may each independently be:
a single bond; or
a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a dibenzooxasiline group, a dibenzothiasiline group, a dibenzodihydroazasiline group, a dibenzodihydrodisiline group, a dibenzodihydrosiline group, a dibenzodioxane group, a dibenzooxathiene group, a dibenzooxazine group, a dibenzopyran group, a dibenzodithiine group, a dibenzothiazine group, a dibenzothiopyran group, a dibenzocyclohexadiene group, a dibenzodihydropyridine group, or a dibenzodihydropyrazine group, each unsubstituted or substituted with deuterium, -F, -Cl, -Br, -I, a hydroxyl group, a cyano group, a nitro group, a C₁-C₂₀ alkyl group, a C₁-C₂₀ alkoxy group, a phenyl group, a naphthyl group, a pyridinyl group, a pyrimidinyl group, a triazinyl group, a fluorenyl group, a dimethylfluorenyl group, a diphenylfluorenyl group, a carbazolyl group, a phenylcarbazolyl group, a dibenzofuranyl group, a dibenzothiophenyl group, a dibenzosilolyl group, a dimethyldibenzosilolyl group, a diphenyldibenzosilolyl group, - O(Q₃₁), -S(Q₃₁), -Si(Q₃₁)(Q₃₂)(Q₃₃), -N(Q₃₁)(Q₃₂), -B(Q₃₁)(Q₃₂), -P(Q₃₁)(Q₃₂), - C(=O)(Q₃₁), -S(=O)₂(Q₃₁), -P(=O)(Q₃₁)(Q₃₂), or a combination thereof,
wherein Q₃₁ to Q₃₃ may each independently be hydrogen, deuterium, a C₁-C₂₀ alkyl group, a C₁-C₂₀ alkoxy group, a phenyl group, a biphenyl group, a terphenyl group, a pyridinyl group, a pyrimidinyl group, a pyridazinyl group, a pyrazinyl group, or a triazinyl group.

In one or more embodiments, in Formula 2, a bond between L₅₁ and R₅₁, a bond between L₅₂ and R₅₂, a bond between L₅₃ and R₅₃, a bond between two or more L₅₁(s), a bond between two or more L₅₂(s), a bond between two or more L₅₃(s), a bond between L₅₁ and carbon between X₅₄ and X₅₅ in Formula 2, a bond between L₅₂ and carbon between X₅₄ and X₅₆ in Formula 2, and a bond between L₅₃ and carbon between X₅₅ and X₅₆ in Formula 2 may each be a "carbon-carbon single bond."

In Formula 2, X₅₄ is N or C(R₅₄), X₅₅ is N or C(R₅₅), X₅₆ is N or C(R₅₆), and at least one of X₅₄ to X₅₆ is N. R₅₄ to R₅₆ may each independently be the same as described above. In one or more embodiments, two or three of X₅₄ to X₅₆ may be N.

R₅₁ to R₅₆, R₇₁ to R₇₄, R₈₁ to R₈₅, R₈₂ₐ, R_{82b}, R₈₃ₐ, R_{83b}, R₈₄ₐ, R_{84b}, R₅₀₀ₐ, R_{500b}, R₅₀₁ to R₅₀₈, R₅₀₅ₐ, R_{505b}, R₅₀₆ₐ, R_{506b}, R₅₀₇ₐ, R_{507b}, R₅₀₈ₐ, and R_{508b} in the present specification are each independently hydrogen, deuterium, -F, -Cl, -Br, -I, a hydroxyl group, a cyano group, a nitro group, a C₁-C₆₀ (C₁-C₂₀) alkyl group unsubstituted or substituted with at least one R₁₀ₐ, a C₂-C₆₀ (C₂-C₂₀) alkenyl group unsubstituted or substituted with at least one R₁₀ₐ, a C₂-C₆₀ (C₂-C₂₀) alkynyl group unsubstituted or substituted with at least one R₁₀ₐ, a C₁-C₆₀ (C₁-C₂₀) alkoxy group unsubstituted or substituted with at least one R₁₀ₐ, a C₃-C₆₀ (C₃-C₃₀) carbocyclic group unsubstituted or substituted with at least one R₁₀ₐ, a C₁-C₆₀ (C₁-C₂₀) heterocyclic group unsubstituted or substituted with at least one R₁₀ₐ, a C₆-C₆₀ (C₆-C₃₀) aryloxy group unsubstituted or substituted with at least one R₁₀ₐ, a C₆-C₆₀ (C₆-C₃₀) arylthio group unsubstituted or substituted with at least one R₁₀ₐ, a C₇-C₆₀ (C₇-C₃₀) arylalkyl group unsubstituted or substituted with at least one R₁₀ₐ, a C₂-C₆₀ (C₂-C₃₀) heteroarylalkyl group unsubstituted or substituted with at least one R₁₀ₐ, -C(Q₁)(Q₂)(Q₃), -Si(Q₁)(Q₂)(Q₃), -N(Q₁)(Q₂)**,** - B(Q₁)(Q₂), -C(=O)(Q₁), -S(=O)₂(Q₁), or -P(=O)(Q₁)(Q₂). Q₁ to Q₃ may each independently be the same as described in the present specification.

For example, i) R₁ to R₈ in Formula 1, ii) R₅₁ to R₅₆, R₇₁ to R₇₄, R₈₁ to R₈₅, R₈₂ₐ, R_{82b}, R₈₃ₐ, R_{83b}, R₈₄ₐ, R_{84b}, R₅₀₀ₐ, R_{500b}, R₅₀₁ to R₅₀₈, R₅₀₅ₐ, R_{505b}, R₅₀₆ₐ, R_{506b}, R₅₀₇ₐ, R_{507b}, R₅₀₈ₐ, and R_{508b} in Formulae 2, 3-1 to 3-5, 502, and/or 503, and iii) R₁₀ₐ may each independently be:
hydrogen, deuterium, -F, -Cl, -Br, -I, a hydroxyl group, a cyano group, a nitro group, a C₁-C₂₀ (e.g. C₁-C₁₀) alkyl group, or a C₁-C₂₀ (e.g. C₁-C₁₀) alkoxy group;
a C₁-C₂₀ (e.g. C₁-C₁₀) alkyl group or a C₁-C₂₀ (e.g. C₁-C₁₀) alkoxy group, each substituted with deuterium, -F, -Cl, -Br, -I, -CD₃, -CD₂H, -CDH₂, -CF₃, -CF₂H, - CFH₂, a hydroxyl group, a cyano group, a nitro group, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, a pyrimidinyl group, or a combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, an azadibenzosilolyl group, or a group represented by Formula 91, each unsubstituted or substituted with deuterium, -F, -Cl, -Br, -I, -CD₃, - CD₂H, -CDH₂, -CF₃, -CF₂H, -CFH₂, a hydroxyl group, a cyano group, a nitro group, a C₁-C₂₀ (e.g. C₁-C₁₀) alkyl group, a C₁-C₂₀ (e.g. C₁-C₁₀) alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, a benzothiazolyl group, a benzoisoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, -O(Q₃₁), -S(Q₃₁), - Si(Q₃₁)(Q₃₂)(Q₃₃), -N(Q₃₁)(Q₃₂), -B(Q₃₁)(Q₃₂), -P(Q₃₁)(Q₃₂), -C(=O)(Q₃₁), -S(=O)₂(Q₃₁), - P(=O)(Q₃₁)(Q₃₂), or a combination thereof; or
-C(Q₁)(Q₂)(Q₃), -Si(Q₁)(Q₂)(Q₃), -N(Q₁)(Q₂)**,** -B(Q₁)(Q₂), -C(=O)(Q₁), - S(=O)₂(Q₁), or -P(=O)(Q₁)(Q₂),
wherein Q₁ to Q₃ and Q₃₁ to Q₃₃ may each independently be:
   -CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, or -CD₂CDH₂; or
   an n-propyl group, an iso-propyl group, an n-butyl group, an isobutyl group, a sec-butyl group, a tert-butyl group, an n-pentyl group, an isopentyl group, a sec-pentyl group, a tert-pentyl group, a phenyl group, a naphthyl group, a pyridinyl group, a pyrimidinyl group, a pyridazinyl group, a pyrazinyl group, or a triazinyl group, each unsubstituted or substituted with deuterium, a C₁-C₁₀ alkyl group, a phenyl group, a biphenyl group, a pyridinyl group, a pyrimidinyl group, a pyridazinyl group, a pyrazinyl group, a triazinyl group, or a combination thereof.

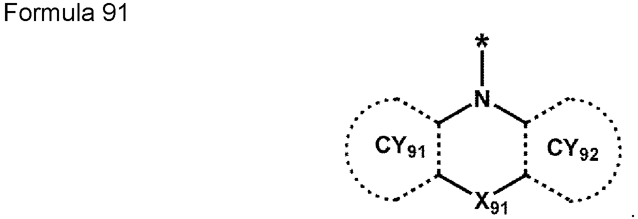

In Formula 91,
rings CY₉₁ and CY₉₂ are each independently a C₅-C₃₀ (e.g. C₅-C₂₀) carbocyclic group unsubstituted or substituted with at least one R₁₀ₐ or a C₁-C₃₀ (e.g. C₁-C₂₀) heterocyclic group unsubstituted or substituted with at least one R₁₀ₐ,
X₉₁ is a single bond, O, S, N(R₉₁), B(R₉₁), C(R₉₁ₐ)(R_{91b}), or Si(R₉₁ₐ)(R_{91b}),
R₉₁, R₉₁ₐ, and R_{91b} are respectively understood by referring to the descriptions of R₈₂, R₈₂ₐ, and R_{82b} provided herein (e.g., R₈₂, R₈₂ₐ, and R_{82b} may be defined as described for R₉₁, R₉₁ₐ, and R_{91b}, respectively),
R₁₀ₐ is understood by referring to the description of R₁₀ₐ provided herein, and
* indicates a binding site to an adjacent atom.

For example, in Formula 91,
rings CY₉₁ and CY₉₂ may each independently be a benzene group, a pyridine group, a pyrimidine group, a pyrazine group, a pyridazine group, or a triazine group, each unsubstituted or substituted with at least one R₁₀ₐ,
R₉₁, R₉₁ₐ, and R_{91b} may each independently be selected from:
   hydrogen or a C₁-C₁₀ alkyl group; or
   a phenyl group, a pyridinyl group, a pyrimidinyl group, a pyridazinyl group, a pyrazinyl group, or a triazinyl group, each unsubstituted or substituted with deuterium, a C₁-C₁₀ alkyl group, a phenyl group, a biphenyl group, a pyridinyl group, a pyrimidinyl group, a pyridazinyl group, a pyrazinyl group, a triazinyl group, or a combination thereof.

In one or more embodiments, i) R₁ to R₈ in Formula 1, ii) R₅₁ to R₅₈, R₇₁ to R₇₄, R₈₁ to R₈₅, R₈₂ₐ, R_{82b}, R₈₃ₐ, R_{83b}, R₈₄ₐ, R_{84b}, R₅₀₀ₐ, R_{500b}, R₅₀₁ to R₅₀₈, R₅₀₅ₐ, R_{505b}, R₅₀₆ₐ, R_{506b}, R₅₀₇ₐ, R_{507b}, R₅₀₈ₐ, and R_{508b} in Formulae 2, 3-1 to 3-5, 502, and 503, and iii) R₁₀ₐ may each independently be,
hydrogen, deuterium, -F, a cyano group, a nitro group, -CH₃, -CD₃, -CD₂H, - CDH₂, -CF₃, -CF₂H, -CFH₂, a group represented by one of Formulae 9-1 to 9-19, a group represented by one of Formulae 10-1 to 10-246, -C(Q₁)(Q₂)(Q₃), -Si(Q₁)(Q₂)(Q₃), or -P(=O)(Q₁)(Q₂) (where Q₁ to Q₃ are each as described herein): 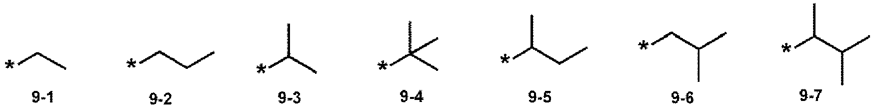 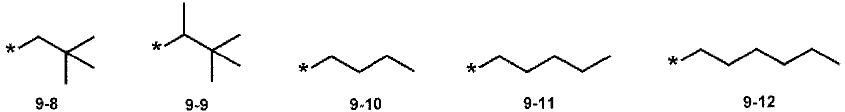 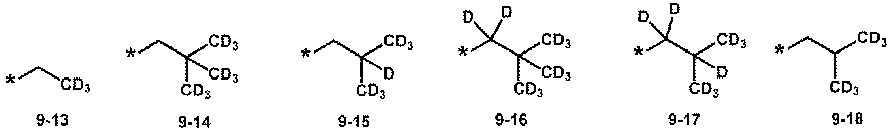 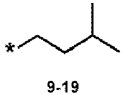 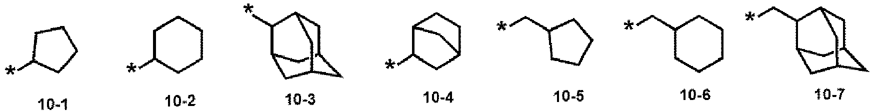 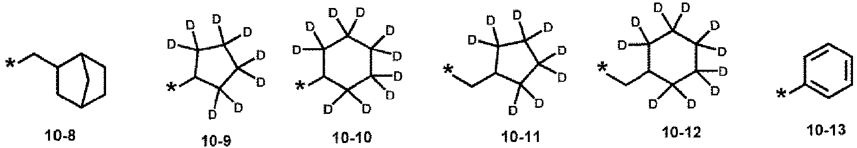 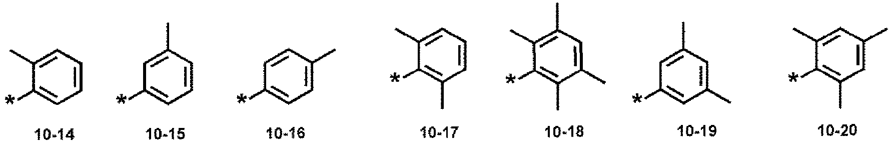 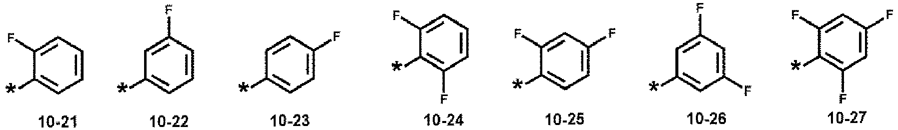 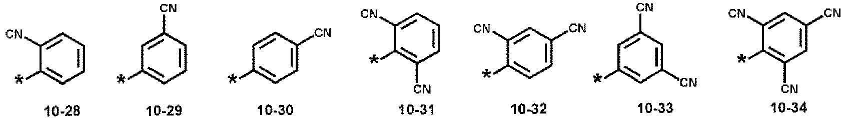 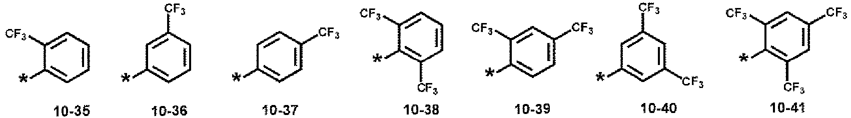 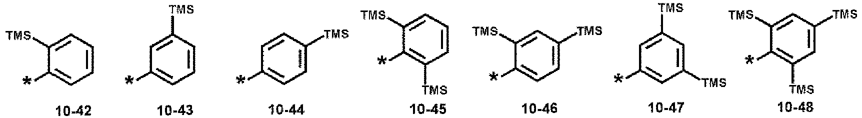 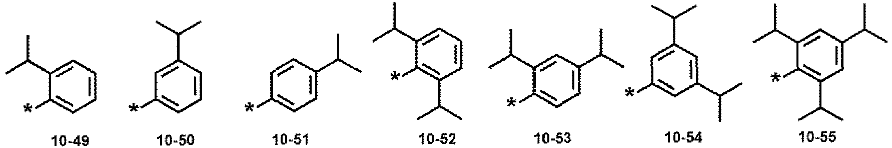 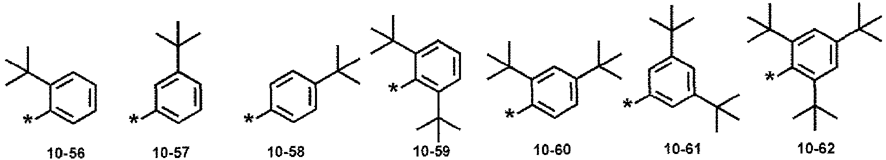 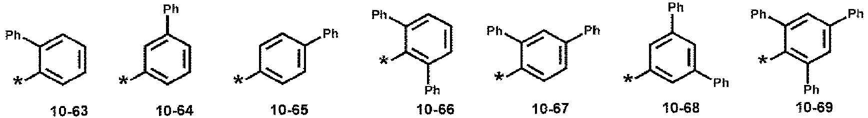 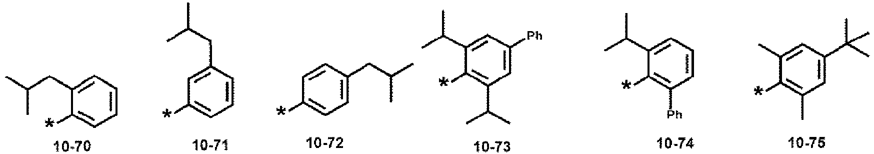 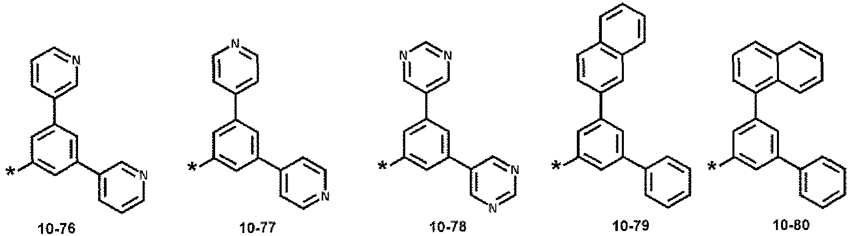 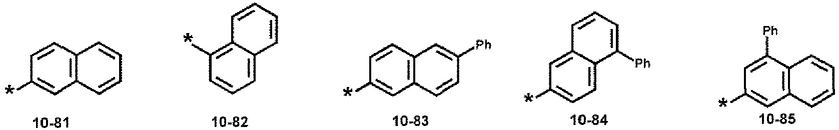 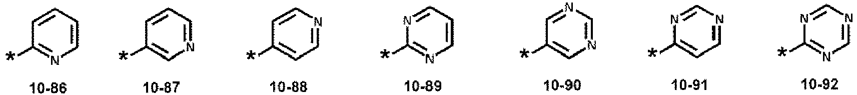 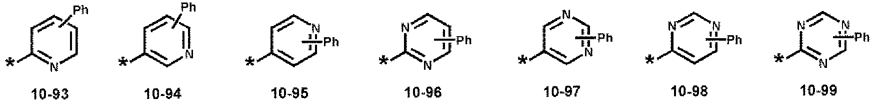 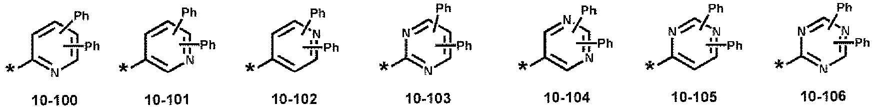 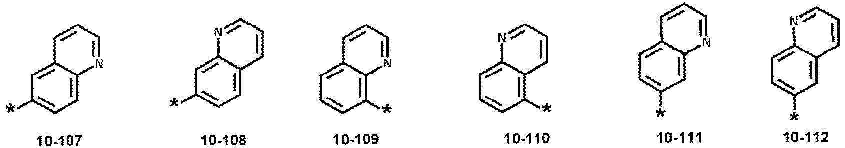 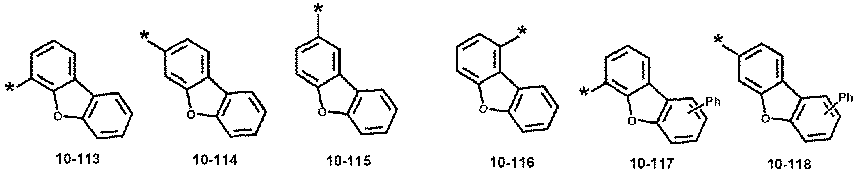 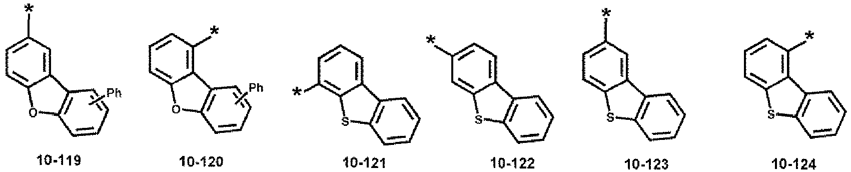 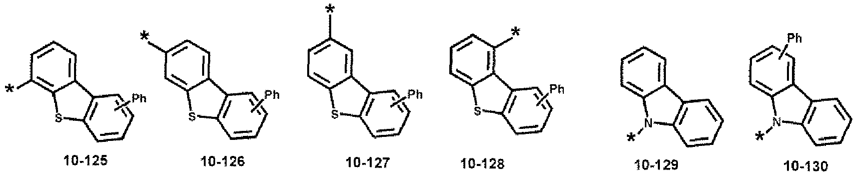 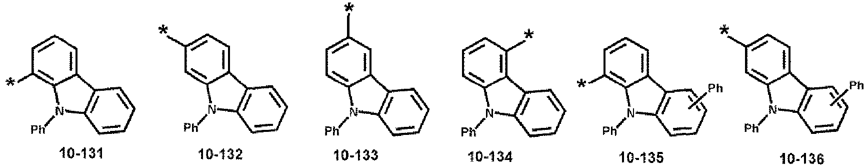 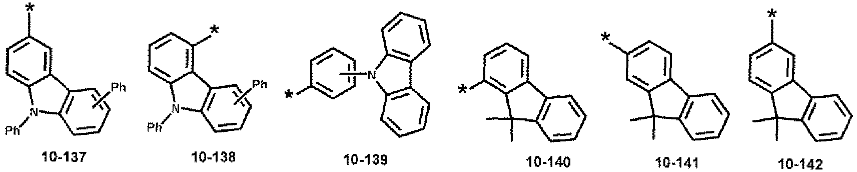 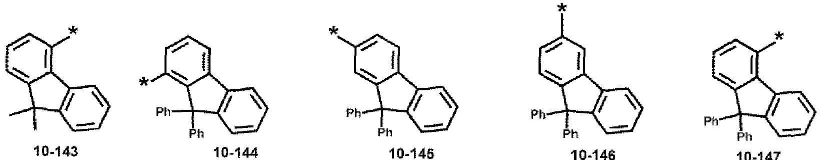 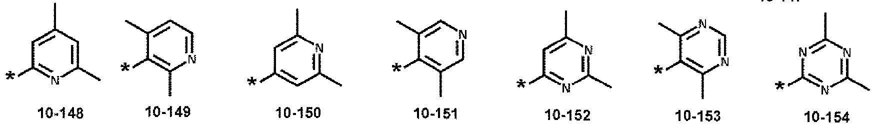 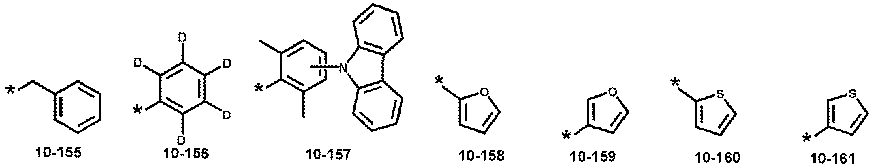 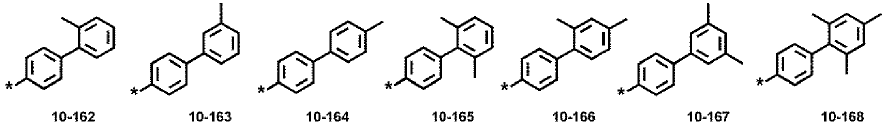 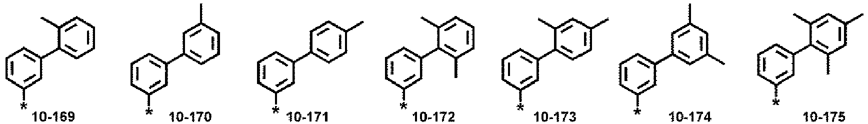 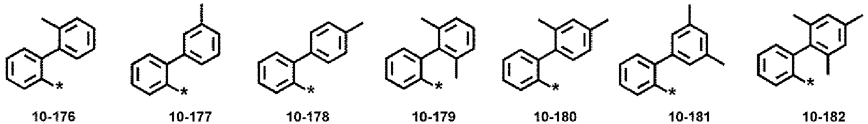 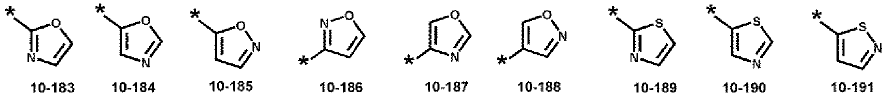 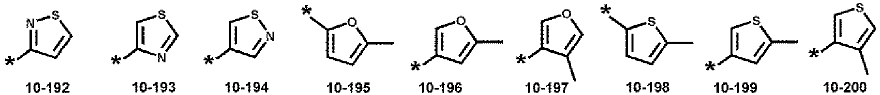 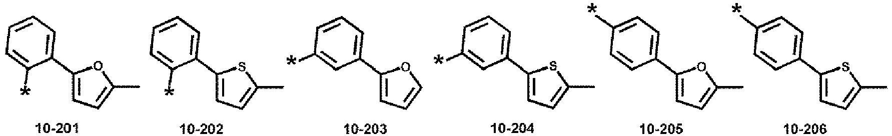 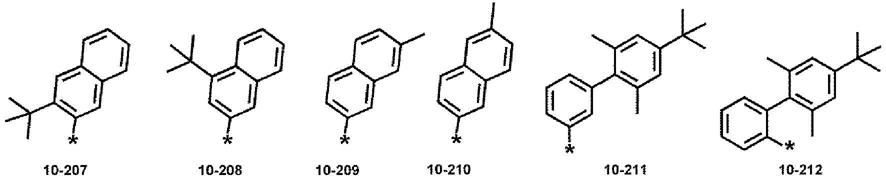 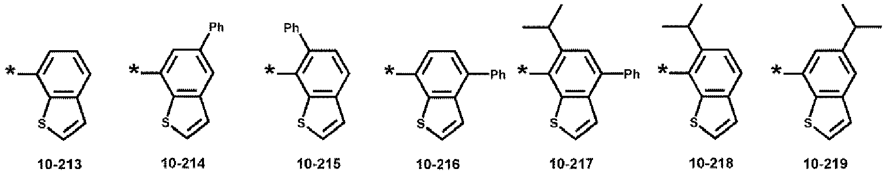 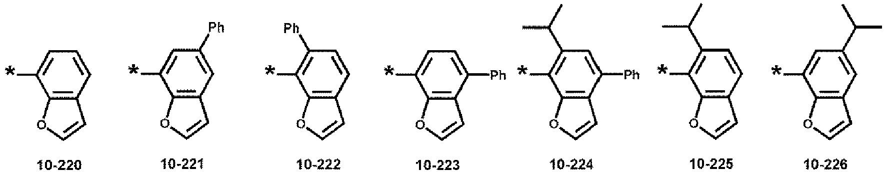 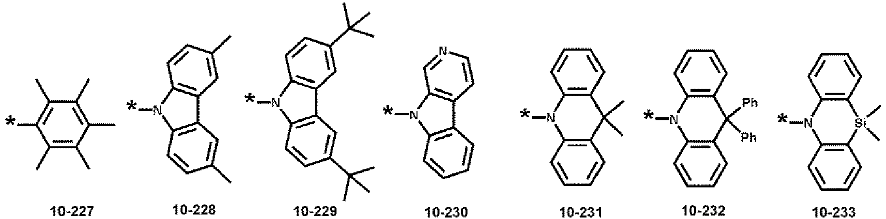 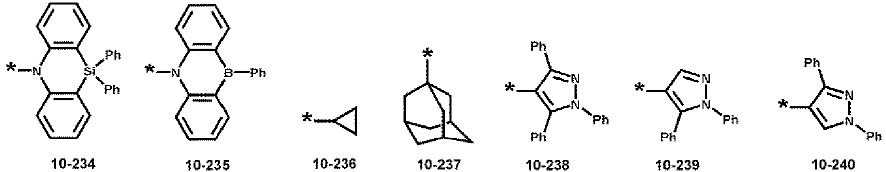 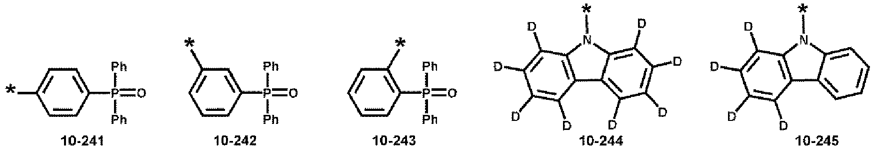 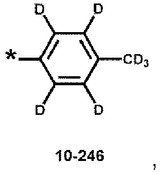 wherein, in Formulae 9-1 to 9-19 and 10-1 to 10-246, * indicates a binding site to an adjacent atom, "Ph" represents a phenyl group, and "TMS" represents a trimethylsilyl group.

In Formulae 3-1 to 3-5, 502, and 503, a71 to a74 and a501 to a504 may respectively indicate the number of R₇₁(s) to R₇₄(s) and R₅₀₁(S) to R₅₀₄(s), and a71 to a74 and a501 to a504 are each independently an integer from 0 to 20. When a71 is 2 or greater, at least two R₇₁(s) may be identical to or different from each other, when a72 is 2 or greater, at least two R₇₂(s) may be identical to or different from each other, when a73 is 2 or greater, at least two R₇₃(s) may be identical to or different from each other, when a74 is 2 or greater, at least two R₇₄(s) may be identical to or different from each other, when a501 is 2 or greater, at least two R₅₀₁(s) may be identical to or different from each other, when a502 is 2 or greater, at least two R₅₀₂(s) may be identical to or different from each other, when a503 is 2 or greater, at least two R₅₀₃(s) may be identical to or different from each other, and when a504 is 2 or greater, at least two R₅₀₄(s) may be identical to or different from each other. a71 to a74 and a501 to a504 may each independently be an integer from 0 to 8.

In Formula 2, a group represented by *-(L₅₁)_{b51}-R₅₁ and a group represented by *-(L₅₂)_{b52}-R₅₂ may each not be a phenyl group.

In one or more embodiments, a group represented by *-(L₅₁)_{b51}-R₅₁ and a group represented by *-(L₅₂)_{b52}-R₅₂ in Formula 2 may be identical to each other.

In one or more embodiments, a group represented by *-(L₅₁)_{b51}-R₅₁ and a group represented by *-(L₅₂)_{b52}-R₅₂ in Formula 2 may be different from each other.

In one or more embodiments, b51 and b52 in Formula 2 may each be 1, 2, or 3, and L₅₁ and L₅₂ may each independently be a benzene group, a pyridine group, a pyrimidine group, a pyridazine group, a pyrazine group, or a triazine group, each unsubstituted or substituted with at least one R₁₀ₐ.

In one or more embodiments, R₅₁ and R₅₂ in Formula 2 may each independently be a C₃-C₆₀ (e.g. C₃-C₃₀) carbocyclic group unsubstituted or substituted with at least one R₁₀ₐ, a C₁-C₆₀ (e.g. C₁-C₂₀) heterocyclic group unsubstituted or substituted with at least one R₁₀ₐ, a C₆-C₆₀ (e.g. C₆-C₃₀) aryloxy group unsubstituted or substituted with at least one R₁₀ₐ, a C₆-C₆₀ (e.g. C₆-C₃₀) arylthio group unsubstituted or substituted with at least one R₁₀ₐ, -C(Q₁)(Q₂)(Q₃), or -Si(Q₁)(Q₂)(Q₃), and
wherein Q₁ to Q₃ may each independently be a C₃-C₆₀ (e.g. C₃-C₃₀) carbocyclic group or a C₁-C₆₀ (e.g. C₁-C₂₀) heterocyclic group, each unsubstituted or substituted with deuterium, -F, a cyano group, a C₁-C₆₀ (e.g. C₁-C₂₀) alkyl group, a C₁-C₆₀ (e.g. C₁-C₂₀) alkoxy group, a phenyl group, a biphenyl group, or a combination thereof.

In one or more embodiments,
a group represented by *-(L₅₁)_{b51}-R₅₁ in Formula 2 may be a group represented by one of Formulae CY51-1 to CY51-26, and/or
a group represented by *-(L₅₂)_{b52}-R₅₂ in Formula 2 may be a group represented by one of Formulae CY52-1 to CY52-26, and/or
a group represented by *-(L₅₃)_{b53}-R₅₃ in Formula 2 may be a group represented by one of Formulae CY53-1 to CY53-27, -C(Q₁)(Q₂)(Q₃), or - Si(Q₁)(Q₂)(Q₃): 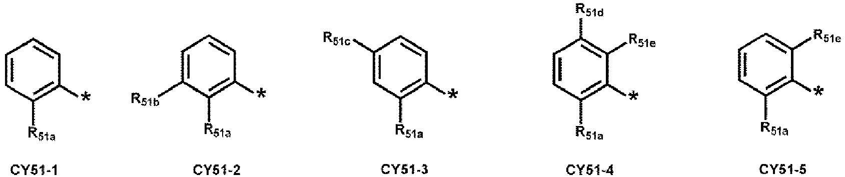 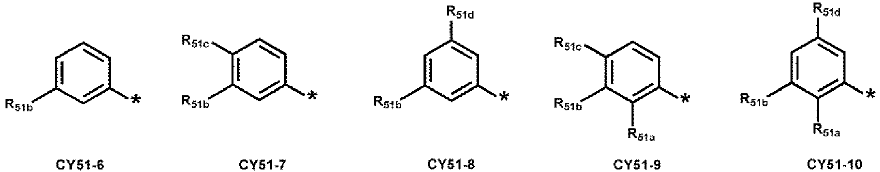 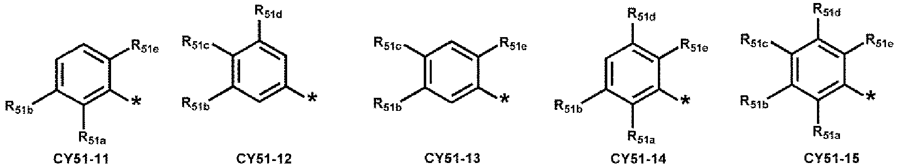 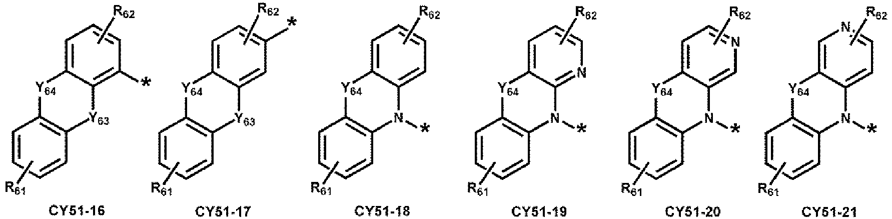 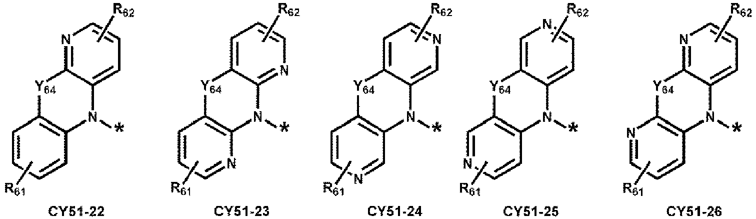 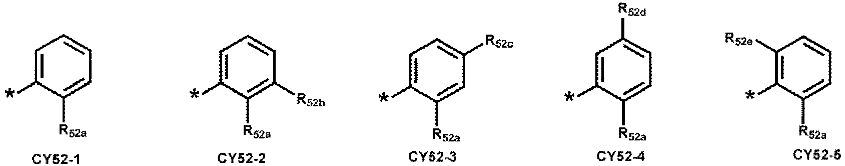 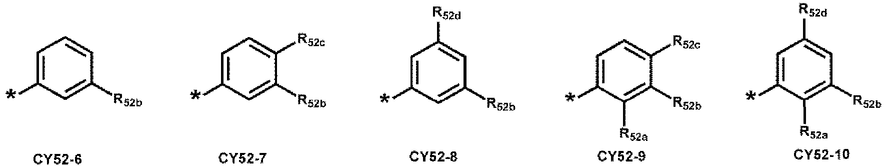 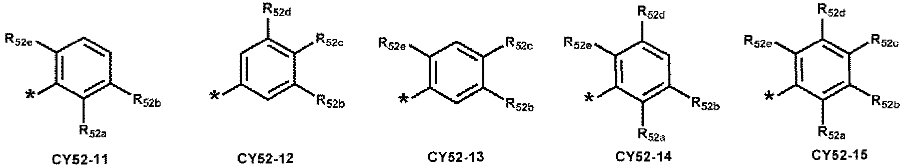 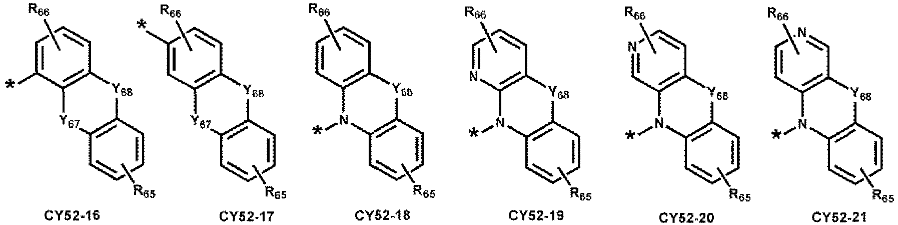 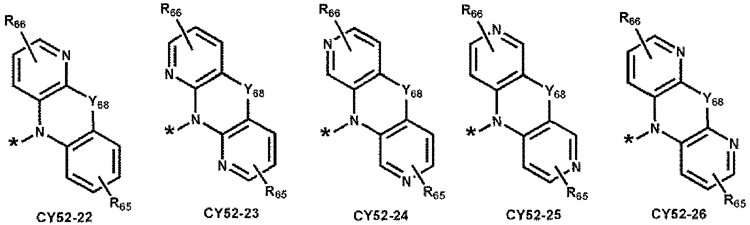 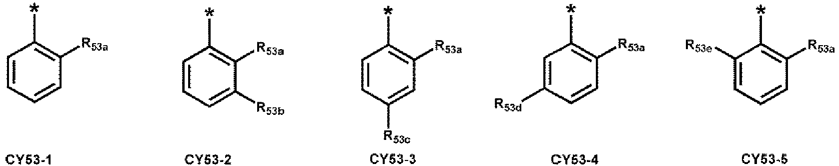 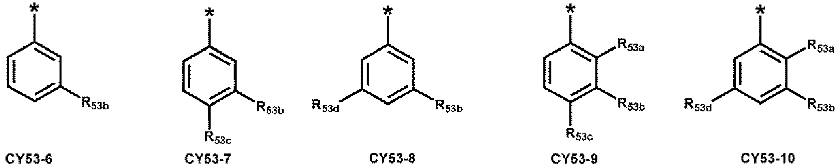 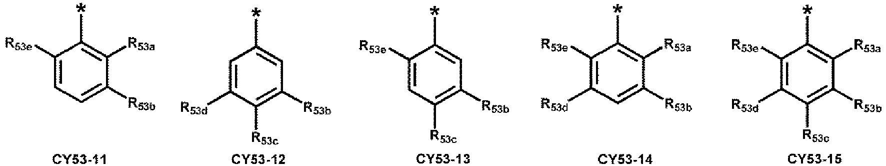 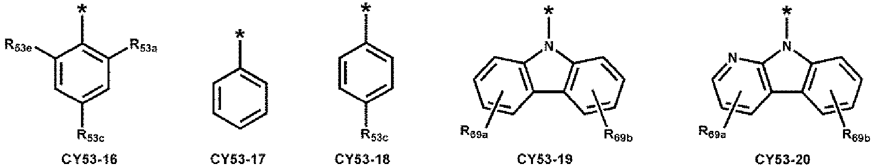 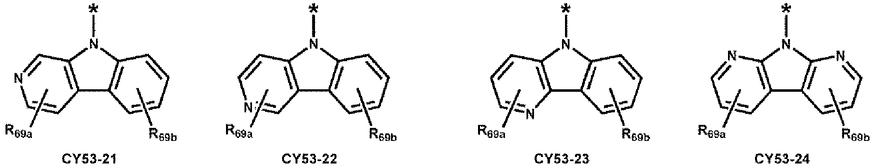 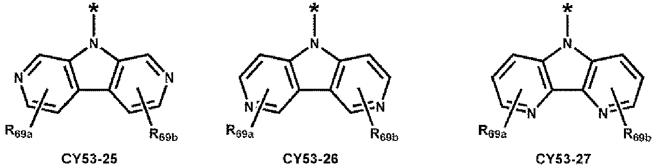
   wherein, in Formulae CY51-1 to CY51-26, CY52-1 to CY52-26, and CY53-1 to CY53-27,
   Y₆₃ is a single bond, O, S, N(R₆₃), B(R₆₃), C(R₆₃ₐ)(R_{63b}), or Si(R₆₃ₐ)(R_{63b}),
   Y₆₄ is a single bond, O, S, N(R₆₄), B(R₆₄), C(R₆₄ₐ)(R_{64b}), or Si(R₆₄ₐ)(R_{64b}),
   Y₆₇ is a single bond, O, S, N(R₆₇), B(R₆₇), C(R₆₇ₐ)(R_{67b}), or Si(R₆₇ₐ)(R_{67b}),
   Y₆₈ is a single bond, O, S, N(R₆₈), B(R₆₈), C(R₆₈ₐ)(R_{68b}), or Si(R₆₈ₐ)(R_{68b}),
   each of Y₆₃ and Y₆₄ in Formulae CY51-16 and CY51-17 may not be a single bond,
   each of Y₆₇ and Y₆₈ in Formulae CY52-16 and CY52-17 may not be a single bond,
   R₅₁ₐ to R₅₁ₑ, R₆₁ to R₆₄, R₆₃ₐ, R_{63b}, R₆₄ₐ, and R_{64b} are each defined as described for (i.e., understood by referring to the description of) R₅₁, and R₅₁ₐ to R₅₁ₑ may not each be hydrogen,
   R₅₂ₐ to R₅₂ₑ, R₆₅ to R₆₈, R₆₇ₐ, R_{67b}, R₆₈ₐ, and R_{68b} are each defined as described for (i.e., understood by referring to the description of) R₅₂, and R₅₂ₐ to R₅₂ₑ may not each be hydrogen,
   R₅₃ₐ to R₅₃ₑ, R₆₉ₐ, and R_{69b} are each defined as described for (i.e., understood by referring to the description of) R₅₃, and R₅₃ₐ to R₅₃ₑ may not each be hydrogen, and
   * indicates a binding site to an adjacent atom.

For example,
R₅₁ₐ to R₅₁ₑ and R₅₂ₐ to R₅₂ₑ in Formulae CY51-1 to CY51-26 and Formulae CY52-1 to 52-26 may each independently be:
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, an azadibenzosilolyl group, or a group represented by Formula 91, each unsubstituted or substituted with deuterium, -F, -Cl, -Br, -I, -CD₃, - CD₂H, -CDH₂, -CF₃, -CF₂H, -CFH₂, a hydroxyl group, a cyano group, a nitro group, a C₁-C₂₀ (e.g. C₁-C₁₀) alkyl group, a C₁-C₂₀ (e.g. C₁-C₁₀) alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, or a combination thereof; or
-C(Q₁)(Q₂)(Q₃) or -Si(Q₁)(Q₂)(Q₃),
wherein Q₁ to Q₃ may each independently be a phenyl group, a naphthyl group, a pyridinyl group, a pyrimidinyl group, a pyridazinyl group, a pyrazinyl group, or a triazinyl group, each unsubstituted or substituted with deuterium, a C₁-C₁₀ alkyl group, a phenyl group, a biphenyl group, a pyridinyl group, a pyrimidinyl group, a pyridazinyl group, a pyrazinyl group, a triazinyl group, or a combination thereof,
in Formulae CY51-16 and CY51-17, i) Y₆₃ may be O or S and Y₆₄ may be Si(R₆₄ₐ)(R_{64b}), or ii) Y₆₃ may be Si(R₆₃ₐ)(R_{63b}) and Y₆₄ may be O or S, and
in Formulae CY52-16 and CY52-17, i) Y₆₇ may be O or S, and Y₆₈ may be Si(R₆₈ₐ)(R_{68b}), or ii) Y₆₇ may be Si(R₆₇ₐ)(R_{67b}), and Y₆₈ may be O or S.

In Formulae 3-1 to 3-5, L₈₁ to L₈₅ may each independently be:
a single bond; or
*-C(Q₄)(Q₅)-*' or *-Si(Q₄)(Q₅)-*'; or
a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, or a benzothiadiazole group, each unsubstituted or substituted with deuterium, - F, -Cl, -Br, -I, a hydroxyl group, a cyano group, a nitro group, a C₁-C₂₀ (*e.g.* C₁-C₁₀) alkyl group, a C₁-C₂₀ (*e.g*. C₁-C₁₀) alkoxy group, a phenyl group, a naphthyl group, a pyridinyl group, a pyrimidinyl group, a triazinyl group, a fluorenyl group, a dimethylfluorenyl group, a diphenylfluorenyl group, a carbazolyl group, a phenylcarbazolyl group, a dibenzofuranyl group, a dibenzothiophenyl group, a dibenzosilolyl group, a dimethyldibenzosilolyl group, a diphenyldibenzosilolyl group, - O(Q₃₁), -S(Q₃₁), -Si(Q₃₁)(Q₃₂)(Q₃₃), -N(Q₃₁)(Q₃₂), -B(Q₃₁)(Q₃₂), -P(Q₃₁)(Q₃₂), - C(=O)(Q₃₁), -S(=O)₂(Q₃₁), -P(=O)(Q₃₁)(Q₃₂), or a combination thereof,
wherein Q₄, Q₅, and Q₃₁ to Q₃₃ may each independently be hydrogen, deuterium, a C₁-C₂₀ (*e.g*. C₁-C₁₀) alkyl group, a C₁-C₂₀ (*e.g*. C₁-C₁₀) alkoxy group, a phenyl group, a biphenyl group, a terphenyl group, a pyridinyl group, a pyrimidinyl group, a pyridazinyl group, a pyrazinyl group, or a triazinyl group.

In one or more embodiments, in Formulae 3-1 and 3-2, a group represented by 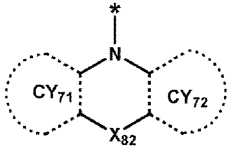 may be represented by one selected from among Formulae CY71-1(1) to CY71-1(8),
in Formulae 3-1 and 3-3, a group represented by 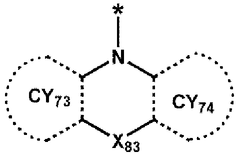 may be represented by one selected from among Formulae CY71-2(1) to CY71-2(8), and/or
in Formulae 3-2 and 3-4, a group represented by 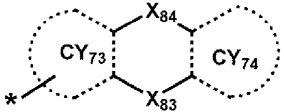 may be represented by one selected from among Formulae CY71-3(1) to CY71-3(32),
in Formulae 3-3 to 3-5, a group represented by 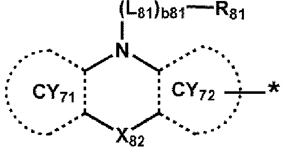 may be represented by one selected from among Formulae CY71-4(1) to CY71-4(32), and/or
in Formula 3-5, a group represented by 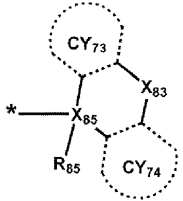 may be represented by one selected from among Formulae CY71-5(1) to CY71-5(8):

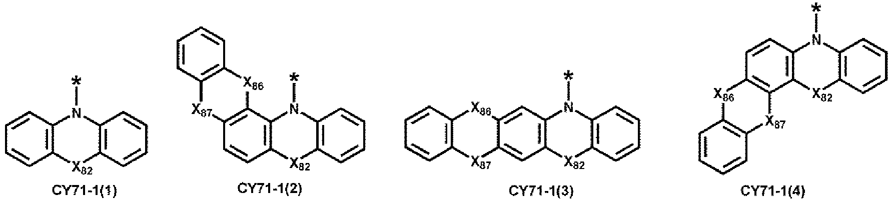

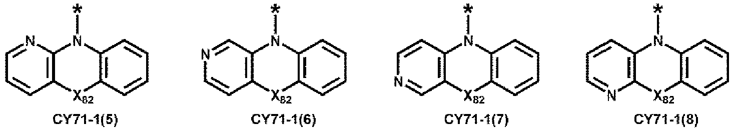

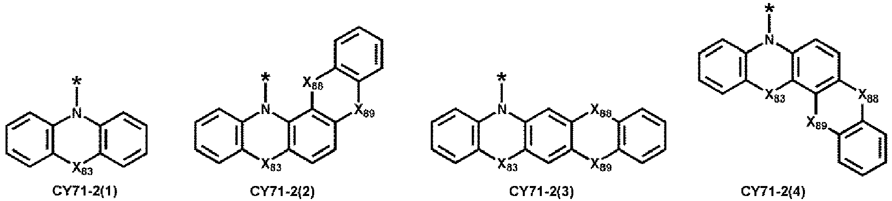

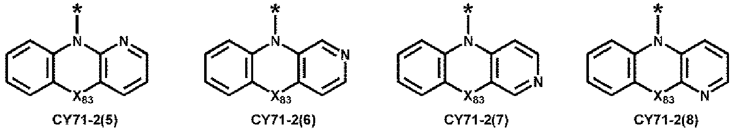

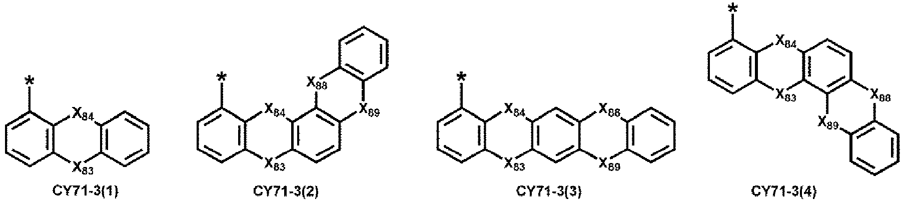

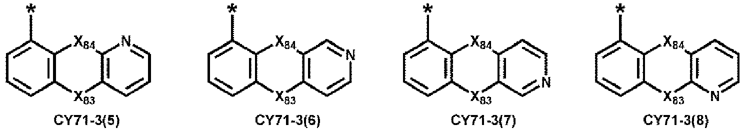

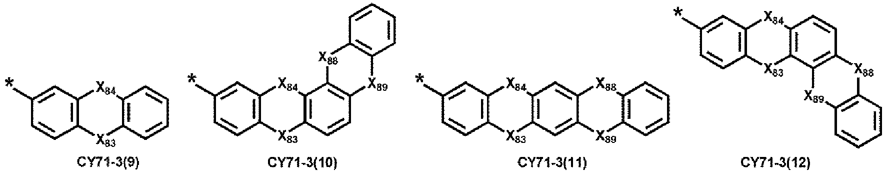

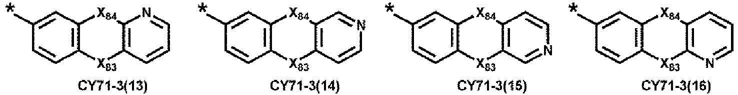

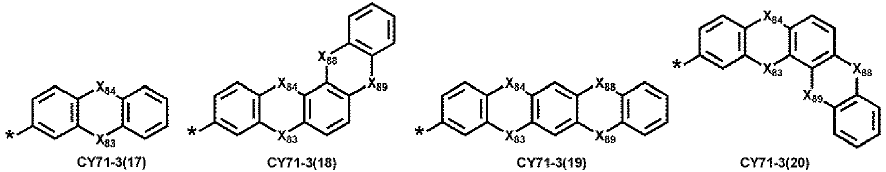

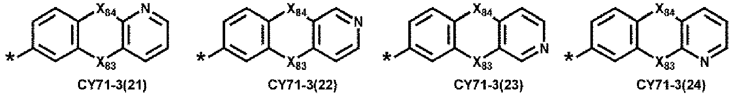

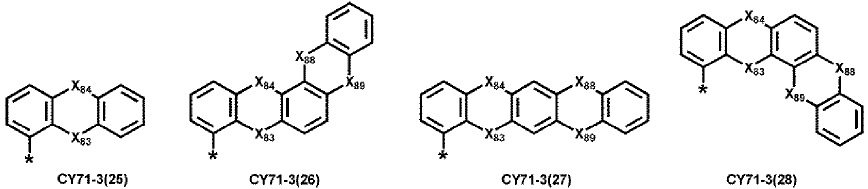

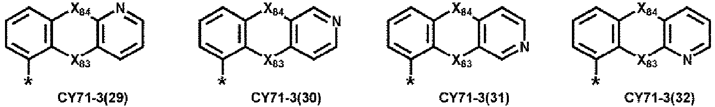

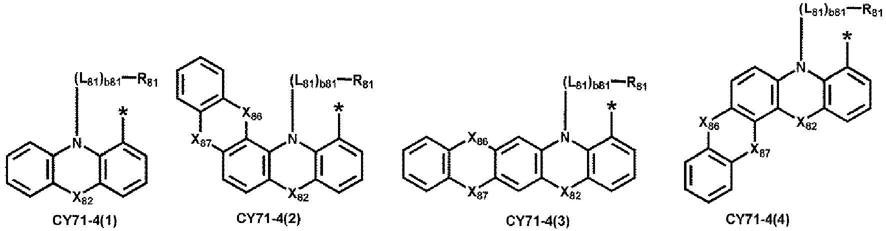

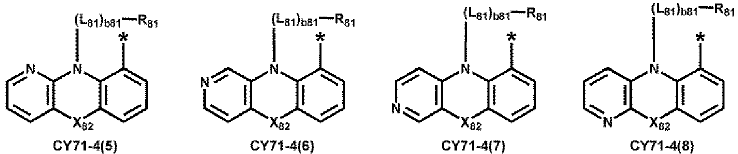

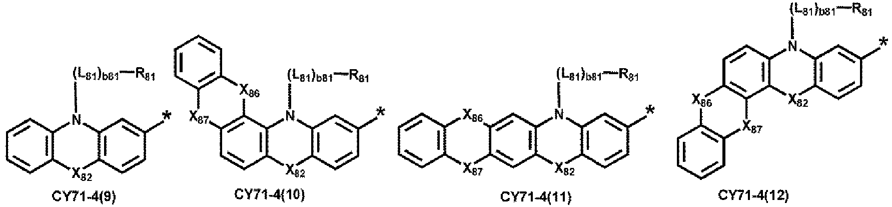

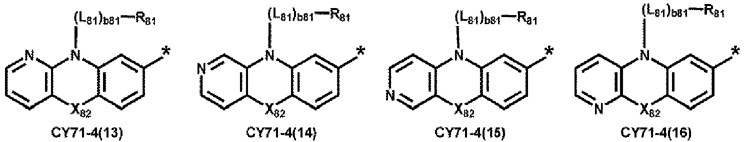

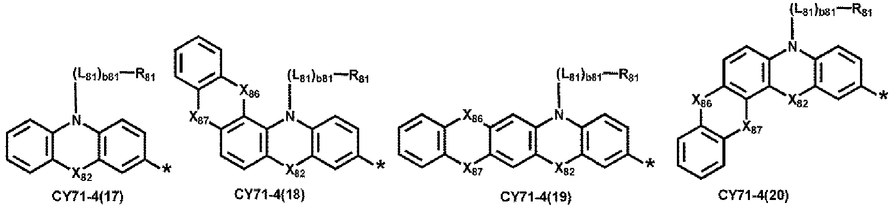

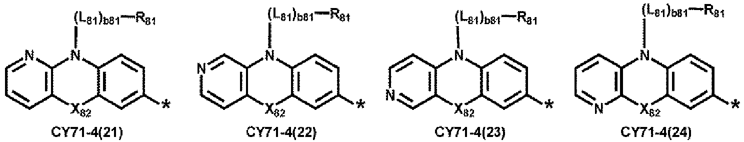

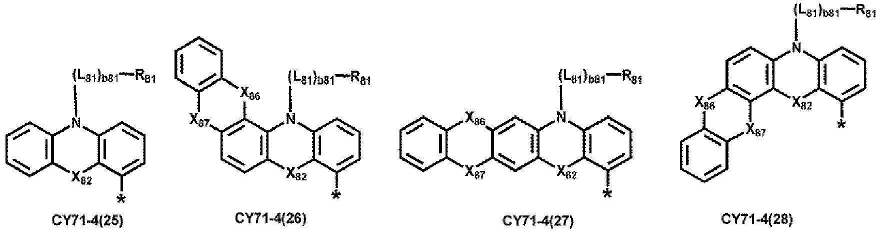

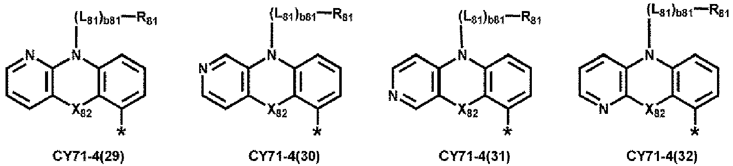

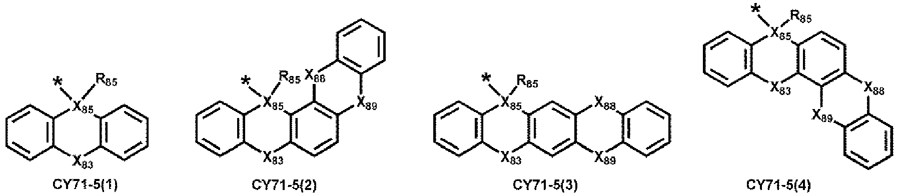

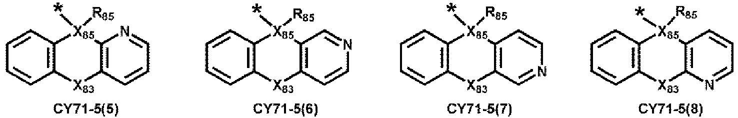

In one or more embodiments, for Formulae CY71-1(1) to CY71-1(8), CY71-2(1) to CY71-2(8), CY71-3(1) to CY71-3(32), CY71-4(1) to CY71-4(32), and CY71-5(1) to CY71-5(8),
X₈₁ to X₈₅, L₈₁, b81, R₈₁, and R₈₅ are respectively defined as described for (i.e., understood by referring to the descriptions of) X₈₁ to X₈₅, L₈₁, b81, R₈₁, and R₈₅ provided herein,
X₈₆ is a single bond, O, S, N(R₈₆), B(R₈₆), C(R₈₆ₐ)(R_{86b}), or Si(R₈₆ₐ)(R_{86b}),
X₈₇ is a single bond, O, S, N(R₈₇), B(R₈₇), C(R₈₇ₐ)(R_{87b}), or Si(R₈₇ₐ)(R_{87b}),
in Formulae CY71-1(1) to CY71-1(8) and CY71-4(1) to CY71-4(32), X₈₆ and X₈₇ are not a single bond simultaneously (e.g., at the same time),
X₈₈ is a single bond, O, S, N(R₈₈), B(R₈₈), C(R₈₈ₐ)(R_{88b}), or Si(R₈₈ₐ)(R_{88b}),
X₈₉ is a single bond, O, S, N(R₈₉), B(R₈₉), C(R₈₉ₐ)(R_{89b}), or Si(R₈₉ₐ)(R_{89b}),
in Formulae CY71-2(1) to CY71-2(8), CY71-3(1) to CY71-3(32), and CY71-5(1) to CY71-5(8), X₈₈ and X₈₉ are not a single bond simultaneously (e.g., at the same time), and
R₈₆ to R₈₉, R₈₆ₐ, R_{86b}, R₈₇ₐ, R_{87b}, R₈₈ₐ, R_{88b}, R₈₉ₐ, and R_{89b} are each defined as described for (i.e., understood by referring to the description of) R₈₁ provided herein.

### Examples of compounds

In one or more embodiments, the organometallic compound represented by Formula 1 may be one of Compounds BD01 to BD120:

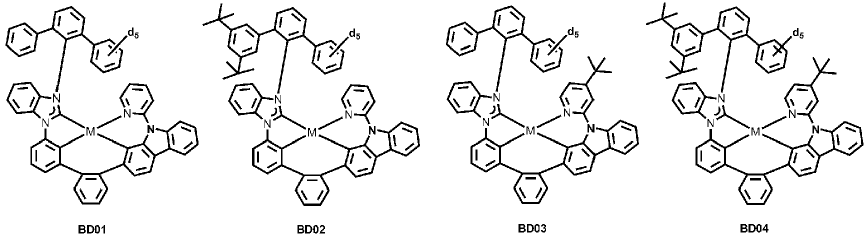

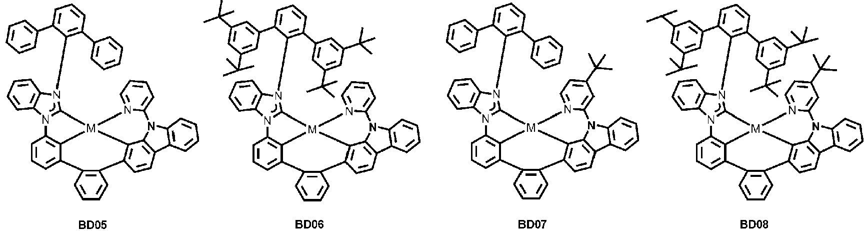

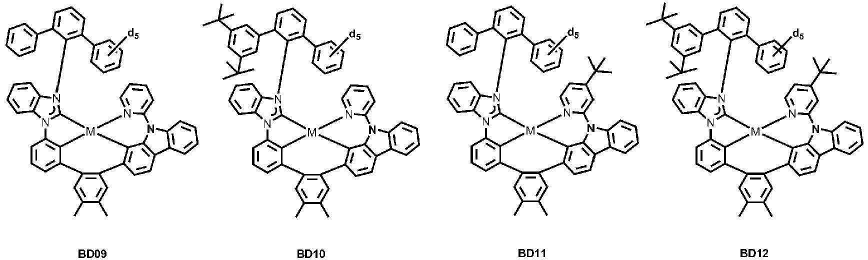

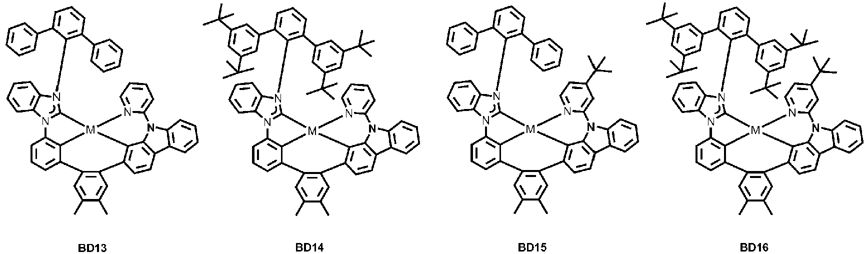

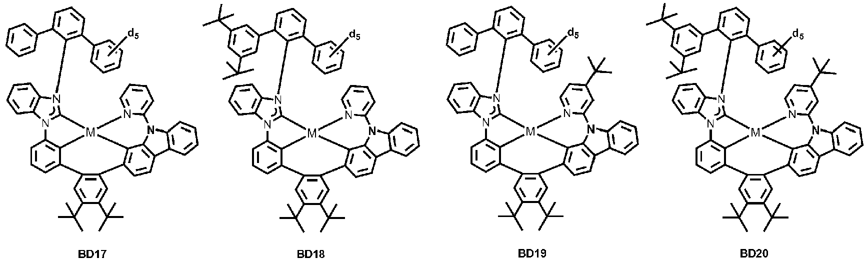

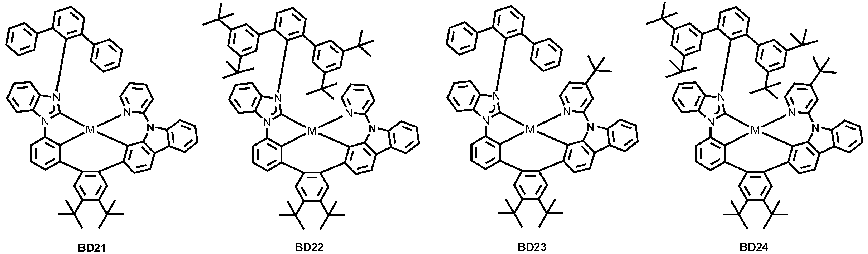

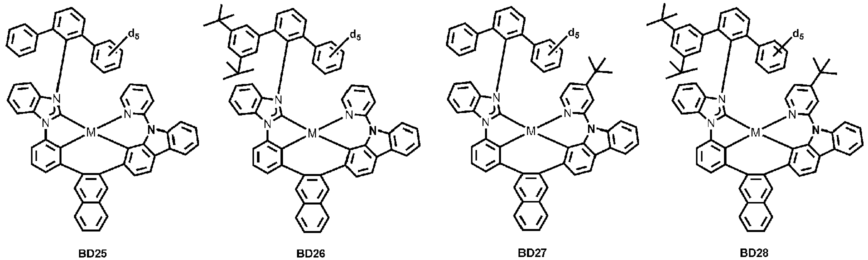

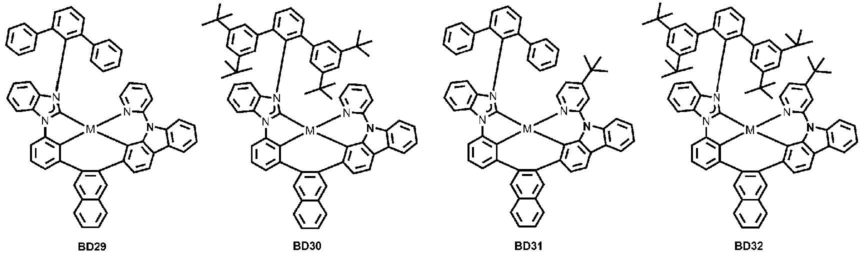

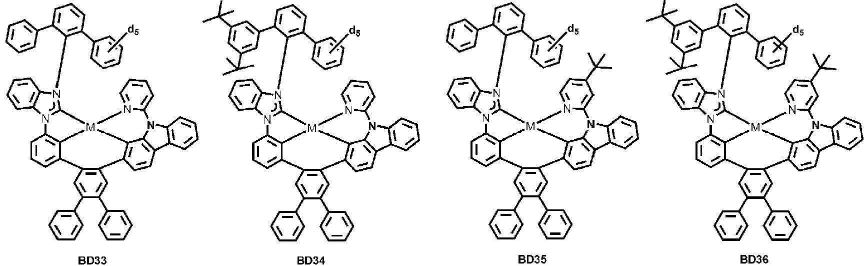

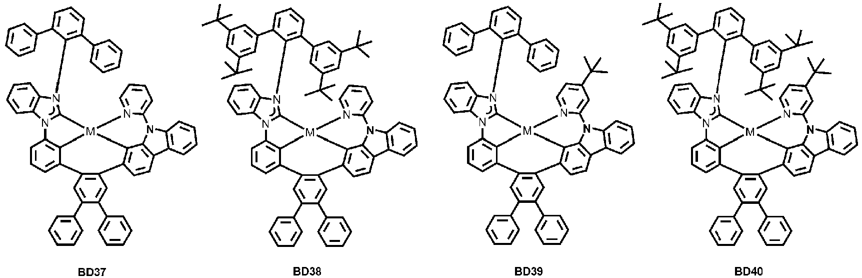

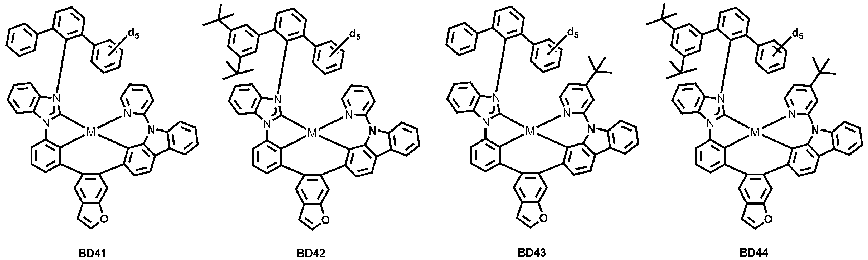

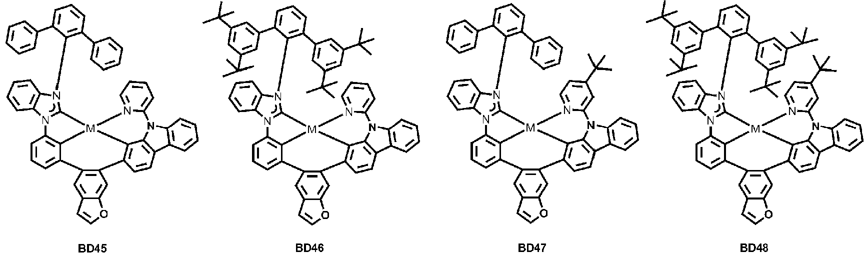

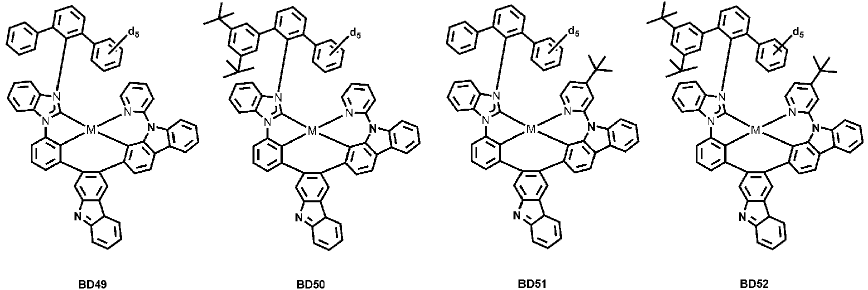

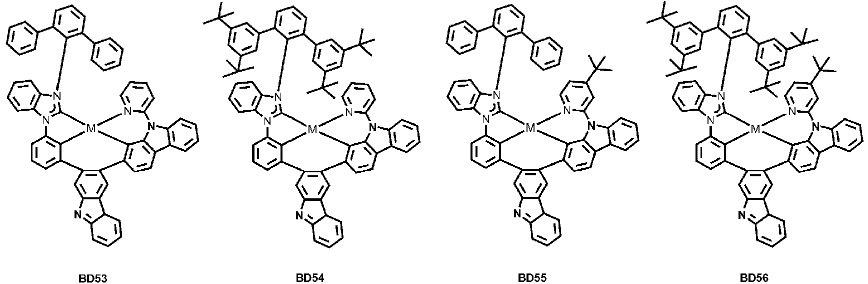

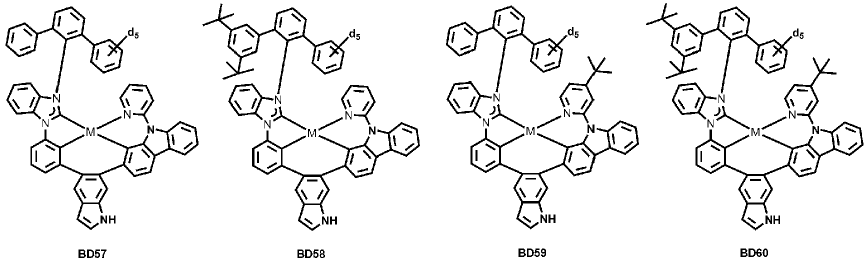

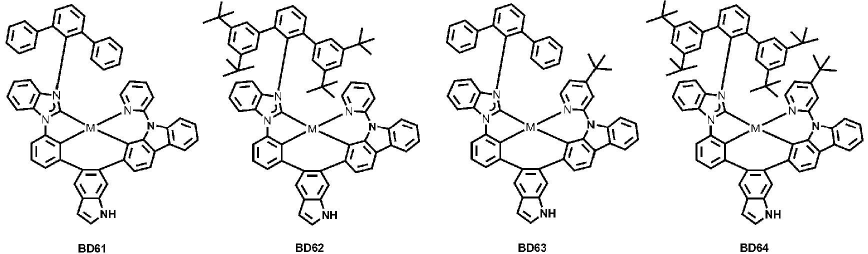

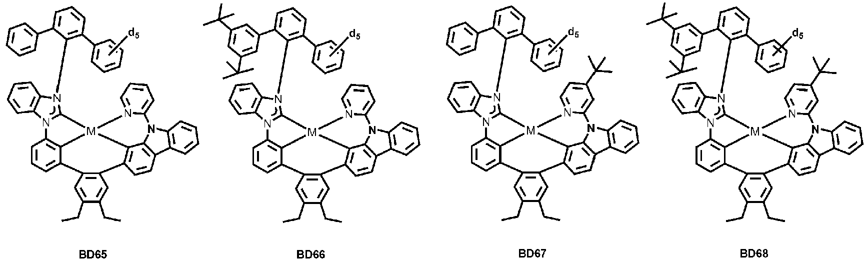

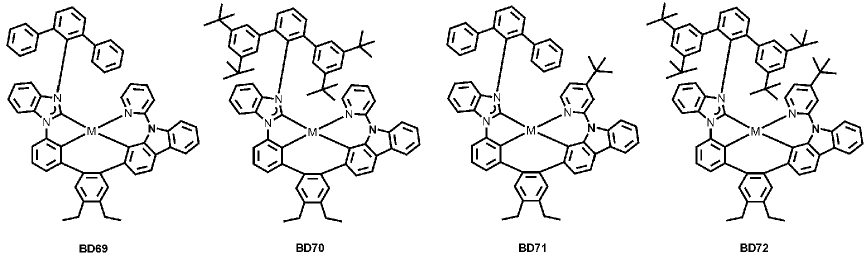

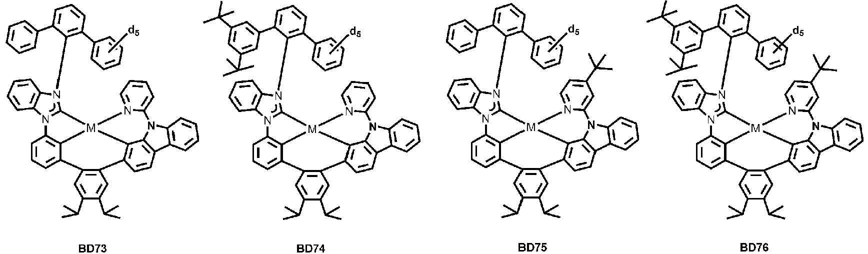

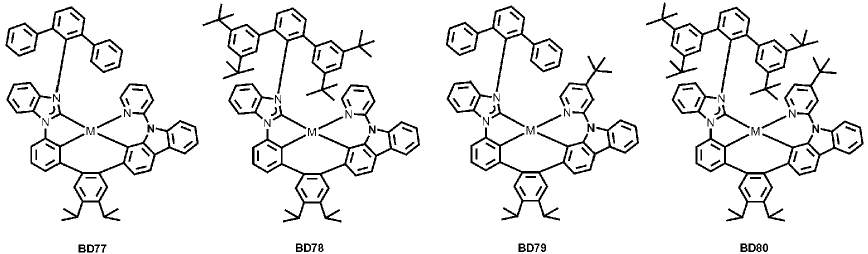

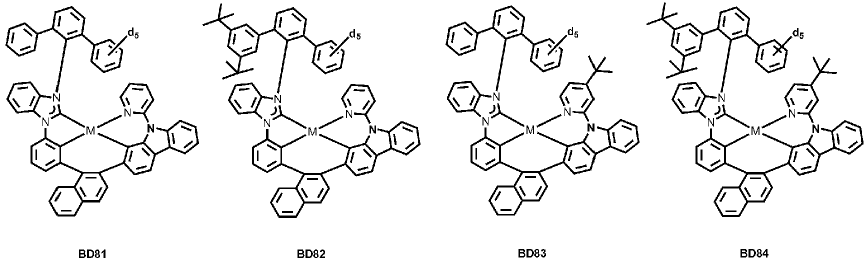

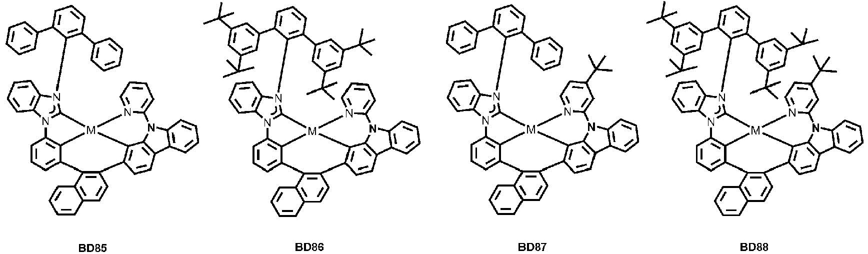

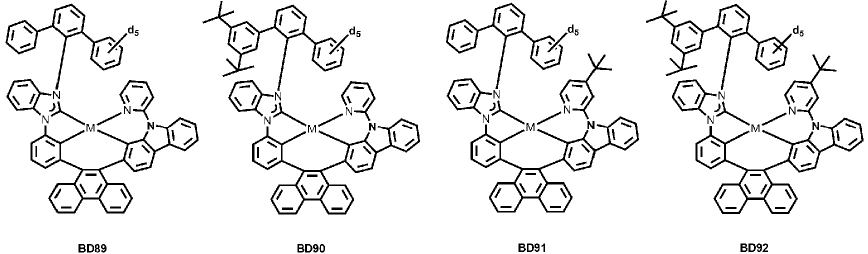

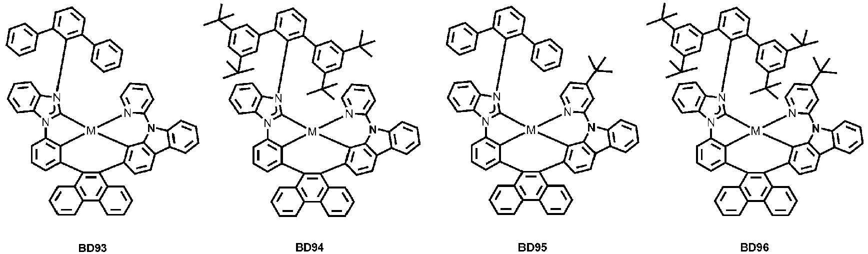

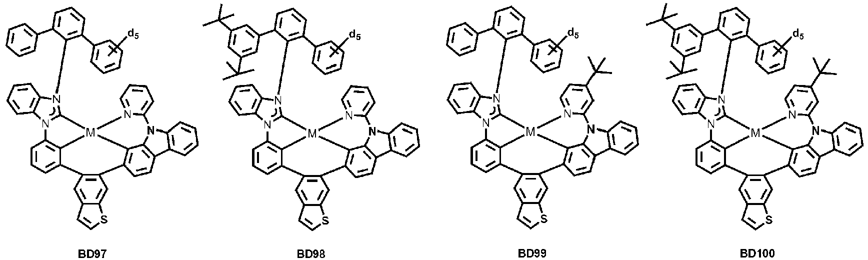

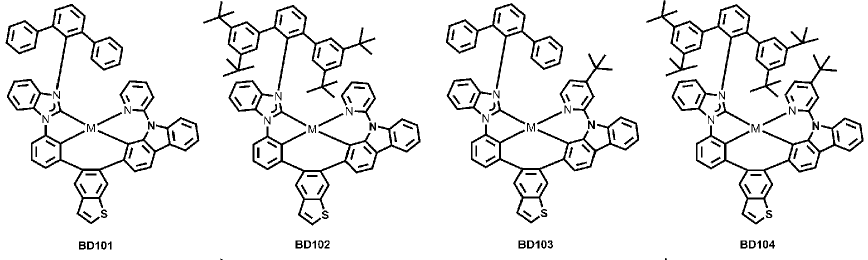

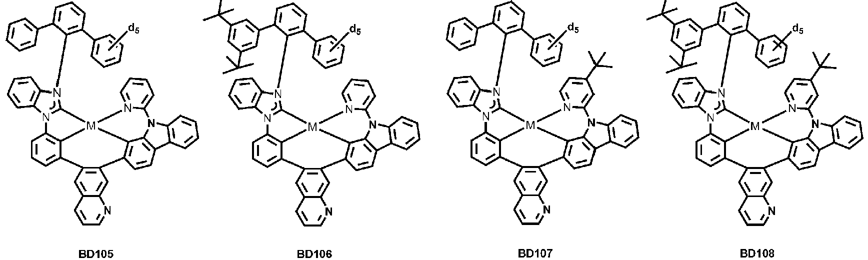

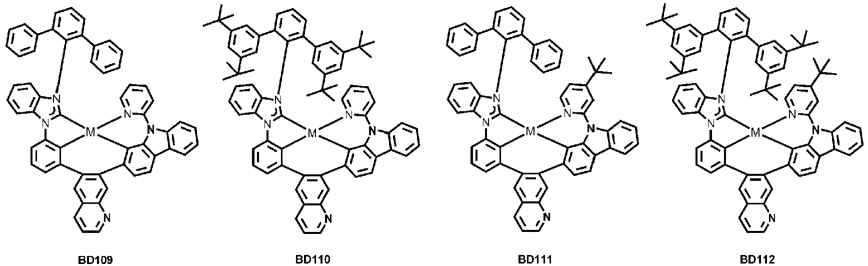

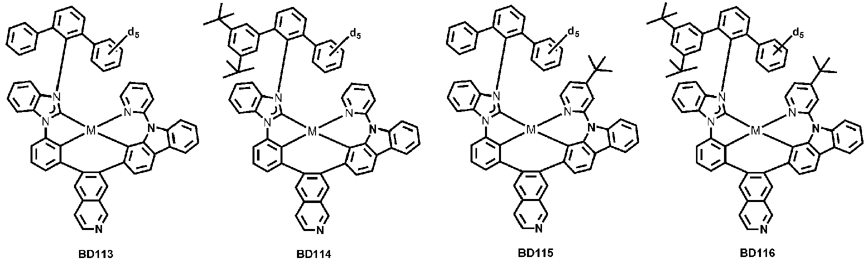

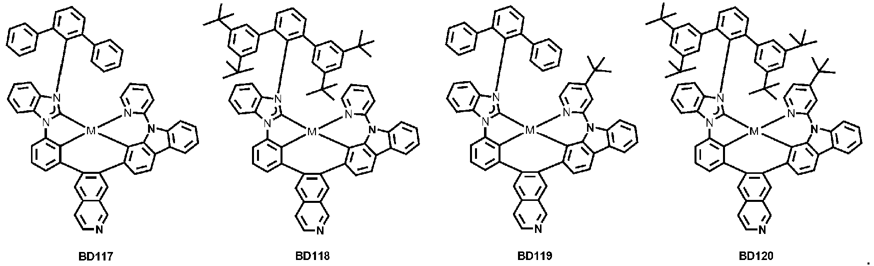

In one or more embodiments, M in Compounds BD01 to BD120 are defined as described herein.

In one or more embodiments, the second compound may be one of Compounds ETH1 to ETH100:

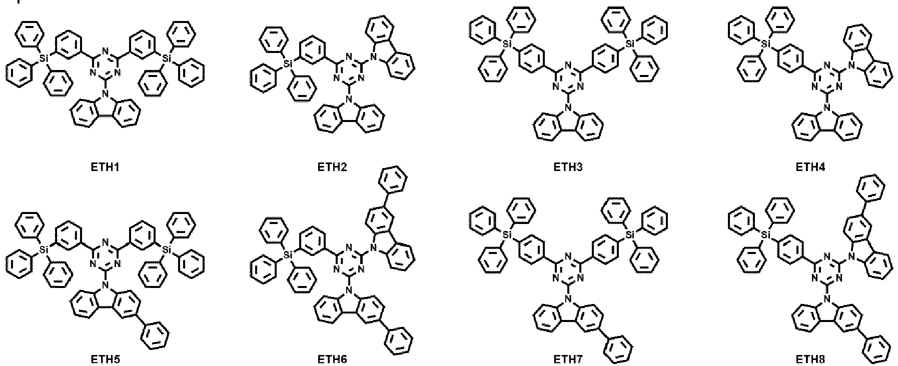

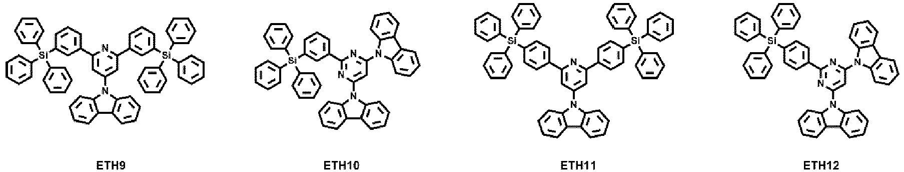

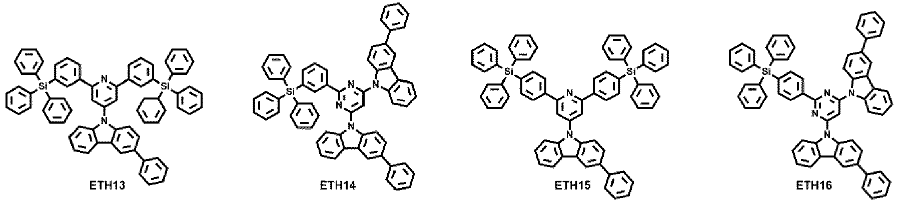

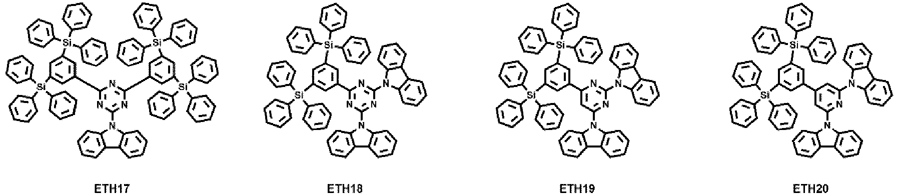

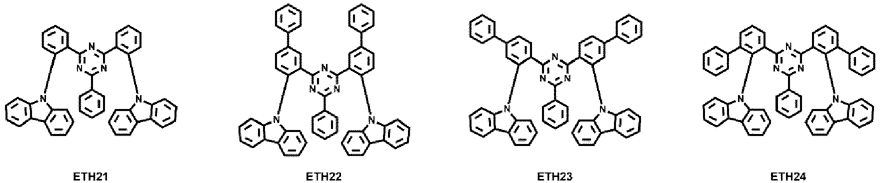

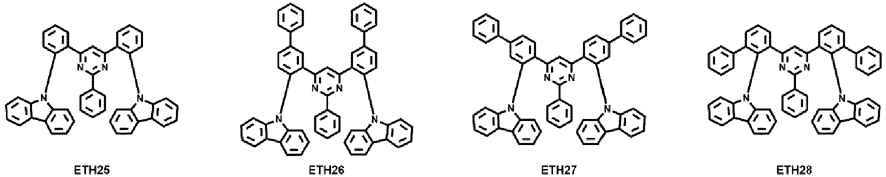

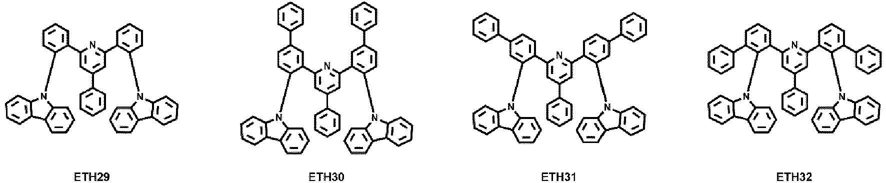

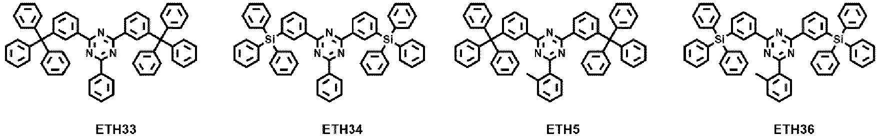

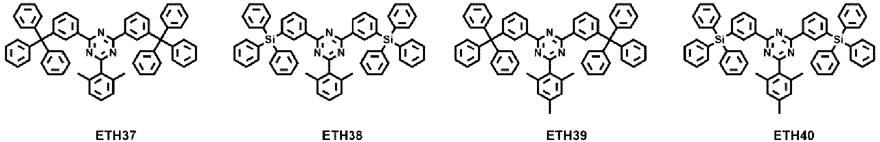

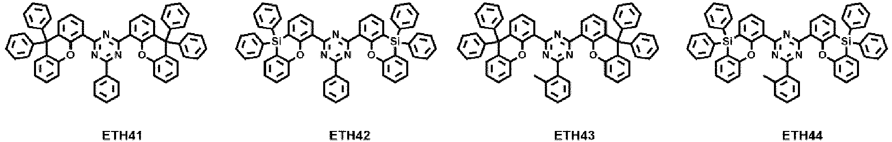

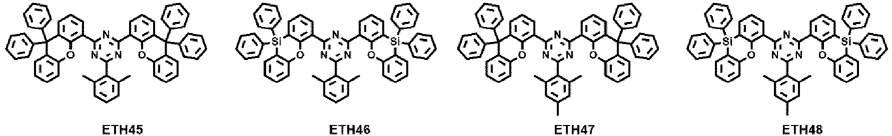

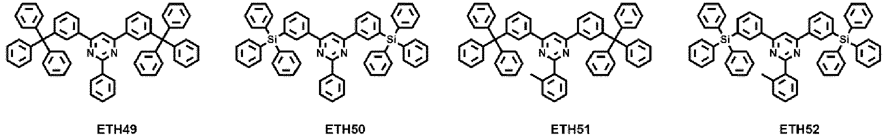

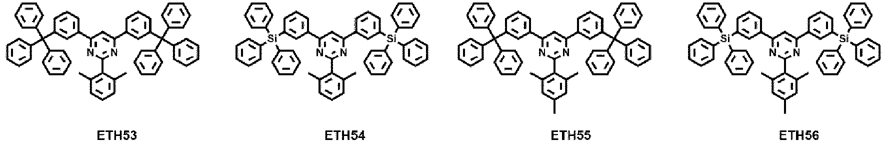

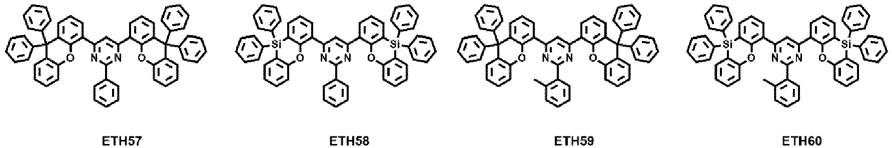

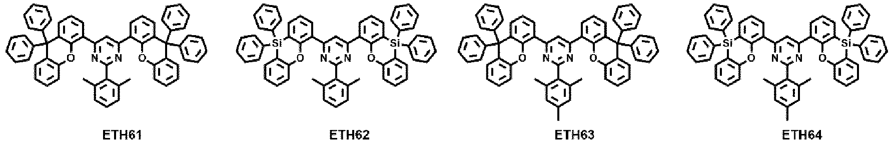

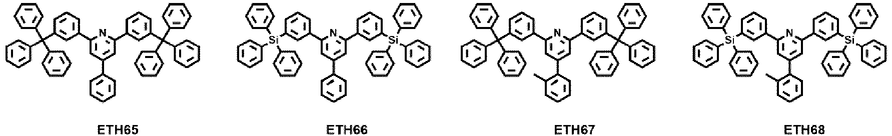

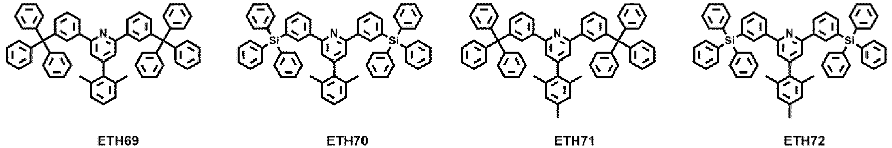

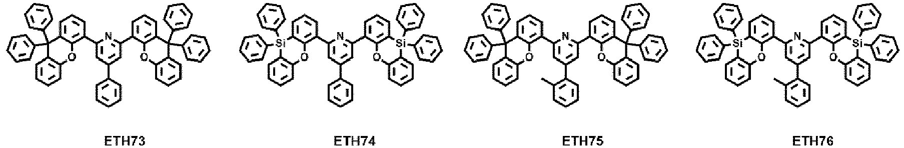

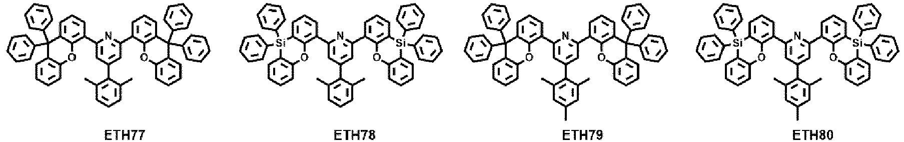

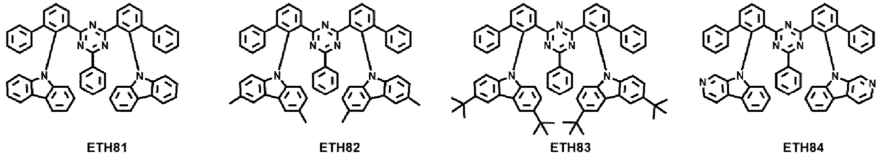

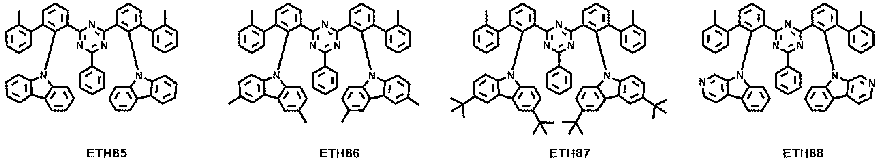

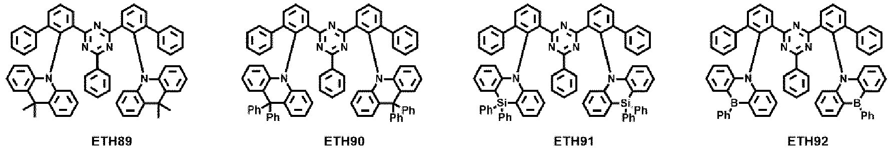

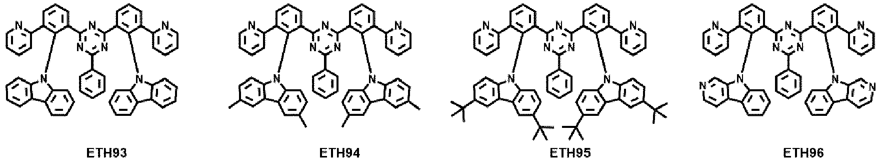

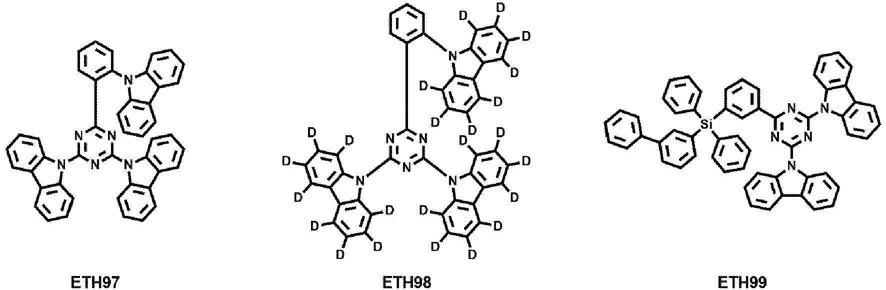

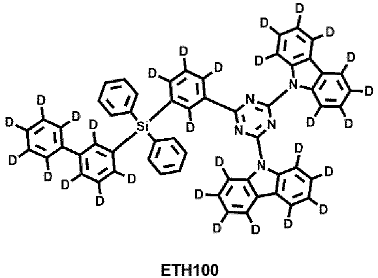

In one or more embodiments, the third compound may be one of Compounds HTH1 to HTH40:

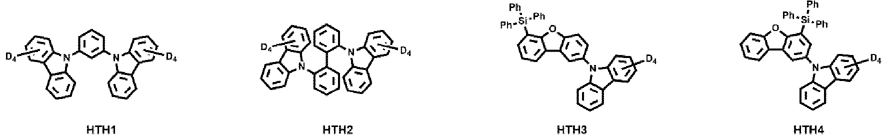

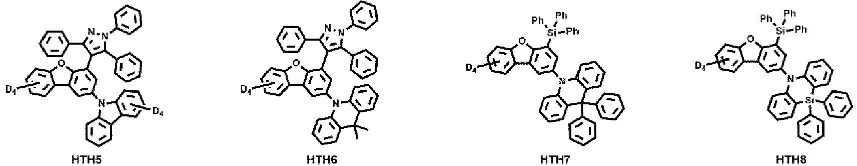

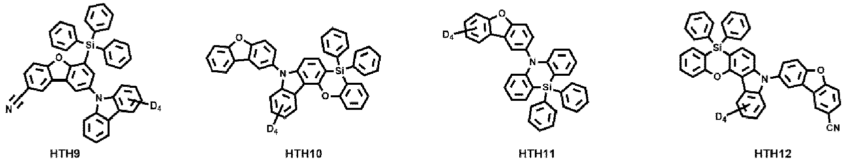

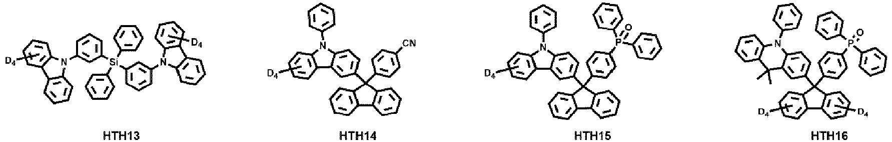

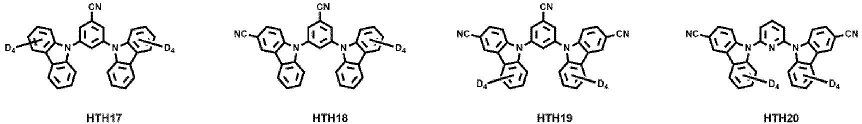

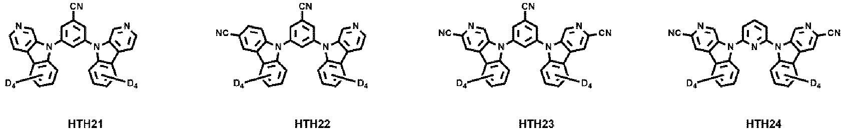

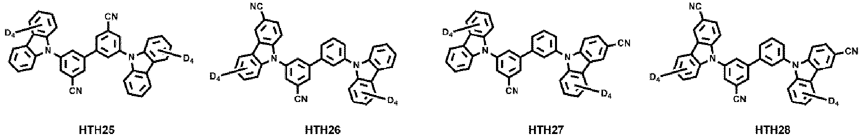

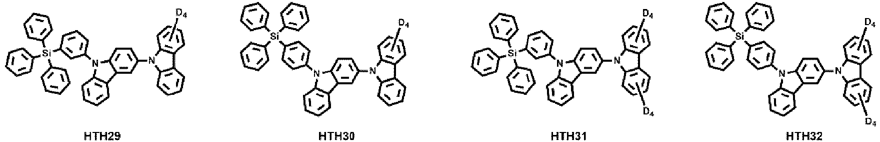

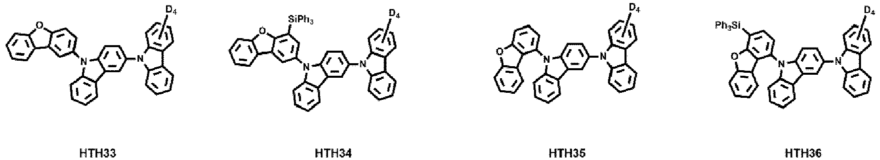

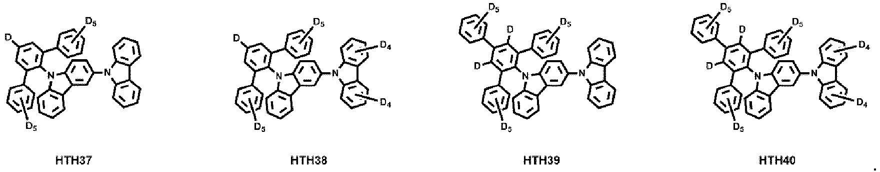

In one or more embodiments, the fourth compound may be one of Compounds DFD1 to DFD29:

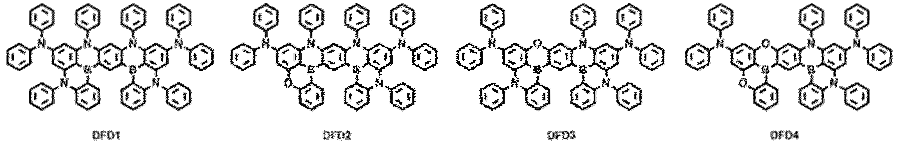

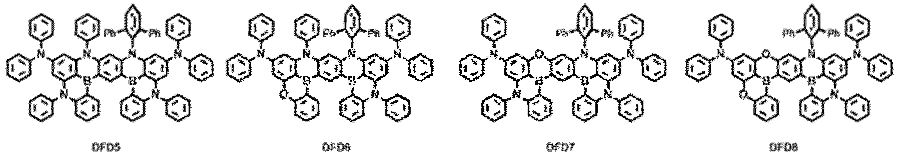

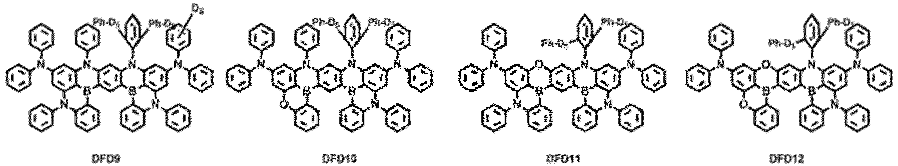

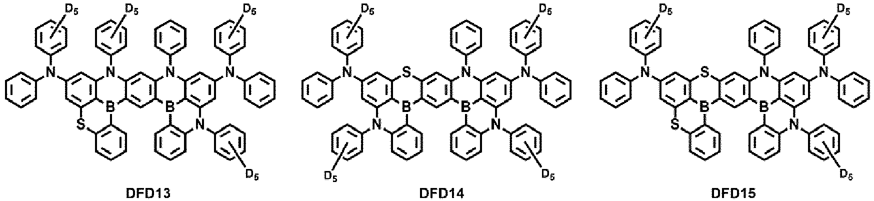

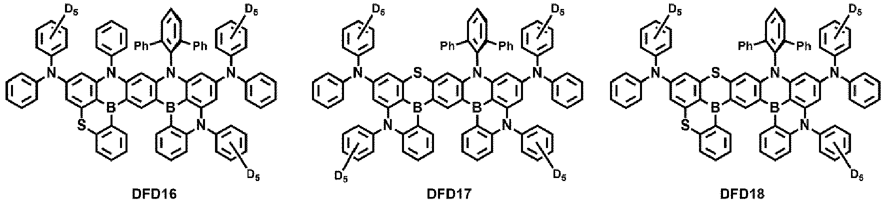

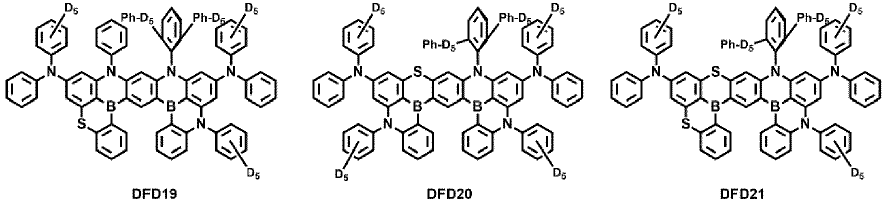

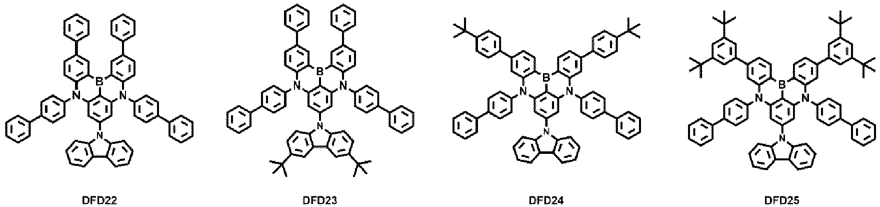

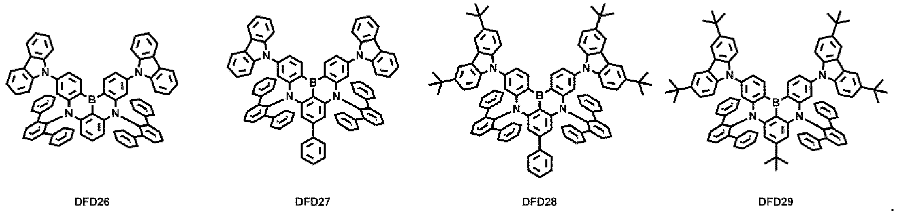

In the compounds described, Ph represents a phenyl group, D₅ represents substitution with five deuterium, and D₄ represents substitution with four deuterium. For example, a group represented by 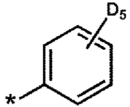 may be substantially the same as, or identical to, a group represented by

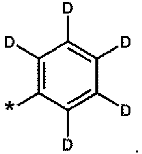

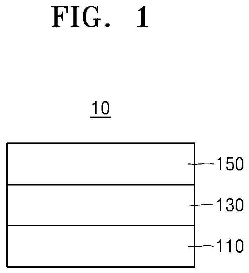

### Description of FIG. 1

FIG. 1 is a schematic cross-sectional view of a light-emitting device 10 according to one or more embodiments. The light-emitting device 10 includes a first electrode 110, an interlayer 130, and a second electrode 150.

Hereinafter, the structure of the light-emitting device 10 according to one or more embodiments and a method of manufacturing the light-emitting device 10 will be described with reference to FIG. 1.

### First electrode 110

In FIG. 1, a substrate may be additionally located under the first electrode 110 or on the second electrode 150. As the substrate, a glass substrate or a plastic substrate may be utilized. In one or more embodiments, the substrate may be a flexible substrate, and may include plastics with excellent or suitable heat resistance and durability, such as polyimide, polyethylene terephthalate (PET), polycarbonate, polyethylene naphthalate, polyarylate (PAR), polyetherimide, or a combination thereof.

The first electrode 110 may be formed by, for example, depositing or sputtering a material for forming the first electrode 110 on the substrate. When the first electrode 110 is an anode, a material for forming the first electrode 110 may be a high work-function material that facilitates injection of holes. The term "high work-function material" as utilized herein refers to a substance (e.g., a metal or metal alloy) that requires a relatively high amount of energy to emit electrons from its surface.

The first electrode 110 may be a reflective electrode, a semi-transmissive electrode, or a transmissive electrode. When the first electrode 110 is a transmissive electrode, a material for forming the first electrode 110 may include indium tin oxide (ITO), indium zinc oxide (IZO), tin oxide (SnO₂), zinc oxide (ZnO), or a combination thereof. In one or more embodiments, when the first electrode 110 is a semi-transmissive electrode or a reflective electrode, a material for forming the first electrode 110 may include magnesium (Mg), silver (Ag), aluminium (Al), aluminium-lithium (Al-Li), calcium (Ca), magnesium-indium (Mg-In), magnesium-silver (Mg-Ag), or a combination thereof.

The first electrode 110 may have a single-layered structure consisting of a single layer or a multi-layered structure including a plurality of layers. For example, the first electrode 110 may have a three-layered structure of ITO/Ag/ITO.

### Interlayer 130

The interlayer 130 may be located on the first electrode 110. The interlayer 130 may include an emission layer.

The interlayer 130 may further include a hole transport region located between the first electrode 110 and the emission layer, and an electron transport region located between the emission layer and the second electrode 150.

The interlayer 130 may further include, in addition to one or more suitable organic materials, a metal-containing compound such as an organometallic compound, an inorganic material such as quantum dots, and/or the like.

In one or more embodiments, the interlayer 130 may include i) two or more emitting units sequentially stacked between the first electrode 110 and the second electrode 150, and ii) a charge generation layer located between two neighboring emitting units. When the interlayer 130 includes emitting units and a charge generation layer as described above, the light-emitting device 10 may be a tandem light-emitting device.

### Hole transport region in interlayer 130

The hole transport region may have: i) a single-layered structure including (e.g., consisting of) a single layer including (e.g., consisting of) a single material, ii) a single-layered structure including (e.g., consisting of) a single layer including (e.g., consisting of) a plurality of different materials, or iii) a multi-layered structure including a plurality of layers including different materials.

The hole transport region may include a hole injection layer, a hole transport layer, an emission auxiliary layer, an electron blocking layer, or a combination thereof.

For example, the hole transport region may have a multi-layered structure including a hole injection layer/hole transport layer structure, a hole injection layer/hole transport layer/emission auxiliary layer structure, a hole injection layer/emission auxiliary layer structure, a hole transport layer/emission auxiliary layer structure, or a hole injection layer/hole transport layer/electron blocking layer structure. In one or more embodiments, the layers of each structure being stacked sequentially from the first electrode 110.

The hole transport region may include a compound represented by Formula 201, a compound represented by Formula 202, and/or a combination thereof: 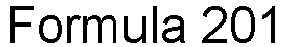 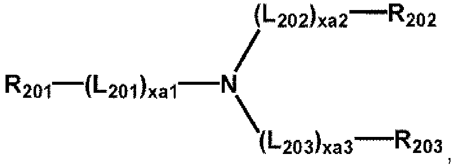 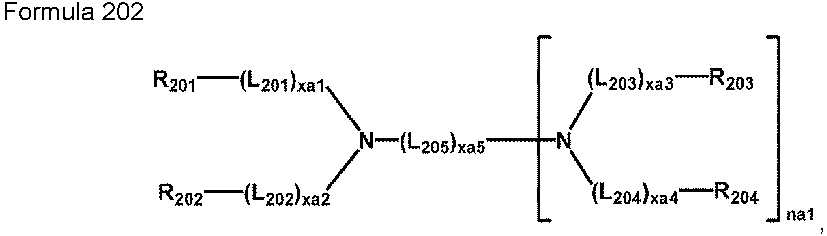 wherein, in Formulae 201 and 202,
L₂₀₁ to L₂₀₄ may each independently be a C₃-C₆₀ (e.g. C₃-C₃₀) carbocyclic group unsubstituted or substituted with at least one R₁₀ₐ or a C₁-C₆₀ (e.g. C₁-C₂₀) heterocyclic group unsubstituted or substituted with at least one R₁₀ₐ,
L₂₀₅ may be *-O-*', *-S-*', *-N(Q₂₀₁)-*', a C₁-C₂₀ (e.g. C₁-C₁₀) alkylene group unsubstituted or substituted with at least one R₁₀ₐ, a C₂-C₂₀ (e.g. C₂-C₁₀) alkenylene group unsubstituted or substituted with at least one R₁₀ₐ, a C₃-C₆₀ (e.g. C₃-C₃₀) carbocyclic group unsubstituted or substituted with at least one R₁₀ₐ, or a C₁-C₆₀ (e.g. C₁-C₂₀) heterocyclic group unsubstituted or substituted with at least one R₁₀ₐ,
xa1 to xa4 may each independently be an integer from 0 to 5,
xa5 may be an integer from 1 to 10,
R₂₀₁ to R₂₀₄ and Q₂₀₁ may each independently be a C₃-C₆₀ (e.g. C₃-C₃₀) carbocyclic group unsubstituted or substituted with at least one R₁₀ₐ, or a C₁-C₆₀ (e.g. C₁-C₂₀) heterocyclic group unsubstituted or substituted with at least one R₁₀ₐ,
R₂₀₁ and R₂₀₂ may optionally be linked to each other via a single bond, a C₁-C₅ alkylene group unsubstituted or substituted with at least one R₁₀ₐ, or a C₂-C₅ alkenylene group unsubstituted or substituted with at least one R₁₀ₐ to form a C₈-C₆₀ (e.g. C₈-C₃₀) polycyclic group (for example, a carbazole group and/or the like) unsubstituted or substituted with at least one R₁₀ₐ (for example, see Compound HT16),
R₂₀₃ and R₂₀₄ may optionally be linked to each other, via a single bond, a C₁-C₅ alkylene group unsubstituted or substituted with at least one R₁₀ₐ, or a C₂-C₅ alkenylene group unsubstituted or substituted with at least one R₁₀ₐ, to form a C₈-C₆₀ (e.g. C₈-C₃₀) polycyclic group unsubstituted or substituted with at least one R₁₀ₐ, and
na1 may be an integer from 1 to 4.

For example, each of Formulae 201 and 202 may include at least one selected from among groups represented by Formulae CY201 to CY217:

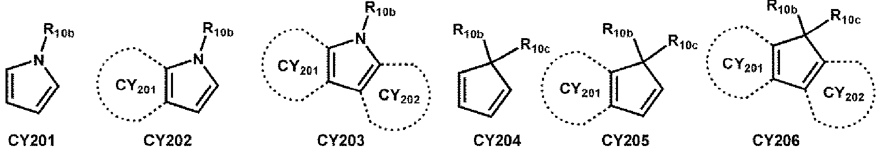

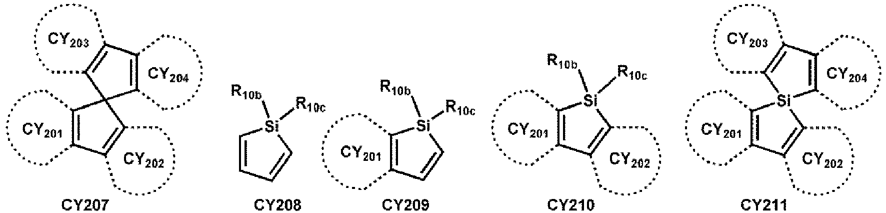

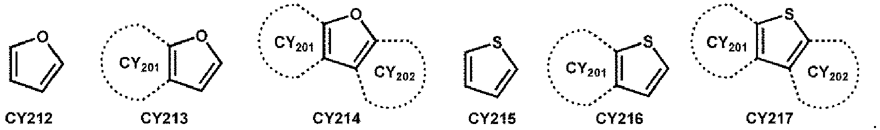

R_{10b} and R_{10c} in Formulae CY201 to CY217 may each independently be the same as described in connection with R₁₀ₐ, ring CY₂₀₁ to ring CY₂₀₄ may each independently be a C₃-C₂₀ carbocyclic group or a C₁-C₂₀ heterocyclic group, and at least one hydrogen in Formulae CY201 to CY217 may be unsubstituted or substituted with R₁₀ₐ.

In one or more embodiments, ring CY₂₀₁ to ring CY₂₀₄ in Formulae CY201 to CY217 may each independently be a benzene group, a naphthalene group, a phenanthrene group, or an anthracene group.

In one or more embodiments, each of Formulae 201 and 202 may include at least one selected from among groups represented by Formulae CY201 to CY203.

In one or more embodiments, Formula 201 may include at least one of the groups represented by Formulae CY201 to CY203 and at least one of the groups represented by Formulae CY204 to CY217.

In one or more embodiments, in Formula 201, xa1 may be 1, R₂₀₁ may be a group represented by one of Formulae CY201 to CY203, xa2 may be 0, and R₂₀₂ may be a group represented by one of Formulae CY204 to CY207.

In one or more embodiments, each of Formulae 201 and 202 may not include (e.g., may exclude) a group represented by one of Formulae CY201 to CY203.

In one or more embodiments, each of Formulae 201 and 202 may not include (e.g., may exclude) a group represented by one of Formulae CY201 to CY203, and may include at least one selected from among the groups represented by Formulae CY204 to CY217.

In one or more embodiments, each of Formulae 201 and 202 may not include (e.g., may exclude) a group represented by one of Formulae CY201 to CY217.

In one or more embodiments, the hole transport region may include one selected from among Compounds HT1 to HT46, m-MTDATA, TDATA, 2-TNATA, NPB(NPD), β-NPB, TPD, Spiro-TPD, Spiro-NPB, methylated NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), and/or a combination thereof:

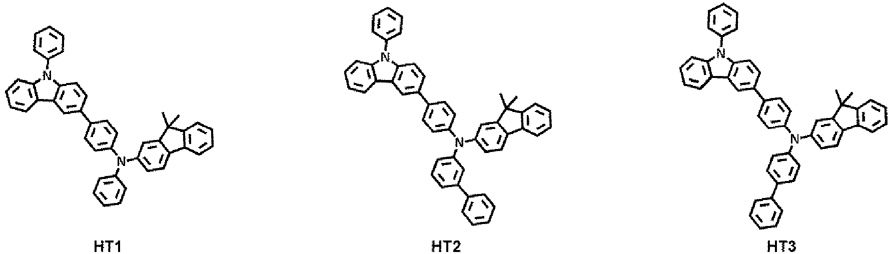

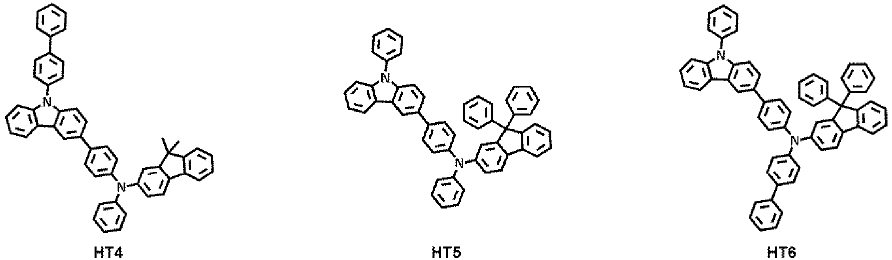

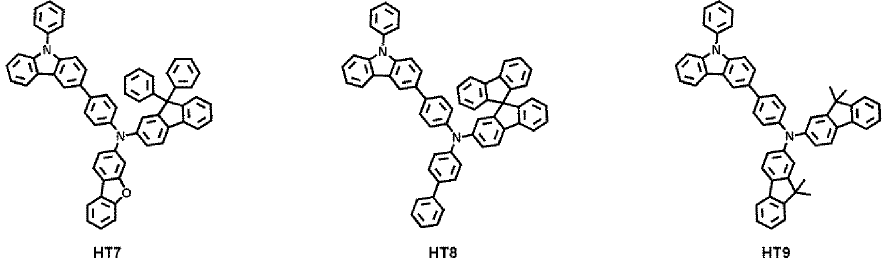

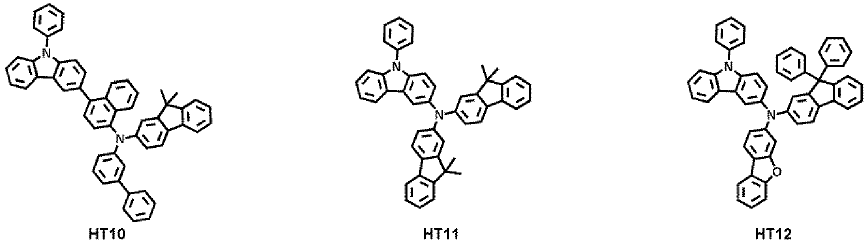

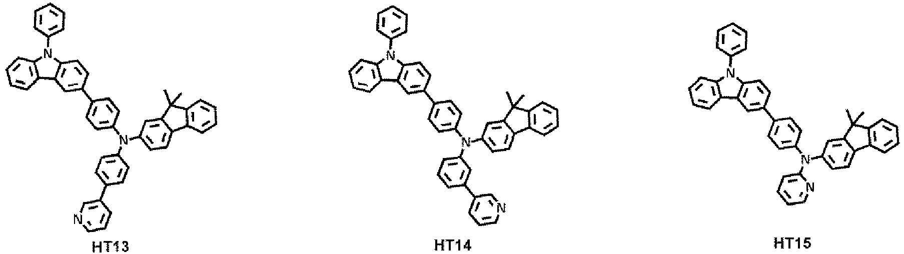

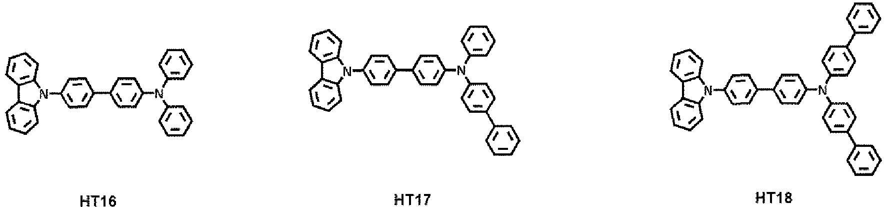

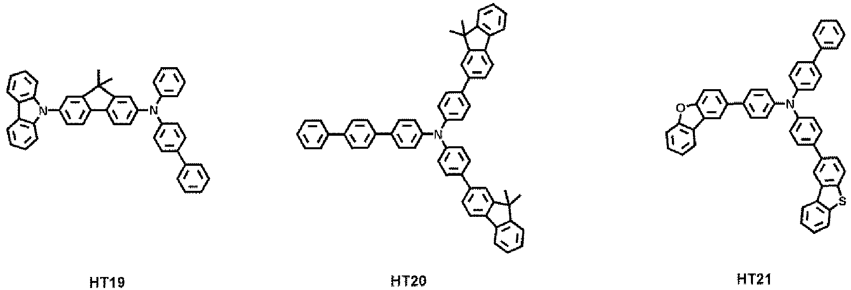

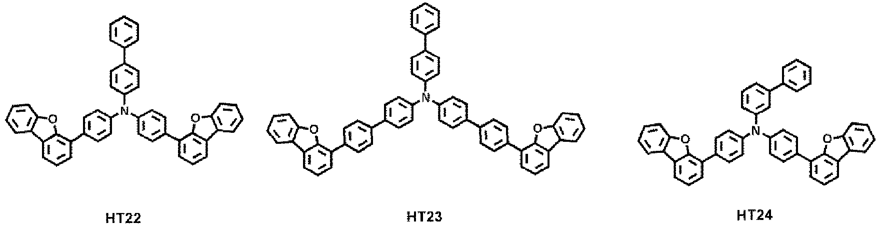

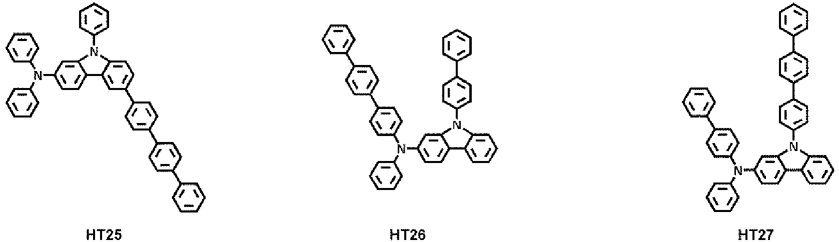

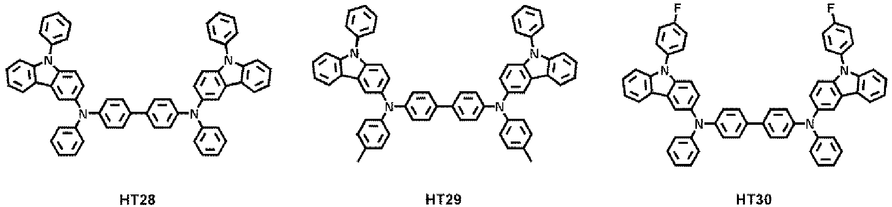

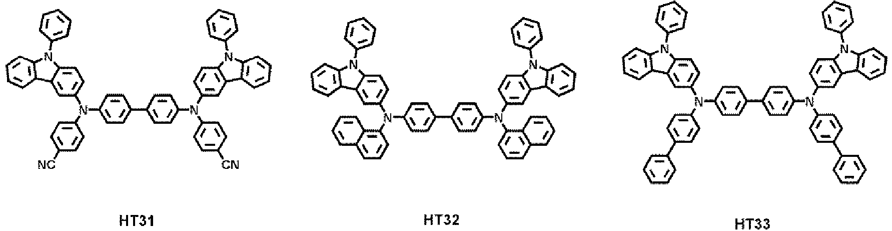

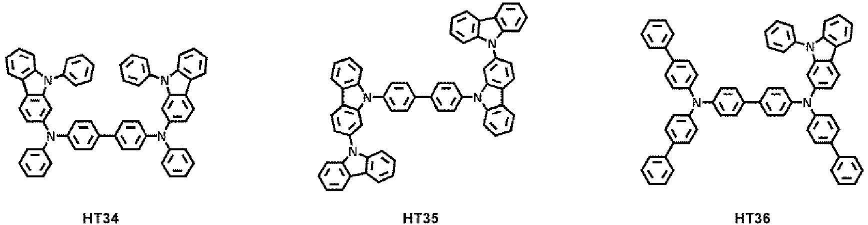

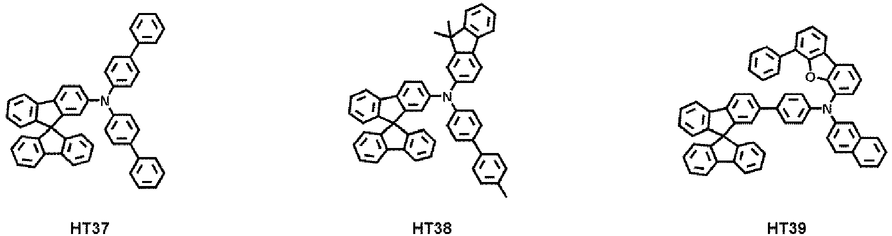

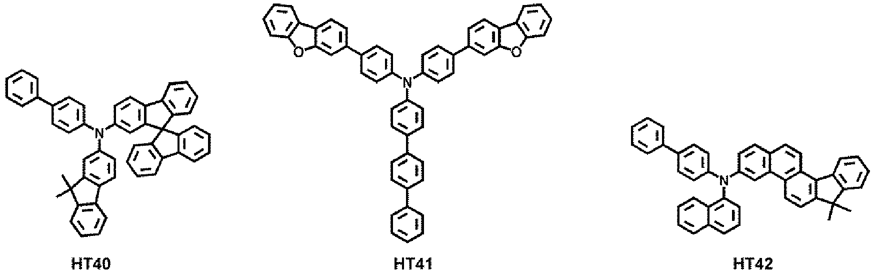

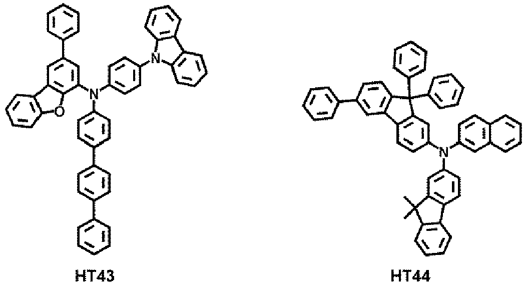

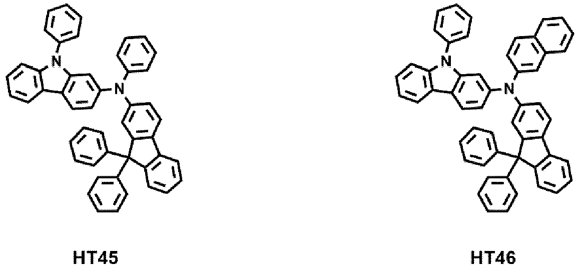

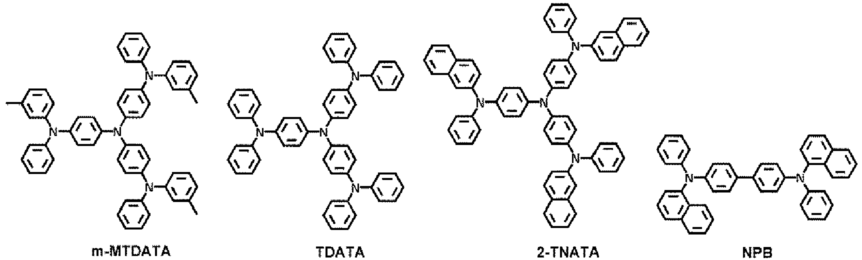

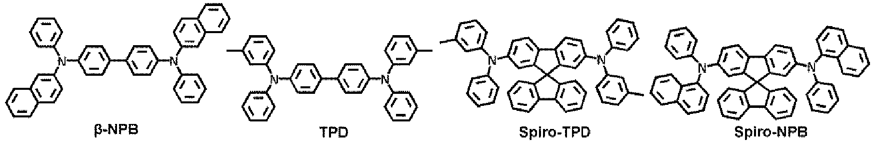

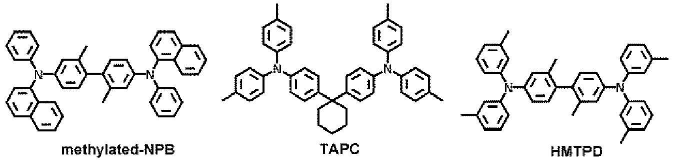

A thickness of the hole transport region may be in a range of about 50 angstrom (Å) to about 10,000 Å, for example, about 100 Å to about 4,000 Å. When the hole transport region includes a hole injection layer, a hole transport layer, or a combination thereof, a thickness of the hole injection layer may be in a range of about 100 Å to about 9,000 Å, for example, about 100 Å to about 1,000 Å, and a thickness of the hole transport layer may be in a range of about 50 Å to about 2,000 Å, for example, about 100 Å to about 1,500 Å. When the thicknesses of the hole transport region, the hole injection layer, and the hole transport layer are within these ranges, satisfactory hole transporting characteristics may be obtained without a substantial increase in driving voltage.

The emission auxiliary layer may increase light-emission efficiency by compensating for an optical resonance distance according to the wavelength of light emitted by an emission layer. In one or more embodiments, the electron blocking layer may block or reduce the leakage of electrons from an emission layer to a hole transport region. Materials that may be included in the hole transport region may be included in the emission auxiliary layer and the electron blocking layer.

### p-dopant

The hole transport region may further include, in addition to these materials, a charge-generation material for the improvement of conductive properties. The charge-generation material may be uniformly or non-uniformly dispersed in the hole transport region (for example, in the form of a single layer consisting of a charge-generation material).

The charge-generation material may be, for example, a p-dopant.

For example, the lowest unoccupied molecular orbital (LUMO) energy level of the p-dopant may be -3.5 eV or less.

In one or more embodiments, the p-dopant may include a quinone derivative, a cyano group-containing compound, a compound including element EL1 and element EL2, or a combination thereof.

Examples of the quinone derivative are TCNQ, F4-TCNQ, and/or the like.

Examples of the cyano group-containing compound are HAT-CN and a compound represented by Formula 221.

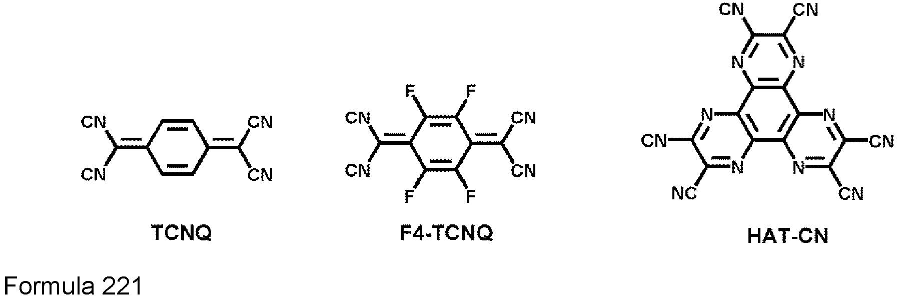

In Formula 221, 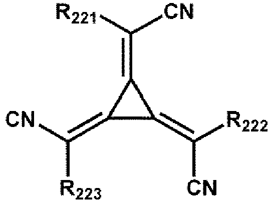
R₂₂₁ to R₂₂₃ may each independently be a C₃-C₆₀ (e.g. C₃-C₃₀) carbocyclic group unsubstituted or substituted with at least one R₁₀ₐ or a C₁-C₆₀ (e.g. C₁-C₂₀) heterocyclic group unsubstituted or substituted with at least one R₁₀ₐ, and
at least one of R₂₂₁ to R₂₂₃ may each independently be a C₃-C₆₀ (e.g. C₃-C₃₀) carbocyclic group or a C₁-C₆₀ (e.g. C₁-C₂₀) heterocyclic group, each substituted with a cyano group; -F; -Cl; -Br; -I; a C₁-C₂₀ alkyl group substituted with a cyano group, -F, - Cl, -Br, -I, or a combination thereof; or a combination thereof.

In the compound including element EL1 and element EL2, element EL1 may be metal, metalloid, or a combination thereof, and element EL2 may be non-metal, metalloid, or a combination thereof.

Examples of the metal are an alkali metal (for example, lithium (Li), sodium (Na), potassium (K), rubidium (Rb), cesium (Cs), etc.); alkaline earth metal (for example, beryllium (Be), magnesium (Mg), calcium (Ca), strontium (Sr), barium (Ba), etc.); a transition metal (for example, titanium (Ti), zirconium (Zr), hafnium (Hf), vanadium (V), niobium (Nb), tantalum (Ta), chromium (Cr), molybdenum (Mo), tungsten (W), manganese (Mn), technetium (Tc), rhenium (Re), iron (Fe), ruthenium (Ru), osmium (Os), cobalt (Co), rhodium (Rh), iridium (Ir), nickel (Ni), palladium (Pd), platinum (Pt), copper (Cu), silver (Ag), gold (Au), etc.); a post-transition metal (for example, zinc (Zn), indium (In), tin (Sn), etc.); a lanthanide metal (for example, lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), lutetium (Lu), etc.) and/or the like..

Examples of the metalloid are silicon (Si), antimony (Sb), tellurium (Te) and/or the like.

Examples of the non-metal are oxygen (O), halogen (for example, F, Cl, Br, I, etc.), and/or the like.

Examples of the compound including element EL1 and element EL2 are metal oxide, metal halide (for example, metal fluoride, metal chloride, metal bromide, or metal iodide), metalloid halide (for example, metalloid fluoride, metalloid chloride, metalloid bromide, or metalloid iodide), metal telluride, or a combination thereof.

Examples of the metal oxide are tungsten oxide (for example, WO, W₂O₃, WO₂, WO₃, W₂O₅, etc.), vanadium oxide (for example, VO, V₂O₃, VO₂, V₂O₅, etc.), molybdenum oxide (MoO, Mo₂O₃, MoO₂, MoO₃, Mo₂O₅, etc.), rhenium oxide (for example, ReO₃, etc.), and/or the like.

Examples of the metal halide are alkali metal halide, alkaline earth metal halide, transition metal halide, post-transition metal halide, and lanthanide metal halide.

Examples of the alkali metal halide are LiF, NaF, KF, RbF, CsF, LiCl, NaCl, KCI, RbCl, CsCl, LiBr, NaBr, KBr, RbBr, CsBr, Lil, Nal, KI, Rbl, and Csl.

Examples of the alkaline earth metal halide are BeF₂, MgF₂, CaF₂, SrF₂, BaF₂, BeCl₂, MgCl₂, CaCl₂, SrCl₂, BaCl₂, BeBr₂, MgBr₂, CaBr₂, SrBr₂, BaBr₂, BeI₂, MgI₂, CaI₂, SrI₂, and BaI₂.

Examples of the transition metal halide are titanium halide (for example, TiF₄, TiCl₄, TiBr₄, TiI₄, etc.), zirconium halide (for example, ZrF₄, ZrCl₄, ZrBr₄, ZrI₄, etc.), hafnium halide (for example, HfF₄, HfCl₄, HfBr₄, HfI₄, etc.), vanadium halide (for example, VF₃, VCl₃, VBr₃, VI₃, etc.), niobium halide (for example, NbF₃, NbCl₃, NbBr₃, NbI₃, etc.), tantalum halide (for example, TaF₃, TaCl₃, TaBr₃, TaI₃, etc.), chromium halide (for example, CrF₃, CrCl₃, CrBr₃, CrI₃, etc.), molybdenum halide (for example, MoF₃, MoCl₃, MoBr₃, MoI₃, etc.), tungsten halide (for example, WF₃, WCl₃, WBr₃, WI₃, etc.), manganese halide (for example, MnF₂, MnCl₂, MnBr₂, MnI₂, etc.), technetium halide (for example, TcF₂, TcCl₂, TcBr₂, TcI₂, etc.), rhenium halide (for example, ReF₂, ReCl₂, ReBr₂, ReI₂, etc.), iron halide (for example, FeF₂, FeCl₂, FeBr₂, FeI₂, etc.), ruthenium halide (for example, RuF₂, RuCl₂, RuBr₂, RuI₂, etc.), osmium halide (for example, OsF₂, OsCl₂, OsBr₂, OsI₂, etc.), cobalt halide (for example, CoF₂, CoCl₂, CoBr₂, CoI₂, etc.), rhodium halide (for example, RhF₂, RhCl₂, RhBr₂, RhI₂, etc.), iridium halide (for example, IrF₂, IrCl₂, IrBr₂, IrI₂, etc.), nickel halide (for example, NiF₂, NiCl₂, NiBr₂, NiI₂, etc.), palladium halide (for example, PdF₂, PdCl₂, PdBr₂, PdI₂, etc.), platinum halide (for example, PtF₂, PtCl₂, PtBr₂, PtI₂, etc.), copper halide (for example, CuF, CuCl, CuBr, Cul, etc.), silver halide (for example, AgF, AgCl, AgBr, AgI, etc.), and gold halide (for example, AuF, AuCl, AuBr, Aul, etc.).

Examples of the post-transition metal halide are zinc halide (for example, ZnF₂, ZnCl₂, ZnBr₂, ZnI₂, etc.), indium halide (for example, InI₃, etc.), and tin halide (for example, SnI₂, etc.).

Examples of the lanthanide metal halide may include YbF, YbF₂, YbF₃, SmF₃, YbCl, YbCl₂, YbCl₃ SmCl₃, YbBr, YbBr₂, YbBr₃, SmBr₃, Ybl, YbI₂, YbI₃, SmI₃, and/or the like.

An example of the metalloid halide is antimony halide (for example, SbCl₅, etc.).

Examples of the metal telluride are alkali metal telluride (for example, Li₂Te, Na₂Te, K₂Te, Rb₂Te, Cs₂Te, etc.), alkaline earth metal telluride (for example, BeTe, MgTe, CaTe, SrTe, BaTe, etc.), transition metal telluride (for example, TiTe₂, ZrTe₂, HfTe₂, V₂Te₃, Nb₂Te₃, Ta₂Te₃, Cr₂Te₃, Mo₂Te₃, W₂Te₃, MnTe, TcTe, ReTe, FeTe, RuTe, OsTe, CoTe, RhTe, IrTe, NiTe, PdTe, PtTe, Cu₂Te, CuTe, Ag₂Te, AgTe, Au₂Te, etc.), post-transition metal telluride (for example, ZnTe, etc.), and lanthanide metal telluride (for example, LaTe, CeTe, PrTe, NdTe, PmTe, EuTe, GdTe, TbTe, DyTe, HoTe, ErTe, TmTe, YbTe, LuTe, etc.).

### Emission layer in interlayer 130

When the light-emitting device 10 is a full-color light-emitting device, the emission layer may be patterned into a red emission layer, a green emission layer, and/or a blue emission layer, according to a sub-pixel. In one or more embodiments, the emission layer may have a stacked structure of two or more layers of a red emission layer, a green emission layer, and a blue emission layer, in which the two or more layers contact each other or are separated from each other to emit white light. In one or more embodiments, the emission layer may include two or more materials of a red light-emitting material, a green light-emitting material, and a blue light-emitting material, in which the two or more materials are mixed with each other in a single layer to emit white light.

In one or more embodiments, the emission layer may include a host and a dopant (or emitter). In one or more embodiments, the emission layer may further include an auxiliary dopant that promotes energy transfer to a dopant (or emitter), in addition to the host and the dopant (or emitter). When the emission layer includes the dopant (or emitter) and the auxiliary dopant, the dopant (or emitter) and the auxiliary dopant are different from each other.

The organometallic compound represented by Formula 1 in the present specification may serve as the dopant (or emitter), or may serve as the auxiliary dopant.

An amount of the dopant (or emitter) in the emission layer may be in a range of about 0.01 parts by weight to about 15 parts by weight based on 100 parts by weight of the host.

The emission layer may include the organometallic compound represented by Formula 1. The amount (weight) of the organometallic compound in the emission layer may be about 0.01 parts by weight to about 30 parts by weight, about 0.1 parts by weight to about 20 parts by weight, or about 0.1 parts by weight to about 15 parts by weight based on 100 parts by weight of the emission layer.

A thickness of the emission layer may be in a range of about 100 Å to about 1,000 Å, for example, about 200 Å to about 600 Å. When the thickness of the emission layer is within these ranges, excellent or suitable light-emission characteristics may be obtained without a substantial increase in driving voltage.

### Host

The host in the emission layer may include the second compound or the third compound described in the present specification, or a combination thereof.

In one or more embodiments, the host may include a compound represented by Formula 301:

Formula 301 [Ar₃₀₁]_{xb11}-[(L₃₀₁)_{xb1}-R₃₀₁]_{xb21}.

In Formula 301,
Ar₃₀₁ and L₃₀₁ may each independently be a C₃-C₆₀ (*e.g*. C₃-C₃₀) carbocyclic group unsubstituted or substituted with at least one R₁₀ₐ or a C₁-C₆₀ (*e.g*. C₁-C₂₀) heterocyclic group unsubstituted or substituted with at least one R₁₀ₐ,
xb11 may be 1, 2, or 3,
xb1 may be an integer from 0 to 5,
R₃₀₁ may be hydrogen, deuterium, -F, -Cl, -Br, -I, a hydroxyl group, a cyano group, a nitro group, a C₁-C₆₀ (*e.g*. C₁-C₂₀) alkyl group unsubstituted or substituted with at least one R₁₀ₐ, a C₂-C₆₀ (*e.g*. C₂-C₂₀) alkenyl group unsubstituted or substituted with at least one R₁₀ₐ, a C₂-C₆₀ (*e.g*. C₂-C₂₀) alkynyl group unsubstituted or substituted with at least one R₁₀ₐ, a C₁-C₆₀ (*e.g*. C₁-C₂₀) alkoxy group unsubstituted or substituted with at least one R₁₀ₐ, a C₃-C₆₀ (*e.g*. C₃-C₃₀) carbocyclic group unsubstituted or substituted with at least one R₁₀ₐ, a C₁-C₆₀ (*e.g*. C₁-C₂₀) heterocyclic group unsubstituted or substituted with at least one R₁₀ₐ,-Si(Q₃₀₁)(Q₃₀₂)(Q₃₀₃), -N(Q₃₀₁)(Q₃₀₂), -B(Q₃₀₁)(Q₃₀₂), - C(=O)(Q₃₀₁), -S(=O)₂(Q₃₀₁), or -P(=O)(Q₃₀₁)(Q₃₀₂),
xb21 may be an integer from 1 to 5, and
Q₃₀₁ to Q₃₀₃ are each the same as described herein with respect to Q₁.

For example, when xb11 in Formula 301 is 2 or more, two or more of Ar₃₀₁(s) may be linked to each other via a single bond.

In one or more embodiments, the host may include a compound represented by Formula 301-1, a compound represented by Formula 301-2, or a combination thereof:

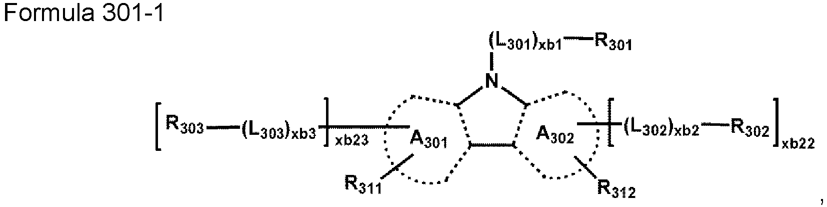

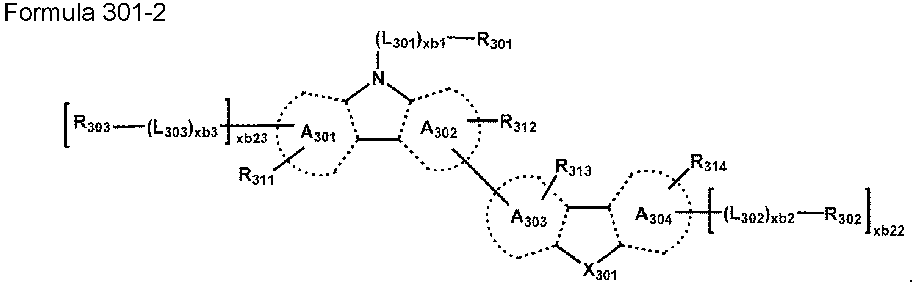

In Formulae 301-1 and 301-2,
ring A₃₀₁ to ring A₃₀₄ may each independently be a C₃-C₆₀ (*e.g*. C₃-C₃₀) carbocyclic group unsubstituted or substituted with at least one R₁₀ₐ or a C₁-C₆₀ (*e.g*. C₁-C₂₀) heterocyclic group unsubstituted or substituted with at least one R₁₀ₐ,
X₃₀₁ may be O, S, N-[(L₃₀₄)_{xb4}-R₃₀₄], C(R₃₀₄)(R₃₀₅), or Si(R₃₀₄)(R₃₀₅),
xb22 and xb23 may each independently be 0, 1, or 2,
L₃₀₁, xb1, and R₃₀₁ may each be the same as described herein,
L₃₀₂ to L₃₀₄ may each independently be the same as described herein with respect to with L₃₀₁,
xb2 to xb4 may each independently be the same as described herein with respect to xb1, and
R₃₀₂ to R₃₀₅ and R₃₁₁ to R₃₁₄ may each be the same as described herein with respect to R₃₀₁.

In one or more embodiments, the host may include an alkali earth metal complex, a post-transition metal complex, or a combination thereof. For example, the host may include a Be complex (for example, Compound H55), an Mg complex, a Zn complex, or a combination thereof.

In one or more embodiments, the host may include at least one of Compounds H1 to H130, 9,10-di(2-naphthyl)anthracene (ADN), 2-methyl-9,10-bis(naphthalen-2-yl)anthracene (MADN), 9,10-di(2-naphthyl)-2-t-butyl-anthracene (TBADN), 4,4'-bis(N-carbazolyl)-1,1'-biphenyl (CBP), 1,3-di-9-carbazolylbenzene (mCP), 1,3,5-tri(carbazol-9-yl)benzene (TCP), or a combination thereof:

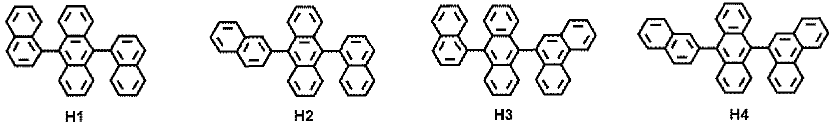

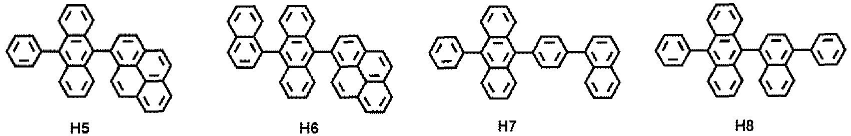

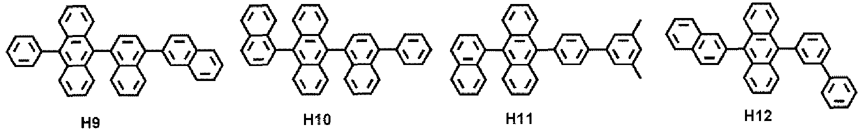

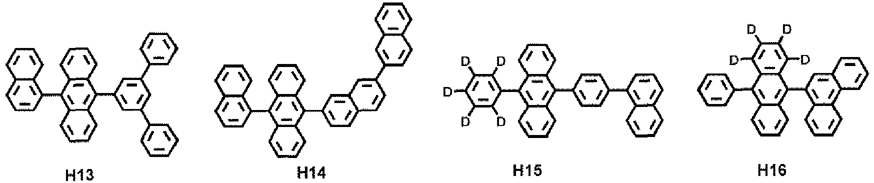

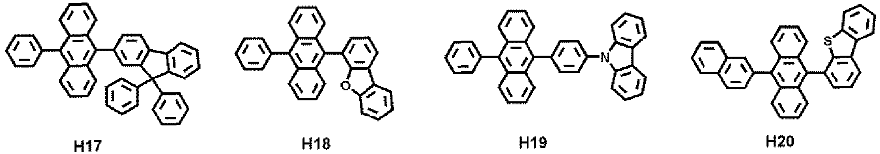

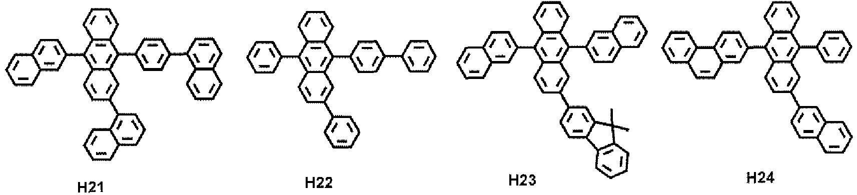

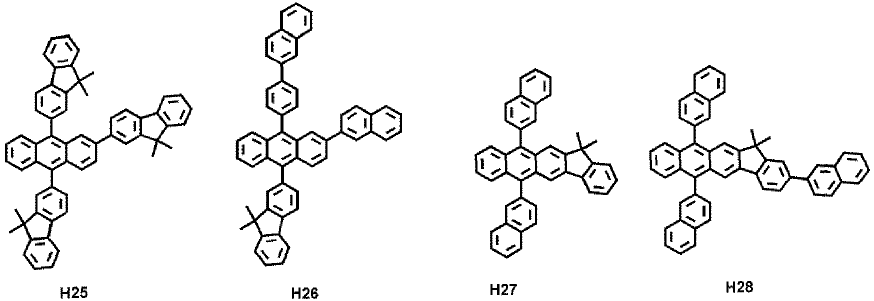

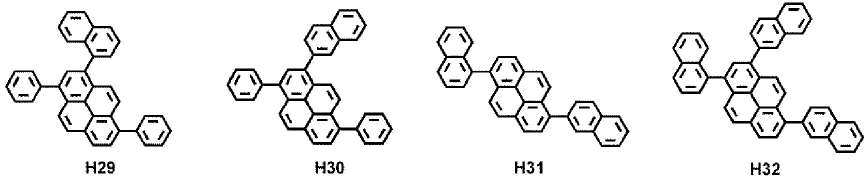

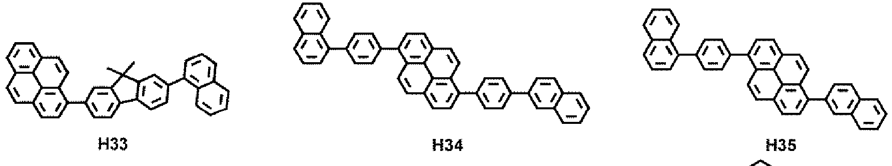

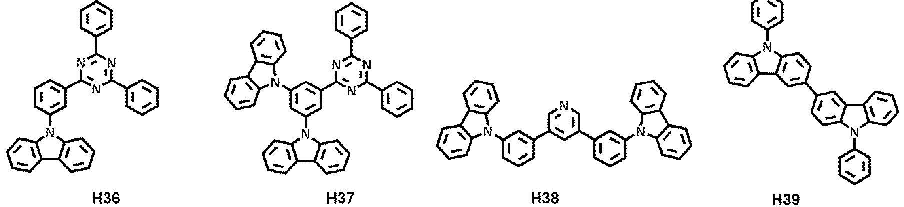

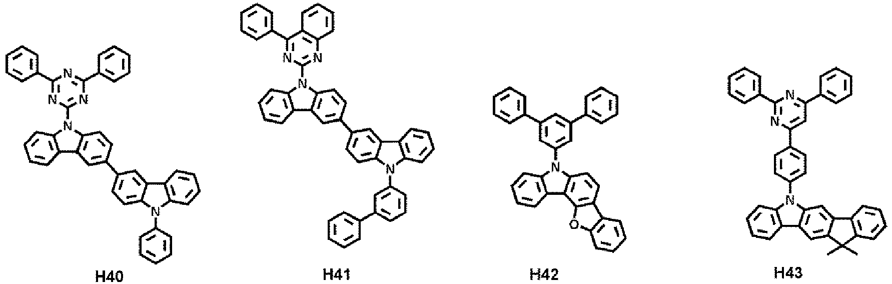

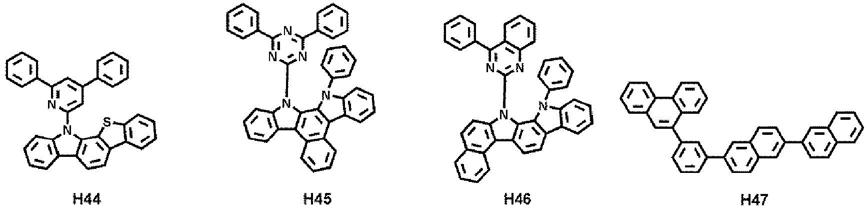

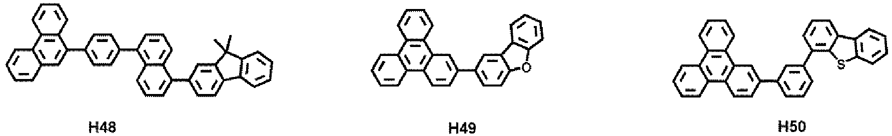

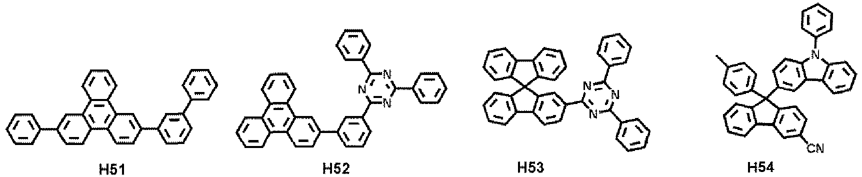

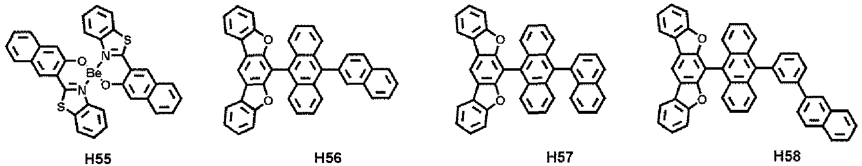

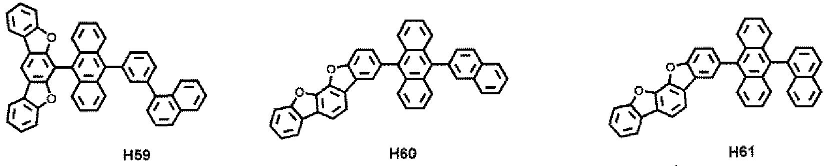

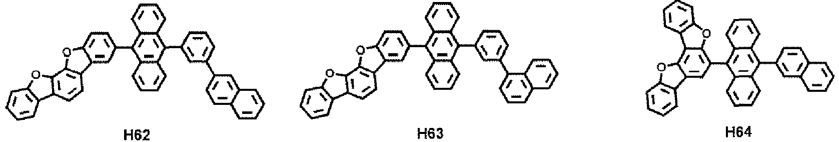

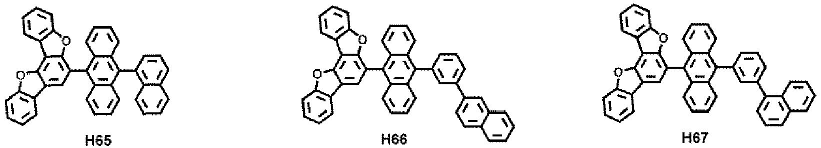

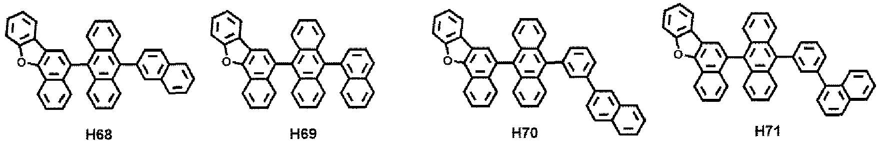

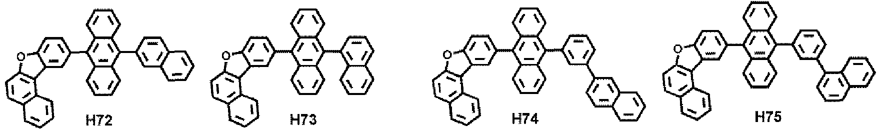

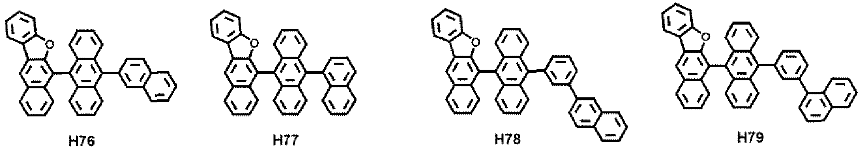

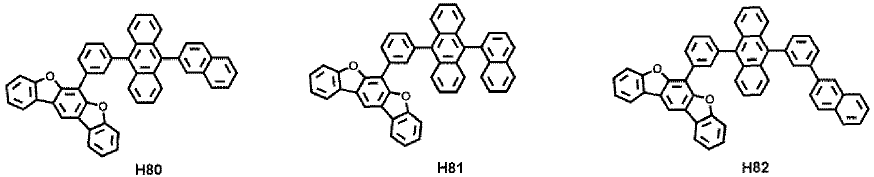

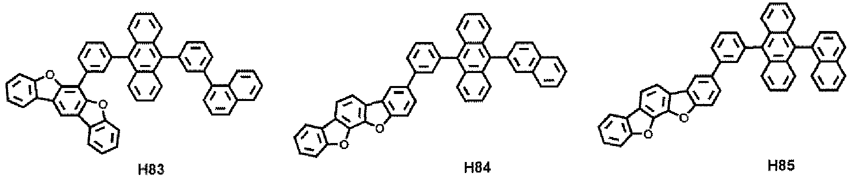

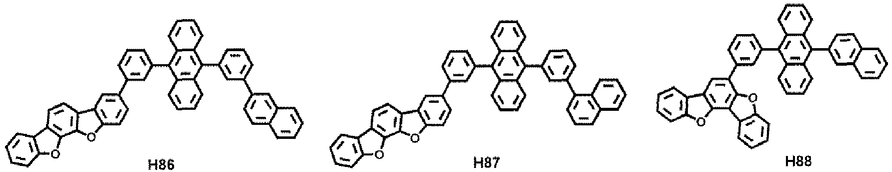

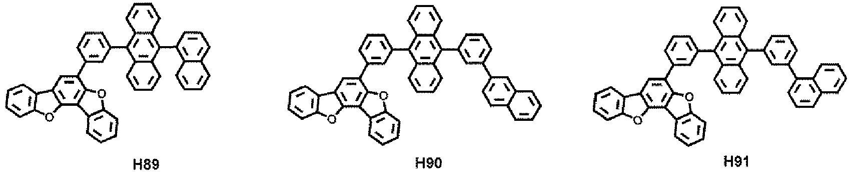

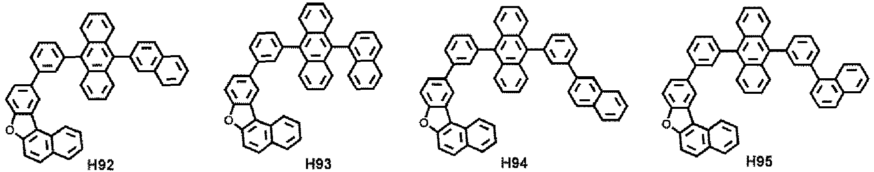

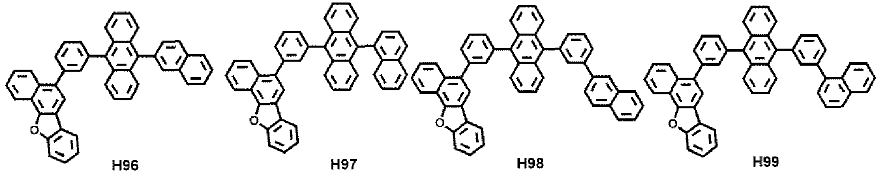

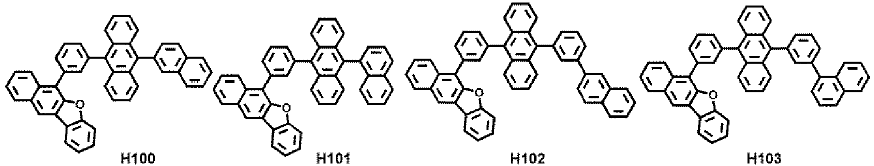

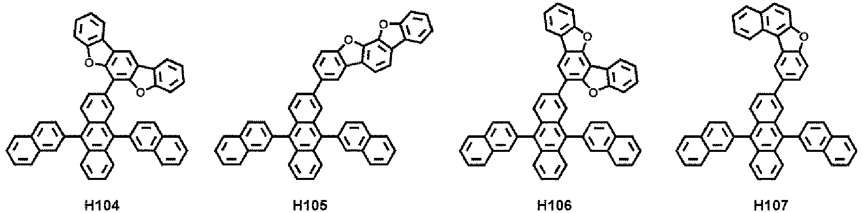

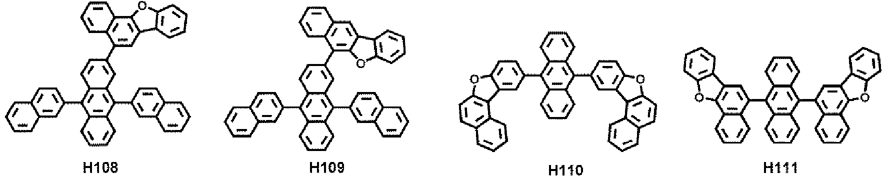

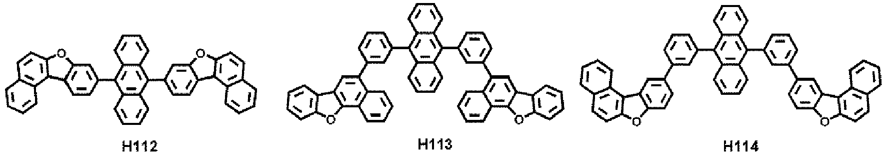

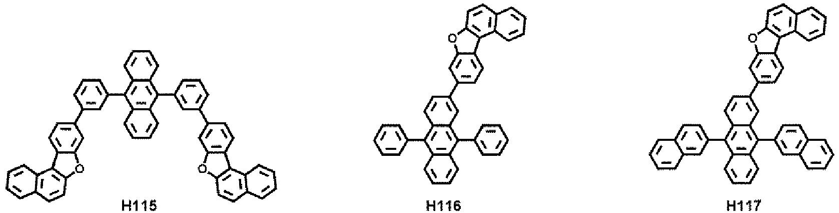

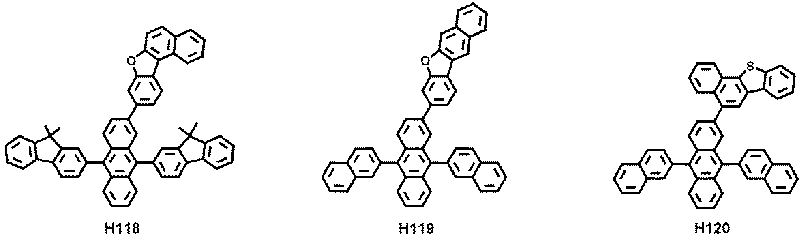

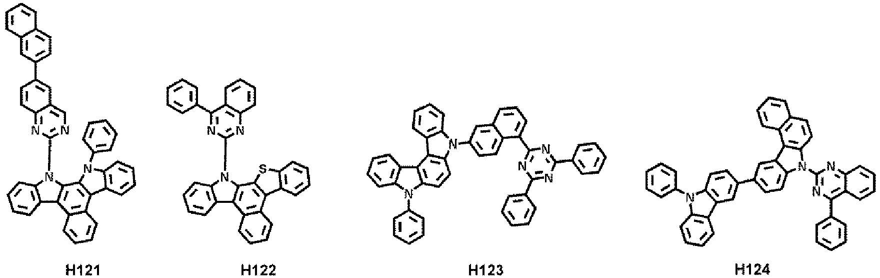

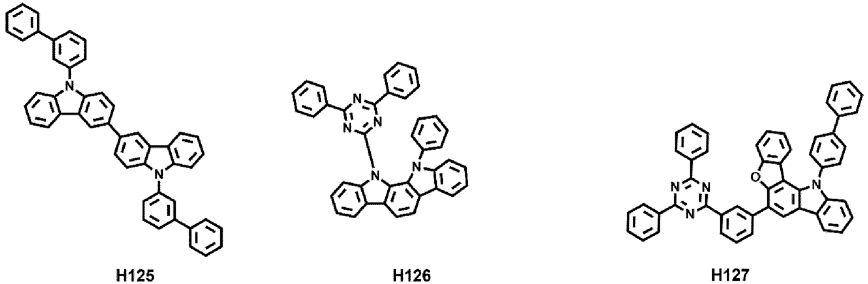

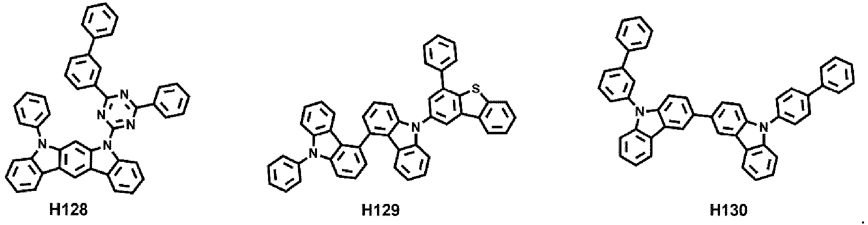

In one or more embodiments, the host may include a silicon-containing compound, a phosphine oxide-containing compound, or a combination thereof.

The host may have one or more suitable modifications. For example, the host may include only one kind of compound, or may include two or more kinds of different compounds.

### Phosphorescent dopant

The emission layer may include, as a phosphorescent dopant, the organometallic compound represented by Formula 1 as described in the present specification.

In one or more embodiments, the emission layer may include an organometallic compound represented by Formula 1, and when the organometallic compound represented by Formula 1 functions as an auxiliary dopant, the emission layer may include a phosphorescent dopant.

In one or more embodiments, the phosphorescent dopant may include at least one transition metal as a central metal.

The phosphorescent dopant may include a monodentate ligand, a bidentate ligand, a tridentate ligand, a tetradentate ligand, a pentadentate ligand, a hexadentate ligand, or a combination thereof.

The phosphorescent dopant may be electrically neutral.

For example, the phosphorescent dopant may include an organometallic compound represented by Formula 401:

Formula 401 M(L₄₀₁)_{xc1}(L₄₀₂)_{xc2},

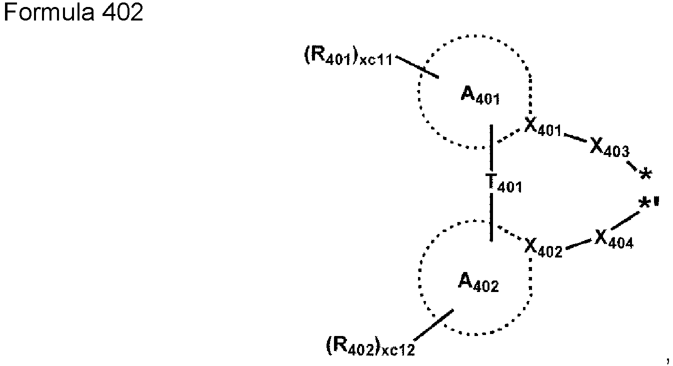

wherein, in Formulae 401 and 402,
M may be a transition metal (for example, iridium (Ir), platinum (Pt), palladium (Pd), osmium (Os), titanium (Ti), gold (Au), hafnium (Hf), europium (Eu), terbium (Tb), rhodium (Rh), rhenium (Re), or thulium (Tm)),
L₄₀₁ may be a ligand represented by Formula 402, and xc1 may be 1, 2, or 3, wherein when xc1 is two or more, two or more of L₄₀₁(s) may be identical to or different from each other,
L₄₀₂ may be an organic ligand, and xc2 may be 0, 1, 2, 3, or 4, and when xc2 is 2 or more, two or more of L₄₀₂(s) may be identical to or different from each other,
X₄₀₁ and X₄₀₂ may each independently be nitrogen or carbon,
rings A₄₀₁ and A₄₀₂ may each independently be a C₃-C₆₀ (*e.g*. C₃-C₃₀) carbocyclic group or a C₁-C₆₀ (*e.g*. C₁-C₂₀) heterocyclic group,
T₄₀₁ may be a single bond, *-O-*', *-S-*', *-C(=O)-*', *-N(Q₄₁₁)-*', *-C(Q₄₁₁)(Q₄₁₂)-*', *-C(Q₄₁₁)=C(Q₄₁₂)-*', *-C(Q₄₁₁)=*', or *=C=*',
X₄₀₃ and X₄₀₄ may each independently be a chemical bond (for example, a covalent bond or a coordination bond), O, S, N(Q₄₁₃), B(Q₄₁₃), P(Q₄₁₃), C(Q₄₁₃)(Q₄₁₄), or Si(Q₄₁₃)(Q₄₁₄),
Q₄₁₁ to Q₄₁₄ may each be the same as described herein with respect to Q₁,
R₄₀₁ and R₄₀₂ may each independently be hydrogen, deuterium, -F, -Cl, -Br, - I, a hydroxyl group, a cyano group, a nitro group, a C₁-C₂₀ alkyl group unsubstituted or substituted with at least one R₁₀ₐ, a C₁-C₂₀ alkoxy group unsubstituted or substituted with at least one R₁₀ₐ, a C₃-C₆₀ (*e.g.* C₃-C₃₀) carbocyclic group unsubstituted or substituted with at least one R₁₀ₐ, a C₁-C₆₀ (*e.g.* C₁-C₂₀) heterocyclic group unsubstituted or substituted with at least one R₁₀ₐ, -Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), -S(=O)₂(Q₄₀₁), or -P(=O)(Q₄₀₁)(Q₄₀₂),
Q₄₀₁ to Q₄₀₃ may each be the same as described herein with respect to Q₁,
xc11 and xc12 may each independently be an integer from 0 to 10, and
* and *' in Formula 402 each indicate a binding site to M in Formula 401.

For example, in Formula 402, i) X₄₀₁ may be nitrogen, and X₄₀₂ may be carbon, or ii) each of X₄₀₁ and X₄₀₂ may be nitrogen.

In one or more embodiments, when xc1 in Formula 402 is 2 or more, two ring A₄₀₁(s) in two or more of L₄₀₁(s) may be optionally linked to each other via T₄₀₂, which is a linking group, or two ring A₄₀₂(s) may be optionally linked to each other via T₄₀₃, which is a linking group (see Compounds PD1 to PD4 and PD7). T₄₀₂ and T₄₀₃ may each be the same as described herein with respect to T₄₀₁.

L₄₀₂ in Formula 401 may be an organic ligand. For example, L₄₀₂ may include a halogen group, a diketone group (for example, an acetylacetonate group), a carboxylic acid group (for example, a picolinate group), -C(=O), an isonitrile group, -CN group, a phosphorus group (for example, a phosphine group, a phosphite group, etc.), or a combination thereof.

The phosphorescent dopant may include, for example, at least one of compounds PD1 to PD25, or a combination thereof:

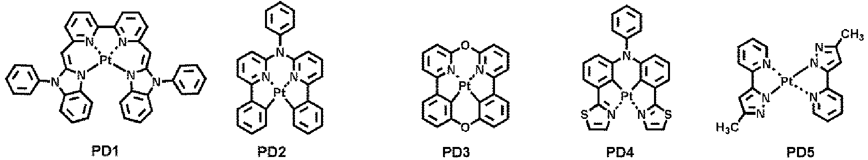

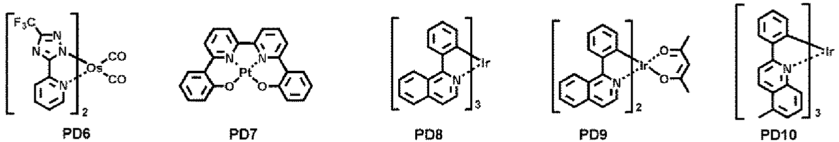

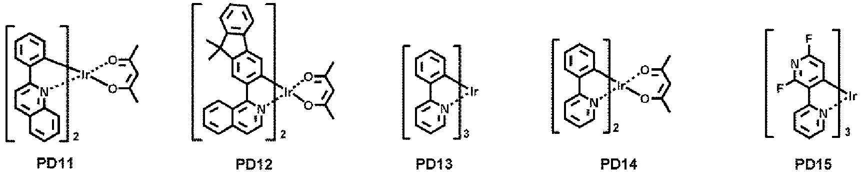

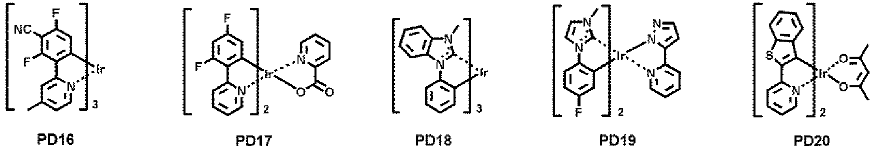

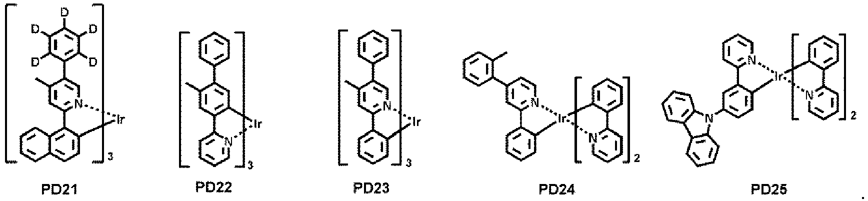

### Fluorescent dopant

In one or more embodiments, the emission layer may include an organometallic compound represented by Formula 1, and when the organometallic compound represented by Formula 1 functions as an auxiliary dopant, the emission layer may further include a fluorescent dopant.

In one or more embodiments, the emission layer may include an organometallic compound represented by Formula 1, and when the organometallic compound represented by Formula 1 functions as a phosphorescent dopant, the emission layer may further include an auxiliary dopant.

The fluorescent dopant and the auxiliary dopant may each independently include an arylamine compound, a styrylamine compound, a boron-containing compound, or a combination thereof.

In one or more embodiments, the fluorescent dopant and the auxiliary dopant may each independently include a compound represented by Formula 501: 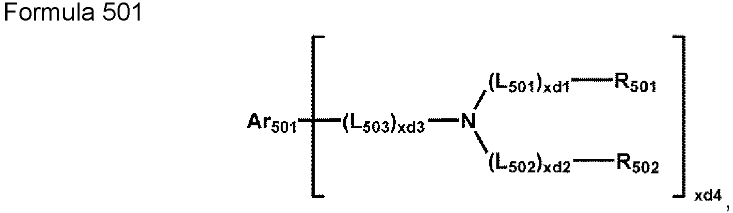 wherein, in Formula 501,
Ar₅₀₁, L₅₀₁ to L₅₀₃, R₅₀₁, and R₅₀₂ may each independently be a C₃-C₆₀ (e.g. C₃-C₃₀) carbocyclic group unsubstituted or substituted with at least one R₁₀ₐ or a C₁-C₆₀ (e.g. C₁-C₂₀) heterocyclic group unsubstituted or substituted with at least one R₁₀ₐ,
xd1 to xd3 may each independently be 0, 1, 2, or 3, and
xd4 may be 1, 2, 3, 4, 5, or 6.

For example, Ar₅₀₁ in Formula 501 may be a condensed cyclic group (for example, an anthracene group, a chrysene group, or a pyrene group) in which three or more monocyclic groups are condensed together.

In one or more embodiments, xd4 in Formula 501 may be 2.

In one or more embodiments, the fluorescent dopant and the auxiliary dopant may each include at least one of Compounds FD1 to FD36, DPVBi, DPAVBi, or a combination thereof:

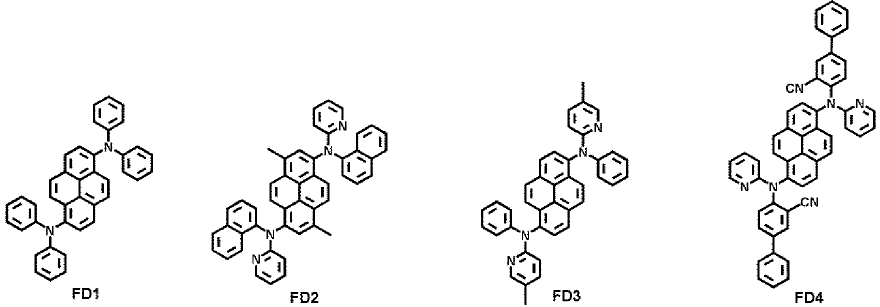

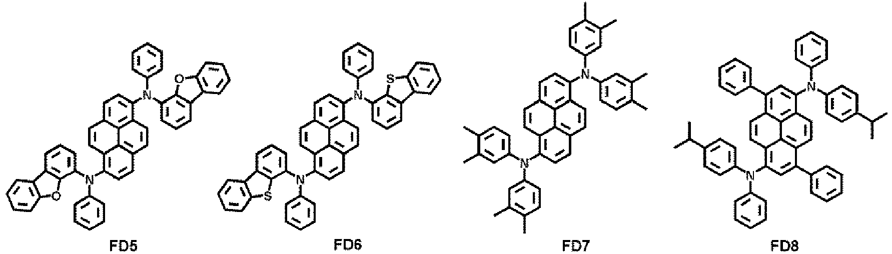

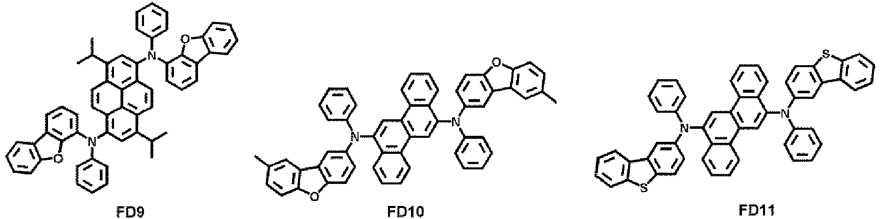

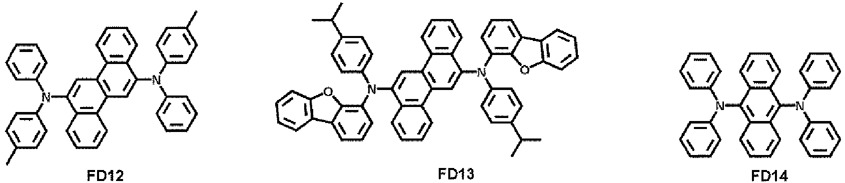

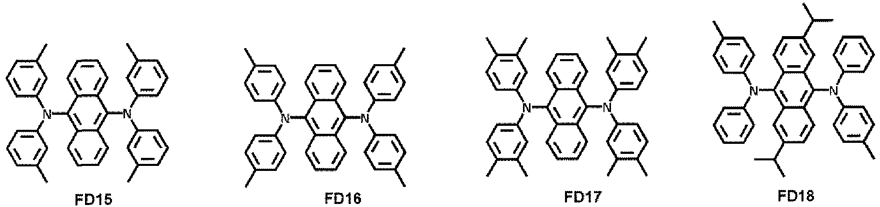

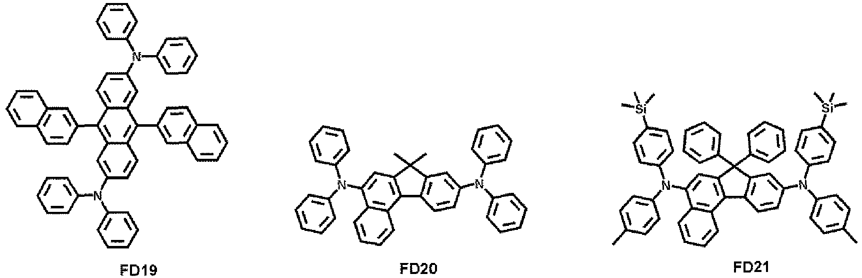

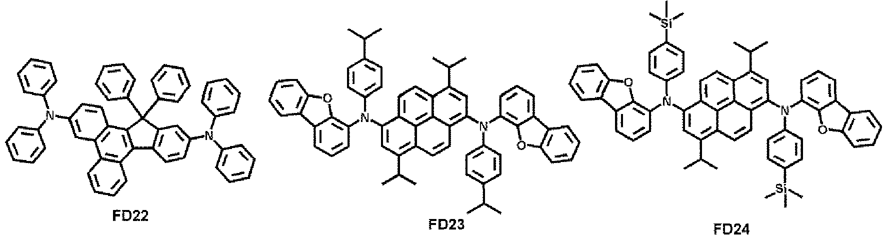

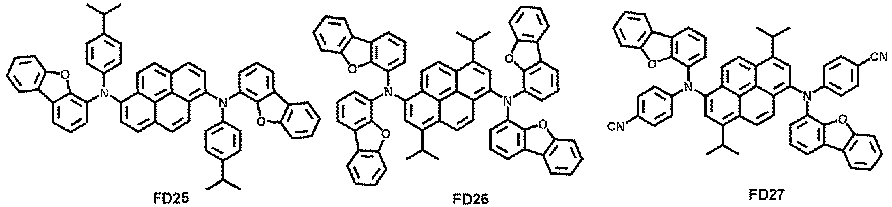

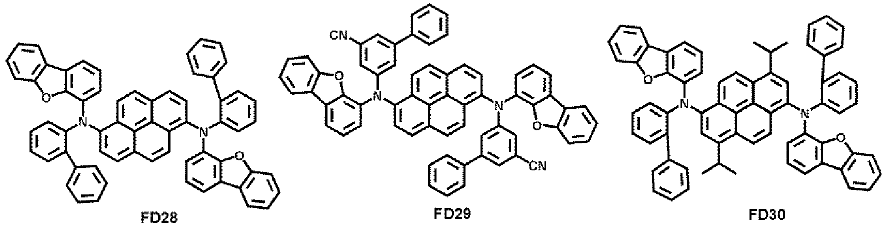

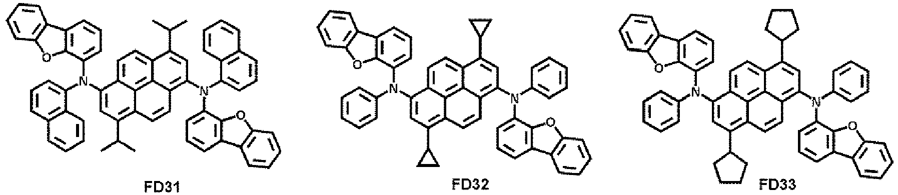

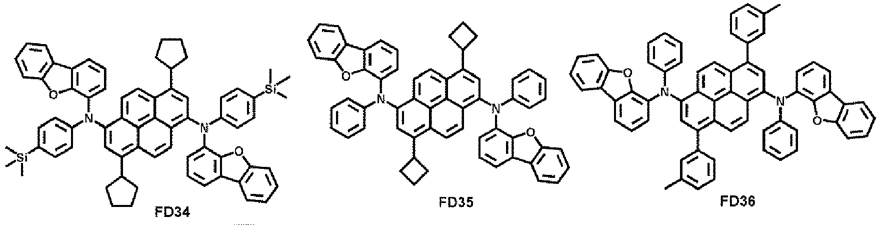

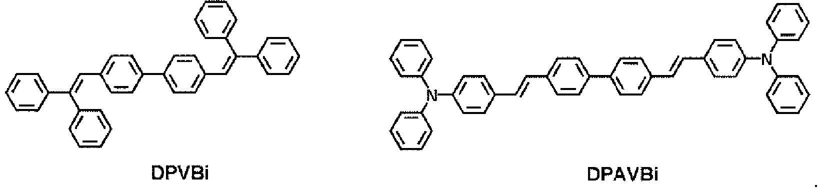

In one or more embodiments, the fluorescent dopant and the auxiliary dopant may each independently include the fourth compound represented by Formula 502 or 503 as described in the present specification.

### Electron transport region in interlayer 130

The electron transport region may have: i) a single-layered structure including (e.g., consisting of) a single layer including (e.g., consisting of) a single material, ii) a single-layered structure including (e.g., consisting of) a single layer including (e.g., consisting of) a plurality of different materials, or iii) a multi-layered structure including a plurality of layers including different materials.

The electron-transporting region may include a buffer layer, a hole blocking layer, an electron control layer, an electron-transporting layer, an electron injection layer, or a combination thereof.

For example, the electron transport region may have an electron transport layer/electron injection layer structure, a hole blocking layer/electron transport layer/electron injection layer structure, an electron control layer/electron transport layer/electron injection layer structure, or a buffer layer/electron transport layer/electron injection layer structure, the constituting layers of each structure being sequentially stacked from an emission layer.

In one or more embodiments, the electron transport region (for example, the buffer layer, the hole blocking layer, the electron control layer, or the electron transport layer in the electron transport region) may include a metal-free compound including at least one π electron-deficient nitrogen-containing C₁-C₆₀ (e.g. C₁-C₃₀) heterocyclic group.

For example, the electron transport region may include a compound represented by Formula 601:

Formula 601 [Ar₆₀₁]ₓₑ₁₁-[(L₆₀₁)ₓₑ₁-R₆₀₁]ₓₑ₂₁,

wherein, in Formula 601,
Ar₆₀₁ and L₆₀₁ may each independently be a C₃-C₆₀ (e.g. C₃-C₃₀) carbocyclic group unsubstituted or substituted with at least one R₁₀ₐ or a C₁-C₆₀ (e.g. C₁-C₂₀) heterocyclic group unsubstituted or substituted with at least one R₁₀ₐ,
xe11 may be 1, 2, or 3,
xe1 may be 0, 1, 2, 3, 4, or 5,
R₆₀₁ may be a C₃-C₆₀ (*e.g*. C₃-C₃₀) carbocyclic group unsubstituted or substituted with at least one R₁₀ₐ, a C₁-C₆₀ (*e.g.* C₁-C₂₀) heterocyclic group unsubstituted or substituted with at least one R₁₀ₐ, -Si(Q₆₀₁)(Q₆₀₂)(Q₆₀₃), -C(=O)(Q₆₀₁), - S(=O)₂(Q₆₀₁), or -P(=O)(Q₆₀₁)(Q₆₀₂),
Q₆₀₁ to Q₆₀₃ may each be the same as described herein with respect to Q₁,
xe21 may be 1, 2, 3, 4, or 5,
at least one selected from among Ar₆₀₁, L₆₀₁, and R₆₀₁ may each independently be a π electron-deficient nitrogen-containing C₁-C₆₀ (*e.g*. C₁-C₃₀) heterocyclic group that is unsubstituted or substituted with at least one R₁₀ₐ.

For example, when xe11 in Formula 601 is 2 or more, two or more of Ar₆₀₁(s) may be linked to each other via a single bond.

In one or more embodiments, Ar₆₀₁ in Formula 601 may be a substituted or unsubstituted anthracene group.

In one or more embodiments, the electron transport region may include a compound represented by Formula 601-1: 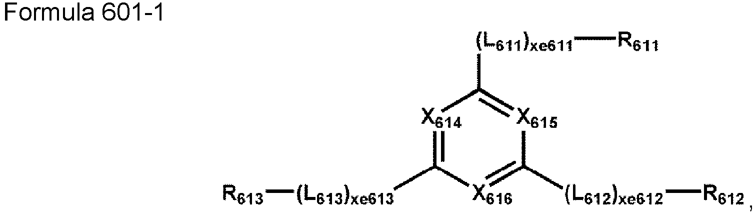 wherein, in Formula 601-1,
X₆₁₄ may be N or C(R₆₁₄), X₆₁₅ may be N or C(R₆₁₅), X₆₁₆ may be N or C(R₆₁₆), and at least one of X₆₁₄ to X₆₁₆ may be N,
L₆₁₁ to L₆₁₃ may each be as described herein with respect to L₆₀₁,
xe611 to xe613 may each be as described herein with respect to xe1,
R₆₁₁ to R₆₁₃ may each be as described herein with respect to R₆₀₁, and
R₆₁₄ to R₆₁₆ may each independently be hydrogen, deuterium, -F, -Cl, -Br, -I, a hydroxyl group, a cyano group, a nitro group, a C₁-C₂₀ (*e.g*. C₁-C₁₀) alkyl group, a C₁-C₂₀ (*e.g*. C₁-C₁₀) alkoxy group, a C₃-C₆₀ (*e.g*. C₃-C₃₀) carbocyclic group unsubstituted or substituted with at least one R₁₀ₐ, or a C₁-C₆₀ (*e.g*. C₁-C₂₀) heterocyclic group unsubstituted or substituted with at least one R₁₀ₐ.

For example, xe1 and xe611 to xe613 in Formulae 601 and 601-1 may each independently be 0, 1, or 2.

The electron transport region may include at least one of Compounds ET1 to ET46, 2,9-dimethyl-4,7-diphenyl-1,10-phenanthroline (BCP), 4,7-diphenyl-1,10-phenanthroline (Bphen), Alq₃, BAlq, TAZ, NTAZ, or a combination thereof:

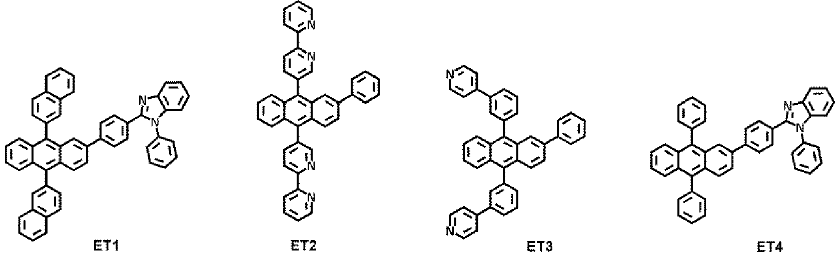

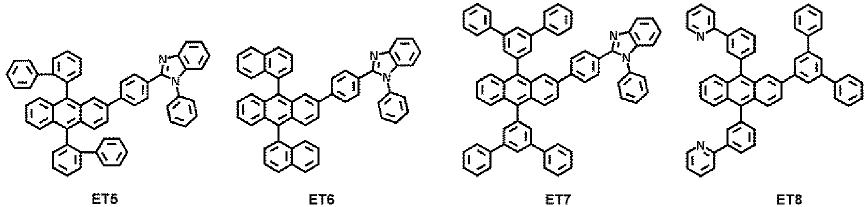

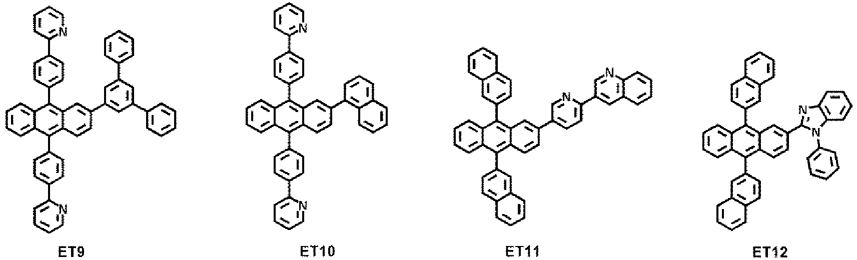

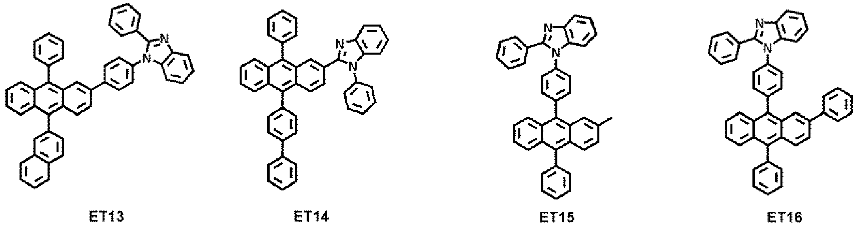

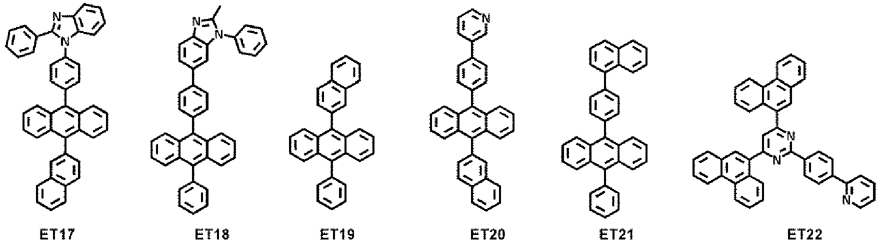

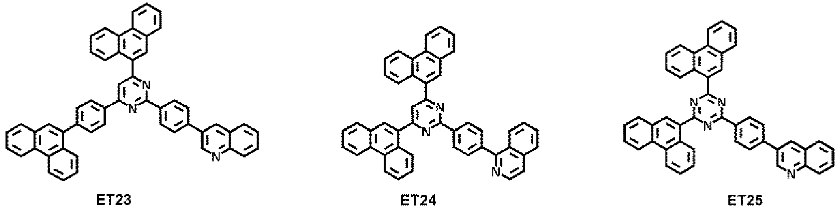

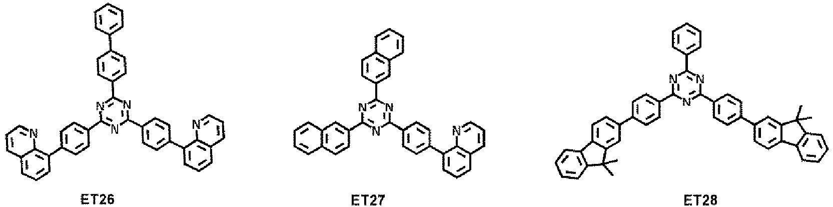

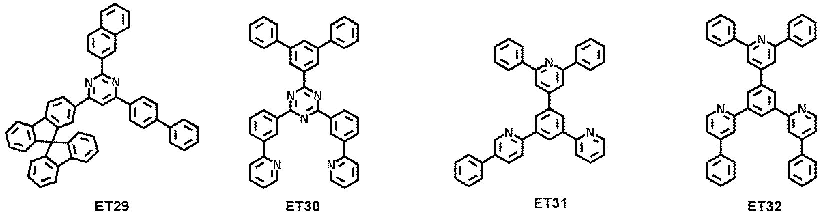

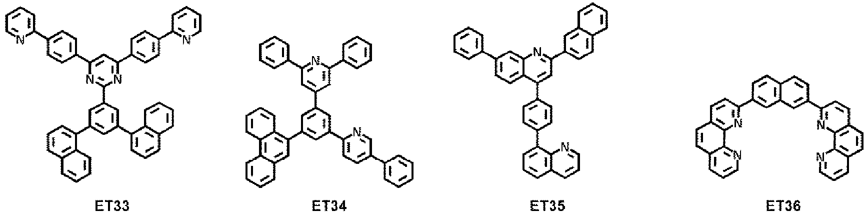

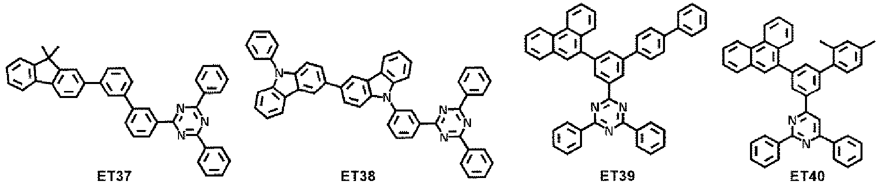

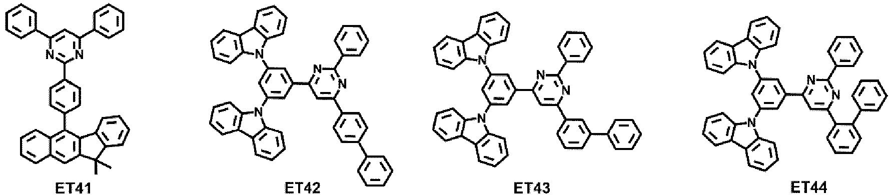

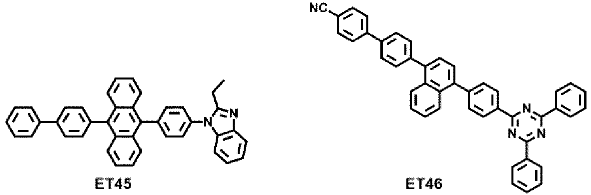

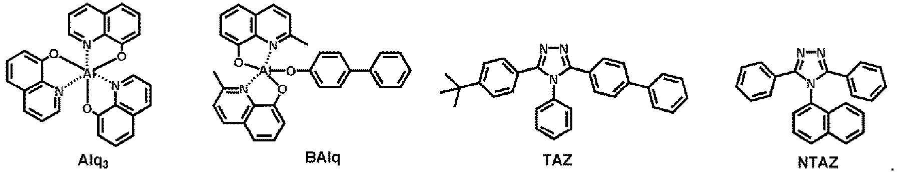

A thickness of the electron transport region may be from about 100 Å to about 5,000 Å, for example, about 160 Å to about 4,000 Å. When the electron transport region includes a buffer layer, a hole blocking layer, an electron control layer, an electron transport layer, or a combination thereof, the thickness of the buffer layer, the hole blocking layer, or the electron control layer may each independently be from about 20 Å to about 1000 Å, for example, about 30 Å to about 300 Å, and the thickness of the electron transport layer may be from about 100 Å to about 1000 Å, for example, about 150 Å to about 500 Å. When the thickness of the buffer layer, the hole blocking layer, the electron control layer, the electron transport layer, and/or the electron transport layer are within these ranges, satisfactory electron transporting characteristics may be obtained without a substantial increase in driving voltage.

The electron transport region (for example, the electron transport layer in the electron transport region) may further include, in addition to the materials described above, a metal-containing material.

The metal-containing material may include an alkali metal complex, an alkaline earth metal complex, or a combination thereof. The metal ion of an alkali metal complex may be a Li ion, a Na ion, a K ion, a Rb ion, or a Cs ion, and the metal ion of an alkaline earth metal complex may be a Be ion, a Mg ion, a Ca ion, a Sr ion, or a Ba ion. A ligand coordinated with the metal ion of the alkali metal complex or the alkaline earth-metal complex may include a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenylbenzimidazole, a hydroxyphenylbenzothiazole, a bipyridine, a phenanthroline, a cyclopentadiene, or a combination thereof.

For example, the metal-containing material may include a Li complex. The Li complex may include, for example, Compound ET-D1 (LiQ) or ET-D2:

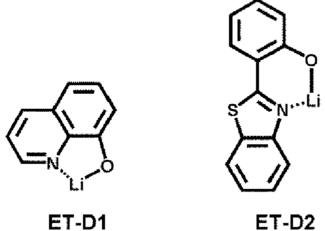

The electron transport region may include an electron injection layer that facilitates the injection of electrons from the second electrode 150. The electron injection layer may directly contact the second electrode 150.

The electron injection layer may have: i) a single-layered structure including (e.g., consisting of) a single layer including (e.g., consisting of) a single material, ii) a single-layered structure including (e.g., consisting of) a single layer including (e.g., consisting of) a plurality of different materials, or iii) a multi-layered structure including a plurality of layers including different materials.

The electron injection layer may include an alkali metal, alkaline earth metal, a rare earth metal, an alkali metal-containing compound, alkaline earth metal-containing compound, a rare earth metal-containing compound, an alkali metal complex, an alkaline earth metal complex, a rare earth metal complex, or a combination thereof.

The alkali metal may include Li, Na, K, Rb, Cs, or a combination thereof. The alkaline earth metal may include Mg, Ca, Sr, Ba, or a combination thereof. The rare earth metal may include Sc, Y, Ce, Tb, Yb, Gd, or a combination thereof.

The alkali metal-containing compound, the alkaline earth metal-containing compound, and the rare earth metal-containing compound may be oxides, halides (for example, fluorides, chlorides, bromides, or iodides), or tellurides of the alkali metal, the alkaline earth metal, and the rare earth metal, or a combination thereof.

The alkali metal-containing compound may include: alkali metal oxides, such as Li₂O, Cs₂O, or K₂O; alkali metal halides, such as LiF, NaF, CsF, KF, Lil, Nal, CsI, KI, or Rbl; or a combination thereof. The alkaline earth metal-containing compound may include an alkaline earth metal compound, such as BaO, SrO, CaO, BaₓSr₁₋ₓO (wherein x is a real number satisfying the condition of 0<x<1), BaₓCa₁₋ₓO (wherein x is a real number satisfying the condition of 0<x<1), and/or the like. The rare earth metal-containing compound may include YbF₃, ScF₃, Sc₂O₃, Y₂O₃, Ce₂O₃, GdF₃, TbF₃, YbI₃, ScI₃, TbI₃, or a combination thereof. In one or more embodiments, the rare earth metal-containing compound may include lanthanide metal telluride. Examples of the lanthanide metal telluride are LaTe, CeTe, PrTe, NdTe, PmTe, SmTe, EuTe, GdTe, TbTe, DyTe, HoTe, ErTe, TmTe, YbTe, LuTe, La₂Te₃, Ce₂Te₃, Pr₂Te₃, Nd₂Te₃, Pm₂Te₃, Sm₂Te₃, Eu₂Te₃, Gd₂Te₃, Tb₂Te₃, Dy₂Te₃, Ho₂Te₃, Er₂Te₃, Tm₂Te₃, Yb₂Te₃, Lu₂Te₃, and/or the like.

The alkali metal complex, the alkaline earth-metal complex, and the rare earth metal complex may include i) one selected from among metal ions of the alkali metal, the alkaline earth metal, and the rare earth metal and ii), as a ligand bonded to the metal ion, for example, a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenyl benzimidazole, a hydroxyphenylbenzothiazole, a bipyridine, a phenanthroline, a cyclopentadiene, or a combination thereof.

The electron injection layer may include (e.g., consist of) an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or a combination thereof, as described above. In one or more embodiments, the electron injection layer may further include an organic material (for example, a compound represented by Formula 601).

In one or more embodiments, the electron injection layer may include (e.g., consist of): i) an alkali metal-containing compound (for example, an alkali metal halide); or ii) a) an alkali metal-containing compound (for example, an alkali metal halide), and b) an alkali metal, an alkaline earth metal, a rare earth metal, or a combination thereof. For example, the electron injection layer may be a KI:Yb co-deposited layer, an RbI:Yb co-deposited layer, a LiF:Yb co-deposited layer, and/or the like.

When the electron injection layer further includes an organic material, an alkali metal, an alkaline earth metal, a rare earth metal, an alkali metal-containing compound, an alkaline earth metal-containing compound, a rare earth metal-containing compound, an alkali metal complex, an alkaline earth-metal complex, a rare earth metal complex, or a combination thereof may be uniformly or non-uniformly dispersed in a matrix including the organic material.

A thickness of the electron injection layer may be in a range of about 1 Å to about 100 Å, and, for example, about 3 Å to about 90 Å. When the thickness of the electron injection layer is within the ranges described above, satisfactory electron injection characteristics may be obtained without a substantial increase in driving voltage.

### Second electrode 150

Returning to FIG. 1, the second electrode 150 may be located on the interlayer 130 having a structure as described herein. The second electrode 150 may be a cathode, which is an electron injection electrode, and as the material for the second electrode 150, a metal, an alloy, an electrically conductive compound, or a combination thereof, each having a low work-function, may be utilized. The term "low work-function material" as utilized herein refers to a substance (e.g., a metal or metal alloy) that requires a relatively small amount of energy to emit electrons from its surface.

The second electrode 150 may include lithium (Li), silver (Ag), magnesium (Mg), aluminium (Al), aluminium-lithium (Al-Li), calcium (Ca), magnesium-indium (Mg-In), magnesium-silver (Mg-Ag), ytterbium (Yb), silver-ytterbium (Ag-Yb), ITO, IZO, or a combination thereof. The second electrode 150 may be a transmissive electrode, a semi-transmissive electrode, or a reflective electrode.

The second electrode 150 may have a single-layered structure or a multi-layered structure including a plurality of layers.

### Capping layer

A first capping layer may be located outside the first electrode 110, and/or a second capping layer may be located outside the second electrode 150. In particular, the light-emitting device 10 may have a structure in which the first capping layer, the first electrode 110, the interlayer 130, and the second electrode 150 are sequentially stacked in the stated order, a structure in which the first electrode 110, the interlayer 130, the second electrode 150, and the second capping layer are sequentially stacked in the stated order, or a structure in which the first capping layer, the first electrode 110, the interlayer 130, the second electrode 150, and the second capping layer are sequentially stacked in the stated order.

Light generated in an emission layer of the interlayer 130 of the light-emitting device 10 may be extracted toward the outside through the first electrode 110 which is a semi-transmissive electrode or a transmissive electrode, and the first capping layer. Light generated in an emission layer of the interlayer 130 of the light-emitting device 10 may be extracted toward the outside through the second electrode 150 which is a semi-transmissive electrode or a transmissive electrode, and the second capping layer.

The first capping layer and the second capping layer may increase external emission efficiency according to the principle of constructive interference. Accordingly, the light extraction efficiency of the light-emitting device 10 is increased, so that the luminescence efficiency of the light-emitting device 10 may be enhanced or improved.

Each of the first capping layer and the second capping layer may include a material having a refractive index of 1.6 or more (at 589 nm).

The first capping layer and the second capping layer may each independently be an organic capping layer including an organic material, an inorganic capping layer including an inorganic material, or an organic-inorganic composite capping layer including an organic material and an inorganic material.

At least one selected from among the first capping layer and the second capping layer may each independently include carbocyclic compounds, heterocyclic compounds, amine group-containing compounds, porphine derivatives, phthalocyanine derivatives, naphthalocyanine derivatives, alkali metal complexes, alkaline earth metal complexes, or a combination thereof. Optionally, the carbocyclic compound, the heterocyclic compound, and the amine group-containing compound may be substituted with a substituent including O, N, S, Se, Si, F, Cl, Br, I, or a combination thereof. In one or more embodiments, at least one of the first capping layer or the second capping layer may each independently include an amine group-containing compound.

For example, at least one of the first capping layer or the second capping layer may each independently include a compound represented by Formula 201, a compound represented by Formula 202, or a combination thereof.

In one or more embodiments, at least one selected from among the first capping layer and the second capping layer may each independently include at least one of Compounds HT28 to HT33, at least one of Compounds CP1 to CP6, β-NPB, or a combination thereof:

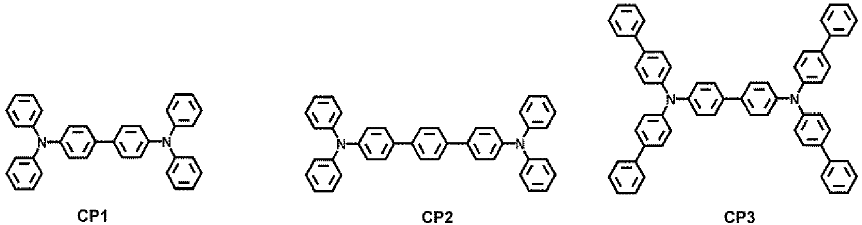

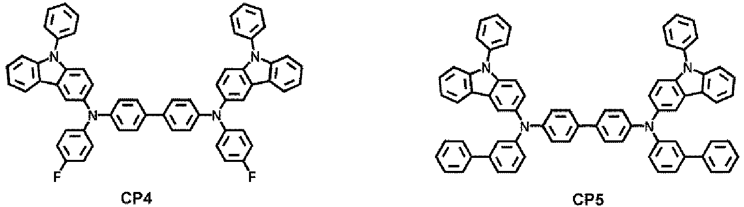

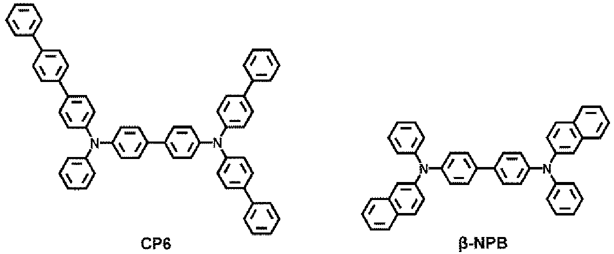

### Electronic apparatus

The light-emitting device may be included in one or more suitable electronic apparatuses. For example, the electronic apparatus including the light-emitting device may be a light-emitting apparatus, an authentication apparatus, and/or the like.

The electronic apparatus (for example, a light-emitting apparatus) may further include, in addition to the light-emitting device, i) a color filter, ii) a color conversion layer, or iii) a color filter and a color conversion layer. The color filter and/or the color conversion layer may be located in at least one direction in which light emitted from the light-emitting device travels. For example, the light emitted from the light-emitting device may be blue light, green light, or white light. For details on the light-emitting device, related description provided above may be referred to. In one or more embodiments, the color conversion layer may include a quantum dot.

The electronic apparatus may include a first substrate. The first substrate may include a plurality of subpixel areas, the color filter may include a plurality of color filter areas respectively corresponding to the subpixel areas, and the color conversion layer may include a plurality of color conversion areas respectively corresponding to the subpixel areas.

A pixel-defining film may be located among the subpixel areas to define each of the subpixel areas.

The color filter may further include a plurality of color filter areas and light-shielding patterns located among the color filter areas, and the color conversion layer may further include a plurality of color conversion areas and light-shielding patterns located among the color conversion areas.

The plurality of color filter areas (or the plurality of color conversion areas) may include a first area emitting first color light, a second area emitting second color light, and/or a third area emitting third color light, wherein the first color light, the second color light, and/or the third color light may have different maximum emission wavelengths from one another. For example, the first color light may be red light, the second color light may be green light, and the third color light may be blue light. For example, the plurality of color filter areas (or the plurality of color conversion areas) may include quantum dots. In particular, the first area may include a red quantum dot, the second area may include a green quantum dot, and the third area may not include a (e.g., may exclude any) quantum dot. For details on the quantum dot, related descriptions provided herein may be referred to. The first area, the second area, and/or the third area may each include a scatterer.

For example, the light-emitting device may be to emit first light, the first area may be to absorb the first light to emit first-first color light, the second area may be to absorb the first light to emit second-first color light, and the third area may be to absorb the first light to emit third-first color light. In this regard, the first-first color light, the second-first color light, and the third-first color light may have different maximum emission wavelengths. In particular, the first light may be blue light, the first-first color light may be red light, the second-first color light may be green light, and the third-first color light may be blue light.

The electronic apparatus may further include a thin-film transistor, in addition to the light-emitting device as described above. The thin-film transistor may include a source electrode, a drain electrode, and an activation layer, wherein any one of the source electrode and the drain electrode may be electrically connected to any one of the first electrode and the second electrode of the light-emitting device.

The thin-film transistor may further include a gate electrode, a gate insulating film, and/or the like.

The activation layer may include crystalline silicon, amorphous silicon, an organic semiconductor, an oxide semiconductor, and/or the like.

The electronic apparatus may further include a sealing portion for sealing the light-emitting device. The sealing portion may be located between the color filter and/or the color conversion layer and the light-emitting device. The sealing portion allows light from the light-emitting device to be extracted to the outside, and concurrently (e.g., simultaneously) prevents ambient air and moisture from penetrating into the light-emitting device. The sealing portion may be a sealing substrate including a transparent glass substrate or a plastic substrate. The sealing portion may be a thin-film encapsulation layer including at least one layer of an organic layer and/or an inorganic layer. When the sealing portion is a thin film encapsulation layer, the electronic apparatus may be flexible.

One or more functional layers may be additionally located on the sealing portion, in addition to the color filter and/or the color conversion layer, according to the utilize of the electronic apparatus. Examples of the functional layers may include a touch screen layer, a polarizing layer, and/or the like. The touch screen layer may be a pressure-sensitive touch screen layer, a capacitive touch screen layer, or an infrared touch screen layer. The authentication apparatus may be, for example, a biometric authentication apparatus that authenticates an individual by utilizing biometric information of a living body (for example, fingertips, pupils, etc.).

The authentication apparatus may further include, in addition to the light-emitting device as described above, a biometric information collector.

The electronic apparatus may be applied to one or more suitable displays, light sources, lighting, personal computers (for example, a mobile personal computer), mobile phones, digital cameras, electronic organizers, electronic dictionaries, electronic game machines, medical instruments (for example, electronic thermometers, sphygmomanometers, blood glucose meters, pulse measurement devices, pulse wave measurement devices, electrocardiogram displays, ultrasonic diagnostic devices, or endoscope displays), fish finders, one or more suitable measuring instruments, meters (for example, meters for a vehicle, an aircraft, and a vessel), projectors, and/or the like.

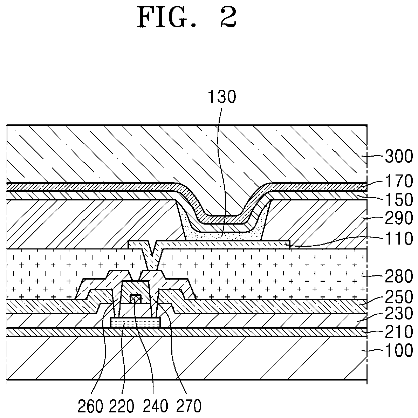

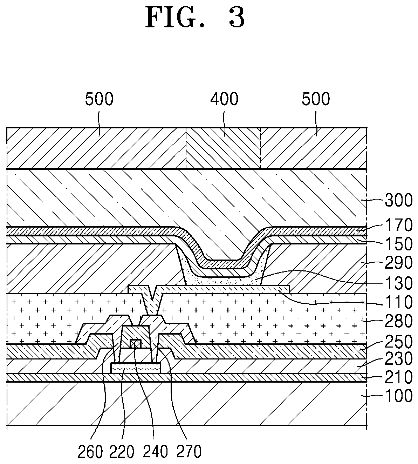

### Description of FIGS. 2 and 3

FIG. 2 is a cross-sectional view of a light-emitting apparatus, which is one of an electronic apparatus, according to one or more embodiments.

The light-emitting apparatus of FIG. 2 includes a substrate 100, a thin-film transistor (TFT), a light-emitting device, and an encapsulation portion 300 that seals the light-emitting device.

The substrate 100 may be a flexible substrate, a glass substrate, or a metal substrate. A buffer layer 210 may be located on the substrate 100. The buffer layer 210 may prevent or reduce penetration of impurities through the substrate 100 and may provide a flat surface on the substrate 100.

The TFT may be located on the buffer layer 210. The TFT may include an activation layer 220, a gate electrode 240, a source electrode 260, and a drain electrode 270.

The activation layer 220 may include an inorganic semiconductor such as silicon or polysilicon, an organic semiconductor, or an oxide semiconductor, and may include a source region, a drain region, and a channel region.

A gate insulating film 230 for insulating the activation layer 220 from the gate electrode 240 may be located on the activation layer 220, and the gate electrode 240 may be located on the gate insulating film 230.

An interlayer insulating film 250 may be located on the gate electrode 240. The interlayer insulating film 250 may be located between the gate electrode 240 and the source electrode 260 and between the gate electrode 240 and the drain electrode 270, to insulate from one another.

The source electrode 260 and the drain electrode 270 may be located on the interlayer insulating film 250. The interlayer insulating film 250 and the gate insulating film 230 may be formed to expose the source region and the drain region of the activation layer 220, and the source electrode 260 and the drain electrode 270 may be located in contact with the exposed portions of the source region and the drain region of the activation layer 220.

The TFT may be electrically connected to a light-emitting device to drive the light-emitting device, and is covered and protected by a passivation layer 280. The passivation layer 280 may include an inorganic insulating film, an organic insulating film, or a combination thereof. A light-emitting device is provided on the passivation layer 280. The light-emitting device may include a first electrode 110, an interlayer 130, and a second electrode 150.

The first electrode 110 may be located on the passivation layer 280. The passivation layer 280 may be located to expose a portion of the drain electrode 270, not fully covering the drain electrode 270, and the first electrode 110 may be located to be connected to the exposed portion of the drain electrode 270.

A pixel defining layer 290 including an insulating material may be located on the first electrode 110. The pixel defining layer 290 may expose a certain region of the first electrode 110, and an interlayer 130 may be formed in the exposed region of the first electrode 110. The pixel defining layer 290 may be a polyimide or polyacrylic organic film. In one or more embodiments, at least some layers of the interlayer 130 may extend beyond the upper portion of the pixel defining layer 290 to be located in the form of a common layer.

The second electrode 150 may be located on the interlayer 130, and a second capping layer 170 may be additionally formed on the second electrode 150. The second capping layer 170 may be formed to cover the second electrode 150.

The encapsulation portion 300 may be located on the second capping layer 170. The encapsulation portion 300 may be located on a light-emitting device to protect the light-emitting device from moisture or oxygen. The encapsulation portion 300 may include: an inorganic film including silicon nitride (SiNx), silicon oxide (SiOx), indium tin oxide (ITO), indium zinc oxide (IZO), or a combination thereof; an organic film including polyethylene terephthalate, polyethylene naphthalate, polycarbonate, polyimide, polyethylene sulfonate, polyoxymethylene, polyarylate, hexamethyldisiloxane, an acrylic resin (for example, polymethyl methacrylate, polyacrylic acid, and/or the like), an epoxy-based resin (for example, aliphatic glycidyl ether (AGE), and/or the like), or a combination thereof; or a combination of the inorganic films and the organic films.

FIG. 3 is a cross-sectional view of a light-emitting apparatus, which is one of an electronic apparatus, according to one or more embodiments.

The light-emitting apparatus of FIG. 3 is the same as the light-emitting apparatus of FIG. 2, except that a light-shielding pattern 500 and a functional region 400 are additionally located on the encapsulation portion 300. The functional region 400 may be i) a color filter area, ii) a color conversion area, or iii) a combination of the color filter area and the color conversion area. In one or more embodiments, the light-emitting device included in the light-emitting apparatus of FIG. 3 may be a tandem light-emitting device.

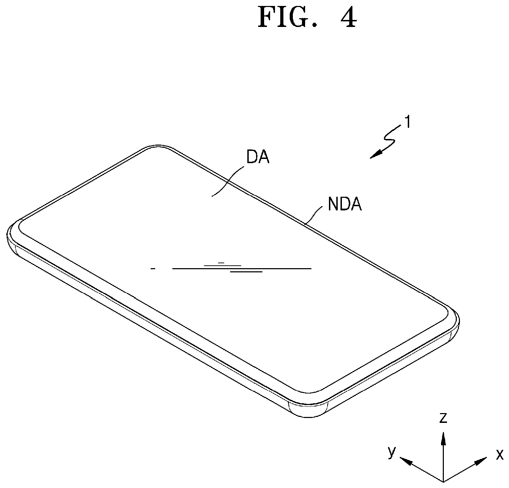

### Description of FIG. 4

FIG. 4 is a schematic perspective view of electronic equipment 1 including a light-emitting device according to one or more embodiments. The electronic equipment 1 may be, as a device apparatus, that displays a moving image or still image, a portable electronic equipment, such as a mobile phone, a smart phone, a tablet personal computer (PC), a mobile communication terminal, an electronic notebook, an electronic book, a portable multimedia player (PMP), a navigation, or a ultra mobile PC (UMPC) as well as one or more suitable products, such as a television, a laptop, a monitor, a billboard or an Internet of things (IOT). The electronic equipment 1 may be such a product, as described herein, or a component or part thereof. In one or more embodiments, the electronic equipment 1 may be a wearable device, such as a smart watch, a watch phone, a glasses-type or kind display, or a head mounted display (HMD), or a part of the wearable device. However, embodiments of the disclosure are not limited thereto. For example, the electronic apparatus 1 may be a center information display (CID) on an instrument panel and a center fascia or dashboard of a vehicle, a room mirror display instead of a side mirror of a vehicle, an entertainment display for the rear seat of a car or a display placed on the back of the front seat, head up display (HUD) installed in front of a vehicle or projected on a front window glass, or a computer generated hologram augmented reality head up display (CGH AR HUD). FIG. 4 illustrates a case in which the electronic equipment 1 is a smartphone for convenience of explanation.

The electronic equipment 1 may include a display area DA and a non-display area NDA outside the display area DA. A display device may implement an image through an array of a plurality of pixels that are two-dimensionally arranged in the display area DA.

The non-display area NDA is an area that does not display an image, and may entirely surround the display area DA. On the non-display area NDA, a driver for providing electrical signals and/or power to display devices located or arranged on the display area DA may be located or arranged. On the non-display area NDA, a pad, which is an area to which an electronic element or a printing circuit board may be electrically connected, may be located or arranged.

In the electronic equipment 1, a length in the x-axis direction and a length in the y-axis direction may be different from each other. For example, as shown in FIG. 4, the length in the x-axis direction may be shorter than the length in the y-axis direction. In one or more embodiments, the length in the x-axis direction may be the same as the length in the y-axis direction. In one or more embodiments, the length in the x-axis direction may be longer than the length in the y-axis direction.

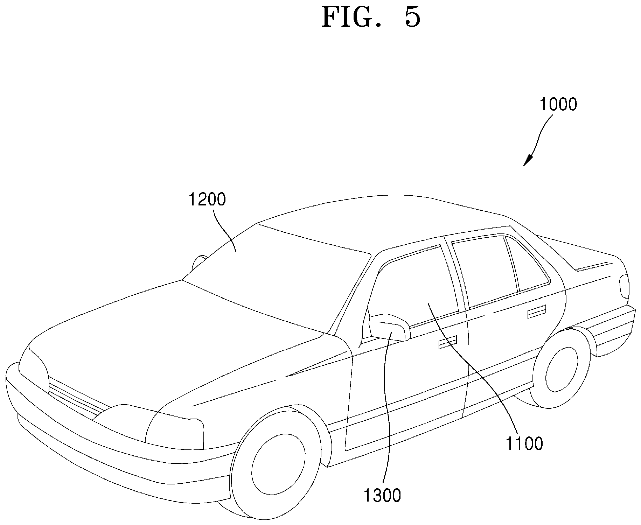

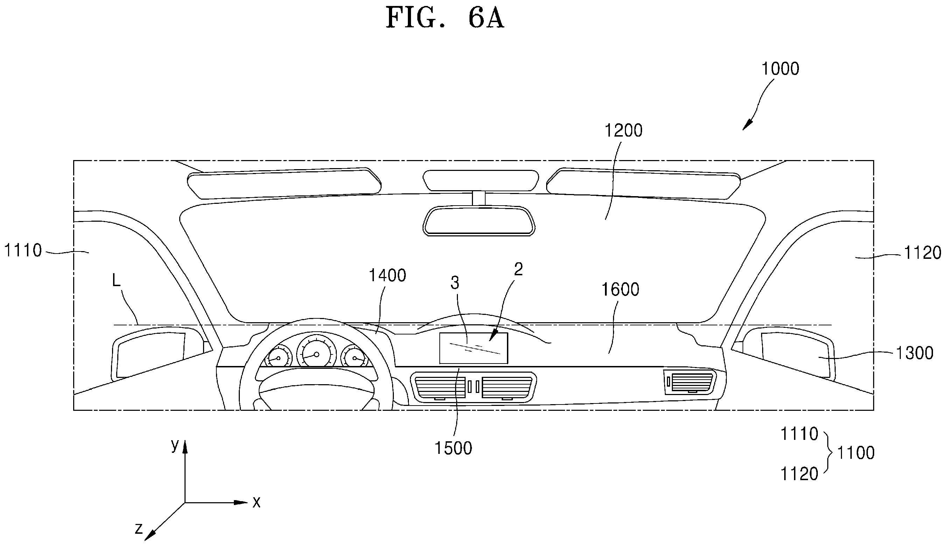

### Descriptions of FIGs. 5 and 6A to 6C

FIG. 5 is a schematic perspective view of the exterior of a vehicle 1000 according to one or more embodiments. FIGS. 6A to 6C are each a schematic view of the interior of vehicle 1000 that includes the electronic equipment including a light-emitting device according to one or more embodiments.

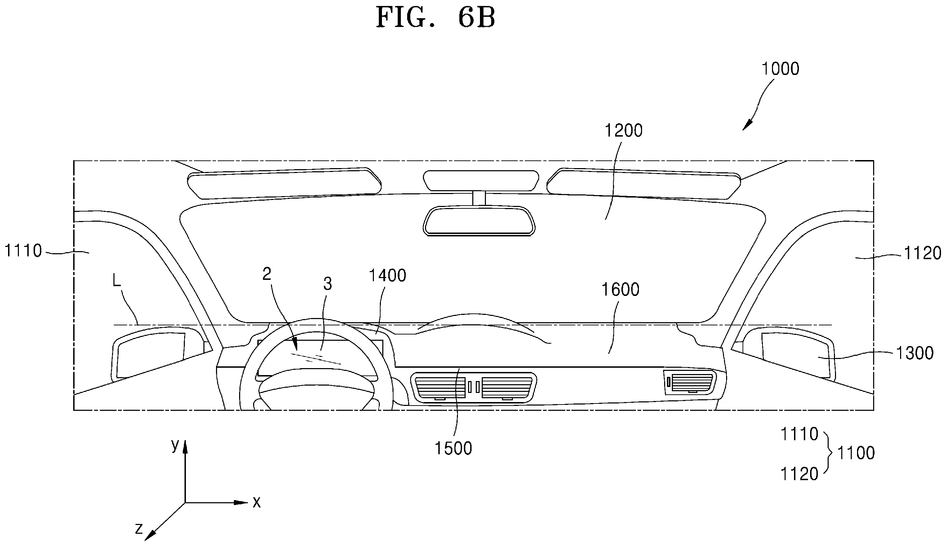

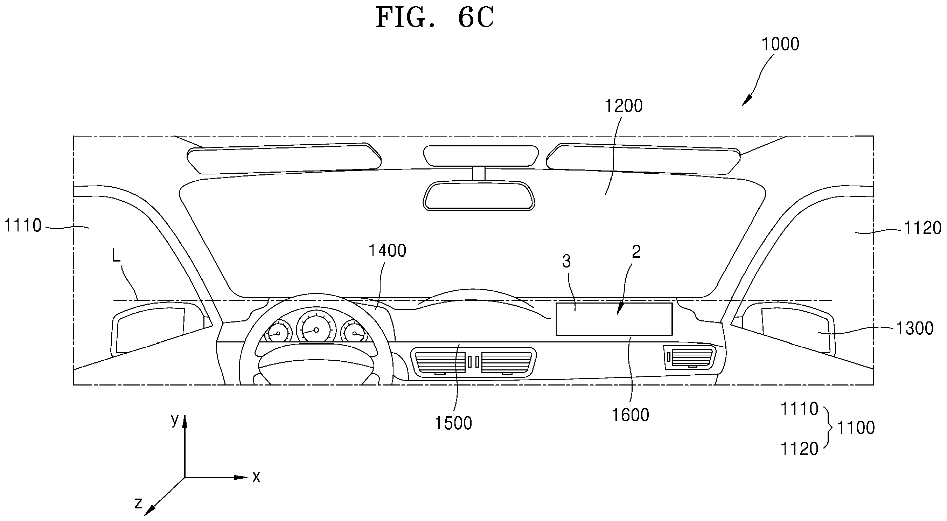

Referring to FIGs. 5, 6A, 6B, and 6C, the vehicle 1000 may refer to one or more suitable apparatus(es) for moving a subject object to be transported, such as a human, an object, and/or an animal, from a departure point to a destination. The vehicle 1000 may include a vehicle (e.g., automobile) traveling on a road or track, a vessel moving over a sea or river, an airplane flying in the sky utilizing the action of air, and/or the like.

The vehicle 1000 may travel on a road or a track. The vehicle 1000 may move in a set or predetermined direction according to the rotation of at least one wheel. For example, the vehicle 1000 may include a three-wheeled or four-wheeled vehicle, a construction machine, a two-wheeled vehicle, a prime mover device, a bicycle, and a train running on a track.

The vehicle 1000 may include a body having an interior and an exterior, and a chassis in which mechanical apparatuses necessary for driving are installed as other parts except for the body. The exterior of the vehicle body may include a front panel, a bonnet (i.e., hood), a roof panel, a rear panel, a trunk, a filler provided at a boundary between doors, and/or the like. The chassis of the vehicle 1000 may include a power generating device, a power transmitting device, a driving device, a steering device, a braking device, a suspension device, a transmission device, a fuel device, front and rear wheels, left and right wheels, and/or the like.

The vehicle 1000 may include a side window glass 1100, a front window glass 1200, a side mirror 1300, a cluster 1400, a center fascia 1500, a passenger seat dashboard 1600, and a display device 2.

The side window glass 1100 and the front window glass 1200 may be partitioned by a filler arranged between the side window glass 1100 and the front window glass 1200.

The side window glass 1100 may be installed on the side of the vehicle 1000. In one or more embodiments, the side window glass 1100 may be installed on a door of the vehicle 1000. A plurality of side window glasses 1100 may be provided and may face each other. In one or more embodiments, the side window glass 1100 may include a first side window glass 1110 and a second side window glass 1120. In one or more embodiments, the first side window glass 1110 may be arranged adjacent to the cluster 1400. The second side window glass 1120 may be arranged adjacent to the passenger seat dashboard 1600.

In one or more embodiments, the side window glasses 1100 may be spaced apart from each other in the +x direction or the -x direction. For example, the first side window glass 1110 and the second side window glass 1120 may be spaced apart from each other in the +x direction or the -x direction. In other words, an imaginary straight line L connecting the side window glasses 1100 may extend in the +x direction or the - x direction. For example, an imaginary straight line L connecting the first side window glass 1110 and the second side window glass 1120 to each other may extend in the +x direction or the -x direction.

The front window glass 1200 may be installed in the front of the vehicle 1000. The front window glass 1200 may be arranged between the side window glasses 1100 facing each other.

The side mirror 1300 may provide a rear view of the vehicle 1000. The side mirror 1300 may be installed on the exterior of the vehicle body. In one embodiment, a plurality of side mirrors 1300 may be provided. Any one selected from among the plurality of side mirrors 1300 may be arranged outside the first side window glass 1110. The other one of the plurality of side mirrors 1300 may be arranged outside the second side window glass 1120.

The cluster 1400 may be arranged in front of the steering wheel. The cluster 1400 may include a tachometer, a speedometer, a coolant thermometer, a fuel gauge turn indicator, a high beam indicator, a warning lamp, a seat belt warning lamp, an odometer, an hodometer, an automatic shift selector indicator lamp, a door open warning lamp, an engine oil warning lamp, and/or a low fuel warning light.

The center fascia 1500 may include a control panel on which a plurality of buttons for adjusting an audio device, an air conditioning device, and a heater of a seat are disposed. The center fascia 1500 may be arranged on one side of the cluster 1400.

A passenger seat dashboard 1600 may be spaced apart from the cluster 1400 with the center fascia 1500 arranged therebetween. In one or more embodiments, the cluster 1400 may be arranged to correspond to a driver seat, and the passenger seat dashboard 1600 may be disposed to correspond to a passenger seat. In one or more embodiments, the cluster 1400 may be adjacent to the first side window glass 1110, and the passenger seat dashboard 1600 may be adjacent to the second side window glass 1120.

In one or more embodiments, the display device 2 may include a display panel 3, and the display panel 3 may display an image. The display device 2 may be arranged inside the vehicle 1000. In one or more embodiments, the display device 2 may be arranged between the side window glasses 1100 facing each other. The display device 2 may be arranged on at least one selected from among the cluster 1400, the center fascia 1500, and the passenger seat dashboard 1600.

The display device 2 may include an organic light-emitting display device, an inorganic electroluminescent (EL) display device, a quantum dot display device, and/or the like. Hereinafter, as the display device 2 according to one or more embodiments of the disclosure, an organic light-emitting display device display including the light-emitting device according to the disclosure will be described as an example, but one or more suitable types (kinds) of display devices as described above may be utilized in embodiments of the disclosure.

Referring to FIG. 6A, the display device 2 may be located or arranged on the center fascia 1500. In one or more embodiments, the display device 2 may display navigation information. In one or more embodiments, the display device 2 may display audio, video, or information regarding vehicle settings.

Referring to FIG. 6B, the display device 2 may be arranged on the cluster 1400. When the display device 2 is arranged on the cluster 1400, the cluster 1400 may display driving information and/or the like through the display device 2. For example, the cluster 1400 may be implemented digitally. The digital cluster 1400 may display vehicle information and driving information as images. For example, a needle and a gauge of a tachometer and one or more suitable warning light icons may be displayed by a digital signal.

Referring to FIG. 6C, the display device 2 may be arranged on the dashboard 1600 of the passenger seat. The display device 2 may be embedded in the passenger seat dashboard 1600 or arranged on the passenger seat dashboard 1600. In one or more embodiments, the display device 2 arranged on the dashboard 1600 for the passenger seat may display an image related to information displayed on the cluster 1400 and/or information displayed on the center fascia 1500. In one or more embodiments, the display device 2 arranged on the passenger seat dashboard 1600 may display information different from information displayed on the cluster 1400 and/or information displayed on the center fascia 1500.

### Manufacturing method

Layers included in the hole transport region, the emission layer, and layers included in the electron transport region may be formed in one or more suitable regions by utilizing one or more suitable methods selected from vacuum deposition, spin coating, casting, Langmuir-Blodgett (LB) deposition, ink-jet printing, laser-printing, and/or laser-induced thermal imaging.

When layers constituting the hole transport region, an emission layer, and layers constituting the electron transport region are formed by vacuum deposition, the deposition may be performed at a deposition temperature of about 100 °C to about 500 °C, a vacuum degree of about 10⁻⁸ torr to about 10⁻³ torr, and a deposition speed of about 0.01 angstrom per second (Å/sec) to about 100 Å/sec, depending on a material to be included in a layer to be formed and the structure of a layer to be formed.

### Definition of terms

The term "C₃-C₆₀ carbocyclic group" as utilized herein refers to a cyclic group consisting of carbon only as a ring-forming atom and having three to sixty carbon atoms, and the term "C₁-C₆₀ heterocyclic group" as utilized herein refers to a cyclic group that has one to sixty carbon atoms and further has, in addition to carbon, a heteroatom as a ring-forming atom. The C₃-C₆₀ carbocyclic group and the C₁-C₆₀ heterocyclic group may each be a monocyclic group consisting of one ring or a polycyclic group in which two or more rings are condensed with each other. For example, the C₁-C₆₀ heterocyclic group has 3 to 61 ring-forming atoms.

The "cyclic group" as utilized herein may include the C₃-C₆₀ carbocyclic group, and the C₁-C₆₀ heterocyclic group.

The term "π electron-rich C₃-C₆₀ cyclic group" as utilized herein refers to a cyclic group that has 3 to 60 carbon atoms and does not include *-N=*' as a ring-forming moiety. The term "π electron-deficient nitrogen-containing C₁-C₆₀ heterocyclic group" as utilized herein refers to a heterocyclic group that has 1 to 60 carbon atoms and includes *-N=*' as a ring-forming moiety.

For example,
the C₃-C₆₀ carbocyclic group may be i) a group T1 or ii) a condensed cyclic group in which two or more groups T1 are condensed with each other (for example, a cyclopentadiene group, an adamantane group, a norbornane group, a benzene group, a pentalene group, a naphthalene group, an azulene group, an indacene group, an acenaphthylene group, a phenalene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indenophenanthrene group, or an indenoanthracene group),
the C₁-C₆₀ heterocyclic group may be i) a T2 group, ii) a condensed cyclic group in which at least two T2 groups are condensed with each other, or iii) a condensed cyclic group in which at least one T2 group and at least one T1 group are condensed with each other (for example, a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, and/or the like.),
the π electron-rich C₃-C₆₀ cyclic group may be i) a group T1, ii) a condensed cyclic group in which two or more groups T1 are condensed with each other, iii) a group T3, iv) a condensed cyclic group in which two or more groups T3 are condensed with each other, or v) a condensed cyclic group in which at least one group T3 and at least one group T1 are condensed with each other (for example, the C₃-C₆₀ carbocyclic group, a 1H-pyrrole group, a silole group, a borole group, a 2H-pyrrole group, a 3H-pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, etc.),
the π electron-deficient nitrogen-containing C₁-C₆₀ heterocyclic group may be i) a T4 group, ii) a condensed cyclic group in which at least two T4 groups are condensed with each other, iii) a condensed cyclic group in which at least one T4 group and at least one T1 group are condensed with each other, iv) a condensed cyclic group in which at least one T4 group and at least one T3 group are condensed with each other, or v) a condensed cyclic group in which at least one T4 group, at least one T1 group, and at least one T3 group are condensed with one another (for example, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, and/or the like),
the group T1 may be a cyclopropane group, a cyclobutane group, a cyclopentane group, a cyclohexane group, a cycloheptane group, a cyclooctane group, a cyclobutene group, a cyclopentene group, a cyclopentadiene group, a cyclohexene group, a cyclohexadiene group, a cycloheptene group, an adamantane group, a norbornane (or a bicyclo[2.2.1]heptane) group, a norbornene group, a bicyclo[1.1.1]pentane group, a bicyclo[2.1.1]hexane group, a bicyclo[2.2.2]octane group, or a benzene group,
the group T2 may be a furan group, a thiophene group, a 1H-pyrrole group, a silole group, a borole group, a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, a tetrazine group, a pyrrolidine group, an imidazolidine group, a dihydropyrrole group, a piperidine group, a tetrahydropyridine group, a dihydropyridine group, a hexahydropyrimidine group, a tetrahydropyrimidine group, a dihydropyrimidine group, a piperazine group, a tetrahydropyrazine group, a dihydropyrazine group, a tetrahydropyridazine group, or a dihydropyridazine group,
the group T3 may be a furan group, a thiophene group, a 1H-pyrrole group, a silole group, or a borole group, and
the group T4 may be a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, or a tetrazine group.

The terms "the cyclic group, the C₃-C₆₀ carbocyclic group, the C₁-C₆₀ heterocyclic group, the π electron-rich C₃-C₆₀ cyclic group, or the π electron-deficient nitrogen-containing C₁-C₆₀ heterocyclic group" as utilized herein refer to a group condensed to any cyclic group, a monovalent group, or a polyvalent group (for example, a divalent group, a trivalent group, a tetravalent group, etc.) according to the structure of a formula for which the corresponding term is utilized. For example, the "benzene group" may be a benzo group, a phenyl group, a phenylene group, and/or the like, which may be easily understood by one of ordinary skill in the art according to the structure of a formula including the "benzene group."

Depending on context, a divalent group may refer or be a polyvalent group (e.g., trivalent, tetravalent, etc., and not just divalent) per, e.g., the structure of a formula in connection with which of the terms are utilized.

Examples of the monovalent C₃-C₆₀ carbocyclic group and the monovalent C₁-C₆₀ heterocyclic group are a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, and a monovalent non-aromatic condensed heteropolycyclic group. Examples of the divalent C₃-C₆₀ carbocyclic group and the monovalent C₁-C₆₀ heterocyclic group are a C₃-C₁₀ cycloalkylene group, a C₁-C₁₀ heterocycloalkylene group, a C₃-C₁₀ cycloalkenylene group, a C₁-C₁₀ heterocycloalkenylene group, a C₆-C₆₀ arylene group, a C₁-C₆₀ heteroarylene group, a divalent non-aromatic condensed polycyclic group, and a substituted or unsubstituted divalent non-aromatic condensed heteropolycyclic group.

The term "C₁-C₆₀ alkyl group" as utilized herein refers to a linear or branched aliphatic hydrocarbon monovalent group that has one to sixty carbon atoms, and specific examples thereof are a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, and a tert-decyl group. The term "C₁-C₆₀ alkylene group" as utilized herein refers to a divalent group having the same structure as the C₁-C₆₀ alkyl group. Corresponding definitions apply to other ranges given for the number of carbon atoms in an alkyl/alkylene group.

The term "C₂-C₆₀ alkenyl group" as utilized herein refers to a monovalent hydrocarbon group having at least one carbon-carbon double bond in the middle or at the terminus of the C₂-C₆₀ alkyl group, and examples thereof are an ethenyl group, a propenyl group, and a butenyl group. The term "C₂-C₆₀ alkenylene group" as utilized herein refers to a divalent group having the same structure as the C₂-C₆₀ alkenyl group. Corresponding definitions apply to other ranges given for the number of carbon atoms in an alkenyl/alkenylene group.

The term "C₂-C₆₀ alkynyl group" as utilized herein refers to a monovalent hydrocarbon group having at least one carbon-carbon triple bond in the middle or at the terminus of the C₂-C₆₀ alkyl group, and examples thereof include an ethynyl group and a propynyl group. The term "C₂-C₆₀ alkynylene group" as utilized herein refers to a divalent group having the same structure as the C₂-C₆₀ alkynyl group. Corresponding definitions apply to other ranges given for the number of carbon atoms in an alkynyl/alkynylene group.

The term "C₁-C₆₀ alkoxy group" as utilized herein refers to a monovalent group represented by -OA₁₀₁ (wherein A₁₀₁ is the C₁-C₆₀ alkyl group), and examples thereof include a methoxy group, an ethoxy group, and an isopropyloxy group. Corresponding definitions apply to other ranges given for the number of carbon atoms in an alkoxy group.

The term "C₃-C₁₀ cycloalkyl group" as utilized herein refers to a monovalent saturated hydrocarbon cyclic group having 3 to 10 carbon atoms, and examples thereof are a cyclopropyl group, a cyclobutyl group, a cyclopentyl group, a cyclohexyl group, a cycloheptyl group, a cyclooctyl group, an adamantanyl group, a norbornanyl group (or bicyclo[2.2.1]heptyl group), a bicyclo[1.1.1]pentyl group, a bicyclo[2.1.1]hexyl group, and a bicyclo[2.2.2]octyl group. The term "C₃-C₁₀ cycloalkylene group" as utilized herein refers to a divalent group having the same structure as the C₃-C₁₀ cycloalkyl group.

The term "C₁-C₁₀ heterocycloalkyl group" as utilized herein refers to a monovalent cyclic group of 1 to 10 carbon atoms, further including, in addition to carbon atoms, at least one heteroatom, as ring-forming atoms, and specific examples are a 1,2,3,4-oxatriazolidinyl group, a tetrahydrofuranyl group, and a tetrahydrothiophenyl group. The term "C₁-C₁₀ heterocycloalkylene group" as utilized herein refers to a divalent group having the same structure as the C₁-C₁₀ heterocycloalkyl group.

The term C₃-C₁₀ cycloalkenyl group utilized herein refers to a monovalent cyclic group that has three to ten carbon atoms and at least one carbon-carbon double bond in the ring thereof and no aromaticity, and specific examples thereof are a cyclopentenyl group, a cyclohexenyl group, and a cycloheptenyl group. The term "C₃-C₁₀ cycloalkenylene group" as utilized herein refers to a divalent group having the same structure as the C₃-C₁₀ cycloalkenyl group.

The term "C₁-C₁₀ heterocycloalkenyl group" as utilized herein refers to a monovalent cyclic group of 1 to 10 carbon atoms, further including, in addition to carbon atoms, at least one heteroatom, as ring-forming atoms, and having at least one carbon-carbon double bond in the cyclic structure thereof. Examples of the C₁-C₁₀ heterocycloalkenyl group include a 4,5-dihydro-1,2,3,4-oxatriazolyl group, a 2,3-dihydrofuranyl group, and a 2,3-dihydrothiophenyl group. The term "C₁-C₁₀ heterocycloalkenylene group" as utilized herein refers to a divalent group having the same structure as the C₁-C₁₀ heterocycloalkenyl group.

The term "C₆-C₆₀ aryl group" as utilized herein refers to a monovalent group having a carbocyclic aromatic system of 6 to 60 carbon atoms, and the term "C₆-C₆₀ arylene group" as utilized herein refers to a divalent group having a carbocyclic aromatic system of 6 to 60 carbon atoms. Examples of the C₆-C₆₀ aryl group are a phenyl group, a pentalenyl group, a naphthyl group, an azulenyl group, an indacenyl group, an acenaphthyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a heptalenyl group, a naphthacenyl group, a picenyl group, a hexacenyl group, a pentacenyl group, a rubicenyl group, a coronenyl group, and an ovalenyl group. When the C₆-C₆₀ aryl group and the C₆-C₆₀ arylene group each include two or more rings, the rings may be condensed with each other. Corresponding definitions apply to other ranges given for the number of carbon atoms in an aryl/arylene group.

The term "C₁-C₆₀ heteroaryl group" as utilized herein refers to a monovalent group having a heterocyclic aromatic system of 1 to 60 carbon atoms, further including, in addition to carbon atoms, at least one heteroatom, as ring-forming atoms. The term "C₁-C₆₀ heteroarylene group" as utilized herein refers to a divalent group having a heterocyclic aromatic system of 1 to 60 carbon atoms, further including, in addition to carbon atoms, at least one heteroatom, as ring-forming atoms. Examples of the C₁-C₆₀ heteroaryl group are a pyridinyl group, a pyrimidinyl group, a pyrazinyl group, a pyridazinyl group, a triazinyl group, a quinolinyl group, a benzoquinolinyl group, an isoquinolinyl group, a benzoisoquinolinyl group, a quinoxalinyl group, a benzoquinoxalinyl group, a quinazolinyl group, a benzoquinazolinyl group, a cinnolinyl group, a phenanthrolinyl group, a phthalazinyl group, and a naphthyridinyl group. When the C₁-C₆₀ heteroaryl group and the C₁-C₆₀ heteroarylene group each include two or more rings, the rings may be condensed with each other. Corresponding definitions apply to other ranges given for the number of carbon atoms in a heteroaryl/heteroarylene group.

The term "monovalent non-aromatic condensed polycyclic group" as utilized herein refers to a monovalent group (for example, having 8 to 60 carbon atoms) having two or more rings condensed to each other, only carbon atoms as ring-forming atoms, and no aromaticity in its entire molecular structure. Examples of the monovalent non-aromatic condensed polycyclic group are an indenyl group, a fluorenyl group, a spiro-bifluorenyl group, a benzofluorenyl group, an indenophenanthrenyl group, and an indeno anthracenyl group. The term "divalent non-aromatic condensed polycyclic group" as utilized herein refers to a divalent group having the same structure as the monovalent non-aromatic condensed polycyclic group described above.

The term "monovalent non-aromatic condensed heteropolycyclic group" as utilized herein refers to a monovalent group (for example, having 1 to 60 carbon atoms) having two or more rings condensed to each other, further including, in addition to carbon atoms, at least one heteroatom, as ring-forming atoms, and having non-aromaticity in its entire molecular structure. Examples of the monovalent non-aromatic condensed heteropolycyclic group include a pyrrolyl group, a thiophenyl group, a furanyl group, an indolyl group, a benzoindolyl group, a naphtho indolyl group, an isoindolyl group, a benzoisoindolyl group, a naphthoisoindolyl group, a benzosilolyl group, a benzothiophenyl group, a benzofuranyl group, a carbazolyl group, a dibenzosilolyl group, a dibenzothiophenyl group, a dibenzofuranyl group, an azacarbazolyl group, an azafluorenyl group, an azadibenzosilolyl group, an azadibenzothiophenyl group, an azadibenzofuranyl group, a pyrazolyl group, an imidazolyl group, a triazolyl group, a tetrazolyl group, an oxazolyl group, an isoxazolyl group, a thiazolyl group, an isothiazolyl group, an oxadiazolyl group, a thiadiazolyl group, a benzopyrazolyl group, a benzimidazolyl group, a benzoxazolyl group, a benzothiazolyl group, a benzoxadiazolyl group, a benzothiadiazolyl group, an imidazopyridinyl group, an imidazopyrimidinyl group, an imidazotriazinyl group, an imidazopyrazinyl group, an imidazopyridazinyl group, an indenocarbazolyl group, an indolocarbazolyl group, a benzofurocarbazolyl group, a benzothienocarbazolyl group, a benzosilolocarbazolyl group, a benzoindolocarbazolyl group, a benzocarbazolyl group, a benzonaphthofuranyl group, a benzonaphthothiophenyl group, a benzonaphthosilolyl group, a benzofurodibenzofuranyl group, a benzofurodibenzothiophenyl group, and a benzothienodibenzothiophenyl group. The term "divalent non-aromatic condensed heteropolycyclic group" as utilized herein refers to a divalent group having the same structure as the monovalent non-aromatic condensed heteropolycyclic group described above.

The term "C₆-C₆₀ aryloxy group" as utilized herein indicates -OA₁₀₂ (wherein A₁₀₂ is the C₆-C₆₀ aryl group), and the term "C₆-C₆₀ arylthio group" as utilized herein indicates -SA₁₀₃ (wherein A₁₀₃ is the C₆-C₆₀ aryl group). Corresponding definitions apply to other ranges given for the number of carbon atoms in an aryloxy group and an arylthio group.

The term "C₇-C₆₀ arylalkyl group" utilized herein refers to -A₁₀₄A₁₀₅ (where A₁₀₄ may be a C₁-C₅₄ alkylene group, and A₁₀₅ may be a C₆-C₅₉ aryl group), and the term C₂-C₆₀ heteroarylalkyl group" utilized herein refers to -A₁₀₆A₁₀₇ (where A₁₀₆ may be a C₁-C₅₉ alkylene group, and A₁₀₇ may be a C₁-C₅₉ heteroaryl group).

The term "R₁₀ₐ" as utilized herein refers to:
deuterium, -F, -Cl, -Br, -I, a hydroxyl group, a cyano group, or a nitro group;
a C₁-C₆₀ (e.g. C₁-C₂₀) alkyl group, a C₂-C₆₀ (e.g. C₂-C₂₀) alkenyl group, a C₂-C₆₀ (e.g. C₂-C₂₀) alkynyl group, or a C₁-C₆₀ (e.g. C₁-C₂₀) alkoxy group, each unsubstituted or substituted with deuterium, -F, -Cl, -Br, -I, a hydroxyl group, a cyano group, a nitro group, a C₃-C₆₀ (e.g. C₃-C₃₀) carbocyclic group, a C₁-C₆₀ (e.g. C₁-C₂₀) heterocyclic group, a C₆-C₆₀ (e.g. C₆-C₃₀) aryloxy group, a C₆-C₆₀ (e.g. C₆-C₃₀) arylthio group, -Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁), - P(=O)(Q₁₁)(Q₁₂), or a combination thereof;
a C₃-C₆₀ (e.g. C₃-C₃₀) carbocyclic group, a C₁-C₆₀ (e.g. C₁-C₂₀) heterocyclic group, a C₆-C₆₀ (e.g. C₆-C₃₀) aryloxy group, a C₆-C₆₀ (e.g. C₆-C₃₀) arylthio group, each unsubstituted or substituted with deuterium, -F, -Cl, -Br, -I, a hydroxyl group, a cyano group, a nitro group, a C₁-C₆₀ (e.g. C₁-C₂₀) alkyl group, a C₂-C₆₀ (e.g. C₂-C₂₀) alkenyl group, a C₂-C₆₀ (e.g. C₂-C₂₀) alkynyl group, a C₁-C₆₀ (e.g. C₁-C₂₀) alkoxy group, a C₃-C₆₀ (e.g. C₃-C₃₀) carbocyclic group, a C₁-C₆₀ (e.g. C₁-C₂₀) heterocyclic group, a C₆-C₆₀ (e.g. C₆-C₃₀) aryloxy group, a C₆-C₆₀ (e.g. C₆-C₃₀) arylthio group, -Si(Q₂₁)(Q₂₂)(Q₂₃), - N(Q₂₁)(Q₂₂), -B(Q₂₁)(Q₂₂), -C(=O)(Q₂₁), -S(=O)₂(Q₂₁), -P(=O)(Q₂₁)(Q₂₂), or a combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂),
wherein Q₁ to Q₃, Q₁₁ to Q₁₃, Q₂₁ to Q₂₃, and Q₃₁ to Q₃₃ may each independently be: hydrogen; deuterium; -F; -Cl; -Br; -I; a hydroxyl group; a cyano group; a nitro group; or a C₁-C₆₀ (e.g. C₁-C₂₀) alkyl group, a C₂-C₆₀ (e.g. C₂-C₂₀) alkenyl group, a C₂-C₆₀ (e.g. C₂-C₂₀) alkynyl group, a C₁-C₆₀ (e.g. C₁-C₂₀) alkoxy group, a C₃-C₆₀ (e.g. C₃-C₃₀) carbocyclic group, or a C₁-C₆₀ (e.g. C₁-C₂₀) heterocyclic group, each unsubstituted or substituted with deuterium, -F, a cyano group, a C₁-C₆₀ (*e.g.* C₁-C₂₀) alkyl group, a C₁-C₆₀ (e.g. C₁-C₂₀) alkoxy group, a phenyl group, a biphenyl group, or a combination thereof.

The term "heteroatom" as utilized herein refers to any atom other than a carbon atom. Examples of the heteroatom are O, S, N, P, Si, B, Ge, Se, and a combinations thereof.

The term "third-row transition metal" utilized herein includes hafnium (Hf), tantalum (Ta), tungsten (W), rhenium (Re), osmium (Os), iridium (Ir), platinum (Pt), gold (Au), and/or the like.

"Ph" as utilized herein refers to a phenyl group, "Me" as utilized herein refers to a methyl group, "Et" as utilized herein refers to an ethyl group, "ter-Bu" or "Bu^{t}" as utilized herein refers to a tert-butyl group, and "OMe" as utilized herein refers to a methoxy group.

The term "biphenyl group" as utilized herein refers to "a phenyl group substituted with a phenyl group." In other words, the "biphenyl group" is a substituted phenyl group having a C₆-C₆₀ aryl group as a substituent.

The term "terphenyl group" as utilized herein refers to "a phenyl group substituted with a biphenyl group." In other words, the "terphenyl group" is a substituted phenyl group having, as a substituent, a C₆-C₆₀ aryl group substituted with a C₆-C₆₀ aryl group.

* and *' as utilized herein, unless defined otherwise, each refer to a binding site to a neighboring atom in a corresponding formula or moiety.

Hereinafter, compounds according to embodiments and light-emitting devices according to embodiments will be described in more detail with reference to the following synthesis examples and examples. The wording "B was utilized instead of A" utilized in describing Synthesis Examples refers to that an identical molar equivalent of B was utilized in place of A.

### Examples

### Synthesis Example 1: Synthesis of Compound BD01 (M = Pt)

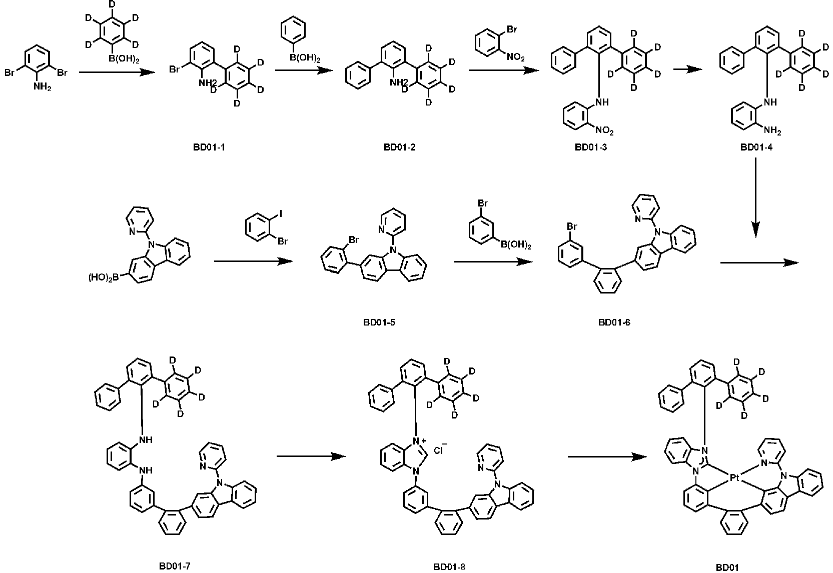

### (1) Synthesis of Intermediate Compound BD01-1

The materials 2,6-dibromoaniline (2.0 eq), (phenyl-d5)boronic acid (1.0 eq), Pd(PPh₃)₄ (0.05 eq), and K₂CO₃ (2.0 eq) were dissolved in tetrahydrofuran:H₂O=4:1 (0.1 M) and stirred at 80 °C for 12 hours. The reaction mixture was subjected to an extraction process utilizing ethyl acetate and washed three times by water to obtain an organic layer. The organic layer thus obtained was dried by utilizing magnesium sulfate, concentrated, and then subjected to column chromatography, so as to synthesize Intermediate Compound BD01-1 (yield: 75%).

### (2) Synthesis of Intermediate Compound BD01-2

Intermediate Compound BD01-1 (1.0 eq), phenyl boronic acid (2.0 eq), Pd(PPh₃)₄ (0.05 eq), and K₂CO₃ (2.0 eq) were dissolved in tetrahydrofuran:H₂O=4:1 (0.1 M) and stirred at 80 °C for 12 hours. The reaction mixture was subjected to an extraction process utilizing ethyl acetate and washed three times by water to obtain an organic layer. The organic layer thus obtained was dried by utilizing magnesium sulfate, concentrated, and then subjected to column chromatography, so as to synthesize Intermediate Compound BD01-2 (yield: 90%).

### (2) Synthesis of Intermediate Compound BD01-3

Intermediate Compound BD01-2 (1.0 eq), 1-bromo-2-nitrobenzene (1.5 eq), Pd₂(dba)₃ (0.1 eq), SPhos (chloro(2-dicyclohexylphosphino-2',6'-dimethoxy-1,1'-biphenyl)[2-(2'-amino-1,1'-biphenyl)]) (0.15 eq), and sodium t-butoxide (4.0 eq) were dissolved in toluene (0.1 M) and stirred at 120 °C for 12 hours. The reaction mixture was cooled at room temperature, and then was filtered through a Celite filter by utilizing dichloromethane, and the filtrate was subjected to an extraction process utilizing dichloromethane and washed three times by water to obtain an organic layer. The organic layer thus obtained was dried by utilizing magnesium sulfate, concentrated, and then subjected to column chromatography, so as to synthesize Intermediate Compound BD01-3 (yield: 78%).

### (4) Synthesis of Intermediate Compound BD01-4

Intermediate Compound BD01-3 (1.0 eq), tin (3.0 eq), and HCl (12 M, 5.0 eq) were dissolved in ethanol (0.12 M) and stirred at 80 °C for 12 hours. The reaction mixture was neutralized with NaOH and subjected to an extraction process utilizing dichloromethane and washed three times by water to obtain an organic layer. The organic layer thus obtained was dried by utilizing magnesium sulfate, concentrated, and then subjected to column chromatography, so as to synthesize Intermediate Compound BD01-4 (yield: 75%).

### (5) Synthesis of Intermediate Compound BD01-5

The materials (9-(pyridin-2-yl)-9H-carbazol-2-yl)boronic acid (1.0 eq), 1-bromo-2-iodobenzene (1.2 eq), Pd(PPh₃)₄ (0.05 eq), and K₂CO₃ (2.0 eq) were dissolved in tetrahydrofuran:H₂O=4:1 (0.1 M) and stirred at 80 °C for 12 hours. The reaction mixture was subjected to an extraction process utilizing ethyl acetate and washed three times by water to obtain an organic layer. The organic layer thus obtained was dried by utilizing magnesium sulfate, concentrated, and then subjected to column chromatography, so as to synthesize Intermediate Compound BD01-5 (yield: 78%).

### (6) Synthesis of Intermediate Compound BD01-6

Intermediate Compound BD01-5 (1.2 eq), (3-bromophenyl)boronic acid (1.0 eq), Pd(PPh₃)₄ (0.05 eq), and K₂CO₃ (2.0 eq) were dissolved in tetrahydrofuran:H₂O=4:1 (0.1 M) and stirred at 80 °C for 12 hours. The reaction mixture was subjected to an extraction process utilizing ethyl acetate and washed three times by water to obtain an organic layer. The organic layer thus obtained was dried by utilizing magnesium sulfate, concentrated, and then subjected to column chromatography, so as to synthesize Intermediate Compound BD01-6 (yield: 62%).

### (7) Synthesis of Intermediate Compound BD01-7

Intermediate Compound BD01-6 (1.0 eq), Intermediate Compound BD01-4 (1.3 eq), Pd₂(dba)₃(0.05 eq), sodium t-butoxide (2.0 eq), and Xphos (2-dicyclohexylphosphino-2',4',6'-triisopropylbiphenyl) (0.15 eq) were dissolved in 1,4-dioxane (0.1 M) and stirred at 110 °C for 4 hours. The reaction mixture was cooled at room temperature, and then subjected to an extraction process utilizing dichloromethane and washed three times by water to obtain an organic layer. The organic layer thus obtained was dried by utilizing magnesium sulfate, concentrated, and then subjected to column chromatography, so as to synthesize Intermediate Compound BD01-7 (yield: 87%).

### (8) Synthesis of Intermediate Compound BD01-8

Intermediate Compound BD01-7 (1.0 eq) and triethyl orthoformate (50.0 eq) were dissolved in HCl (35%, 1.2 eq) and stirred at 80 °C for 12 hours. The reaction mixture was subjected to an extraction process utilizing dichloromethane and washed three times by water to obtain an organic layer. The organic layer thus obtained was dried by utilizing magnesium sulfate, concentrated, and then subjected to column chromatography, so as to synthesize Intermediate Compound BD01-8 (yield: 89%).

### (9) Synthesis of Compound BD01

Intermediate Compound BD01-8 (1.0 eq), K₂PtCl₄ (1.1 eq), and 2,6-lutidine (4.0 eq) were dissolved in o-DCB (1,2-dichlorobenzene) (0.05 M) and stirred at 120 °C for 12 hours. The reaction mixture was cooled at room temperature, and was filtered through a Si filter by utilizing dichloromethane and n-hexane to remove o-DCB therefrom and synthesize Compound BD01 (yield 55 %).

### Synthesis Example 2: Synthesis of Compound BD07 (M = Pt)

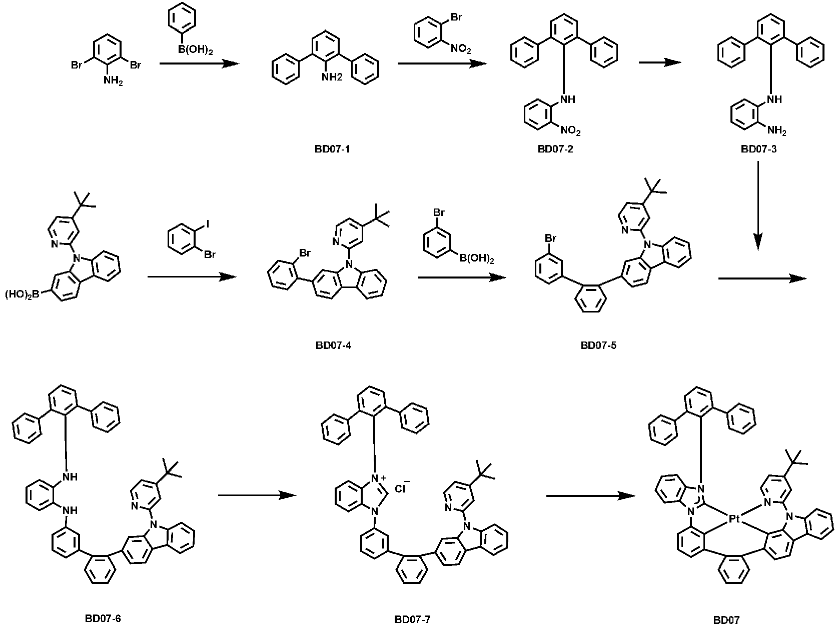

### (1) Synthesis of Intermediate Compound BD07-1

The materials 2,6-dibromoaniline (1.0 eq), phenyl boronic acid (2.0 eq), Pd(PPh₃)₄ (0.05 eq), and K₂CO₃ (2.0 eq) were dissolved in tetrahydrofuran:H₂O=4:1 (0.1 M) and stirred at 80 °C for 12 hours. The reaction mixture was subjected to an extraction process utilizing ethyl acetate and washed three times by water to obtain an organic layer. The organic layer thus obtained was dried by utilizing magnesium sulfate, concentrated, and then subjected to column chromatography, so as to synthesize Intermediate Compound BD07-1 (yield: 94%).

### (2) Synthesis of Intermediate Compound BD07-2

Intermediate Compound BD07-2 (1.0 eq), 1-bromo-2-nitrobenzene (1.5 eq), Pd₂(dba)₃ (0.1 eq), SPhos (0.15 eq), and sodium t-butoxide (4.0 eq) were dissolved in toluene (0.1 M) and stirred at 120 °C for 12 hours. The reaction mixture was cooled at room temperature, and then was filtered through a Celite filter by utilizing dichloromethane, and the filtrate was subjected to an extraction process utilizing dichloromethane and washed three times by water to obtain an organic layer. The organic layer thus obtained was dried by utilizing magnesium sulfate, concentrated, and then subjected to column chromatography, so as to synthesize Intermediate Compound BD07-2 (yield: 80%).

### (3) Synthesis of Intermediate Compound BD07-3

Intermediate Compound BD07-2 (1.0 eq), tin (3.0 eq), and HCl (12 M, 5.0 eq) were dissolved in ethanol (0.12 M) and stirred at 80 °C for 12 hours. The reaction mixture was neutralized with NaOH and subjected to an extraction process utilizing dichloromethane and washed three times by water to obtain an organic layer. The organic layer thus obtained was dried by utilizing magnesium sulfate, concentrated, and then subjected to column chromatography, so as to synthesize Intermediate Compound BD07-3 (yield: 75%).

### (4) Synthesis of Intermediate Compound BD07-4

The materials (9-(4-(tert-butyl)pyridin-2-yl)-9H-carbazol-2-yl)boronic acid (1.0 eq), 1-bromo-2-iodobenzene (1.2 eq), Pd(PPh₃)₄ (0.05 eq), and K₂CO₃ (2.0 eq) were dissolved in tetrahydrofuran:H₂O=4:1 (0.1 M) and stirred at 80 °C for 12 hours. The reaction mixture was subjected to an extraction process utilizing ethyl acetate and washed three times by water to obtain an organic layer. The organic layer thus obtained was dried by utilizing magnesium sulfate, concentrated, and then subjected to column chromatography, so as to synthesize Intermediate Compound BD07-4 (yield: 66%).

### (5) Synthesis of Intermediate Compound BD07-5

Intermediate Compound BD07-4 (1.2 eq), (3-bromophenyl)boronic acid (1.0 eq), Pd(PPh₃)₄ (0.05 eq), and K₂CO₃ (2.0 eq) were dissolved in tetrahydrofuran:H₂O=4:1 (0.1 M) and stirred at 80 °C for 12 hours. The reaction mixture was subjected to an extraction process utilizing ethyl acetate and washed three times by water to obtain an organic layer. The organic layer thus obtained was dried by utilizing magnesium sulfate, concentrated, and then subjected to column chromatography, so as to synthesize Intermediate Compound BD07-5 (yield: 81%).

### (6) Synthesis of Intermediate Compound BD07-6

Intermediate Compound BD07-5 (1.0 eq), Intermediate Compound BD07-3 (1.3 eq), Pd₂(dba)₃(0.05 eq), sodium t-butoxide (2.0 eq), and Xphos (0.15 eq) were dissolved in 1,4-dioxane (0.1 M) and stirred at 110 °C for 4 hours. The reaction mixture was cooled at room temperature, and then subjected to an extraction process utilizing dichloromethane and washed three times by water to obtain an organic layer. The organic layer thus obtained was dried by utilizing magnesium sulfate, concentrated, and then subjected to column chromatography, so as to synthesize Intermediate Compound BD07-6 (yield: 76%).

### (7) Synthesis of Intermediate Compound BD07-7

Intermediate Compound BD07-6 (1.0 eq) and triethyl orthoformate (50.0 eq) were dissolved in HCl (35%, 1.2 eq) and stirred at 80 °C for 12 hours. The reaction mixture was subjected to an extraction process utilizing dichloromethane and washed three times by water to obtain an organic layer. The organic layer thus obtained was dried by utilizing magnesium sulfate, concentrated, and then subjected to column chromatography, so as to synthesize Intermediate Compound BD07-7 (yield: 83%).

### (8) Synthesis of Compound BD07

Intermediate Compound BD07-7 (1.0 eq), K₂PtCl₄ (1.1 eq), and 2,6-lutidine (4.0 eq) were dissolved in o-DCB (0.05 M) and stirred at 120 °C for 12 hours. The reaction mixture was cooled at room temperature, and was filtered through a Si filter by utilizing dichloromethane and n-hexane to remove o-DCB therefrom and synthesize Compound BD07 (yield 52%).

### Synthesis Example 3: Synthesis of Compound BD17 (M = Pt)

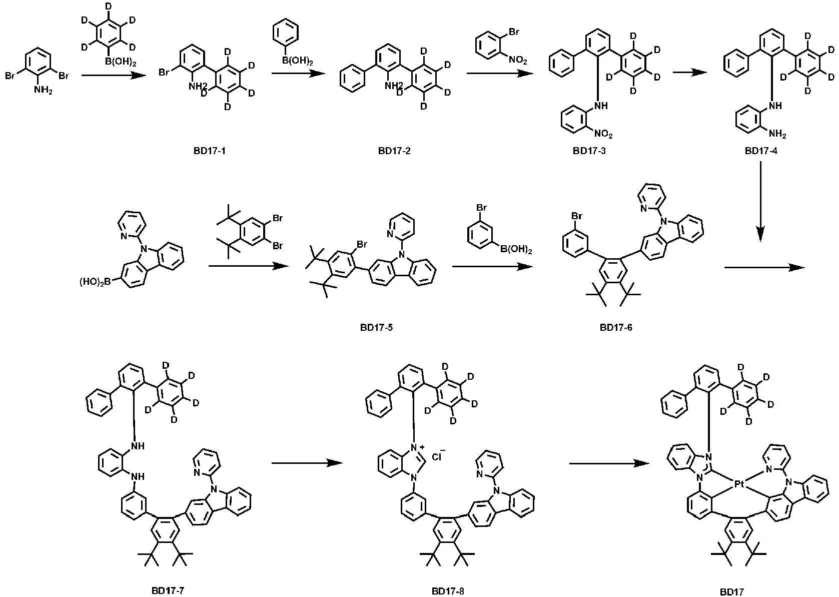

### (1) Synthesis of Intermediate Compound BD17-1

The materials 2,6-dibromoaniline (2.0 eq), (phenyl-d5)boronic acid (1.0 eq), Pd(PPh₃)₄ (0.05 eq), and K₂CO₃ (2.0 eq) were dissolved in tetrahydrofuran:H₂O=4:1 (0.1 M) and stirred at 80 °C for 12 hours. The reaction mixture was subjected to an extraction process utilizing ethyl acetate and washed three times by water to obtain an organic layer. The organic layer thus obtained was dried by utilizing magnesium sulfate, concentrated, and then subjected to column chromatography, so as to synthesize Intermediate Compound BD17-1 (yield: 75%).

### (2) Synthesis of Intermediate Compound BD17-2

Intermediate Compound BD17-1 (1.0 eq), phenyl boronic acid (2.0 eq), Pd(PPh₃)₄ (0.05 eq), and K₂CO₃ (2.0 eq) were dissolved in tetrahydrofuran:H₂O=4:1 (0.1 M) and stirred at 80 °C for 12 hours. The reaction mixture was subjected to an extraction process utilizing ethyl acetate and washed three times by water to obtain an organic layer. The organic layer thus obtained was dried by utilizing magnesium sulfate, concentrated, and then subjected to column chromatography, so as to synthesize Intermediate Compound BD17-2 (yield: 90%).

### (3) Synthesis of Intermediate Compound BD17-3

Intermediate Compound BD17-2 (1.0 eq), 1-bromo-2-nitrobenzene (1.5 eq), Pd₂(dba)₃ (0.1 eq), SPhos (0.15 eq), and sodium t-butoxide (4.0 eq) were dissolved in toluene (0.1 M) and stirred at 120 °C for 12 hours. The reaction mixture was cooled at room temperature, and then was filtered through Celite filter by utilizing dichloromethane, and the filtrate was subjected to an extraction process utilizing dichloromethane and washed three times by water to obtain an organic layer. The organic layer thus obtained was dried by utilizing magnesium sulfate, concentrated, and then subjected to column chromatography, so as to synthesize Intermediate Compound BD17-3 (yield: 78%).

### (4) Synthesis of Intermediate Compound BD17-4

Intermediate Compound BD17-3 (1.0 eq), tin (3.0 eq), and HCl (12 M, 5.0 eq) were dissolved in ethanol (0.12 M) and stirred at 80 °C for 12 hours. The reaction mixture was neutralized with NaOH and subjected to an extraction process utilizing dichloromethane and washed three times by water to obtain an organic layer. The organic layer thus obtained was dried by utilizing magnesium sulfate, concentrated, and then subjected to column chromatography, so as to synthesize Intermediate Compound BD17-4 (yield: 75%).

### (5) Synthesis of Intermediate Compound BD17-5

The materials (9-(pyridin-2-yl)-9H-carbazol-2-yl)boronic acid (1.0 eq), 1,2-dibromo-4,5-di-tert-butylbenzene (2.0 eq), Pd(PPh₃)₄ (0.05 eq), and K₂CO₃ (2.0 eq) were dissolved in tetrahydrofuran:H₂O=4:1 (0.1 M) and stirred at 80 °C for 12 hours. The reaction mixture was subjected to an extraction process utilizing ethyl acetate and washed three times by water to obtain an organic layer. The organic layer thus obtained was dried by utilizing magnesium sulfate, concentrated, and then subjected to column chromatography, so as to synthesize Intermediate Compound BD17-5 (yield: 15%).

### (6) Synthesis of Intermediate Compound BD17-6

Intermediate Compound BD17-5 (1.2 eq), (3-bromophenyl)boronic acid (1.0 eq), Pd(PPh₃)₄ (0.05 eq), and K₂CO₃ (2.0 eq) were dissolved in tetrahydrofuran:H₂O=4:1 (0.1 M) and stirred at 80 °C for 12 hours. The reaction mixture was subjected to an extraction process utilizing ethyl acetate and washed three times by water to obtain an organic layer. The organic layer thus obtained was dried by utilizing magnesium sulfate, concentrated, and then subjected to column chromatography, so as to synthesize Intermediate Compound BD17-6 (yield: 67 %).

### (7) Synthesis of Intermediate Compound BD17-7

Intermediate Compound BD17-6 (1.0 eq), Intermediate Compound BD17-4 (1.3 eq), Pd₂(dba)₃(0.05 eq), sodium t-butoxide (2.0 eq), and Xphos (0.15 eq) were dissolved in 1,4-dioxane (0.1 M) and stirred at 110 °C for 4 hours. The reaction mixture was cooled at room temperature, and then subjected to an extraction process utilizing dichloromethane and washed three times by water to obtain an organic layer. The organic layer thus obtained was dried by utilizing magnesium sulfate, concentrated, and then subjected to column chromatography, so as to synthesize Intermediate Compound BD17-7 (yield: 75%).

### (8) Synthesis of Intermediate Compound BD17-8

Intermediate Compound BD17-7 (1.0 eq) and triethyl orthoformate (50.0 eq) were dissolved in HCl (35%, 1.2 eq) and stirred at 80 °C for 12 hours. The reaction mixture was subjected to an extraction process utilizing dichloromethane and washed three times by water to obtain an organic layer. The organic layer thus obtained was dried by utilizing magnesium sulfate, concentrated, and then subjected to column chromatography, so as to synthesize Intermediate Compound BD17-8 (yield: 81%).

### (9) Synthesis of Compound BD17

Intermediate Compound BD17-8 (1.0 eq), K₂PtCl₄ (1.1 eq), and 2,6-lutidine (4.0 eq) were dissolved in o-DCB (0.05 M) and stirred at 120 °C for 12 hours. The reaction mixture was cooled at room temperature, and was filtered through a Si filter by utilizing dichloromethane and n-hexane to remove o-DCB therefrom and synthesize Compound BD17 (yield 53%).

### Synthesis Example 4: Synthesis of Compound BD25 (M = Pt)

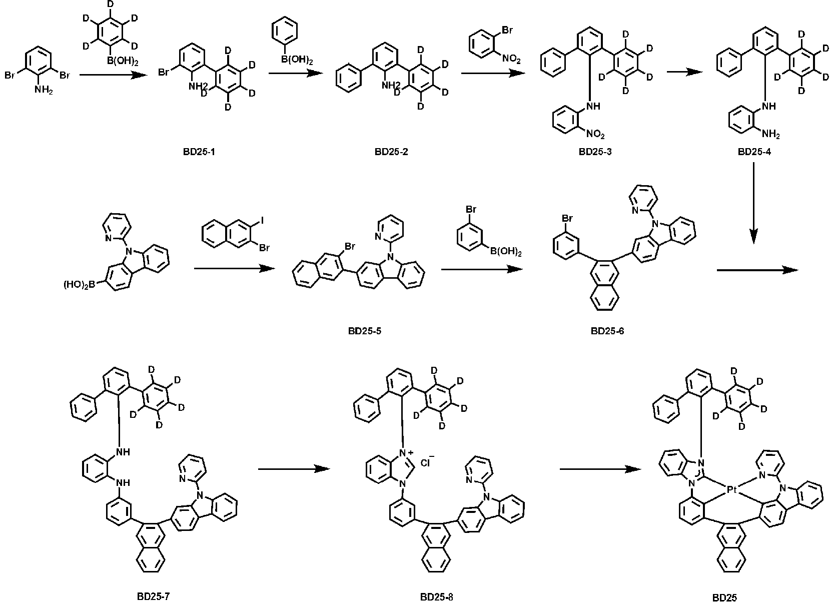

### (1) Synthesis of Intermediate Compound BD25-1

The materials 2,6-dibromoaniline (2.0 eq), (phenyl-d5)boronic acid (1.0 eq), Pd(PPh₃)₄ (0.05 eq), and K₂CO₃ (2.0 eq) were dissolved in tetrahydrofuran:H₂O=4:1 (0.1 M) and stirred at 80 °C for 12 hours. The reaction mixture was subjected to an extraction process utilizing ethyl acetate and washed three times by water to obtain an organic layer. The organic layer thus obtained was dried by utilizing magnesium sulfate, concentrated, and then subjected to column chromatography, so as to synthesize Intermediate Compound BD25-1 (yield: 75%).

### (2) Synthesis of Intermediate Compound BD25-2

Intermediate Compound BD25-1 (1.0 eq), phenyl boronic acid (2.0 eq), Pd(PPh₃)₄ (0.05 eq), and K₂CO₃ (2.0 eq) were dissolved in tetrahydrofuran:H₂O=4:1 (0.1 M) and stirred at 80 °C for 12 hours. The reaction mixture was subjected to an extraction process utilizing ethyl acetate and washed three times by water to obtain an organic layer. The organic layer thus obtained was dried by utilizing magnesium sulfate, concentrated, and then subjected to column chromatography, so as to synthesize Intermediate Compound BD25-2 (yield: 90%).

### (3) Synthesis of Intermediate Compound BD25-3

Intermediate Compound BD25-2 (1.0 eq), 1-bromo-2-nitrobenzene (1.5 eq), Pd₂(dba)₃ (0.1 eq), SPhos (0.15 eq), and sodium t-butoxide (4.0 eq) were dissolved in toluene (0.1 M) and stirred at 120 °C for 12 hours. The reaction mixture was cooled at room temperature, and then was filtered through a Celite filter by utilizing dichloromethane, and the filtrate was subjected to an extraction process utilizing dichloromethane and washed three times by water to obtain an organic layer. The organic layer thus obtained was dried by utilizing magnesium sulfate, concentrated, and then subjected to column chromatography, so as to synthesize Intermediate Compound BD25-3 (yield: 78%).

### (4) Synthesis of Intermediate Compound BD25-4

Intermediate Compound BD25-3 (1.0 eq), tin (3.0 eq), and HCl (12 M, 5.0 eq) were dissolved in ethanol (0.12 M) and stirred at 80 °C for 12 hours. The reaction mixture was neutralized with NaOH and subjected to an extraction process utilizing dichloromethane and washed three times by water to obtain an organic layer. The organic layer thus obtained was dried by utilizing magnesium sulfate, concentrated, and then subjected to column chromatography, so as to synthesize Intermediate Compound BD25-4 (yield: 75%).

### (5) Synthesis of Intermediate Compound BD25-5

The materials (9-(pyridin-2-yl)-9H-carbazol-2-yl)boronic acid (1.0 eq), 2-bromo-3-iodonaphthalene (1.2 eq), Pd(PPh₃)₄ (0.05 eq), and K₂CO₃ (2.0 eq) were dissolved in tetrahydrofuran:H₂O=4:1 (0.1 M) and stirred at 80 °C for 12 hours. The reaction mixture was subjected to an extraction process utilizing ethyl acetate and washed three times by water to obtain an organic layer. The organic layer thus obtained was dried by utilizing magnesium sulfate, concentrated, and then subjected to column chromatography, so as to synthesize Intermediate Compound BD25-5 (yield: 70%).

### (6) Synthesis of Intermediate Compound BD25-6

Intermediate Compound BD25-5 (1.2 eq), (3-bromophenyl)boronic acid (1.0 eq), Pd(PPh₃)₄ (0.05 eq), and K₂CO₃ (2.0 eq) were dissolved in tetrahydrofuran:H₂O=4:1 (0.1 M) and stirred at 80 °C for 12 hours. The reaction mixture was subjected to an extraction process utilizing ethyl acetate and washed three times by water to obtain an organic layer. The organic layer thus obtained was dried by utilizing magnesium sulfate, concentrated, and then subjected to column chromatography, so as to synthesize Intermediate Compound BD25-6 (yield: 69%).

### (7) Synthesis of Intermediate Compound BD25-7

Intermediate Compound BD25-6 (1.0 eq), Intermediate Compound BD25-4 (1.3 eq), Pd₂(dba)₃ (0.05 eq), sodium t-butoxide (2.0 eq), and Xphos (0.15 eq) were dissolved in 1,4-dioxane (0.1 M) and stirred at 110 °C for 4 hours. The reaction mixture was cooled at room temperature, and then subjected to an extraction process utilizing dichloromethane and washed three times by water to obtain an organic layer. The organic layer thus obtained was dried by utilizing magnesium sulfate, concentrated, and then subjected to column chromatography, so as to synthesize Intermediate Compound BD25-7 (yield: 88%).

### (8) Synthesis of Intermediate Compound BD25-8

Intermediate Compound BD25-7 (1.0 eq) and triethyl orthoformate (50.0 eq) were dissolved in HCl (35%, 1.2 eq) and stirred at 80 °C for 12 hours. The reaction mixture was subjected to an extraction process utilizing dichloromethane and washed three times by water to obtain an organic layer. The organic layer thus obtained was dried by utilizing magnesium sulfate, concentrated, and then subjected to column chromatography, so as to synthesize Intermediate Compound BD25-8 (yield: 80%).

### (9) Synthesis of Compound BD25

Intermediate Compound BD25-8 (1.0 eq), K₂PtCl₄ (1.1 eq), and 2,6-lutidine (4.0 eq) were dissolved in o-DCB (0.05 M) and stirred at 120 °C for 12 hours. The reaction mixture was cooled at room temperature, and was filtered through a Si filter by utilizing dichloromethane and n-hexane to remove o-DCB therefrom and synthesize Compound BD25 (yield 55%).

### Synthesis Example 5: Synthesis of Compound BD41 (M = Pt)

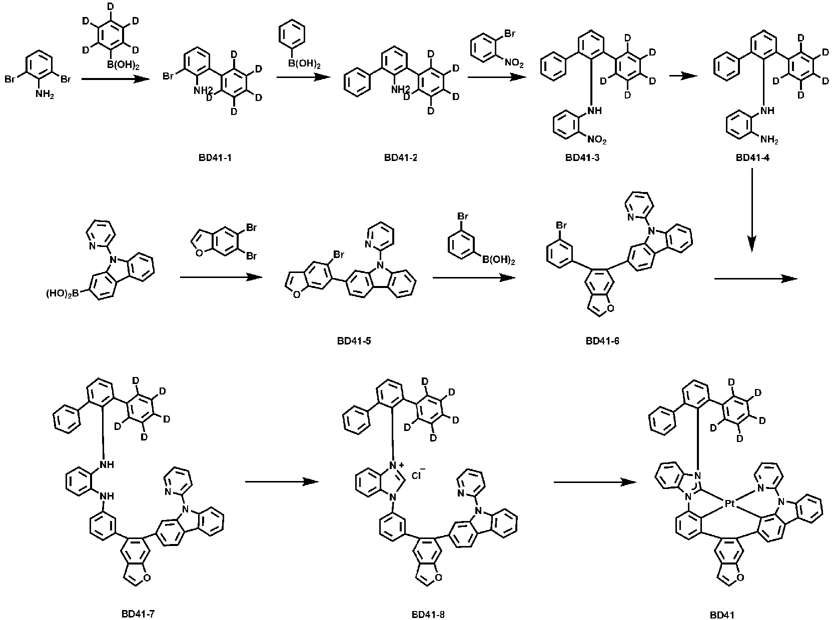

### (1) Synthesis of Intermediate Compound BD41-1

The materials 2,6-dibromoaniline (2.0 eq), (phenyl-d5)boronic acid (1.0 eq), Pd(PPh₃)₄ (0.05 eq), and K₂CO₃ (2.0 eq) were dissolved in tetrahydrofuran:H₂O=4:1 (0.1 M) and stirred at 80 °C for 12 hours. The reaction mixture was subjected to an extraction process utilizing ethyl acetate and washed three times by water to obtain an organic layer. The organic layer thus obtained was dried by utilizing magnesium sulfate, concentrated, and then subjected to column chromatography, so as to synthesize Intermediate Compound BD41-1 (yield: 75%).

### (2) Synthesis of Intermediate Compound BD41-2

Intermediate Compound BD41-1 (1.0 eq), phenyl boronic acid (2.0 eq), Pd(PPh₃)₄ (0.05 eq), and K₂CO₃ (2.0 eq) were dissolved in tetrahydrofuran:H₂O=4:1 (0.1 M) and stirred at 80 °C for 12 hours. The reaction mixture was subjected to an extraction process utilizing ethyl acetate and washed three times by water to obtain an organic layer. The organic layer thus obtained was dried by utilizing magnesium sulfate, concentrated, and then subjected to column chromatography, so as to synthesize Intermediate Compound BD41-2 (yield: 90%).

### (3) Synthesis of Intermediate Compound BD41-3

Intermediate Compound BD41-2 (1.0 eq), 1-bromo-2-nitrobenzene (1.5 eq), Pd₂(dba)₃ (0.1 eq), SPhos (0.15 eq), and sodium t-butoxide (4.0 eq) were dissolved in toluene (0.1 M) and stirred at 120 °C for 12 hours. The reaction mixture was cooled at room temperature, and then was filtered through a Celite filter by utilizing dichloromethane, and the filtrate was subjected to an extraction process utilizing dichloromethane and washed three times by water to obtain an organic layer. The organic layer thus obtained was dried by utilizing magnesium sulfate, concentrated, and then subjected to column chromatography, so as to synthesize Intermediate Compound BD41-3 (yield: 78%).

### (4) Synthesis of Intermediate Compound BD41-4

Intermediate Compound BD41-3 (1.0 eq), tin (3.0 eq), and HCl (12 M, 5.0 eq) were dissolved in ethanol (0.12 M) and stirred at 80 °C for 12 hours. The reaction mixture was neutralized with NaOH and subjected to an extraction process utilizing dichloromethane and washed three times by water to obtain an organic layer. The organic layer thus obtained was dried by utilizing magnesium sulfate, concentrated, and then subjected to column chromatography, so as to synthesize Intermediate Compound BD41-4 (yield: 75%).

### (5) Synthesis of Intermediate Compound BD41-5

The materials (9-(pyridin-2-yl)-9H-carbazol-2-yl)boronic acid (1.0 eq), 5,6-dibromobenzofuran (1.2 eq), Pd(PPh₃)₄ (0.05 eq), and K₂CO₃ (2.0 eq) were dissolved in tetrahydrofuran:H₂O=4:1 (0.1 M) and stirred at 80 °C for 12 hours. The reaction mixture was subjected to an extraction process utilizing ethyl acetate and washed three times by water to obtain an organic layer. The organic layer thus obtained was dried by utilizing magnesium sulfate, concentrated, and then subjected to column chromatography, so as to synthesize Intermediate Compound BD41-5 (yield: 15%).

### (6) Synthesis of Intermediate Compound BD41-6

Intermediate Compound BD41-5 (1.2 eq), (3-bromophenyl)boronic acid (1.0 eq), Pd(PPh₃)₄ (0.05 eq), and K₂CO₃ (2.0 eq) were dissolved in tetrahydrofuran:H₂O=4:1 (0.1 M) and stirred at 80 °C for 12 hours. The reaction mixture was subjected to an extraction process utilizing ethyl acetate and washed three times by water to obtain an organic layer. The organic layer thus obtained was dried by utilizing magnesium sulfate, concentrated, and then subjected to column chromatography, so as to synthesize Intermediate Compound BD41-6 (yield: 61%).

### (7) Synthesis of Intermediate Compound BD41-7

Intermediate Compound BD41-6 (1.0 eq), Intermediate Compound BD41-4 (1.3 eq), Pd₂(dba)₃ (0.05 eq), sodium t-butoxide (2.0 eq), and Xphos (0.15 eq) were dissolved in 1,4-dioxane (0.1 M) and stirred at 110 °C for 4 hours. The reaction mixture was cooled at room temperature, and then subjected to an extraction process utilizing dichloromethane and washed three times by water to obtain an organic layer. The organic layer thus obtained was dried by utilizing magnesium sulfate, concentrated, and then subjected to column chromatography, so as to synthesize Intermediate Compound BD41-7 (yield: 85%).

### (8) Synthesis of Intermediate Compound BD41-8

Intermediate Compound BD41-7 (1.0 eq) and triethyl orthoformate (50.0 eq) were dissolved in HCl (35%, 1.2 eq) and stirred at 80 °C for 12 hours. The reaction mixture was subjected to an extraction process utilizing dichloromethane and washed three times by water to obtain an organic layer. The organic layer thus obtained was dried by utilizing magnesium sulfate, concentrated, and then subjected to column chromatography, so as to synthesize Intermediate Compound BD41-8 (yield: 72%).

### (9) Synthesis of Compound BD41

Intermediate Compound BD41-8 (1.0 eq), K₂PtCl₄ (1.1 eq), and 2,6-lutidine (4.0 eq) were dissolved in o-DCB (0.05 M) and stirred at 120 °C for 12 hours. The reaction mixture was cooled at room temperature, and was filtered through a Si filter by utilizing dichloromethane and n-hexane to remove o-DCB therefrom and synthesize Compound BD41 (yield: 50%).

### Synthesis Example 6: Synthesis of Compound BD49 (M = Pt)

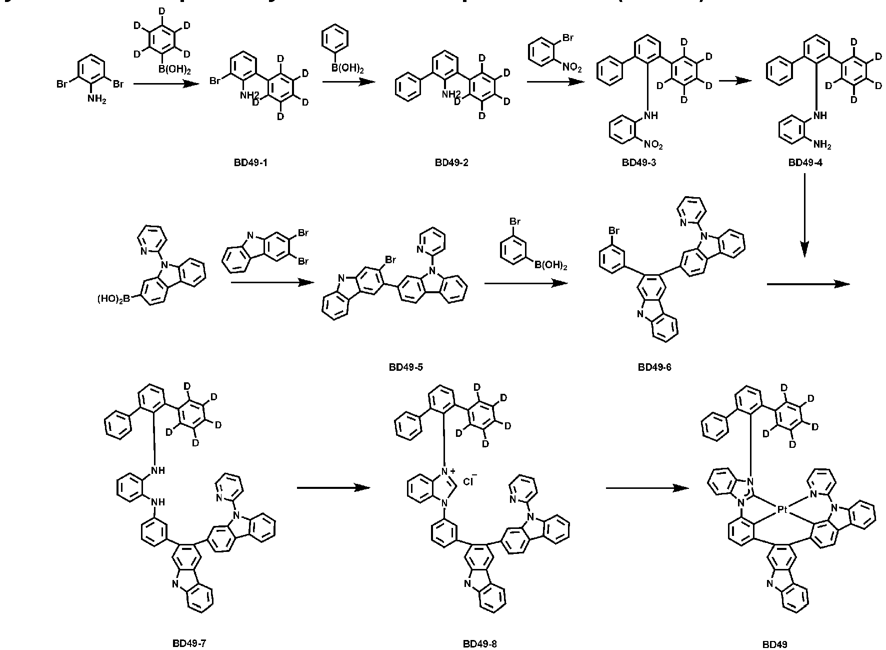

### (1) Synthesis of Intermediate Compound BD49-1

The materials 2,6-dibromoaniline (2.0 eq), (phenyl-d5)boronic acid (1.0 eq), Pd(PPh₃)₄ (0.05 eq), and K₂CO₃ (2.0 eq) were dissolved in tetrahydrofuran:H₂O=4:1(0.1 M) and stirred at 80 °C for 12 hours. The reaction mixture was subjected to an extraction process utilizing ethyl acetate and washed three times by water to obtain an organic layer. The organic layer thus obtained was dried by utilizing magnesium sulfate, concentrated, and then subjected to column chromatography, so as to synthesize Intermediate Compound BD49-1 (yield: 75%).

### (2) Synthesis of Intermediate Compound BD49-2

Intermediate Compound BD49-1 (1.0 eq), phenyl boronic acid (2.0 eq), Pd(PPh₃)₄ (0.05 eq), and K₂CO₃ (2.0 eq) were dissolved in tetrahydrofuran:H₂O=4:1 (0.1 M) and stirred at 80 °C for 12 hours. The reaction mixture was subjected to an extraction process utilizing ethyl acetate and washed three times by water to obtain an organic layer. The organic layer thus obtained was dried by utilizing magnesium sulfate, concentrated, and then subjected to column chromatography, so as to synthesize Intermediate Compound BD49-2 (yield: 90%).

### (3) Synthesis of Intermediate Compound BD49-3

Intermediate Compound BD49-2 (1.0 eq), 1-bromo-2-nitrobenzene (1.5 eq), Pd₂(dba)₃ (0.1 eq), SPhos (0.15 eq), and sodium t-butoxide (4.0 eq) were dissolved in toluene (0.1 M) and stirred at 120 °C for 12 hours. The reaction mixture was cooled at room temperature, and then was filtered through a Celite filter by utilizing dichloromethane, and the filtrate was subjected to an extraction process utilizing dichloromethane and washed three times by water to obtain an organic layer. The organic layer thus obtained was dried by utilizing magnesium sulfate, concentrated, and then subjected to column chromatography, so as to synthesize Intermediate Compound BD49-3 (yield: 78%).

### (4) Synthesis of Intermediate Compound BD49-4

Intermediate Compound BD49-3 (1.0 eq), tin (3.0 eq), and HCl (12 M, 5.0 eq) were dissolved in ethanol (0.12 M) and stirred at 80 °C for 12 hours. The reaction mixture was neutralized with NaOH and subjected to an extraction process utilizing dichloromethane and washed three times by water to obtain an organic layer. The organic layer thus obtained was dried by utilizing magnesium sulfate, concentrated, and then subjected to column chromatography, so as to synthesize Intermediate Compound BD49-4 (yield: 77%).

### (5) Synthesis of Intermediate Compound BD49-5

The materials (9-(pyridin-2-yl)-9H-carbazol-2-yl)boronic acid (1.0 eq), 2,3-dibromocarbazole (2.0 eq), Pd(PPh₃)₄ (0.05 eq), and K₂CO₃ (2.0 eq) were dissolved in tetrahydrofuran:H₂O=4:1 (0.1 M) and stirred at 80 °C for 12 hours. The reaction mixture was subjected to an extraction process utilizing ethyl acetate and washed three times by water to obtain an organic layer. The organic layer thus obtained was dried by utilizing magnesium sulfate, concentrated, and then subjected to column chromatography, so as to synthesize Intermediate Compound BD49-5 (yield: 12%).

### (6) Synthesis of Intermediate Compound BD49-6

Intermediate Compound BD49-5 (1.2 eq), (3-bromophenyl)boronic acid (1.0 eq), Pd(PPh₃)₄ (0.05 eq), and K₂CO₃ (2.0 eq) were dissolved in tetrahydrofuran:H₂O=4:1 (0.1 M) and stirred at 80 °C for 12 hours. The reaction mixture was subjected to an extraction process utilizing ethyl acetate and washed three times by water to obtain an organic layer. The organic layer thus obtained was dried by utilizing magnesium sulfate, concentrated, and then subjected to column chromatography, so as to synthesize Intermediate Compound BD49-6 (yield: 55%).

### (7) Synthesis of Intermediate Compound BD49-7

Intermediate Compound BD49-6 (1.0 eq), Intermediate Compound BD49-4 (1.3 eq), Pd₂(dba)₃ (0.05 eq), sodium t-butoxide (2.0 eq), and Xphos (0.15 eq) were dissolved in 1,4-dioxane (0.1 M) and stirred at 110 °C for 4 hours. The reaction mixture was cooled at room temperature, and then subjected to an extraction process utilizing dichloromethane and washed three times by water to obtain an organic layer. The organic layer thus obtained was dried by utilizing magnesium sulfate, concentrated, and then subjected to column chromatography, so as to synthesize Intermediate Compound BD49-7 (yield: 91%).

### (8) Synthesis of Intermediate Compound BD49-8

Intermediate Compound BD49-7 (1.0 eq) and triethyl orthoformate (50.0 eq) were dissolved in HCl (35%, 1.2 eq) and stirred at 80 °C for 12 hours. The reaction mixture was subjected to an extraction process utilizing dichloromethane and washed three times by water to obtain an organic layer. The organic layer thus obtained was dried by utilizing magnesium sulfate, concentrated, and then subjected to column chromatography, so as to synthesize Intermediate Compound BD49-8 (yield: 79%).

### (9) Synthesis of Compound BD49

Intermediate Compound BD49-8 (1.0 eq), K₂PtCl₄ (1.1 eq), and 2,6-lutidine (4.0 eq) were dissolved in o-DCB (0.05 M) and stirred at 120 °C for 12 hours. The reaction mixture was cooled at room temperature, and was filtered through a Si filter by utilizing dichloromethane and n-hexane to remove o-DCB therefrom and synthesize Compound BD49 (yield: 56%).

¹H NMR and MS/FAB of the compounds synthesized according to Synthesis Examples 1-6 are shown in Table 1. Synthesis methods of other compounds in addition to the compound synthesized in Synthesis Example may be easily recognized by those skilled in the art by referring to the synthesis paths and source materials.

**Table 1**

| ID | ¹H NMR (CDCl₃ , 400 MHz) | MS/FAB | |
|---|---|---|---|
| | | found | calc. |
| BD01 | 8.65(d,1H), 8.55(d, 1H), 8.20-8.15(m,3H), 8.02-7.91(m,5H), 7.60-7.55(m,3H), 7.43-7.28(m,8H), 7.16-7.08(m,5H), 6.95(t,2H) | 939.28 | 940.02 |
| BD07 | H), 8.55(d,1H), 8.22-8.19(m,2H), 7,96(d,2H), 7.60-7.39(m,15H), 7,28-7.08(m,8H), 6.95(t,2H), 1.32(s,9H) | 990.31 | 991.09 |
| BD17 | 8.65(d,1H), 8.55(d,1H), 8.31(d,1H), 8.20-8.15(m,3H), 8.04-8.02(m,3H), 7.94-7.91 (m,2H), 7.55(t,1H), 7.43-7.28(m,8H), 7.16-7.08(m,5H), 6.95(m,2H), 1.35(s,9H) | 1051.41 | 1052.23 |
| BD25 | 8.65(d,1H), 8.57-8.55(m,3H), 8.31(d,1H), 8.20-8.15(m,5H), 8.02(d,1H), 7.94-7.91(m,2H), 7.64-7.55(m,3H), 7.43-7.28(m,8H), 7.16-7.08(m,5H), 6.95(m,2H) | 989.30 | 990.08 |
| BD41 | 8.65(d,1H), 8.55(d,1H), 8.31(d,1H), 8.20-8.15(m,3H), 8.02-7.91(m,5H), 7.61-7.55(m,2H), 7.43-7.28(m,8H), 7.16-7.08(m,5H), 6.95(m,2H), 6,76(d,1H) | 979.28 | 980.04 |
| BD49 | 11.66(s,1H), 8.65(d,1H), 8.55(d,1H), 8.31(d,1H), 8.20-7.91(m,9H), 7.63-7.08(m,17H), 6.95(m,2H), | 1028.31 | 1029.11 |

### Evaluation Example 1

The HOMO energy level (eV), LUMO energy level (eV), simulation maximum emission wavelength (λₘₐₓ^{sim}), actual maximum emission wavelength (λₘₐₓ^{exp}), and ratio of presence of triplet metal-to-ligand charge transfer state (³MLCT) of each of Compounds BD01, BD07, BD17, BD25, BD41, and BD49 were evaluated utilizing the DFT method of the Gaussian program, which is structure-optimized or enhanced at the B3LYP/6-31G(d,p) level, and results thereof are shown in Table 2.

**Table 2**

| ID | HOMO (eV) | LUMO (eV) | λₘₐₓ^{sim}(nm) | λₘₐₓ^{exp}(nm) | ³MLCT(%) |
|---|---|---|---|---|---|
| BD01 | -5.12 | -1.40 | 456 | 459 | 14 |
| BD07 | -5.08 | -1.39 | 457 | 460 | 15 |
| BD17 | -5.11 | -1.45 | 459 | 462 | 14 |
| BD25 | -4.95 | -1.40 | 459 | 461 | 14 |
| BD41 | -4.96 | -1.38 | 461 | 464 | 15 |
| BD49 | -5.06 | -1.39 | 460 | 463 | 16 |

### Example 1

As an anode, a substrate with 15 ohms per square centimeter (Ω/cm²) (1,200 angstrom (Å)) ITO glass thereon was cut to a size of 50 mm x 50 mm x 0.7 mm, sonicated with isopropyl alcohol and pure water each for 5 minutes, and then cleaned by exposure to ultraviolet rays and ozone for 30 minutes. The resultant glass substrate was loaded onto a vacuum deposition apparatus.

A quantity of 2-TNATA was vacuum-deposited on the anode to form a hole injection layer having a thickness of 600 Å, and a quantity of NPB was vacuum-deposited on the hole injection layer to form a hole transport layer having a thickness of 300 Å.

Compound BD01, which was the dopant, and ETH2: HTH29, which were a mixed host at the weight ratio of 5:5, were co-deposited on the hole transport layer to form an emission layer having a thickness of 300 Å, wherein the ratio of the dopant to the mixed host was 10%, and the emission layer was a blue fluorescent emission layer. Subsequently, ETH2 was vacuum-deposited thereon to form a hole-blocking layer having a thickness of 50 Å. Then, Alq₃ was deposited on the emission layer to form an electron transport layer having a thickness of 300 Å, and then, LiF, which is a halogenated alkali metal, was deposited on the electron transport layer to form an electron injection layer having a thickness of 10 Å and Al was vacuum-deposited thereon to form an Al electrode having a thickness of 3,000 Å (cathode) to form an LiF/Al electrode, thereby completing the manufacture of an organic light-emitting device.

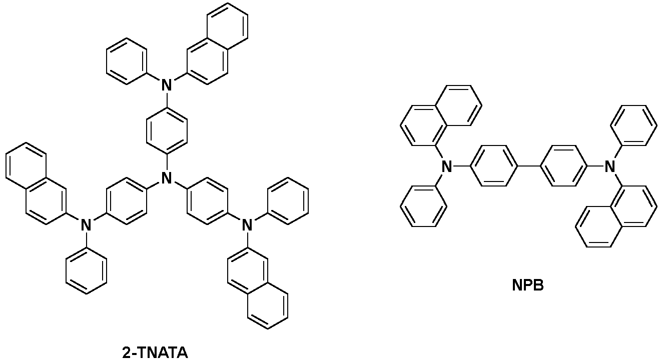

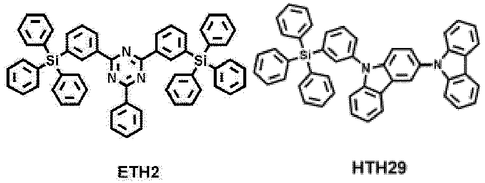

### Examples 2 to 6 and Comparative Examples 1 and 2

Organic light-emitting devices of Examples 2 to 6 and Comparative Examples 1 and 2 (CE-1 and CE-2) were manufactured in substantially the same manner as in Example 1, except that in forming the respective emission layers, Compounds BD07, BD17, BD25, BD41, and BD49 (Examples 2 to 6) and Compounds CE1 and CE2 (Comparative Examples 1 and 2 (CE-1 and CE-2)), were utilized as a dopant instead of Compound BD01, as shown in Table 3.

### Evaluation Example 2

A voltage was applied to the light-emitting devices manufactured in Examples 1 to 6 and Comparative Examples 1 and 2 (CE-1 and CE-2) to establish in the light-emitting devices a current density of 50 milliamp per square centimeter (mA/cm²). Then the driving voltage, CIE(y), color conversion luminescence efficiency (C.C.L.E.), maximum emission wavelength (λₘₐₓ^{exp}), and device lifespan obtained at 1000 candela per square meter (cd/m²) were measured by utilizing Keithley SMU 236 and luminance meter PR650, and the results thereof are shown in Table 3.

**Table 3**

| ID | Dopant in emission layer | Driving voltage (V) | CIE(y) | C.C.L.E. (cd/A/y) | λₘₐₓ^{exp} (nm) | Device lifespan (T₉₀, h) | HOMO energy level (eV) |
|---|---|---|---|---|---|---|---|
| Example 1 | BD01 | 4.0 | 0.131 | 126.4 | 459 | 138 | -5.62 |
| Example 2 | BD07 | 4.0 | 0.141 | 125.2 | 460 | 137 | -5.59 |
| Example 3 | BD17 | 4.1 | 0.152 | 127.5 | 462 | 135 | -5.52 |
| Example 4 | BD25 | 4.2 | 0.147 | 124.0 | 461 | 120 | -5.44 |
| Example 5 | BD41 | 4.1 | 0.160 | 126.3 | 464 | 128 | -5.47 |
| Example 6 | BD49 | 4.0 | 0.158 | 126.3 | 463 | 132 | -5.56 |
| CE- 1 | CE1 | 4.2 | 0.179 | 121.7 | 467 | 113 | -5.43 |
| CE- 2 | CE2 | 5.5 | 0.250 | 78.3 | 528 | 97 | -5.30 |

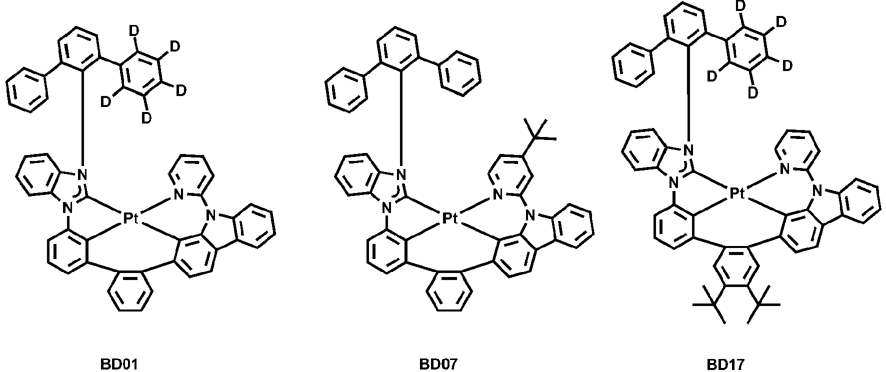

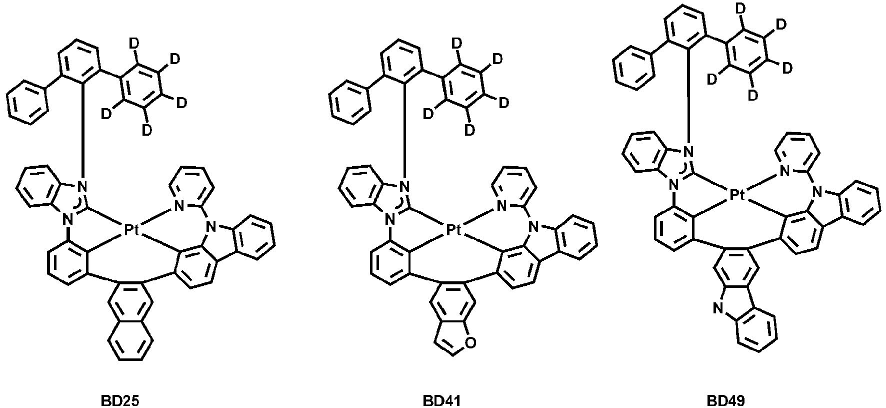

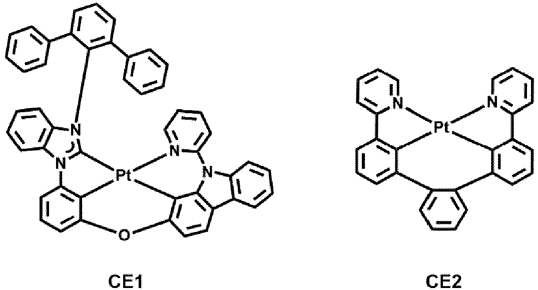

From Table 3, the organic light-emitting devices of Examples 1 to 6 were found to have lower HOMO energy levels than those of Comparative Examples 1 and 2, thereby providing (having) excellent or suitable color purity, luminescence efficiency, and device lifespan.

According to the one or more embodiments, by utilizing the organometallic compound, a light-emitting device having a relatively low driving voltage and high efficiency and a relatively high-quality electronic apparatus including the light-emitting device may be manufactured.

## Claims

1. A light-emitting device comprising:
a first electrode;
a second electrode facing the first electrode;
an interlayer located between the first electrode and the second electrode and comprising an emission layer; and
an organometallic compound represented by Formula 1: 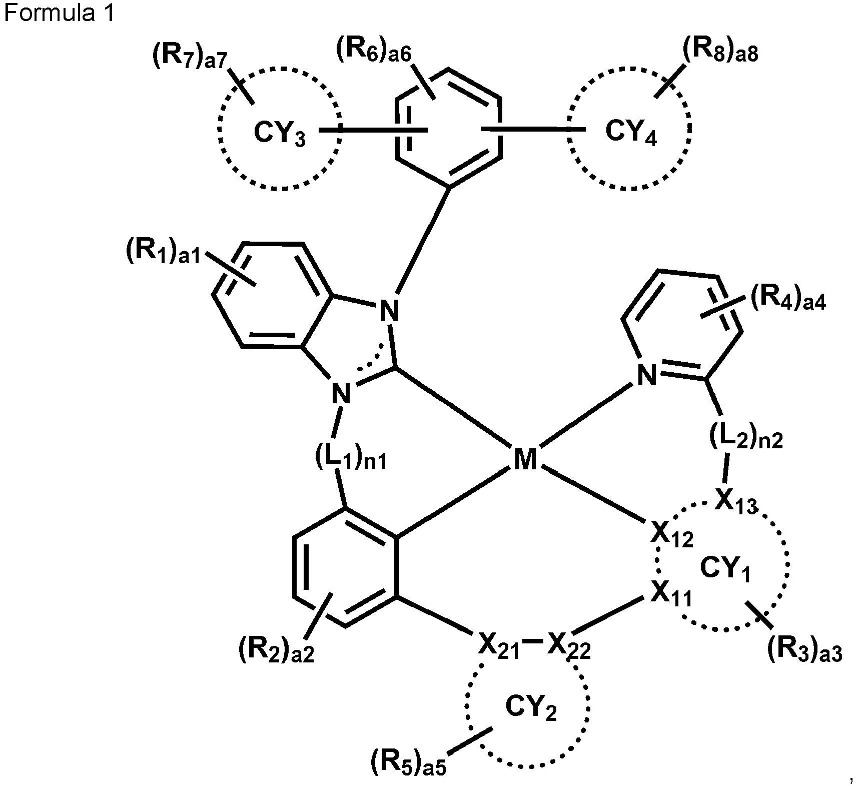 wherein, in Formula 1,
M is platinum (Pt), palladium (Pd), copper (Cu), silver (Ag), gold (Au), rhodium (Rh), ruthenium (Ru), osmium (Os), titanium (Ti), zirconium (Zr), hafnium (Hf), europium (Eu), terbium (Tb), or thulium (Tm),
X₁₁ to X₁₃, X₂₁, and X₂₂ are each independently C or N,
X₂₁ and X₂₂ are linked to each other via a chemical bond,
rings CY₁ to CY₄ are each independently a C₅-C₃₀ carbocyclic group or a C₁-C₃₀ heterocyclic group,
L₁ and L₂ are each independently a single bond, *-C(R₁ₐ)(R_{1b})-*', *-C(R₁ₐ)=*', *=C(R₁ₐ)-*', *-C(R₁ₐ)=C(R_{1b})-*', *-C(=O)-*', *-C(=S)-*', *-C≡C-*', *-B(R₁ₐ)-*', *-N(R₁ₐ)-*', *-O-*', *-P(R₁ₐ)-*', *-Al(R₁ₐ)-*, *-Si(R₁ₐ)(R_{1b})-*', *-P(=O)(R₁ₐ)-*', *-S-*', *-S(=O)-*', *-S(=O)₂-*', or *-Ge(R₁ₐ)(R_{1b})-*', and * and *' each indicate a binding site to a neighboring atom,
n1 and n2 are each independently an integer from 1 to 5,
R₁ to R₈, R₁ₐ, and R_{1b} are each independently hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₁-C₆₀ alkylthio group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -C(Q₁)(Q₂)(Q₃), -Si(Q₁)(Q₂)(Q₃), - N(Q₁)(Q₂), -B(Q₁)(Q₂), -C(=O)(Q₁), -S(=O)₂(Q₁), or -P(=O)(Q₁)(Q₂),
a1 is an integer from 1 to 4,
a2 is an integer from 1 to 3,
a3 is an integer from 1 to 6,
a4 is an integer from 1 to 4,
a5 is an integer from 1 to 8,
a6 is an integer from 1 to 3,
a7 and a8 are each independently an integer from 1 to 5,
R₁₀ₐ is:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, -Si(Q₁₁)(Q₁₂)(Q₁₃), - N(Q₁₁)(Q₁₂), -B(Q₁₁)(Q₁₂), -C(=O)(Q₁₁), -S(=O)₂(Q₁₁), -P(=O)(Q₁₁)(Q₁₂), or a combination thereof;
a C₃-C₆₀ carbocyclic group, a C₁-C₆₀ heterocyclic group, a C₆-C₆₀ aryloxy group, or a C₆-C₆₀ arylthio group, each unsubstituted or substituted with deuterium, -F, -Cl, - Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, - Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), - P(=O)(Q₂₁)(Q₂₂), or a combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂), and
wherein Q₁ to Q₃, Q₁₁ to Q₁₃, Q₂₁ to Q₂₃, and Q₃₁ to Q₃₃ are each independently: hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; or a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or a combination thereof.

2. The light-emitting device of claim 1, wherein
the emission layer comprises a host and a dopant, and
the dopant comprises the organometallic compound.

3. The light-emitting device of claim 1 or claim 2, further comprising
a second compound comprising at least one π electron-deficient nitrogen-containing C₁-C₆₀ heterocyclic group, a third compound comprising a group represented by Formula 3, a fourth compound capable of emitting delayed fluorescence, or a combination thereof, wherein
the organometallic compound, the second compound, the third compound, and the fourth compound are different from each other: 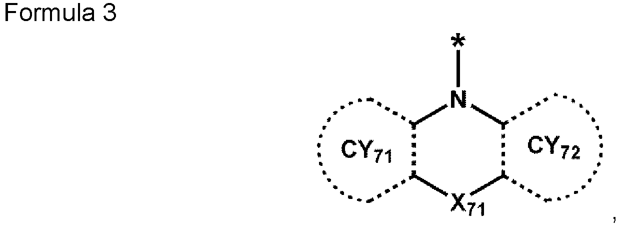 and
wherein, in Formula 3,
rings CY₇₁ and CY₇₂ are each independently a π electron-rich C₃-C₆₀ cyclic group or a pyridine group,
X₇₁ is a single bond or a linking group comprising O, S, N, B, C, Si, or a combination thereof, and
* in Formula 3 is a binding site to an atom included in portions excluding Formula 3.

4. The light-emitting device of claim 3, wherein
the second compound comprises a pyridine group, a pyrimidine group, a pyrazine group, a pyridazine group, a triazine group, or a combination thereof, and
the fourth compound is a compound comprising at least one cyclic group comprising, as ring-forming atoms, each of boron (B) and nitrogen (N).

5. The light-emitting device of claim 3 or claim 4, wherein the emission layer comprises:
i) the organometallic compound; and
ii) the second compound, the third compound, the fourth compound, or a combination thereof, wherein
the emission layer is to emit blue light.

6. An electronic apparatus comprising the light-emitting device of any one of claims 1 to 5.

7. The electronic apparatus of claim 6, further comprising:
(i) a thin-film transistor, wherein
the thin-film transistor comprises a source electrode and a drain electrode, and
the first electrode of the light-emitting device is electrically connected to one selected from among the source electrode and the drain electrode of the thin-film transistor; and/or
(ii) a color filter, a color conversion layer, a touch screen layer, a polarizing layer, or a combination thereof.

8. Electronic equipment comprising the light-emitting device of any one of claims 1 to 5, optionally wherein the electronic equipment is a flat panel display, a curved display, a computer monitor, a medical monitor, a television, a billboard, an indoor or outdoor light and/or light for signal, a head-up display, a fully or partially transparent display, a flexible display, a rollable display, a foldable display, a stretchable display, a laser printer, a telephone, a portable phone, a tablet personal computer, a phablet, a personal digital assistant (PDA), a wearable device, a laptop computer, a digital camera, a camcorder, a viewfinder, a micro display, a three-dimensional (3D) display, a virtual reality or augmented reality display, a vehicle, a video wall with multiple displays tiled together, a theater or stadium screen, a phototherapy device, and/or a signboard.

9. An organometallic compound represented by Formula 1: 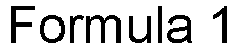 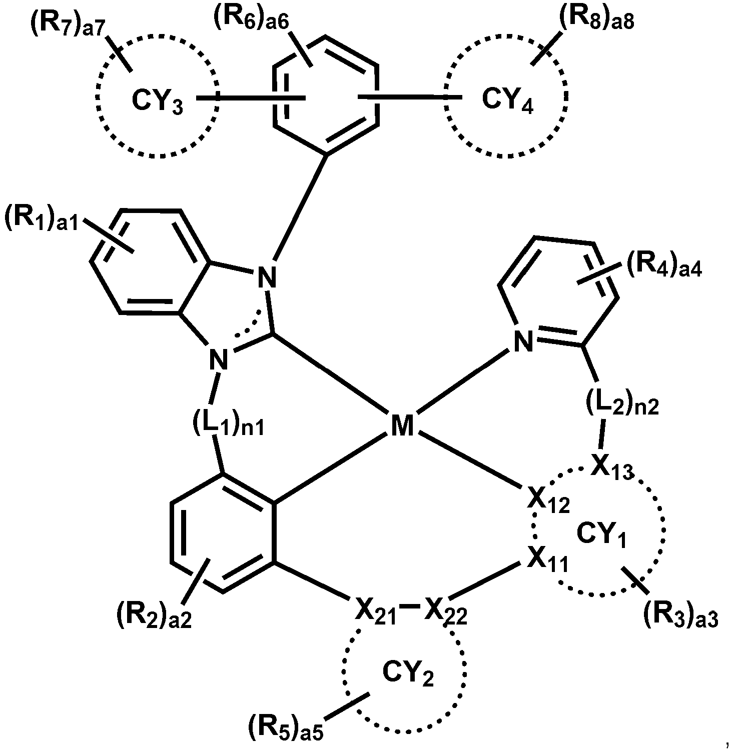 wherein, in Formula 1,
M is platinum (Pt), palladium (Pd), copper(Cu), silver (Ag), gold (Au), rhodium (Rh), ruthenium (Ru), osmium (Os), titanium (Ti), zirconium (Zr), hafnium (Hf), europium (Eu), terbium (Tb), or thulium (Tm),
X₁₁ to X₁₃, X₂₁, and X₂₂ are each independently C or N,
X₂₁ and X₂₂ are linked to each other via a chemical bond,
rings CY₁ to CY₄ are each independently a C₅-C₃₀ carbocyclic group or a C₁-C₃₀ heterocyclic group,
L₁ and L₂ are each independently a single bond, *-C(R₁ₐ)(R_{1b})-*', *-C(R₁ₐ)=*', *=C(R₁ₐ)-*', *-C(R₁ₐ)=C(R_{1b})-*', *-C(=O)-*', *-C(=S)-*', *-C≡C-*', *-B(R₁ₐ)-*', *-N(R₁ₐ)-*', *-O-*', *-P(R₁ₐ)-*', *-Al(R₁ₐ)-*, *-Si(R₁ₐ)(R_{1b})-*', *-P(=O)(R₁ₐ)-*', *-S-*', *-S(=O)-*', *-S(=O)₂-*', or *-Ge(R₁ₐ)(R_{1b})-*', and * and *' each indicate a binding site to a neighboring atom,
n1 and n2 are each independently an integer from 1 to 5,
R₁ to R₈, R₁ₐ, and R_{1b} are each independently hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₁-C₆₀ alkylthio group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -C(Q₁)(Q₂)(Q₃), -S(Q₁)(Q₂)(Q₃), - N(Q₁)(Q₂), -B(Q₁)(Q₂), -C(=O)(Q₁), -S(=O)₂(Q₁), or -P(=O)(Q₁)(Q₂),
a1 is an integer from 1 to 4,
a2 is an integer from 1 to 3,
a3 is an integer from 1 to 6,
a4 is an integer from 1 to 4,
a5 is an integer from 1 to 8,
a6 is an integer from 1 to 3,
a7 and a8 are each independently an integer from 1 to 5,
R₁₀ₐ is:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, -Si(Q₁₁)(Q₁₂)(Q₁₃), - N(Q₁₁)(Q₁₂), -B(Q₁₁)(Q₁₂), -C(=O)(Q₁₁), -S(=O)₂(Q₁₁), -P(=O)(Q₁₁)(Q₁₂), or a combination thereof;
a C₃-C₆₀ carbocyclic group, a C₁-C₆₀ heterocyclic group, a C₆-C₆₀ aryloxy group, or a C₆-C₆₀ arylthio group, each unsubstituted or substituted with deuterium, -F, -Cl, - Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, - Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), - P(=O)(Q₂₁)(Q₂₂), or a combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂), and
wherein Q₁ to Q₃, Q₁₁ to Q₁₃, Q₂₁ to Q₂₃, and Q₃₁ to Q₃₃ are each independently: hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; or a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or a combination thereof.

10. The organometallic compound of claim 9, wherein:
(i) X₁₁ and X₁₂ are each C, and X₁₃ is N; and/or
(ii) X₂₁ and X₂₂ are each C.

11. The organometallic compound of claim 9 or claim 10, wherein:
(i) ring CY₁ is a pyridine group, a pyrimidine group, a dibenzofuran group, a dibenzothiophene group, a carbazole group, a fluorene group, a dibenzosilole group, an azadibenzofuran group, an azadibenzothiophene group, an azacarbazole group, an azafluorene group, or an azadibenzosilole group; and/or
(ii) ring CY₂ is a benzene group, a naphthalene group, an anthracene group, a phenanthrene group, an indene group, a fluorene group, an indole group, a carbazole group, a benzofuran group, a dibenzofuran group, a benzothiophene group, a dibenzothiophene group, a quinoline group, an isoquinoline group, a quinoxaline group, or a quinazoline group.

12. The organometallic compound of any one of claims 9 to 11, wherein:
(i) rings CY₃ and CY₄ are each independently a benzene group, a naphthalene group, an anthracene group, a phenanthrene group, a triphenylene group, a pyrene group, a chrysene group, or a cyclopentadiene group; and/or
(ii) at least one of CY₃ and CY₄ is substituted with at least one deuterium.

13. The organometallic compound of any one of claims 9 to 12, wherein R₁ to R₈ are each independently:
hydrogen, deuterium, or a C₁-C₂₀ alkyl group;
a C₁-C₂₀ alkyl group substituted with deuterium, -CD₃, -CD₂H, -CDH₂, or a combination thereof;
a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, or a chrysenyl group, each unsubstituted or substituted with deuterium, -CD₃, -CD₂H, -CDH₂, a C₁-C₂₀ alkyl group, or a combination thereof; or
-C(Q₁)(Q₂)(Q₃) or -Si(Q₁)(Q₂)(Q₃), and
wherein Q₁ to Q₃ and Q₃₁ to Q₃₃ are each independently: hydrogen; deuterium; a C₁-C₆₀ alkyl group; a C₂-C₆₀ alkenyl group; a C₂-C₆₀ alkynyl group; or a C₃-C₆₀ carbocyclic group unsubstituted or substituted with deuterium, a C₁-C₆₀ alkyl group, a phenyl group, a biphenyl group, or a combination thereof.

14. The organometallic compound of any one of claims 9 to 13, wherein ring CY₂ in Formula 1 is selected from groups represented by Formulae L1 to L10: 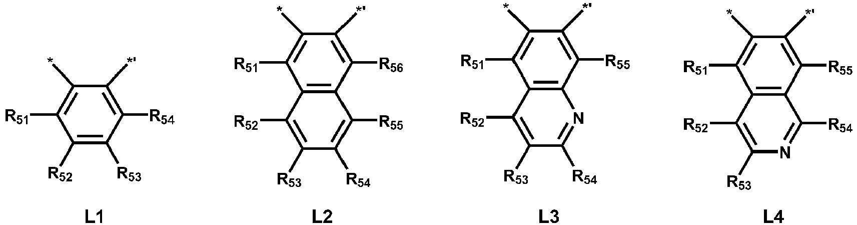 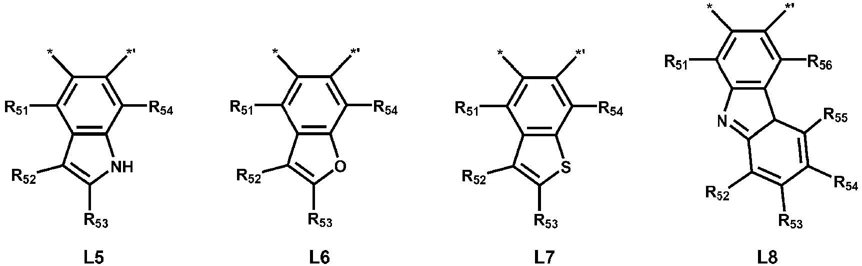 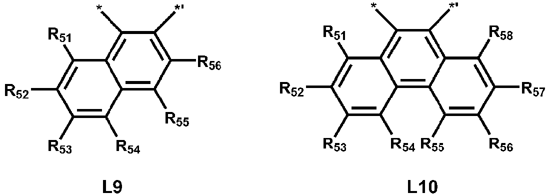 , and
wherein, in Formulae L1 to L10,
R₅₁ to R₅₈ are each defined as for R₅ in Formula 1, and
* and *' each indicate a binding site to a neighboring atom.

15. The organometallic compound of any one of claims 9 to 14, wherein a group represented by 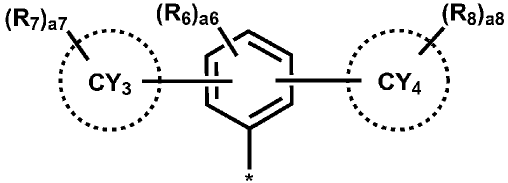 in Formula 1 is a group represented by Formula 1-1: 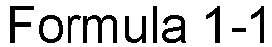 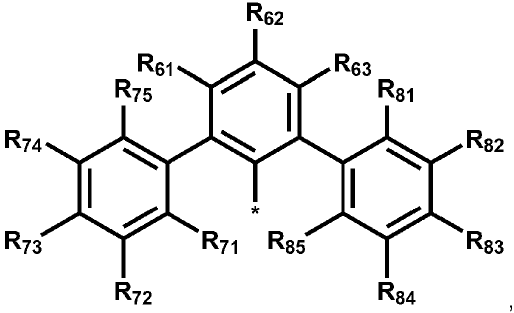 and
wherein, in Formula 1-1,
R₆₁ to R₆₃ are each defined as for R₆,
R₇₁ to R₇₅ are each defined as for R₇,
R₈₁ to R₈₅ are each defined as for R₈ in Formula 1, and
* indicates a binding site to a neighboring atom.

## Patentansprüche

1. Lichtemittierende Vorrichtung, umfassend:
eine erste Elektrode;
eine zweite Elektrode, die der ersten Elektrode zugewandt ist;
eine Zwischenschicht, die zwischen der ersten Elektrode und der zweiten Elektrode angeordnet ist und eine Emissionsschicht umfasst; und
eine organometallische Verbindung, dargestellt durch Formel 1: 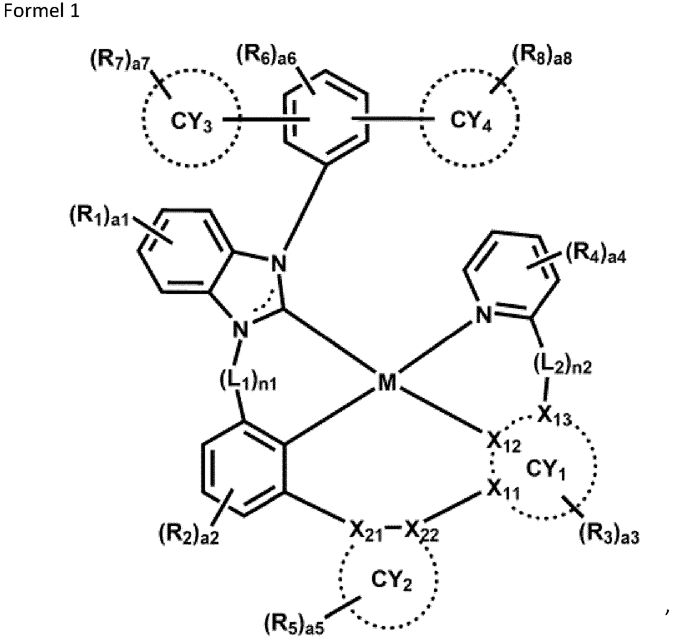 wobei in Formel 1
M Platin (Pt), Palladium (Pd), Kupfer (Cu), Silber (Ag), Gold (Au), Rhodium (Rh), Ruthenium (Ru), Osmium (Os), Titan (Ti), Zirkonium (Zr), Hafnium (Hf), Europium (Eu), Terbium (Tb) oder Thulium (Tm) ist,
X₁₁ bis X₁₃, X₂₁und X₂₂ jeweils unabhängig C oder N sind,
X₂₁ und X₂₂ über eine chemische Bindung miteinander verbunden sind,
Ringe CY₁ bis CY₄ jeweils unabhängig eine carbocyclische C₅-C₃₀-Gruppe oder eine heterocyclische C₁-C₃₀-Gruppe sind,
L₁ und L₂ jeweils unabhängig eine Einfachbindung, *-C(R₁ₐ)(R_{1b})-*', *-C(R₁ₐ)=*', *=C(R₁ₐ)-*', *-C(R₁ₐ)=C(R_{1b})-*', *-C(=O)-*', *-C(=S)-*', *-C≡C-*', *-B(R₁ₐ)-*', *-N(R₁ₐ)-*', *-O-*' , *-P(R₁ₐ)-*', *-Al(R₁ₐ)-*, *-Si(R₁ₐ)(R_{1b})-*', *-P(=O)(R₁ₐ)-*', *-S-*', *-S(=O)-*', *-S(=O)₂-*' oder *-Ge(R₁ₐ)(R_{1b})-*' sind und *und *' jeweils eine Bindungsstelle zu einem benachbarten Atom anzeigen,
n1 und n2 jeweils unabhängig eine ganze Zahl von 1 bis 5 sind;
R₁ bis R₈, R₁ₐ und R_{1b} jeweils unabhängig Wasserstoff, Deuterium, -F, -Cl, -Br, -I, eine Hydroxylgruppe, eine Cyanogruppe, eine Nitrogruppe, eine C₁-C₆₀-Alkylgruppe, unsubstituiert oder substituiert mit mindestens einem R₁₀ₐ, eine C₂-C₆₀-Alkenylgruppe, unsubstituiert oder substituiert mit mindestens einem R₁₀ₐ, eine C₂-C₆₀-Alkinylgruppe, unsubstituiert oder substituiert mit mindestens einem R₁₀ₐ, eine C₁-C₆₀-Alkoxygruppe, unsubstituiert oder substituiert mit mindestens einem R₁₀ₐ, eine C₁-C₆₀-Alkylthiogruppe, unsubstituiert oder substituiert mit mindestens einem R₁₀ₐ, eine carbocyclische C₃-C₆₀-Gruppe, unsubstituiert oder substituiert mit mindestens einem R₁₀ₐ, eine heterocyclische C₁-C₆₀-Gruppe, unsubstituiert oder substituiert mit mindestens einem R₁₀ₐ, eine C₆-C₆₀-Aryloxygruppe, unsubstituiert oder substituiert mit mindestens einem R₁₀ₐ, eine C₆-C₆₀-Arylthiogruppe, unsubstituiert oder substituiert mit mindestens einem R₁₀ₐ, - C(Q₁)(Q₂)(Q₃), -Si(Q₁)(O₂)(Q₃), -N(Q₁)(Q₂), -B(Q₁)(Q₂), -C(=O)(Q₁), -S(=O)₂(O₁) oder - P(=O)(Q₁)(O₂) sind,
a1 eine ganze Zahl von 1 bis 4 ist;
a2 eine ganze Zahl von 1 bis 3 ist,
a3 eine ganze Zahl von 1 bis 6 ist,
a4 eine ganze Zahl von 1 bis 4 ist,
a5 eine ganze Zahl von 1 bis 8 ist,
a6 eine ganze Zahl von 1 bis 3 ist,
a7 und a8 jeweils unabhängig eine ganze Zahl von 1 bis 5 sind;
R₁₀ₐ ist:
Deuterium, -F, -Cl, -Br, -I, eine Hydroxylgruppe, eine Cyanogruppe oder eine Nitrogruppe;
eine C₁-C₆₀-Alkylgruppe, eine C₂-C₆₀-Alkenylgruppe, eine C₂-C₆₀-Alkinylgruppe oder eine C₁-C₆₀-Alkoxygruppe, jeweils unsubstituiert oder substituiert mit Deuterium, -F, -Cl, -Br, -I, einer Hydroxylgruppe, einer Cyanogruppe, einer Nitrogruppe, einer carbocyclischen C₃-C₆₀-Gruppe, einer heterocyclischen C₁-C₆₀-Gruppe, einer C₆-C₆₀-Aryloxygruppe, einer C₆-C₆₀-Arylthiogruppe, -Si(Q₁₁)(Q₁₂)(O- ₁₃), -N(Q₁₁)(Q₁₂), -B(Q₁₁)(Q₁₂), -C(=O)(Q₁₁), -S(=O)₂(O₁₁), -P(=O)(Q₁₁)(Q₁₂) oder einer Kombination davon;
eine carbocyclische C₃-C₆₀-Gruppe, eine heterocyclische C₁-C₆₀-Gruppe, eine C₆-C₆₀-Aryloxygruppe oder eine C₆-C₆₀-Arylthiogruppe, jeweils unsubstituiert oder substituiert mit Deuterium, -F, -Cl, -Br, -I, einer Hydroxylgruppe, einer Cyanogruppe, einer Nitrogruppe, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer carbocyclischen C₃-C₆₀-Gruppe, einer heterocyclischen C₁-C₆₀-Gruppe, einer C₆-C₆₀-Aryloxygruppe, einer C₆-C₆₀-Arylthiogruppe, -Si(Q₂₁)(Q₂₂)(Q₂₃), -N(Q₂₁)(Q₂₂), -B(Q₂₁)(Q₂₂), -C(=O)(Q₂₁), -S(=O)2(Q₂₁), -P(=O)(Q₂₁)(Q₂₂) oder einer Kombination davon; oder
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) oder - P(=O)(Q₃₁)(Q₃₂) und
wobei Q₁ bis Q₃, Q₁₁ bis Q₁₃, Q₂₁ bis Q₂₃ und Q₃₁ bis Q₃₃ jeweils unabhängig sind: Wasserstoff; Deuterium; -F; -Cl; -Br; -I; eine Hydroxylgruppe; eine Cyanogruppe; eine Nitrogruppe; eine C₁-C₆₀-Alkylgruppe; eine C₂-C₆₀-Alkenylgruppe; eine C₂-C₆₀-Alkinylgruppe; eine C₁-C₆₀-Alkoxygruppe; oder eine carbocyclische C₃-C₆₀-Gruppe oder eine heterocyclische C₁-C₆₀-Gruppe, jeweils unsubstituiert oder substituiert mit Deuterium, -F, einer Cyanogruppe, einer C₁-C₆₀-Alkylgruppe, einer C₁-C₆₀-Alkoxygruppe, einer Phenylgruppe, einer Biphenylgruppe oder einer Kombination davon sind.

2. Lichtemittierende Vorrichtung nach Anspruch 1, wobei
die Emissionsschicht einen Wirt und einen Dotierstoff umfasst und
der Dotierstoff die organometallische Verbindung umfasst.

3. Lichtemittierende Vorrichtung nach Anspruch 1 oder Anspruch 2, weiter umfassend
eine zweite Verbindung, die mindestens eine π-elektronenarme stickstoffhaltige heterocyclische C₁-C₆₀-Gruppe umfasst, eine dritte Verbindung, die eine durch Formel 3 dargestellte Gruppe umfasst, eine vierte Verbindung, die verzögerte Fluoreszenz emittieren kann, oder eine Kombination davon, wobei
die organometallische Verbindung, die zweite Verbindung, die dritte Verbindung und die vierte Verbindung sich voneinander unterscheiden: 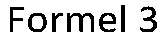 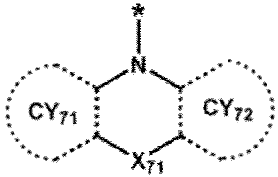 und
wobei in Formel 3
die Ringe CY₇₁ und CY₇₂ jeweils unabhängig eine π-elektronenreiche cyclische C₃-C₆₀-Gruppe oder eine Pyridingruppe sind,
X₇₁ eine Einfachbindung oder eine Verbindungsgruppe ist, die O, S, N, B, C, Si oder eine Kombination davon umfasst und
* in Formel 3 eine Bindungsstelle an ein Atom ist, das in Abschnitten beinhaltet ist, die nicht in Formel 3 aufgeführt sind.

4. Lichtemittierende Vorrichtung nach Anspruch 3, wobei
die zweite Verbindung eine Pyridingruppe, eine Pyrimidingruppe, eine Pyrazingruppe, eine Pyridazingruppe, eine Triazingruppe oder eine Kombination davon umfasst und
die vierte Verbindung eine Verbindung ist, die mindestens eine cyclische Gruppe umfasst, die als ringbildende Atome jeweils Bor (B) und Stickstoff (N) umfasst.

5. Lichtemittierende Vorrichtung nach Anspruch 3 oder Anspruch 4, wobei die Emissionsschicht umfasst:
i) die organometallische Verbindung; und
ii) die zweite Verbindung, die dritte Verbindung, die vierte Verbindung oder eine Kombination davon, wobei
die Emissionsschicht blaues Licht emittieren soll.

6. Elektronische Einrichtung, umfassend die lichtemittierende Vorrichtung nach einem der Ansprüche 1 bis 5.

7. Elektronische Einrichtung nach Anspruch 6, weiter umfassend:
(i) einen Dünnschichttransistor, wobei
der Dünnschichttransistor eine Source-Elektrode und eine Drain-Elektrode umfasst und
die erste Elektrode der lichtemittierenden Vorrichtung elektrisch mit einer Elektrode verbunden ist, die aus der Source-Elektrode und der Drain-Elektrode des Dünnschichttransistors ausgewählt ist; und/oder
(ii) ein Farbfilter, eine Farbkonvertierungsschicht, eine Touchscreen-Schicht, eine Polarisationsschicht oder eine Kombination davon.

8. Elektronisches Gerät, das die lichtemittierende Vorrichtung nach einem der Ansprüche 1 bis 5 umfasst, wobei das elektronische Gerät wahlweise ein Flachbildschirm, ein gekrümmter Bildschirm, ein Computermonitor, ein medizinischer Monitor, ein Fernseher, eine Werbetafel, eine Innen- oder Außenleuchte und/oder Licht für Signal, ein Head-up-Display, ein vollständig oder teilweise transparentes Display, ein flexibles Display, ein rollbares Display, ein faltbares Display, ein dehnbares Display, ein Laserdrucker, ein Telefon, ein tragbares Telefon, ein Tablet-PC, ein Phablet, ein Personal Digital Assistant (PDA), eine tragbare Vorrichtung, ein Laptop-Computer, eine Digitalkamera, ein Camcorder, ein Sucher, ein Mikrodisplay, ein dreidimensionales (3D) Display, ein Virtual-Reality- oder Augmented-Reality-Display, ein Fahrzeug, eine Videowand mit mehreren nebeneinander angeordneten Displays, eine Kino- oder Stadionleinwand, eine Phototherapievorrichtung und/oder ein Schild ist.

9. Organometallische Verbindung, dargestellt durch Formel 1: 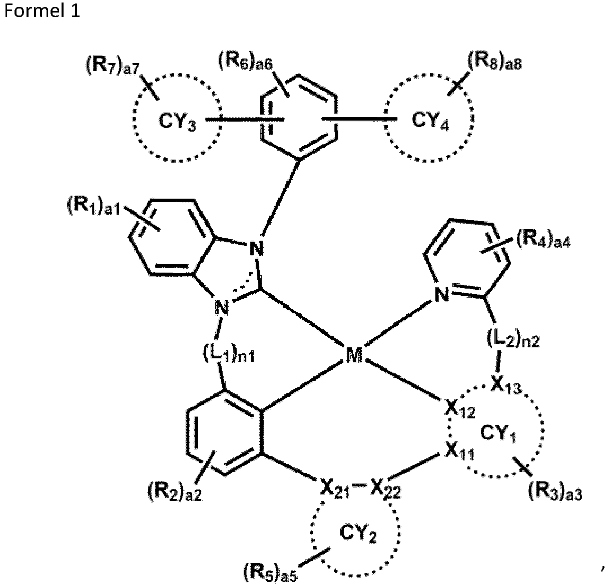 wobei in Formel 1
M Platin (Pt), Palladium (Pd), Kupfer (Cu), Silber (Ag), Gold (Au), Rhodium (Rh), Ruthenium (Ru), Osmium (Os), Titan (Ti), Zirkonium (Zr), Hafnium (Hf), Europium (Eu), Terbium (Tb) oder Thulium (Tm) ist,
X₁₁ bis X₁₃, X₂₁ und X₂₂ jeweils unabhängig C oder N sind,
X₂₁ und X₂₂ über eine chemische Bindung miteinander verbunden sind,
Ringe CY₁ bis CY₄ jeweils unabhängig eine carbocyclische C₅-C₃₀-Gruppe oder eine heterocyclische C₁-C₃₀-Gruppe sind,
L₁ und L₂ jeweils unabhängig eine Einfachbindung, *-C(R₁ₐ)(R_{1b})-*', *-C(R₁ₐ)=*', *=C(R₁ₐ)-*', *-C(R₁ₐ)=C(R_{1b})-*', *-C(=O)-*', *-C(=S)-*', *-C≡C-*', *-B(R₁ₐ)-*', *-N(R₁ₐ)-*', *-O-*', *-P(R₁ₐ)-*', *-Al(R₁ₐ)-*, *-Si(R₁ₐ)(R_{1b})-*', *-P(=O)(R₁ₐ)-*', *-S-*', *-S(=O)-*', *-S(=O)₂-*' oder *-Ge(R₁ₐ)(R_{1b})-*' sind und *und *' jeweils eine Bindungsstelle zu einem benachbarten Atom anzeigen,
n1 und n2 jeweils unabhängig eine ganze Zahl von 1 bis 5 sind;
R₁ bis R₈, R₁ₐ und R_{1b} jeweils unabhängig Wasserstoff, Deuterium, -F, -Cl, -Br, -I, eine Hydroxylgruppe, eine Cyanogruppe, eine Nitrogruppe, eine C₁-C₆₀-Alkylgruppe, unsubstituiert oder substituiert mit mindestens einem R₁₀ₐ, eine C₂-C₆₀-Alkenylgruppe, unsubstituiert oder substituiert mit mindestens einem R₁₀ₐ, eine C₂-C₆₀-Alkinylgruppe, unsubstituiert oder substituiert mit mindestens einem R₁₀ₐ, eine C₁-C₆₀-Alkoxygruppe, unsubstituiert oder substituiert mit mindestens einem R₁₀ₐ, eine C₁-C₆₀-Alkylthiogruppe, unsubstituiert oder substituiert mit mindestens einem R₁₀ₐ, eine carbocyclische C₃-C₆₀-Gruppe, unsubstituiert oder substituiert mit mindestens einem R₁₀ₐ, eine heterocyclische C₁-C₆₀-Gruppe, unsubstituiert oder substituiert mit mindestens einem R₁₀ₐ, eine C₆-C₆₀-Aryloxygruppe, unsubstituiert oder substituiert mit mindestens einem R₁₀ₐ, eine C₆-C₆₀-Arylthiogruppe, unsubstituiert oder substituiert mit mindestens einem R₁₀ₐ, - C(Q₁)(Q₂)(Q₃), -Si(Q₁)(Q₂)(Q₃), -N(Q₁)(Q₂), -B(Q₁)(Q₂), -C(=O)(Q₁), -S(=O)₂(O₁) oder - P(=O)(Q₁)(O₂) sind,
a1 eine ganze Zahl von 1 bis 4 ist;
a2 eine ganze Zahl von 1 bis 3 ist,
a3 eine ganze Zahl von 1 bis 6 ist,
a4 eine ganze Zahl von 1 bis 4 ist,
a5 eine ganze Zahl von 1 bis 8 ist,
a6 eine ganze Zahl von 1 bis 3 ist,
a7 und a8 jeweils unabhängig eine ganze Zahl von 1 bis 5 sind;
R₁₀ₐ ist:
Deuterium, -F, -Cl, -Br, -I, eine Hydroxylgruppe, eine Cyanogruppe oder eine Nitrogruppe;
eine C₁-C₆₀-Alkylgruppe, eine C₂-C₆₀-Alkenylgruppe, eine C₂-C₆₀-Alkinylgruppe oder eine C₁-C₆₀-Alkoxygruppe, jeweils unsubstituiert oder substituiert mit Deuterium, -F, -Cl, -Br, -I, einer Hydroxylgruppe, einer Cyanogruppe, einer Nitrogruppe, einer carbocyclischen C₃-C₆₀-Gruppe, einer heterocyclischen C₁-C₆₀-Gruppe, einer C₆-C₆₀-Aryloxygruppe, einer C₆-C₆₀-Arylthiogruppe, -Si(Q₁₁)(Q₁₂)(Q₁₃), -N(Q₁₁)(Q₁₂), -B(Q₁₁)(Q₁₂), - C(=O)(Q₁₁), -S(=O)₂(O₁₁), -P(=O)(Q₁₁)(Q₁₂), oder einer Kombination davon;
eine carbocyclische C₃-C₆₀-Gruppe, eine heterocyclische C₁-C₆₀-Gruppe, eine C₆-C₆₀-Aryloxygruppe oder eine C₆-C₆₀-Arylthiogruppe, jeweils unsubstituiert oder substituiert mit Deuterium, -F, -Cl, -Br, -I, einer Hydroxylgruppe, einer Cyanogruppe, einer Nitrogruppe, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer carbocyclischen C₃-C₆₀-Gruppe, einer heterocyclischen C₁-C₆₀-Gruppe, einer C₆-C₆₀-Aryloxygruppe, einer C₆-C₆₀-Arylthiogruppe, -Si(Q₂₁)(Q₂₂)(Q₂₃), -N(Q₂₁)(Q₂₂), -B(Q₂₁)(Q₂₂), -C(=O)(Q₂₁), -S(=O)2(Q₂₁), -P(=O)(Q₂₁)(Q₂₂) oder einer Kombination davon; oder
-Si(Q₃₁)(Q₃₂)(Q₃₃), -N(Q₃₁)(Q₃₂), -B(Q₃₁)(Q₃₂), -C(=O)(Q₃₁), -S(=O)₂(O₃₁) oder - P(=O)(Q₃₁)(Q₃₂) und
wobei Q₁ bis Q₃, Q₁₁ bis Q₁₃, Q₂₁ bis Q₂₃ und Q₃₁ bis Q₃₃ jeweils unabhängig sind: Wasserstoff; Deuterium; -F; -Cl; -Br; -I; eine Hydroxylgruppe; eine Cyanogruppe; eine Nitrogruppe; eine C₁-C₆₀-Alkylgruppe; eine C₂-C₆₀-Alkenylgruppe; eine C₂-C₆₀-Alkinylgruppe; eine C₁-C₆₀-Alkoxygruppe; oder eine carbocyclische C₃-C₆₀-Gruppe oder eine heterocyclische C₁-C₆₀-Gruppe, jeweils unsubstituiert oder substituiert mit Deuterium, -F, einer Cyanogruppe, einer C₁-C₆₀-Alkylgruppe, einer C₁-C₆₀-Alkoxygruppe, einer Phenylgruppe, einer Biphenylgruppe oder einer Kombination davon sind.

10. Organometallische Verbindung nach Anspruch 9, wobei;
(i) X₁₁ und X₁₂ jeweils C sind und X₁₃ N ist; und/oder
(ii) X₂₁ und X₂₂ jeweils C sind.

11. Organometallische Verbindung nach Anspruch 9 oder Anspruch 10, wobei:
(i) Ring CY₁ eine Pyridingruppe, eine Pyrimidingruppe, eine Dibenzofurangruppe, eine Dibenzothiophengruppe, eine Carbazolgruppe, eine Fluorengruppe, eine Dibenzosilolgruppe, eine Azadibenzofurangruppe, eine Azadibenzothiophengruppe, eine Azacarbazolgruppe, eine Azafluorengruppe oder eine Azadibenzosilolgruppe ist; und/oder
(ii) Ring CY₂ eine Benzolgruppe, eine Naphthalingruppe, eine Anthracengruppe, eine Phenanthrengruppe, eine Indengruppe, eine Fluorengruppe, eine Indolgruppe, eine Carbazolgruppe, eine Benzofurangruppe, eine Dibenzofurangruppe, eine Benzothiophengruppe, eine Dibenzothiophengruppe, eine Chinolingruppe, eine Isochinolingruppe, eine Chinoxalingruppe oder eine Chinazolingruppe ist.

12. Organometallische Verbindung nach einem der Ansprüche 9 bis 11, wobei
(i) Ringe CY₃ und CY₄ jeweils unabhängig eine Benzolgruppe, eine Naphthalingruppe, eine Anthracengruppe, eine Phenanthrengruppe, eine Triphenylengruppe, eine Pyrengruppe, eine Chrysengruppe oder eine Cyclopentadiengruppe sind; und/oder
(ii) mindestens eines von CY₃ und CY₄ durch mindestens ein Deuterium ersetzt ist.

13. Organometallische Verbindung nach einem der Ansprüche 9 bis 12, wobei R₁ bis R₈ jeweils unabhängig sind:
Wasserstoff, Deuterium oder eine C₁-C₂₀-Alkylgruppe;
eine C₁-C₂₀-Alkylgruppe, substituiert mit Deuterium, -CD₃, -CD₂H, -CDH₂oder einer Kombination davon;
eine Cyclopentenylgruppe, eine Cyclohexenylgruppe, eine Cycloheptenylgruppe, eine Phenylgruppe, eine Biphenylgruppe, eine C₁-C₁₀-Alkylphenylgruppe, eine Naphthylgruppe, eine Fluorenylgruppe, eine Phenanthrenylgruppe, eine Anthracenylgruppe, eine Fluoranthenylgruppe, eine Triphenylenylgruppe, eine Pyrenylgruppe oder eine Chrysenylgruppe, jeweils unsubstituiert oder substituiert mit Deuterium, -CD₃, -CD₂H, -CDH₂, einer C₁-C₂₀-Alkylgruppe oder einer Kombination davon; oder
-C(Q₁)(O₂)(Q₃) oder -Si(Q₁)(Q₂)(Q₃) und
wobei Q₁ bis Q₃ und Q₃₁ bis Q₃₃ jeweils unabhängig sind: Wasserstoff, Deuterium;
eine C₁-C₆₀-Alkylgruppe; eine C₂-C₆₀-Alkenylgruppe; eine C₂-C₆₀-Alkinylgruppe; oder eine carbocyclische C₃-C₆₀-Gruppe, unsubstituiert oder substituiert mit Deuterium, einer C₁-C₆₀-Alkylgruppe, einer Phenylgruppe, einer Biphenylgruppe oder einer Kombination davon.

14. Organometallische Verbindung nach einem der Ansprüche 9 bis 13, wobei Ring CY₂ in Formel 1 aus Gruppen ausgewählt ist, die durch Formeln L1 bis L10 dargestellt sind: 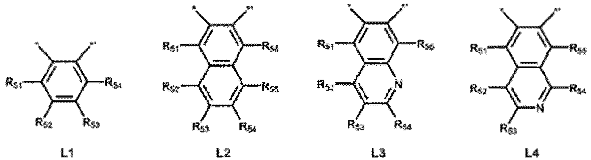 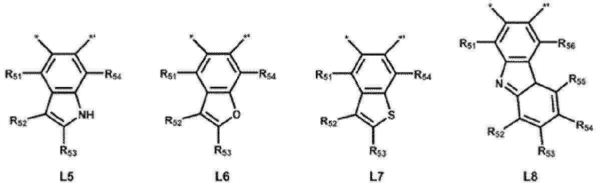 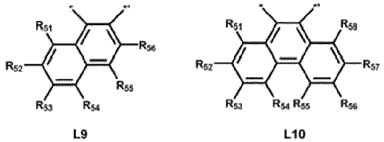 und
wobei in Formeln L1 bis L10
R₅₁ bis R₅₈ jeweils wie R₅ in Formel 1 definiert sind und
* und *' jeweils eine Bindungsstelle zu einem benachbarten Atom anzeigen.

15. Organometallische Verbindung nach einem der Ansprüche 9 bis 14, wobei eine Gruppe, die durch 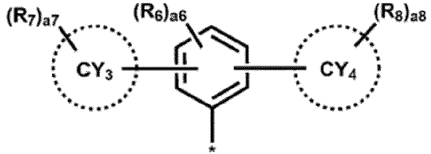 in Formel 1 dargestellt ist, eine Gruppe ist, die durch Formel 1-1 dargestellt ist: 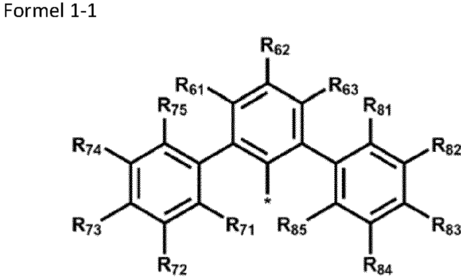 und
wobei in Formel 1-1
R₆₁ bis R₆₃ jeweils wie für R₆ definiert sind,
R₇₁ bis R₇₅ jeweils wie für R₇ definiert sind,
R₈₁ bis R₈₅ jeweils wie für R₈ in Formel 1 definiert sind und
* eine Bindungsstelle an ein benachbartes Atom anzeigt.

## Revendications

1. Dispositif électroluminescent comprenant :
une première électrode ;
une seconde électrode faisant face à la première électrode ;
une couche intermédiaire située entre la première électrode et la seconde électrode et comprenant une couche d'émission ; et
un composé organométallique représenté par la Formule 1 : 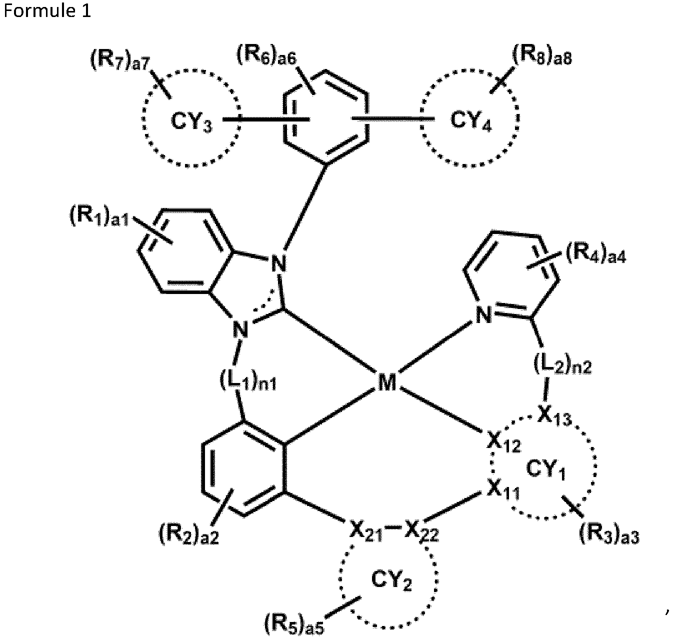 dans lequel, dans la Formule 1,
M est le platine (Pt), le palladium (Pd), le cuivre (Cu), l'argent (Ag), l'or (Au), le rhodium (Rh), le ruthénium (Ru), l'osmium (Os), le titane (Ti), le zirconium (Zr), le hafnium (Hf), l'europium (Eu), le terbium (Tb) ou le thulium (Tm),
X₁₁ à X₁₃, X₂₁ et X₂₂ sont chacun indépendamment C ou N,
X₂₁ et X₂₂ sont liés l'un à l'autre par une liaison chimique,
les cycles CY₁ à CY₄ sont chacun indépendamment un groupe carbocyclique en C₅-C₃₀ ou un groupe hétérocyclique en C₁-C₃₀,
L₁ et L₂ sont chacun indépendamment une liaison simple, *-C(R₁ₐ)(R_{1b})-*', *-C(R₁ₐ)=*', *=C(R₁ₐ)-*', *-C(R₁ₐ)=C(R_{1b})-*', *-C(=O)-*', *-C(=S)-*', *-C≡C-*', *-B(R₁ₐ)-*', *-N(R₁ₐ)-*", *-O-*', *-P(R₁ₐ)-*', *-Al(R₁ₐ)-*, *-Si(R₁ₐ)(R_{1b})-*", *-P(=O)(R₁ₐ)-*', *-S-*', *-S(=O)-*', *-S(=O)₂-*', ou *-Ge(R₁ₐ)(R_{1b})-*', et * et *' indiquent chacun un site de liaison à un atome voisin,
n1 et n2 sont chacun indépendamment un nombre entier de 1 à 5,
R₁ à R₈, R₁ₐ et R_{1b} sont chacun indépendamment un hydrogène, un deutérium, -F, -Cl, -Br, -I, un groupe hydroxyle, un groupe cyano, un groupe nitro, un groupe alkyle en C₁-C₆₀ non substitué ou substitué par au moins un R₁₀ₐ, un groupe alcényle en C₂-C₆₀ non substitué ou substitué par au moins un R₁₀ₐ, un groupe alcynyle en C₂-C₆₀ non substitué ou substitué par au moins un R₁₀ₐ, un groupe alcoxy en C₁-C₆₀ non substitué ou substitué par au moins un R₁₀ₐ, un groupe alkylthio en C₁-C₆₀ non substitué ou substitué par au moins un R₁₀ₐ, un groupe carbocyclique en C₃-C₆₀ non substitué ou substitué par au moins un R₁₀ₐ, un groupe hétérocyclique en C₁-C₆₀ non substitué ou substitué par au moins un R₁₀ₐ, un groupe aryloxy en C₆-C₆₀ non substitué ou substitué par au moins un R₁₀ₐ, un groupe arylthio en C₆-C₆₀ non substitué ou substitué par au moins un R₁₀ₐ, -C(Q₁)(Q₂)(Q₃), -Si(Q₁)(Q₂)(Q₃), -N(Q₁)(Q₂), -B(Q₁)(Q₂), -C(=O)(Q₁), -S(=O)₂(O₁), ou -P(=O)(Q₁)(Q₂),
a1 est un nombre entier de 1 à 4,
a2 est un nombre entier de 1 à 3,
a3 est un nombre entier de 1 à 6,
a4 est un nombre entier de 1 à 4,
a5 est un nombre entier de 1 à 8,
a6 est un nombre entier de 1 à 3,
a7 et a8 sont chacun indépendamment un nombre entier de 1 à 5,
R₁₀ₐ est :
un deutérium, -F, -Cl, -Br, -I, un groupe hydroxyle, un groupe cyano ou un groupe nitro ;
un groupe alkyle en C₁-C₆₀, un groupe alcényle en C₂-C₆₀, un groupe alcynyle en C₂-C₆₀ ou un groupe alcoxy en C₁-C₆₀, chacun non substitué ou substitué par un deutérium, -F, -Cl, -Br, -I, un groupe hydroxyle, un groupe cyano, un groupe nitro, un groupe carbocyclique en C₃-C₆₀, un groupe hétérocyclique en C₁-C₆₀, un groupe aryloxy en C₆-C₆₀, un groupe arylthio en C₆-C₆₀, -Si(Q₁₁)(Q₁₂)(Q₁₃), -N(Q₁₁)(Q₁₂), -B(Q₁₁)(Q₁₂), - C(=O)(Q₁₁), -S(=O)₂(O₁₁), -P(=O)(Q₁₁)(Q₁₂), ou une combinaison de ceux-ci ;
un groupe carbocyclique en C₃-C₆₀, un groupe hétérocyclique en C₁-C₆₀, un groupe aryloxy en C₆-C₆₀ ou un groupe arylthio en C₆-C₆₀, chacun non substitué ou substitué par un deutérium, -F, -Cl, - Br, -I, un groupe hydroxyle, un groupe cyano, un groupe nitro, un groupe alkyle en C₁-C₆₀, un groupe alcényle en C₂-C₆₀, un groupe alcynyle en C₂-C₆₀, un groupe alcoxy en C₁-C₆₀, un groupe carbocyclique en C₃-C₆₀, un groupe hétérocyclique en C₁-C₆₀, un groupe aryloxy en C₆-C₆₀, un groupe arylthio en C₆-C₆₀, - Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), -P(=O)(Q₂₁)(Q₂₂), ou une combinaison de ceux-ci ; ou
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), ou - P(=O)(Q₃₁)(Q₃₂), et
dans lequel Q₁ à Q₃, Q₁₁ à Q₁₃, Q₂₁ à Q₂₃ et Q₃₁ à Q₃₃ sont chacun indépendamment : un hydrogène ; un deutérium ; -F ; -CI ; -Br ; -I ; un groupe hydroxyle ; un groupe cyano ; un groupe nitro ; un groupe alkyle en C₁-C₆₀ ; un groupe alcényle en C₂-C₆₀ ; un groupe alcynyle en C₂-C₆₀ ; un groupe alcoxy en C₁-C₆₀ ; ou un groupe carbocyclique en C₃-C₆₀ ou un groupe hétérocyclique en C₁-C₆₀, chacun non substitué ou substitué par un deutérium, -F, un groupe cyano, un groupe alkyle en C₁-C₆₀, un groupe alcoxy en C₁-C₆₀, un groupe phényle, un groupe biphényle ou une combinaison de ceux-ci.

2. Dispositif électroluminescent selon la revendication 1, dans lequel
la couche d'émission comprend un hôte et un dopant, et
le dopant comprend le composé organométallique.

3. Dispositif électroluminescent selon la revendication 1 ou la revendication 2, comprenant en outre
un deuxième composé comprenant au moins un groupe hétérocyclique en C₁-C₆₀ contenant de l'azote et déficient en électrons π, un troisième composé comprenant un groupe représenté par la Formule 3, un quatrième composé capable d'émettre une fluorescence retardée, ou une combinaison de ceux-ci, dans lequel
le composé organométallique, le deuxième composé, le troisième composé et le quatrième composé sont différents les uns des autres : 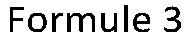 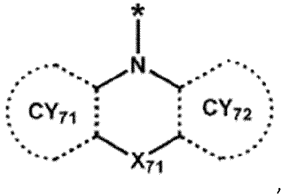 et
dans lequel, dans la Formule 3,
les cycles CY₇₁ et CY₇₂ sont chacun indépendamment un groupe cyclique en C₃-C₆₀ riche en électrons π ou un groupe pyridine,
X₇₁ est une liaison simple ou un groupe de liaison comprenant O, S, N, B, C, Si ou une combinaison de ceux-ci, et
* dans la Formule 3 est un site de liaison à un atome inclus dans des parties excluant la Formule 3.

4. Dispositif électroluminescent selon la revendication 3, dans lequel
le deuxième composé comprend un groupe pyridine, un groupe pyrimidine, un groupe pyrazine, un groupe pyridazine, un groupe triazine ou une combinaison de ceux-ci, et
le quatrième composé est un composé comprenant au moins un groupe cyclique comprenant, comme atomes formant un cycle, chacun du bore (B) et de l'azote (N).

5. Dispositif électroluminescent selon la revendication 3 ou la revendication 4, dans lequel la couche d'émission comprend :
i) le composé organométallique ; et
ii) le deuxième composé, le troisième composé, le quatrième composé ou une combinaison de ceux-ci, dans lequel
la couche d'émission doit émettre de la lumière bleue.

6. Appareil électronique comprenant le dispositif électroluminescent selon l'une quelconque des revendications 1 à 5.

7. Appareil électronique selon la revendication 6, comprenant en outre :
(i) un transistor à couches minces, dans lequel
le transistor à couches minces comprend une électrode de source et une électrode de drain, et
la première électrode du dispositif électroluminescent est électriquement raccordée à l'une choisie parmi l'électrode de source et l'électrode de drain du transistor à couches minces ; et/ou
(ii) un filtre de couleur, une couche de conversion de couleur, une couche d'écran tactile, une couche polarisante ou une combinaison de ceux-ci.

8. Équipement électronique comprenant le dispositif électroluminescent selon l'une quelconque des revendications 1 à 5, facultativement dans lequel l'équipement électronique est un écran plat, un écran incurvé, un moniteur d'ordinateur, un moniteur médical, un téléviseur, un panneau d'affichage, un éclairage intérieur ou extérieur et/ou un éclairage de signalisation, un affichage tête haute, un écran entièrement ou partiellement transparent, un écran flexible, un écran enroulable, un écran pliable, un écran extensible, une imprimante laser, un téléphone, un téléphone portable, une tablette, un téléphone-tablette, un assistant numérique personnel (PDA), un dispositif portable, un ordinateur portable, un appareil photo numérique, un caméscope, un viseur, un micro-écran, un écran tridimensionnel (3D), un écran de réalité virtuelle ou de réalité augmentée, un véhicule, un mur vidéo avec plusieurs écrans assemblés, un écran de cinéma ou de stade, un appareil de photothérapie, et/ou une enseigne.

9. Composé organométallique représenté par la Formule 1 : 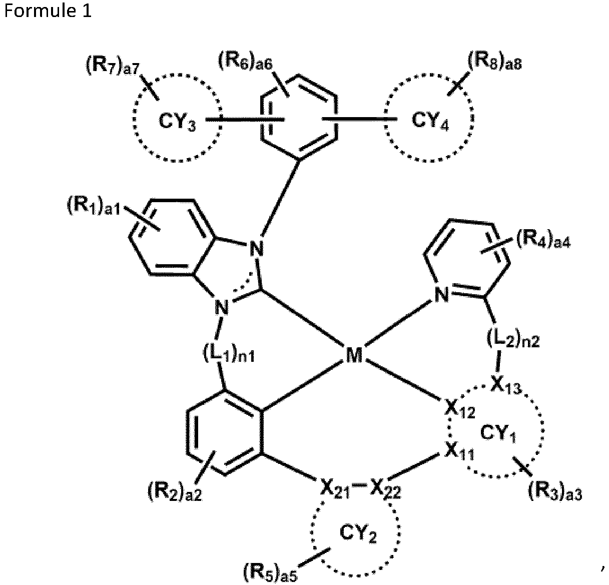 dans lequel, dans la Formule 1,
M est le platine (Pt), le palladium (Pd), le cuivre (Cu), l'argent (Ag), l'or (Au), le rhodium (Rh), le ruthénium (Ru), l'osmium (Os), le titane (Ti), le zirconium (Zr), le hafnium (Hf), l'europium (Eu), le terbium (Tb) ou le thulium (Tm),
X₁₁ à X₁₃, X₂₁ et X₂₂ sont chacun indépendamment C ou N,
X₂₁ et X₂₂ sont liés l'un à l'autre par une liaison chimique,
les cycles CY₁ à CY₄ sont chacun indépendamment un groupe carbocyclique en C₅-C₃₀ ou un groupe hétérocyclique en C₁-C₃₀,
L₁ et L₂ sont chacun indépendamment une liaison simple, *-C(R₁ₐ)(R_{1b})-*', *-C(R₁ₐ)=*', *=C(R₁ₐ)-*', *-C(R₁ₐ)=C(R_{1b})-*', *-C(=O)-*', *-C(=S)-*', *-C≡C-*', *-B(R₁ₐ)-*', *-N(R₁ₐ)-*', *-O-*', *-P(R₁ₐ)-*', *-Al(R₁ₐ)-*, *-Si(R₁ₐ)(R_{1b})-*', *-P(=O)(R₁ₐ)-*', *-S-*', *-S(=O)-*', *-S(=O)₂-*', ou *-Ge(R₁ₐ)(R_{1b})-*', et * et *' indiquent chacun un site de liaison à un atome voisin,
n1 et n2 sont chacun indépendamment un nombre entier de 1 à 5,
R₁ à R₈, R₁ₐ et R_{1b} sont chacun indépendamment un hydrogène, un deutérium, -F, -Cl, -Br, -I, un groupe hydroxyle, un groupe cyano, un groupe nitro, un groupe alkyle en C₁-C₆₀ non substitué ou substitué par au moins un R₁₀ₐ, un groupe alcényle en C₂-C₆₀ non substitué ou substitué par au moins un R₁₀ₐ, un groupe alcynyle en C₂-C₆₀ non substitué ou substitué par au moins un R₁₀ₐ, un groupe alcoxy en C₁-C₆₀ non substitué ou substitué par au moins un R₁₀ₐ, un groupe alkylthio en C₁-C₆₀ non substitué ou substitué par au moins un R₁₀ₐ, un groupe carbocyclique en C₃-C₆₀ non substitué ou substitué par au moins un R₁₀ₐ, un groupe hétérocyclique en C₁-C₆₀ non substitué ou substitué par au moins un R₁₀ₐ, un groupe aryloxy en C₆-C₆₀ non substitué ou substitué par au moins un R₁₀ₐ, un groupe arylthio en C₆-C₆₀ non substitué ou substitué par au moins un R₁₀ₐ, -C(Q₁)(Q₂)(Q₃), -Si(Q₁)(Q₂)(Q₃), -N(Q₁)(Q₂), -B(Q₁)(Q₂), -C(=O)(Q₁), -S(=O)₂(O₁), ou -P(=O)(Q₁)(Q₂),
a1 est un nombre entier de 1 à 4,
a2 est un nombre entier de 1 à 3,
a3 est un nombre entier de 1 à 6,
a4 est un nombre entier de 1 à 4,
a5 est un nombre entier de 1 à 8,
a6 est un nombre entier de 1 à 3,
a7 et a8 sont chacun indépendamment un nombre entier de 1 à 5,
R₁₀ₐ est :
un deutérium, -F, -Cl, -Br, -I, un groupe hydroxyle, un groupe cyano ou un groupe nitro ;
un groupe alkyle en C₁-C₆₀, un groupe alcényle en C₂-C₆₀, un groupe alcynyle en C₂-C₆₀ ou un groupe alcoxy en C₁-C₆₀, chacun non substitué ou substitué par un deutérium, -F, -Cl, -Br, -I, un groupe hydroxyle, un groupe cyano, un groupe nitro, un groupe carbocyclique en C₃-C₆₀, un groupe hétérocyclique en C₁-C₆₀, un groupe aryloxy en C₆-C₆₀, un groupe arylthio en C₆-C₆₀, -Si(Q₁₁)(Q₁₂)(O₁₃), -N(Q₁₁)(Q₁₂), -B(Q₁₁)(Q₁₂), - C(=O)(Q₁₁), -S(=O)₂(O₁₁), -P(=O)(Q₁₁)(Q₁₂), ou une combinaison de ceux-ci ;
un groupe carbocyclique en C₃-C₆₀, un groupe hétérocyclique en C₁-C₆₀, un groupe aryloxy en C₆-C₆₀ ou un groupe arylthio en C₆-C₆₀, chacun non substitué ou substitué par un deutérium, -F, -Cl, - Br, -I, un groupe hydroxyle, un groupe cyano, un groupe nitro, un groupe alkyle en C₁-C₆₀, un groupe alcényle en C₂-C₆₀, un groupe alcynyle en C₂-C₆₀, un groupe alcoxy en C₁-C₆₀, un groupe carbocyclique en C₃-C₆₀, un groupe hétérocyclique en C₁-C₆₀, un groupe aryloxy en C₆-C₆₀, un groupe arylthio en C₆-C₆₀, - Si(Q₂₁)(Q₂₂)(Q₂₃), -N(Q₂₁)(Q₂₂), -B(Q₂₁)(Q₂₂), -C(=O)(Q₂₁), -S(=O)2(Q₂₁), -P(=O)(Q₂₁)(Q₂₂), ou une combinaison de ceux-ci ; ou
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), ou - P(=O)(Q₃₁)(Q₃₂), et
dans lequel Q₁ à Q₃, Q₁₁ à Q₁₃, Q₂₁ à Q₂₃ et Q₃₁ à Q₃₃ sont chacun indépendamment : un hydrogène ; un deutérium ; -F ; -CI ; -Br ; -I ; un groupe hydroxyle ; un groupe cyano ; un groupe nitro ; un groupe alkyle en C₁-C₆₀ ; un groupe alcényle en C₂-C₆₀ ; un groupe alcynyle en C₂-C₆₀ ; un groupe alcoxy en C₁-C₆₀ ; ou un groupe carbocyclique en C₃-C₆₀ ou un groupe hétérocyclique en C₁-C₆₀, chacun non substitué ou substitué par un deutérium, -F, un groupe cyano, un groupe alkyle en C₁-C₆₀, un groupe alcoxy en C₁-C₆₀, un groupe phényle, un groupe biphényle ou une combinaison de ceux-ci.

10. Composé organométallique selon la revendication 9, dans lequel :
(i) X₁₁ et X₁₂ sont chacun C, et X₁₃ est N ; et/ou
(ii) X₂₁ et X₂₂ sont chacun C.

11. Composé organométallique selon la revendication 9 ou la revendication 10, dans lequel :
(i) le cycle CY₁ est un groupe pyridine, un groupe pyrimidine, un groupe dibenzofurane, un groupe dibenzothiophène, un groupe carbazole, un groupe fluorène, un groupe dibenzosilole, un groupe azadibenzofurane, un groupe azadibenzothiophène, un groupe azacarbazole, un groupe azafluorène ou un groupe azadibenzosilole ; et/ou
(ii) le cycle CY₂ est un groupe benzène, un groupe naphtalène, un groupe anthracène, un groupe phénanthrène, un groupe indène, un groupe fluorène, un groupe indole, un groupe carbazole, un groupe benzofurane, un groupe dibenzofurane, un groupe benzothiophène, un groupe dibenzothiophène, un groupe quinoléine, un groupe isoquinoléine, un groupe quinoxaline ou un groupe quinazoline.

12. Composé organométallique selon l'une quelconque des revendications 9 à 11, dans lequel :
(i) les cycles CY₃ et CY₄ sont chacun indépendamment un groupe benzène, un groupe naphtalène, un groupe anthracène, un groupe phénanthrène, un groupe triphénylène, un groupe pyrène, un groupe chrysène ou un groupe cyclopentadiène ; et/ou
(ii) au moins l'un parmi CY₃ et CY₄ est substitué par au moins un deutérium.

13. Composé organométallique selon l'une quelconque des revendications 9 à 12, dans lequel R₁ à R₈ sont chacun indépendamment :
un hydrogène, un deutérium ou un groupe alkyle en C₁-C₂₀ ;
un groupe alkyle en C₁-C₂₀ substitué par un deutérium, -CD₃, -CD₂H, -CDH₂, ou une combinaison de ceux-ci ;
un groupe cyclopentényle, un groupe cyclohexényle, un groupe cycloheptényle, un groupe phényle, un groupe biphényle, un groupe alkylphényle en C₁-C₁₀, un groupe naphtyle, un groupe fluorényle, un groupe phénanthrényle, un groupe anthracényle, un groupe fluoranthényle, un groupe triphénylényle, un groupe pyrényle ou un groupe chrysényle, chacun non substitué ou substitué par un deutérium, -CD₃, -CD₂H, -CDH₂, un groupe alkyle en C₁-C₂₀, ou une combinaison de ceux-ci ; ou
-C(Q₁)(Q₂)(Q₃) ou -Si(Q₁)(Q₂)(Q₃), et
dans lequel Q₁ à Q₃ et Q₃₁ à Q₃₃ sont chacun indépendamment : un hydrogène ; un deutérium ;
un groupe alkyle en C₁-C₆₀; un groupe alcényle en C₂-C₆₀; un groupe alcynyle en C₂-C₆₀ ou un groupe carbocyclique en C₃-C₆₀ non substitué ou substitué par un deutérium, un groupe alkyle en C₁-C₆₀, un groupe phényle, un groupe biphényle ou une combinaison de ceux-ci.

14. Composé organométallique selon l'une quelconque des revendications 9 à 13, dans lequel le cycle CY₂ dans la Formule 1 est choisi parmi les groupes représentés par les Formules L1 à L10 : 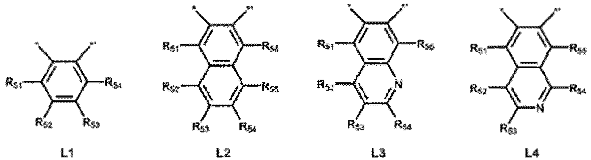 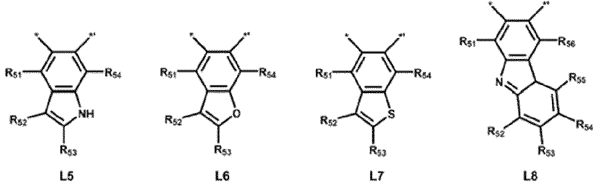 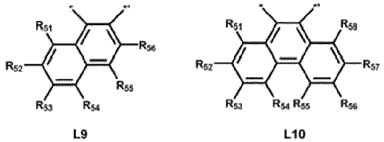 , et
dans lequel, dans les Formules L1 à L10,
R₅₁ à R₅₈ sont chacun définis comme pour R₅ dans la Formule 1, et
* et *' indiquent chacun un site de liaison à un atome voisin.

15. Composé organométallique selon l'une quelconque des revendications 9 à 14, dans lequel un groupe représenté par 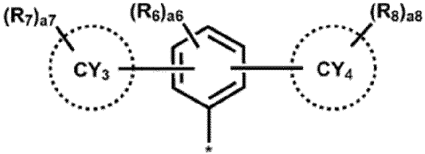 dans la Formule 1 est un groupe représenté par la Formule 1-1 : 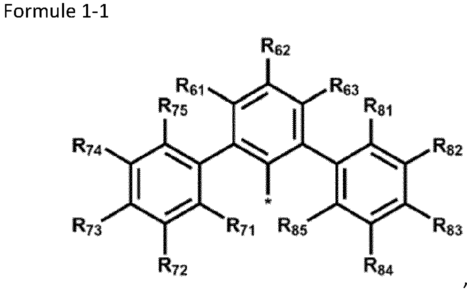 et
dans lequel, dans la Formule 1-1,
R₆₁ à R₆₃ sont chacun définis comme pour R₆,
R₇₁ à R₇₅ sont chacun définis comme pour R₇,
R₈₁ à R₈₅ sont chacun définis comme pour R₈ dans la Formule 1, et
* indique un site de liaison à un atome voisin.
